# EUROPEAN PATENT APPLICATION

(11) **EP 4 700 029 A1**
(43) Date of publication of application: **25.02.2026**
(21) Application number: 24875003.6
(22) Date of filing: 04.10.2024
(51) Int. Cl.: C07F 5/02, C07F 7/08, H10K 85/60, H10K 85/40, H10K 50/11, H10K 50/18, H10K 50/17

(54) **COMPOUND AND ORGANIC LIGHT-EMITTING DEVICE COMPRISING SAME**

(30) Priority: 06.10.2023 KR 20230133371
(71) Applicant: LG Chem, Ltd., Seoul 07336 (KR)
(72) Inventor: KIM, Kyunghee, Daejeon 34122 (KR); KIM, Moung Gon, Daejeon 34122 (KR); LEE, Woochul, Daejeon 34122 (KR); CHA, Yongbum, Daejeon 34122 (KR); HWANG, Sunghyun, Daejeon 34122 (KR)
(74) Representative: Hoffmann Eitle
(86) International application number: PCT/KR2024/015131
(87) International publication number: WO 2025/075448

(57) **Abstract**

This specification provides a compound represented by Chemical Formula 1 and an organic light-emitting device containing the same.

## Description

### [Technical Field]

This specification relates to a compound and an organic light-emitting device containing the same.

This application claims the benefit of Korean Patent Application No. 10-2023-0133371, filed in the Korean Intellectual Property Office on October 6, 2023, the entire content of which is incorporated herein by reference.

### [Background Art]

In general, the phenomenon of organic light emission refers to a phenomenon wherein electrical energy is converted to light energy using an organic material. An organic light-emitting device, which utilizes the phenomenon of organic light emission, typically has a structure that includes an anode, a cathode, and an organic layer situated between them. Here, the organic layer often has a multi-layer structure made of different materials to enhance the efficiency and stability of the organic light-emitting device. For example, it can consist of a hole injection layer, a hole transport layer, a light-emitting layer, an electron transport layer, an electron injection layer, etc. In the structure of the organic light-emitting device, when a voltage is applied between the two electrodes, holes from the anode and electrons from the cathode are injected into the organic layer. Excitons are formed when the injected holes and electrons recombine, and light is emitted as the excitons return to the ground state.

It is required to develop new materials for the organic light-emitting device described above.

### [References of Related Art]

### [Patent Documents]

(Patent document 1) Japanese Patent Publication No. 2021-095342 A.

### [Disclosure]

### [Technical Problem]

This specification provides a compound and an organic light-emitting device containing the same.

### [Technical Solution]

An exemplary embodiment of the present specification provides a compound represented by Chemical Formula 1.

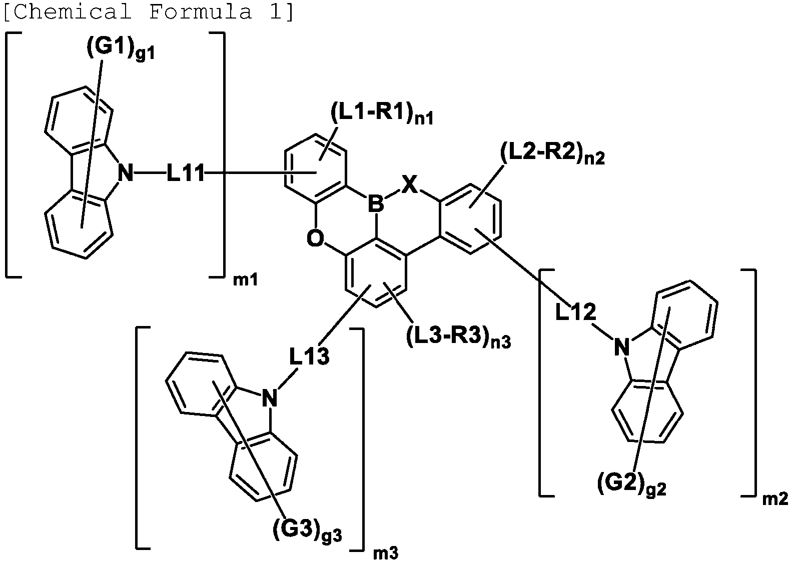

In Chemical Formula 1,
X is NR; O; or S,
at least one of R and R1 to R3 is a substituted or unsubstituted silyl group; a substituted or unsubstituted aryl group; or a substituted or unsubstituted heterocyclic group, and each of the rest, which are identical or different, is independently hydrogen; deuterium; a halogen group; a nitrile group; a substituted or unsubstituted alkyl group; or a substituted or unsubstituted cycloalkyl group,
each of L1 to L3 and L11 to L13, which are identical or different, is independently a direct bond; a substituted or unsubstituted arylene group; or a substituted or unsubstituted divalent heterocyclic group,
each of G1 to G3, which are identical or different, is independently hydrogen; deuterium; a halogen group; a nitrile group; a substituted or unsubstituted silyl group; a substituted or unsubstituted alkyl group; a substituted or unsubstituted cycloalkyl group; a substituted or unsubstituted aryl group; or a substituted or unsubstituted heterocyclic group,
each of n1 and n2 is an integer from 1 to 4, and each of m1 and m2 is an integer from 0 to 4,
n3 is an integer from 1 to 3, and m3 is an integer from 0 to 3,
each of g1 to g3 is an integer from 0 to 8,
the substituents within the parentheses are identical or different if each of n1 to n3, m1 to m3, and g1 to g3 is 2 or greater,
n1 + m1 is 4 or smaller, n2 + m2 is 4 or smaller, and n3 + m3 is 3 or smaller, and
m1 + m2 + m3 is an integer which is 1 or greater.

In addition, an exemplary embodiment of the present specification provides an organic light-emitting device including an anode; a cathode; and one or more organic layers provided between the anode and the cathode, wherein at least one of the organic layers contains the compound represented by Chemical Formula 1.

### [Advantageous Effects]

The compounds described in this specification can be used as materials for the organic layer of an organic light-emitting device. The compounds according to at least one exemplary embodiment of the present specification can improve the efficiency, low driving voltage and/or lifespan characteristics of organic light-emitting devices.

In particular, the compounds described in this specification can be used as materials for hole injection, hole transport, hole injection and transport, electron blocking, light emission, hole blocking, electron transport or electron injection. In addition, they have the effects of low driving voltage, high efficiency and/or long lifespan as compared to the existing materials for organic light-emitting devices.

### [Brief Description of Drawings]

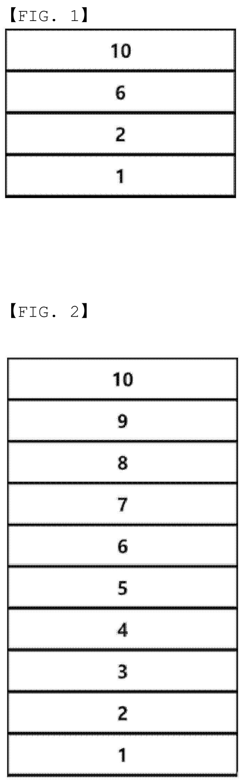

FIG. 1 shows an example of an organic light-emitting device in which a substrate 1, an anode 2, a light-emitting layer 6, and a cathode 10 are stacked sequentially.
FIG. 2 shows an example of an organic light-emitting device in which a substrate 1, an anode 2, a hole injection layer 3, a hole transport layer 4, an electron blocking layer 5, a light-emitting layer 6, a hole blocking layer 7, an electron transport layer 8, an electron injection layer 9, and a cathode 10 are stacked sequentially.

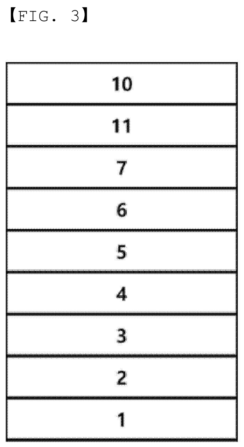

FIG. 3 shows an example of an organic light-emitting device in which a substrate 1, an anode 2, a hole injection layer 3, a hole transport layer 4, an electron blocking layer 5, a light-emitting layer 6, a hole blocking layer 7, an electron injection and transport layer 11, and a cathode 10 are stacked sequentially.

### [Best Mode]

The present disclosure will be described in more detail.

In this specification, when a part is described to "include" a certain component, it means that it can further include other components, unless specified otherwise to the contrary.

In the present specification, when a member is said to be located "on" another member, it includes not only the case where the member is in contact with the another member but also the case where another member exists between the two members.

In this specification, substitution with deuterium by N% means that N% of the available hydrogen in the corresponding structure is substituted with deuterium. For example, if dibenzofuran is substituted with deuterium by 25%, it means that 2 out of the 8 hydrogens in the dibenzofuran are substituted with deuterium.

In this specification, the degree of deuteration can be confirmed by known methods such as nuclear magnetic resonance spectroscopy (¹H NMR), GC/MS, etc.

Examples of substituents in this specification are described below, although not being limited thereto.

The term "substitution" refers to the replacement of a hydrogen atom bonded to a carbon atom in a compound with another substituent. The position of substitution is not limited as long as it is the position where the hydrogen atom is substituted, i.e., any position where a substituent can be substituted. In cases where two or more substitutions occur, the two or more substituents may be identical or different.

In this specification, the term "substituted or unsubstituted" means substituted with one or more substituents selected from a group consisting of deuterium; a halogen group; a nitrile group (-CN); a nitro group; a hydroxy group; an alkyl group; a cycloalkyl group; an alkoxy group; a phosphine oxide group; an aryloxy group; an alkylthio group; an arylthio group; an alkylsulfoxy group; an arylsulfoxy group; an alkenyl group; a silyl group; a boron group; an amine group; an aryl group; or a heterocyclic group, substituted with a substituent in which two or more of the above exemplified substituents are linked, or having no substituent at all. For example, the "substituent in which two or more substituents are linked" may be a biphenyl group. The biphenyl group can be interpreted as an aryl group or a substituent in which two phenyl groups are linked.

In this specification, the term "substituted or unsubstituted" means substituted with one or more substituents selected from a group consisting of deuterium; a halogen group; a nitrile group; a nitro group; a hydroxy group; an amino group; a silyl group; a boron group; an alkoxy group; an aryloxy group; an alkyl group; a cycloalkyl group; an aryl group; and a heterocyclic group, substituted with a substituent in which two or more of the above exemplified substituents are linked, or having no substituent at all.

In this specification, the term "substituted or unsubstituted" means substituted with one or more substituents selected from a group consisting of deuterium; an alkyl group; an aryl group; and a heterocyclic group, substituted with a substituent in which two or more of the above exemplified substituents are linked, or having no substituent at all.

Examples of the above substituents will be explained below, although not being limited thereto.

In this specification, examples of the halogen group include fluorine (-F), chlorine (-Cl), bromine (-Br), or iodine (-I).

In this specification, the silyl group can be represented by the chemical formula -SiYₐY_{b}Y_{c}, wherein each of Yₐ, Y_{b} and Y_{c} may be hydrogen; a substituted or unsubstituted alkyl group; or a substituted or unsubstituted aryl group. Specifically, the silyl group includes trimethylsilyl, triethylsilyl, t-butyldimethylsilyl, vinyldimethylsilyl, propyldimethylsilyl, triphenylsilyl, diphenylsilyl, phenylsilyl, etc., although not being limited thereto.

In this specification, the boron group can be represented by the chemical formula -BY_{d}Yₑ, wherein each of Yₑ and Yₑ may be hydrogen; a substituted or unsubstituted alkyl group; or a substituted or unsubstituted aryl group. The boron group may specifically be a trimethylboron group, a triethylboron group, a t-butyldimethylboron group, a triphenylboron group, a phenylboron group, etc., although not being limited thereto.

In the present specification, the alkyl group may be straight or branched, and may have 1 to 60 carbon atoms, although not being specially limited thereto. According to an exemplary embodiment, the number of carbon atoms in the alkyl group is 1 to 30. According to another exemplary embodiment, the number of carbon atoms in the alkyl group is 1 to 20. According to another exemplary embodiment, the number of carbon atoms in the alkyl group is 1 to 10. Specific examples of the alkyl group include a methyl group, an ethyl group, a propyl group, a n-propyl group, an isopropyl group, a butyl group, a n-butyl group, an isobutyl group, a tert-butyl group, a pentyl group, a n-pentyl group, a hexyl group, a n-hexyl group, a heptyl group, a n-heptyl group, an octyl group, a n-octyl group, etc., although not being limited thereto.

In this specification, the description of the alkyl group mentioned above can be applied to the arylalkyl group, except that it is substituted with an aryl group.

In this specification, the alkoxy group may be linear, branched or cyclic. The number of carbon atoms in the alkoxy group is not particularly limited, but may specifically be 1 to 20. Specifically, it may be methoxy, ethoxy, n-propoxy, isopropoxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, etc., although not being limited thereto.

The alkyl group, the alkoxy group and the other substituents containing alkyl moieties described in this specification include both linear and branched forms.

In this specification, the alkenyl group may be linear or branched, and the number of carbon atoms is specifically 2 to 40, although not being specially limited thereto. According to an exemplary embodiment, the number of carbon atoms in the alkenyl group is 2 to 20. According to another exemplary embodiment, the number of carbon atoms in the alkenyl group is 2 to 10. According to another exemplary embodiment, the number of carbon atoms in the alkenyl group is 2 to 6. Specific examples include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, styrenyl, etc., although not being limited thereto.

In this specification, the alkynyl group refers to a substituent containing a triple bond between carbon atoms. It can be linear or branched, and the number of carbon atoms may specifically be 2 to 40, although not being specially limited thereto. According to an exemplary embodiment, the number of carbon atoms in the alkynyl group is 2 to 20. According to another exemplary embodiment, the number of carbon atoms in the alkynyl group is 2 to 10.

In this specification, the cycloalkyl group may have 3 to 60 carbon atoms, although not being specially limited thereto. According to an exemplary embodiment, the number of carbon atoms in the cycloalkyl group is 3 to 30. According to another exemplary embodiment, the number of carbon atoms in the cycloalkyl group is 3 to 20. According to another exemplary embodiment, the number of carbon atoms in the cycloalkyl group is 3 to 6. Specifically, the cycloalkyl group may be a cyclopropyl group, a cyclobutyl group, a cyclopentyl group, a cyclohexyl group, a cycloheptyl group, a cyclooctyl group, etc., although not being limited thereto.

In this specification, the amino group is -NH₂, and the amino group may be substituted with an alkyl group, an aryl group, a heterocyclic group, an alkenyl group, a cycloalkyl group, or combinations thereof. The number of carbon atoms in the substituted amine group may be specifically 1 to 30, although not being specially limited thereto. According to an exemplary embodiment, the number of carbon atoms in the amine group is 1 to 20. According to an exemplary embodiment, the number of carbon atoms in the amine group is 1 to 10. Specific examples of the substituted amine group include a methylamine group, a dimethylamine group, an ethylamine group, a diethylamine group, a phenylamine group, a 9,9-dimethylfluorenylphenylamine group, a pyridylphenylamine group, a diphenylamine group, a phenylpyridylamine group, a naphthylamine group, a biphenylamine group, an anthracenylamine group, a dibenzofuranylphenylamine group, a 9-methylanthracenylamine group, a diphenylamine group, a phenylnaphthylamine group, a ditolylamine group, a phenyltolylamine group, a diphenylamine group, etc., although not being limited thereto.

In this specification, the aryl group is specifically one having 6 to 60 carbon atoms, although not being specially limited thereto. According to an exemplary embodiment, the number of carbon atoms in the aryl group is 6 to 30. According to an exemplary embodiment, the number of carbon atoms in the aryl group is 6 to 20. The aryl group may be an aryl group consisting of a single ring or a polycyclic aryl group (aryl group with two or more rings). The aryl group consisting of a single ring can also be expressed as a monocyclic aryl group, and may refer to a phenyl group; or a group wherein two or more phenyl groups are linked. The aryl group consisting of a single ring mentioned above can be a phenyl group, a biphenyl group, a terphenyl group, a quaterphenyl group, etc., although not being limited thereto. The polycyclic aryl groups can refer to a group in which two or more monocyclic rings are fused together, such as a naphthyl group, a phenanthrenyl group, etc. The polycyclic aryl group can include a naphthyl group, an anthracenyl group, a phenanthrenyl group, a pyrenyl group, a perylenyl group, a chrysenyl group, a fluorenyl group, a triphenylenyl group, etc., although not being limited thereto.

In this specification, the fluorenyl group may be substituted, and two substituents can combine to form a spiro structure. At this time, the spiro structure may be an aromatic hydrocarbon ring or an aliphatic hydrocarbon ring.

When the above fluorenyl group is substituted, it may be a spirofluorenyl group such as 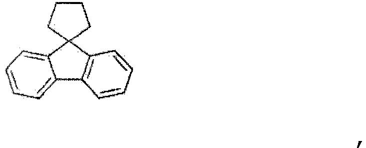 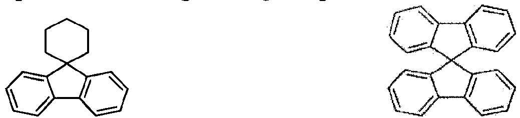 substituted fluorenyl group such as 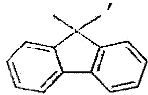 etc. or a (9,9-dimethylfluorenyl group) and 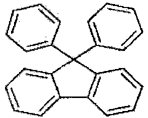 (9, 9-diphenylfluorenyl group), although not being limited thereto.

In this specification, the foregoing description of the aryl group can be applied to the aryl group in the aryloxy group.

In this specification, the foregoing description of the alkyl group can be applied to the alkyl group in the alkylthioxy group and the alkylsulfoxy group.

In this specification, the foregoing description of the aryl group can be applied to the aryl group in the arylthioxy group and the arylsulfoxy group.

In this specification, the heterocyclic group refers to a cyclic group containing one or more heteroatoms selected from N, O, P, S, Si and Se, and the number of carbon atoms is specifically 2 to 60, although not being specially limited thereto. According to an exemplary embodiment, the number of carbon atoms in the heterocyclic group is 2 to 30. According to an exemplary embodiment, the number of carbon atoms in the heterocyclic group is 2 to 20. Examples of heterocyclic group include a pyridine group, pyrrole group, a pyrimidine group, a quinoline group, a pyridazinyl group, a furan group, a thiophene group, an imidazole group, a pyrazole group, a dibenzofuran group, a dibenzothiophene group, a carbazole group, a benzocarbazole group, a naphthobenzofuran group, a benzonaphthothiophene group, an indenocarbazole group, a triazinyl group, etc., although not being limited thereto.

In the present specification, the foregoing description of the heterocyclic group may apply, except that the heteroaryl group is aromatic.

In this specification, the foregoing description of the aryl group may apply, except that the arylene group is divalent.

In this specification, the foregoing description of the heterocyclic group may apply, except that the divalent heterocyclic group is divalent.

In this specification, in the substituted or unsubstituted ring formed through joining of adjacent groups, the "ring" means a hydrocarbon ring; or a heterocyclic ring.

The hydrocarbon ring may be an aromatic ring, an aliphatic ring, or a fused ring of aromatic and aliphatic rings, and may be selected from the cycloalkyl groups or aryl groups exemplified above.

In this specification, the expression that "a ring is formed through joining of adjacent groups" means a substituted or unsubstituted aliphatic hydrocarbon ring; a substituted or unsubstituted aromatic hydrocarbon ring; a substituted or unsubstituted aliphatic heterocyclic ring; a substituted or unsubstituted aromatic heterocyclic ring; or a fused ring thereof is formed through joining of adjacent groups. The hydrocarbon ring above refers to a ring consisting only of carbon and hydrogen atoms. The heterocyclic ring refers to a ring containing one or more element selected from N, O, P, S, Si, Se, etc. In this specification, the aliphatic hydrocarbon ring, aromatic hydrocarbon ring, aliphatic heterocyclic ring, and aromatic heterocyclic ring may be monocyclic or polycyclic.

In this specification, the aliphatic hydrocarbon ring refers to a non-aromatic ring consisting only of carbon and hydrogen atoms. Examples of the aliphatic hydrocarbon ring include cyclopropane, cyclobutane, cyclobutene, cyclopentane, cyclopentene, cyclohexane, cyclohexene, 1,4-cyclohexadiene, cycloheptane, cycloheptene, cyclooctane, cyclooctene, etc., although not being limited thereto.

In this specification, the aromatic hydrocarbon ring refers to an aromatic ring consisting only of carbon and hydrogen atoms. Examples of the aromatic hydrocarbon ring include benzene, naphthalene, anthracene, phenanthrene, perylene, fluoranthene, triphenylene, phenalene, pyrene, tetracene, chrysene, pentacene, fluorene, indene, acenaphthylene, benzofluorene, spirofluorene, etc., although not being limited thereto. In this specification, the aromatic hydrocarbon ring can be understood to have the same meaning as the aryl group.

In this specification, the aliphatic heterocyclic ring refers to an aliphatic ring containing one or more heteroatoms. Examples of the aliphatic heterocyclic ring include oxirane, tetrahydrofuran, 1, 4-dioxane, pyrrolidine, piperidine, morpholine, oxepane, azocane, thiocane, etc., although not being limited thereto.

In this specification, the aromatic heterocyclic ring refers to an aromatic ring containing one or more heteroatoms. Examples of the aromatic heterocyclic ring include pyridine, pyrrole, pyrimidine, pyridazine, furan, thiophene, imidazole, pyrazole, oxazole, isoxazole, thiazole, isothiazole, triazole, oxadiazole, thiadiazole, dithiazole, tetrazole, pyran, thiopyran, diazine, oxazine, thiazine, dioxin, triazine, tetrazine, isoquinoline, quinoline, quinone, quinazoline, quinoxaline, naphthyridine, acridine, phenanthridine, diazanaphthalene, triazaindene, indole, indolizine, benzothiazole, benzoxazole, benzimidazole, benzothiophene, benzofuran, dibenzothiophene, dibenzofuran, carbazole, benzocarbazole, dibenzocarbazole, phenazine, imidazopyridine, phenoxazine, indolocarbazole, indenocarbazole, etc., although not being limited thereto.

Hereinafter, specific exemplary embodiments of the present disclosure will be described in detail. However, the exemplary embodiments of the present disclosure can be modified in various forms, and the scope of the present disclosure is not limited to the exemplary embodiments described below.

The compound represented by Chemical Formula 1 of the present disclosure is characterized by having a carbazole group and a silyl or an aryl group connected to a benzene ring included in a multi-resonance core structure containing boron. When a carbazole group and a silyl or aryl group are connected to the core structure as described above, the bulkiness of the molecule itself increases as compared to a structure where only one carbazole group is substituted, thereby increasing the distance between molecules and preventing aggregation of the molecules. This suppresses quenching, thereby increasing the efficiency and lifespan of an organic light-emitting device.

Therefore, when the compound represented by Chemical Formula 1 of the present disclosure is applied to an organic light-emitting device, an organic light-emitting device with high efficiency, low voltage, and/or long lifespan characteristics can be obtained.

Hereinafter, a detailed description will be given for Chemical Formula 1.

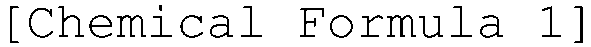

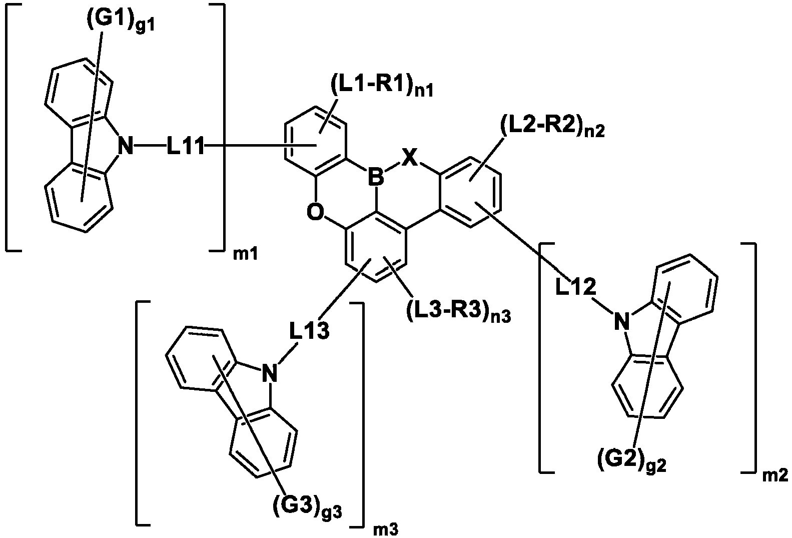

In Chemical Formula 1,
X is NR; O; or S,
at least one of R and R1 to R3 is a substituted or unsubstituted silyl group; a substituted or unsubstituted aryl group; or a substituted or unsubstituted heterocyclic group, and each of the rest, which are identical or different, is independently hydrogen; deuterium; a halogen group; a nitrile group; a substituted or unsubstituted alkyl group; or a substituted or unsubstituted cycloalkyl group,
each of L1 to L3 and L11 to L13, which are identical or different, is independently a direct bond; a substituted or unsubstituted arylene group; or a substituted or unsubstituted divalent heterocyclic group,
each of G1 to G3, which are identical or different, is independently hydrogen; deuterium; a halogen group; a nitrile group; a substituted or unsubstituted silyl group; a substituted or unsubstituted alkyl group; a substituted or unsubstituted cycloalkyl group; a substituted or unsubstituted aryl group; or a substituted or unsubstituted heterocyclic group,
each of n1 and n2 is an integer from 1 to 4, and each of m1 and m2 is an integer from 0 to 4,
n3 is an integer from 1 to 3, and m3 is an integer from 0 to 3,
each of g1 to g3 is an integer from 0 to 8,
the substituents within the parentheses are identical or different if each of n1 to n3, m1 to m3, and g1 to g3 is 2 or greater,
n1 + m1 is 4 or smaller, n2 + m2 is 4 or smaller, and n3 + m3 is 3 or smaller, and
m1 + m2 + m3 is an integer which is 1 or greater.

In an exemplary embodiment of the present specification, X is NR; O; or S.

In an exemplary embodiment of the present specification, X is NR.

In an exemplary embodiment of the present specification, X is O.

In an exemplary embodiment of the present specification, X is S.

In an exemplary embodiment of the present specification, R is hydrogen; deuterium; a halogen group; a nitrile group; a substituted or unsubstituted alkyl group; a substituted or unsubstituted cycloalkyl group; a substituted or unsubstituted aryl group; or a substituted or unsubstituted heterocyclic group.

In an exemplary embodiment of the present specification, R is a substituted or unsubstituted aryl group; or a substituted or unsubstituted heterocyclic group.

In an exemplary embodiment of the present specification, R is a substituted or unsubstituted aryl group.

In an exemplary embodiment of the present specification, R is a phenyl group or a biphenyl group.

In an exemplary embodiment of the present specification, at least one of R1 to R3 is a substituted or unsubstituted silyl group; a substituted or unsubstituted aryl group; or a substituted or unsubstituted heterocyclic group, and each of the rest, which are identical or different, is independently hydrogen; deuterium; a halogen group; a nitrile group; a substituted or unsubstituted alkyl group; or a substituted or unsubstituted cycloalkyl group.

In an exemplary embodiment of the present specification, at least one of R1 to R3 is a substituted or unsubstituted silyl group; a substituted or unsubstituted aryl group having 6 to 60 carbon atoms; or a substituted or unsubstituted heterocyclic group having 2 to 60 carbon atoms, and each of the rest, which are identical or different, is independently hydrogen; deuterium; a halogen group; a nitrile group; a substituted or unsubstituted alkyl group having 1 to 60 carbon atoms; or a substituted or unsubstituted cycloalkyl group having 3 to 60 carbon atoms.

In an exemplary embodiment of the present specification, at least one of R1 to R3 is a substituted or unsubstituted silyl group; a substituted or unsubstituted aryl group having 6 to 30 carbon atoms; or a substituted or unsubstituted heterocyclic group having 2 to 30 carbon atoms, and each of the rest, which are identical or different, is independently hydrogen; deuterium; a halogen group; a nitrile group; a substituted or unsubstituted alkyl group having 1 to 30 carbon atoms; or a substituted or unsubstituted cycloalkyl group having 3 to 30 carbon atoms.

In an exemplary embodiment of the present specification, at least one of R1 to R3 is a substituted or unsubstituted silyl group; a substituted or unsubstituted aryl group having 6 to 20 carbon atoms; or a substituted or unsubstituted heterocyclic group having 2 to 20 carbon atoms, and each of the rest, which are identical or different, is independently hydrogen; deuterium; a halogen group; a nitrile group; a substituted or unsubstituted alkyl group having 1 to 20 carbon atoms; or a substituted or unsubstituted cycloalkyl group having 3 to 20 carbon atoms.

In an exemplary embodiment of the present specification, at least one of R1 to R3 is a silyl group substituted or unsubstituted with deuterium, an alkyl group, or an aryl group; an aryl group substituted or unsubstituted with deuterium or an aryl group; or a heterocyclic group substituted or unsubstituted with deuterium or a heterocyclic group, and each of the rest, which are identical or different, is independently hydrogen; or deuterium.

In an exemplary embodiment of the present specification, at least one of R1 to R3 is a silyl group substituted or unsubstituted with deuterium, an alkyl group having 1 to 60 carbon atoms, or an aryl group having 6 to 60 carbon atoms; an aryl group having 6 to 60 carbon atoms substituted or unsubstituted with deuterium or an aryl group having 6 to 60 carbon atoms; or a heterocyclic group having 2 to 60 carbon atoms substituted or unsubstituted with deuterium or a heterocyclic group having 2 to 60 carbon atoms, and each of the rest, which are identical or different, is independently hydrogen; or deuterium.

In an exemplary embodiment of the present specification, at least one of R1 to R3 is a silyl group substituted or unsubstituted with deuterium, an alkyl group having 1 to 30 carbon atoms, or an aryl group having 6 to 30 carbon atoms; an aryl group having 6 to 30 carbon atoms substituted or unsubstituted with deuterium or an aryl group having 6 to 30 carbon atoms; or a heterocyclic group having 2 to 30 carbon atoms substituted or unsubstituted with deuterium or a heterocyclic group having 2 to 30 carbon atoms, and each of the rest, which are identical or different, is independently hydrogen; or deuterium.

In an exemplary embodiment of the present specification, at least one of R1 to R3 is a silyl group substituted or unsubstituted with deuterium, an alkyl group having 1 to 20 carbon atoms, or an aryl group having 6 to 20 carbon atoms; an aryl group having 6 to 20 carbon atoms substituted or unsubstituted with deuterium or an aryl group having 6 to 20 carbon atoms; or a heterocyclic group having 2 to 20 carbon atoms substituted or unsubstituted with deuterium or a heterocyclic group having 2 to 20 carbon atoms, and each of the rest, which are identical or different, is independently hydrogen; or deuterium.

In an exemplary embodiment of the present specification, at least one of R1 to R3 is a silyl group substituted with a phenyl group; a phenyl group; a biphenyl group; a carbazole group; a dibenzofuran group; a dibenzothiophene group; or a heterocyclic group containing at least one of N and O as a heteroatom, having 2 to 60 carbon atoms, and each of the rest, which are identical or different, is independently hydrogen; or deuterium.

In an exemplary embodiment of this specification, at least one of R1 to R3 is a triphenylsilyl group; a phenyl group; a biphenyl group; a carbazole group; a dibenzofuran group; a benzofuranodibenzofuran group; or an indolocarbazole group, and each of the rest, which are identical or different, is independently hydrogen; or deuterium.

In an exemplary embodiment of the present specification, the benzofuranodibenzofuran group is a benzo[1,2-b:3,4-b']bisbenzofuran group.

In an exemplary embodiment of the present specification, the indolocarbazole group is indolo[3,2,1-jk]carbazole group.

In an exemplary embodiment of the present specification, at least one of R1 to R3 is a group represented by the following structural formula, or a substituted or unsubstituted aryl group.

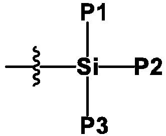

In the above structural formula, P1 to P3 are substituted or unsubstituted aryl groups, and 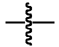 represents the position where it is bonded to L1 to L3.

In an exemplary embodiment of the present specification, P1 to P3 are substituted or unsubstituted aryl groups having 6 to 60 carbon atoms.

In an exemplary embodiment of the present specification, P1 to P3 are substituted or unsubstituted aryl groups having 6 to 30 carbon atoms.

In an exemplary embodiment of the present specification, P1 to P3 are substituted or unsubstituted aryl groups having 6 to 20 carbon atoms.

In an exemplary embodiment of the present specification, P1 to P3 are phenyl groups.

In an exemplary embodiment of the present specification, each of L1 to L3, which are identical or different, is independently a direct bond; a substituted or unsubstituted arylene group; or a substituted or unsubstituted divalent heterocyclic group.

In an exemplary embodiment of the present specification, each of L1 to L3, which are identical or different, is independently a direct bond; a substituted or unsubstituted arylene group having 6 to 60 carbon atoms; or a substituted or unsubstituted divalent heterocyclic group having 2 to 60 carbon atoms.

In an exemplary embodiment of the present specification, each of L1 to L3, which are identical or different, is independently a direct bond; a substituted or unsubstituted arylene group having 6 to 30 carbon atoms; or a substituted or unsubstituted divalent heterocyclic group having 2 to 30 carbon atoms.

In an exemplary embodiment of the present specification, each of L1 to L3, which are identical or different, is independently a direct bond; a substituted or unsubstituted arylene group having 6 to 20 carbon atoms; or a substituted or unsubstituted divalent heterocyclic group having 2 to 20 carbon atoms.

In an exemplary embodiment of the present specification, each of L1 to L3, which are identical or different, is independently a direct bond; or a substituted or unsubstituted arylene group.

In an exemplary embodiment of the present specification, each of L1 to L3, which are identical or different, is independently a direct bond; or an arylene group having 6 to 60 carbon atoms.

In an exemplary embodiment of the present specification, each of L1 to L3, which are identical or different, is independently a direct bond; or an arylene group having 6 to 30 carbon atoms.

In an exemplary embodiment of the present specification, each of L1 to L3, which are identical or different, is independently a direct bond; or an arylene group having 6 to 20 carbon atoms.

In an exemplary embodiment of the present specification, each of L1 to L3, which are identical or different, is independently a direct bond; or a phenylene group.

In an exemplary embodiment of the present specification, each of L11 to L13, which are identical or different, is independently a direct bond; a substituted or unsubstituted arylene group; or a substituted or unsubstituted divalent heterocyclic group.

In an exemplary embodiment of the present specification, each of L11 to L13, which are identical or different, is independently a direct bond; a substituted or unsubstituted arylene group having 6 to 60 carbon atoms; or a substituted or unsubstituted divalent heterocyclic group having 2 to 60 carbon atoms.

In an exemplary embodiment of the present specification, each of L11 to L13, which are identical or different, is independently a direct bond; a substituted or unsubstituted arylene group having 6 to 30 carbon atoms; or a substituted or unsubstituted divalent heterocyclic group having 2 to 30 carbon atoms.

In an exemplary embodiment of the present specification, each of L11 to L13, which are identical or different, is independently a direct bond; a substituted or unsubstituted arylene group having 6 to 20 carbon atoms; or a substituted or unsubstituted divalent heterocyclic group having 2 to 20 carbon atoms.

In an exemplary embodiment of the present specification, each of L11 to L13, which are identical or different, is independently a direct bond; or a substituted or unsubstituted arylene group.

In an exemplary embodiment of the present specification, each of L11 to L13, which are identical or different, is independently a direct bond; or an arylene group.

In an exemplary embodiment of the present specification, each of L11 to L13, which are identical or different, is independently a direct bond; or an arylene group having 6 to 60 carbon atoms.

In an exemplary embodiment of the present specification, each of L11 to L13, which are identical or different, is independently a direct bond; or an arylene group having 6 to 30 carbon atoms.

In an exemplary embodiment of this specification, each of L11 to L13, which are identical or different, is independently a direct bond; or an arylene group having 6 to 20 carbon atoms.

In an exemplary embodiment of the present specification, each of L11 to L13, which are identical or different, is independently a direct bond; or a phenylene group.

In an exemplary embodiment of the present specification, each of G1 to G3, which are identical or different, is independently hydrogen; deuterium; a halogen group; a nitrile group; a substituted or unsubstituted silyl group; a substituted or unsubstituted alkyl group; a substituted or unsubstituted cycloalkyl group; a substituted or unsubstituted aryl group; or a substituted or unsubstituted heterocyclic group.

In an exemplary embodiment of the present specification, each of G1 to G3, which are identical or different, is independently hydrogen; deuterium; a halogen group; a nitrile group; a substituted or unsubstituted silyl group; a substituted or unsubstituted alkyl group having 1 to 60 carbon atoms; substituted or unsubstituted cycloalkyl group having 3 to 60 carbon atoms; a substituted or unsubstituted aryl group having 6 to 60 carbon atoms; or a substituted or unsubstituted heterocyclic group having 2 to 60 carbon atoms.

In an exemplary embodiment of the present specification, each of G1 to G3, which are identical or different, is independently hydrogen; deuterium; a halogen group; a nitrile group; a substituted or unsubstituted silyl group; a substituted or unsubstituted alkyl group having 1 to 30 carbon atoms; a substituted or unsubstituted cycloalkyl group having 3 to 30 carbon atoms; a substituted or unsubstituted aryl group having 6 to 30 carbon atoms; or a substituted or unsubstituted heterocyclic group having 2 to 30 carbon atoms.

In an exemplary embodiment of the present specification, each of G1 to G3, which are identical or different, is independently hydrogen; deuterium; a halogen group; a nitrile group; a substituted or unsubstituted silyl group; a substituted or unsubstituted alkyl group having 1 to 20 carbon atoms; a substituted or unsubstituted cycloalkyl group having 3 to 20 carbon atoms; a substituted or unsubstituted aryl group having 6 to 20 carbon atoms; or a substituted or unsubstituted heterocyclic group having 2 to 20 carbon atoms.

In an exemplary embodiment of the present specification, each of G1 to G3, which are identical or different, is independently hydrogen; or deuterium.

In an exemplary embodiment of the present specification, G1 to G3 are hydrogen.

In an exemplary embodiment of this specification, each of n1 and n2 is an integer from 1 to 4, and each of m1 and m2 is an integer from 0 to 4.

In an exemplary embodiment of the present specification, n3 is an integer from 1 to 3, and m3 is an integer from 0 to 3.

In an exemplary embodiment of the present specification, n1 is 1.

In an exemplary embodiment of the present specification, n2 is 1.

In an exemplary embodiment of the present specification, n3 is 1.

In an exemplary embodiment of the present specification, m1 is 0.

In an exemplary embodiment of the present specification, m1 is 1.

In an exemplary embodiment of the present specification, m2 is 0.

In an exemplary embodiment of the present specification, m2 is 1.

In an exemplary embodiment of the present specification, m3 is 0.

In an exemplary embodiment of the present specification, m3 is 1.

In an exemplary embodiment of this specification, each of g1 to g3 is an integer from 0 to 8.

In an exemplary embodiment of the present specification, g1 to g3 are 0.

In an exemplary embodiment of the present specification, g1 to g3 are 8.

In an exemplary embodiment of the present specification, n1 + m1 is 4 or smaller, n2 + m2 is 4 or smaller, and n3 + m3 is 3 or smaller.

In an exemplary embodiment of the present specification, m1 + m2 + m3 is an integer 1 or greater.

In an exemplary embodiment of the present specification, m1 + m2 + m3 is 1 to 3.

In an exemplary embodiment of the present specification, m1 + m2 + m3 is 1 or 2.

In an exemplary embodiment of the present specification, Chemical Formula 1 is represented by any one of Chemical Formulas 1-A-1 to 1-A-3.

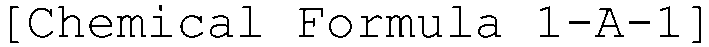

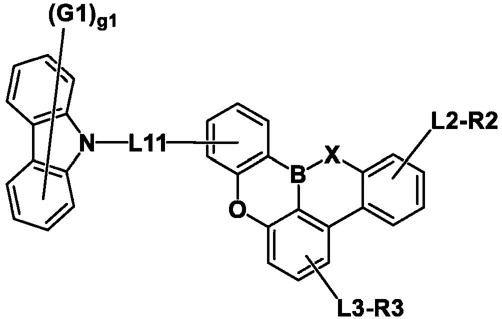

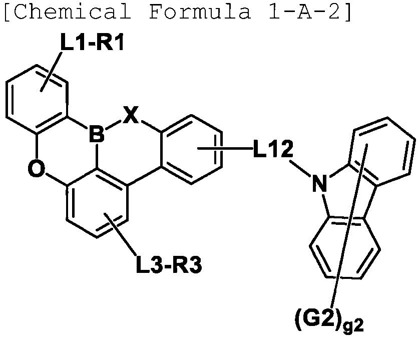

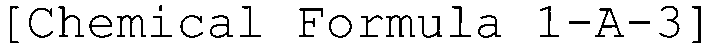

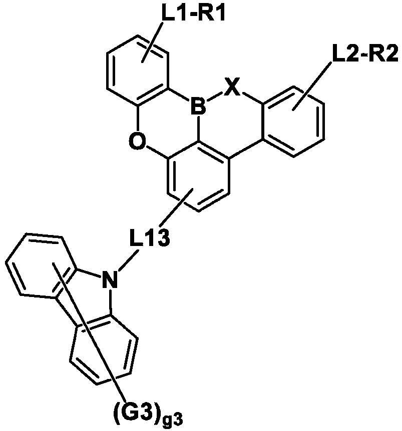

In Chemical Formulas 1-A-1 to 1-A-3,
X, R1 to R3, L1 to L3, L11 to L13, G1 to G3, and g1 to g3 are the same as defined in Chemical Formula 1.

In an exemplary embodiment of the present specification, Chemical Formula 1 is represented by any one of Chemical Formulas 1-B-1 to 1-B-3.

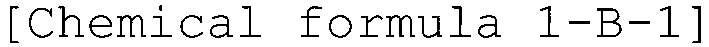

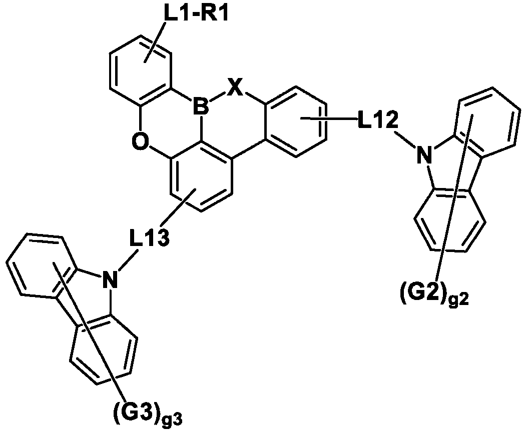

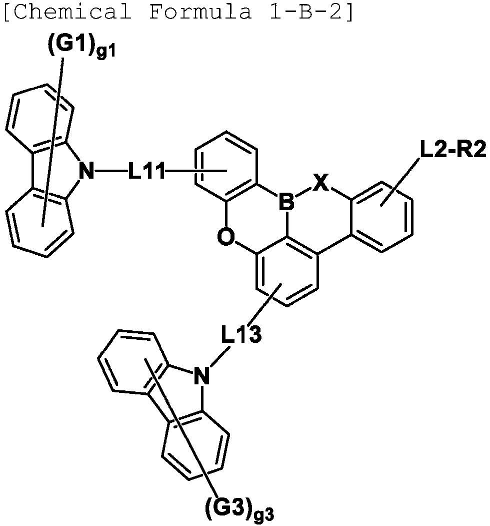

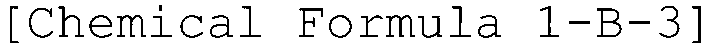

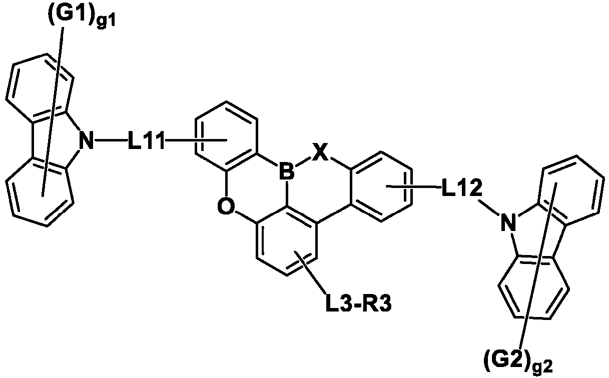

In Chemical Formulas 1-B-1 to 1-B-3,
X, R1 to R3, L1 to L3, L11 to L13, G1 to G3, and g1 to g3 are the same as defined in Chemical Formula 1.

In an exemplary embodiment of the present specification, the deuterium-containing compound of Chemical Formula 1 can be prepared by known deuteration reactions. In an exemplary embodiment of the present specification, the compound represented by Chemical Formula 1 may be formed using a deuterated compound as a precursor, or deuterium may be introduced into the compound through a hydrogen-deuterium exchange reaction in the presence of an acid catalyst using a deuterated solvent.

In an exemplary embodiment of the present specification, the compound represented by Chemical Formula 1 is substituted with deuterium by 20% or more. In another exemplary embodiment, the compound represented by Chemical Formula 1 is substituted with deuterium by 30% or more. In another exemplary embodiment, the compound represented by Chemical Formula 1 is substituted with deuterium at 40% or more. In another exemplary embodiment, the compound represented by Chemical Formula 1 is substituted with deuterium by 50% or more. In another exemplary embodiment, the compound represented by Chemical Formula 1 is substituted with deuterium by 60% or more. In another exemplary embodiment, the compound represented by Chemical Formula 1 is substituted with deuterium by 70% or more. In another exemplary embodiment, the compound represented by Chemical Formula 1 is substituted with deuterium by 80% or more. In another exemplary embodiment, the compound represented by Chemical Formula 1 is substituted with deuterium by 90% or more. In another exemplary embodiment, the compound represented by Chemical Formula 1 is substituted with deuterium by 100%.

In an exemplary embodiment of the present specification, the compound represented by Chemical Formula 1 contains 40% to 60% of deuterium. In another exemplary embodiment, the compound represented by Chemical Formula 1 contains 40% to 80% of deuterium. In another exemplary embodiment, the compound represented by Chemical Formula 1 contains 60% to 80% of deuterium. In another exemplary embodiment, the compound represented by Chemical Formula 1 contains 80% to 100% of deuterium.

In an exemplary embodiment of the present specification, the compound represented by Chemical Formula 1 is any one of the following compounds. 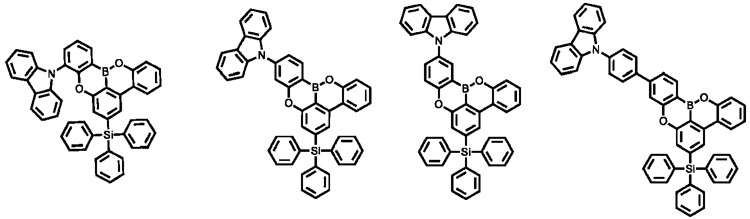 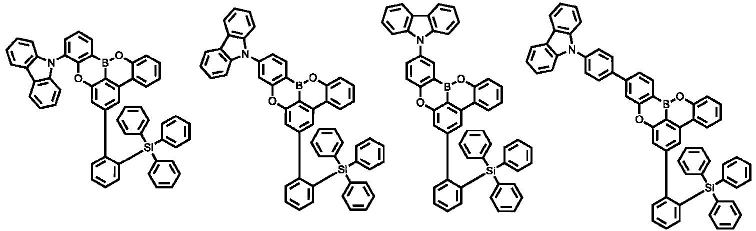 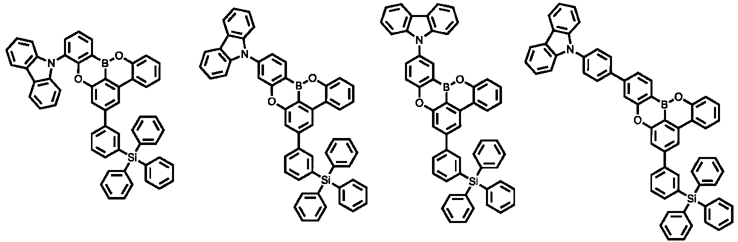 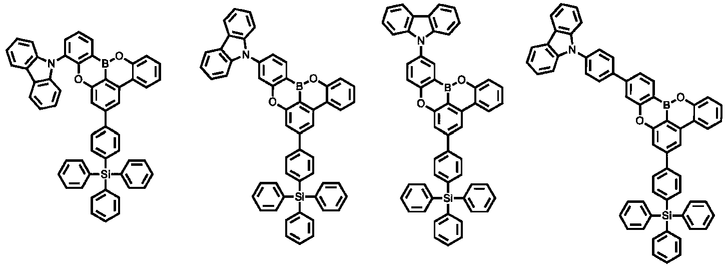 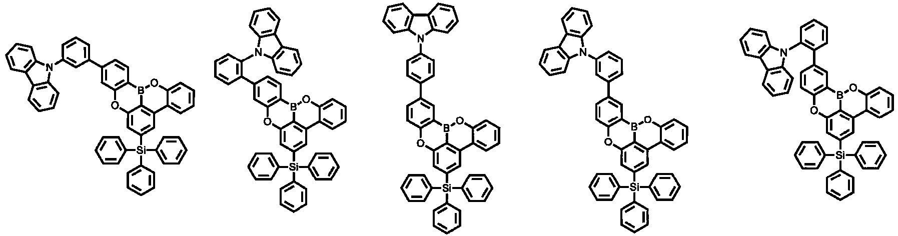 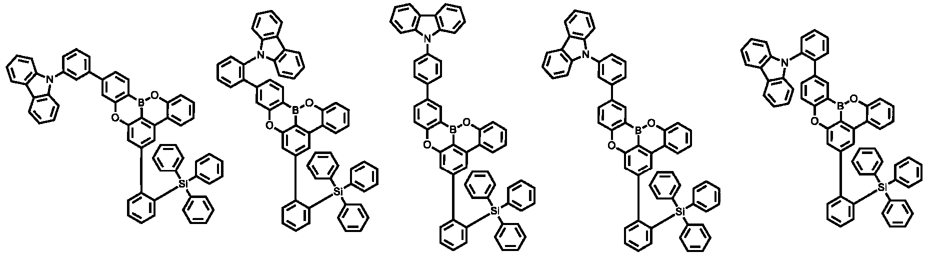 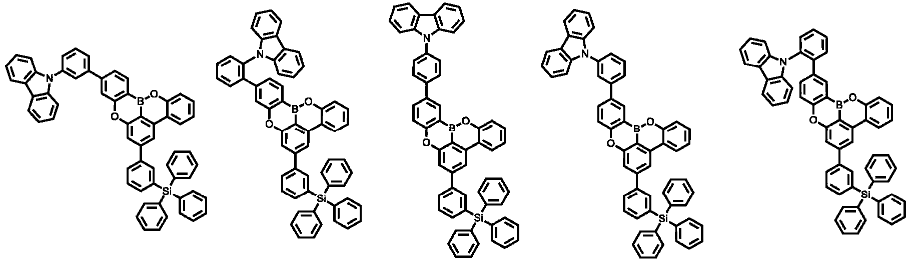 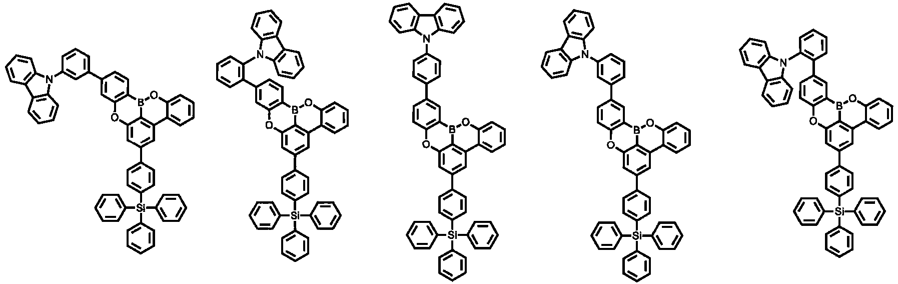 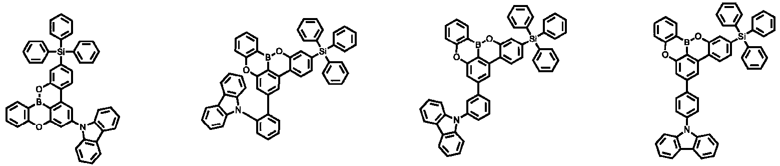 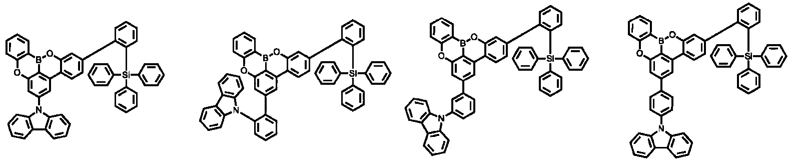 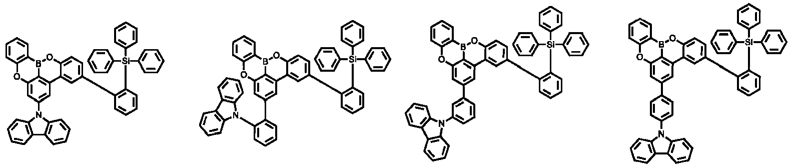 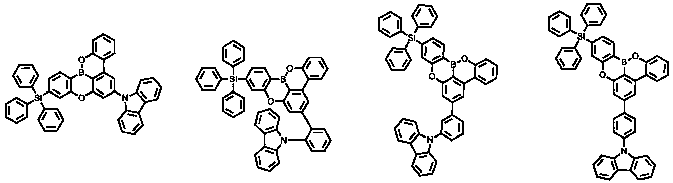 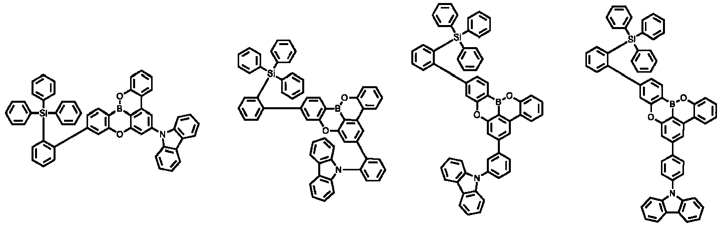 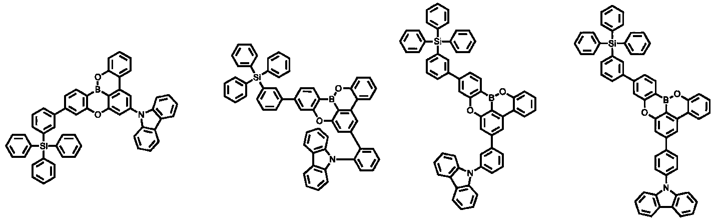 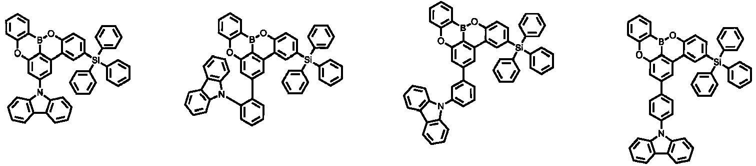 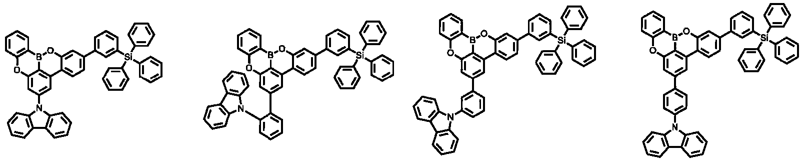 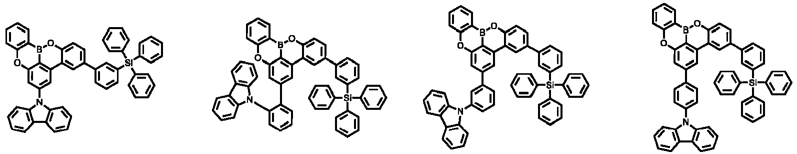 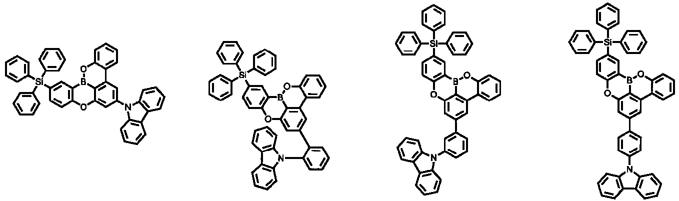 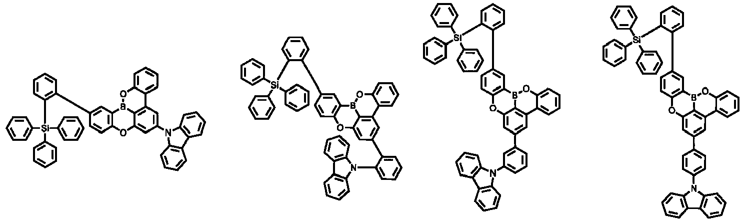 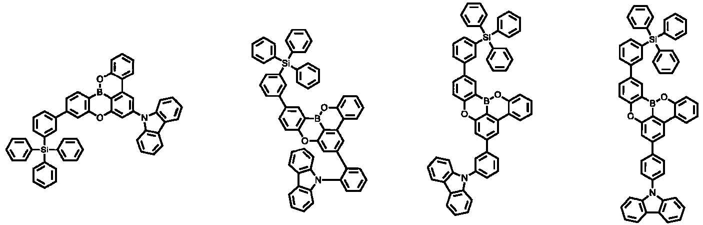 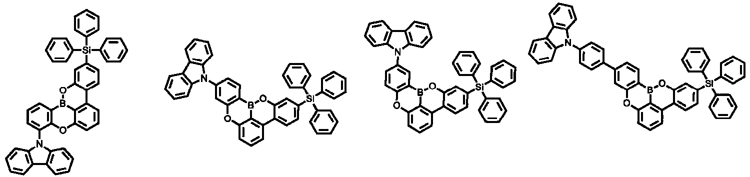 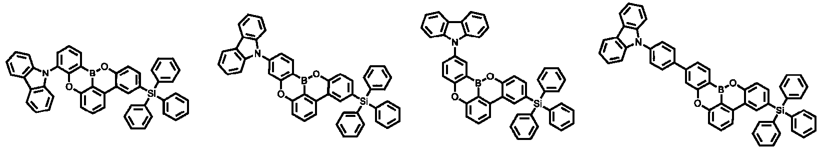 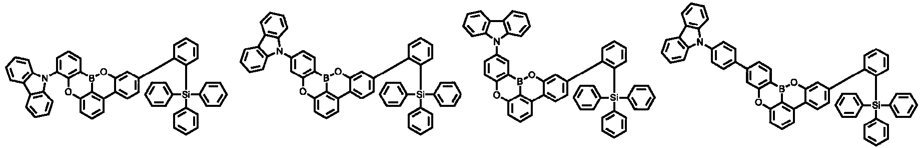 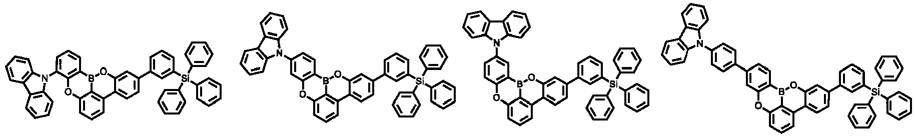 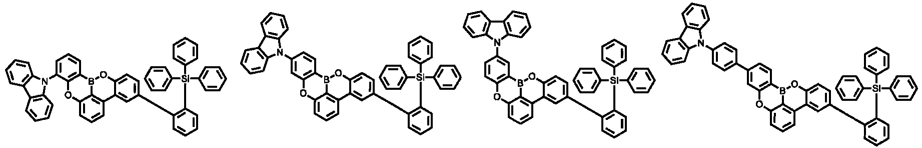 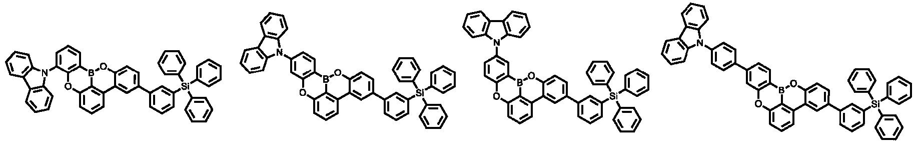 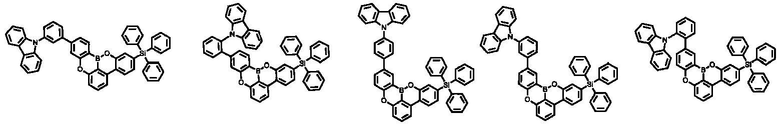 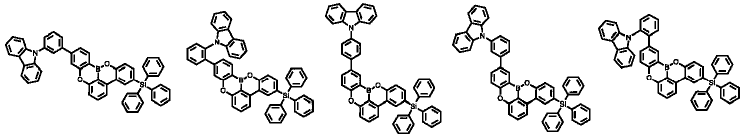 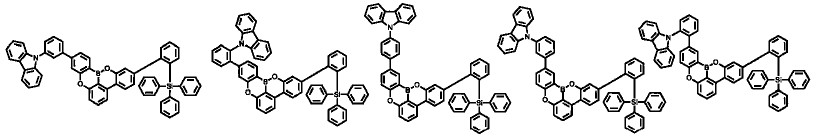 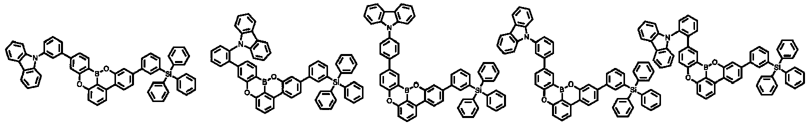 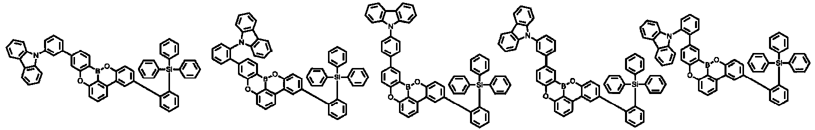 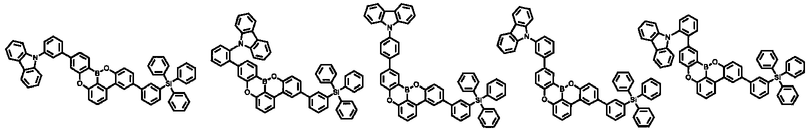 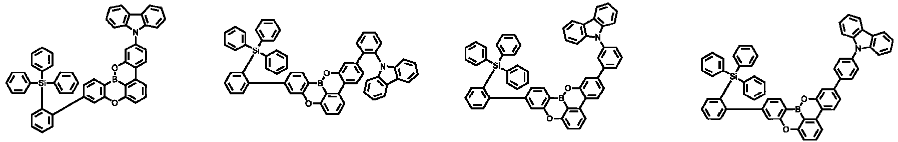 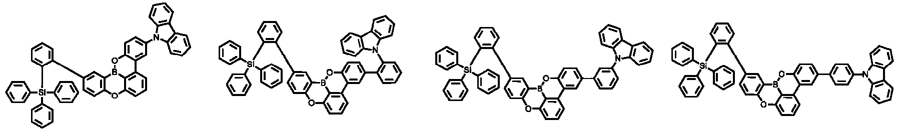 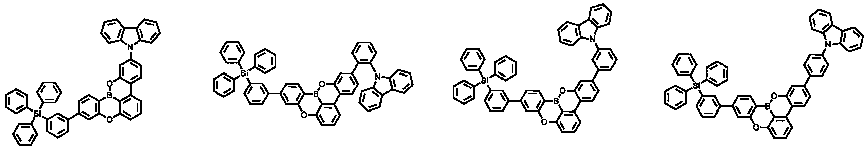 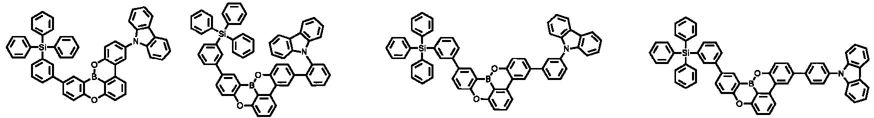 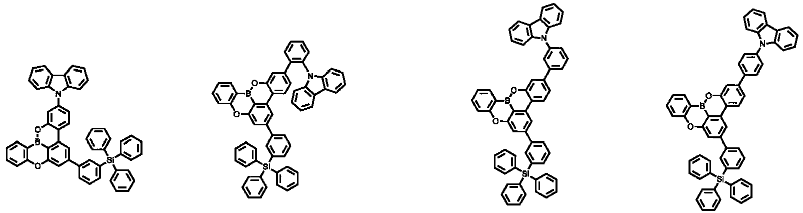 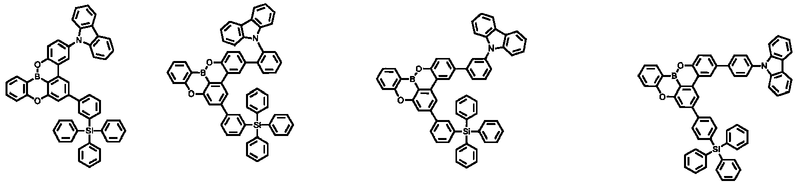 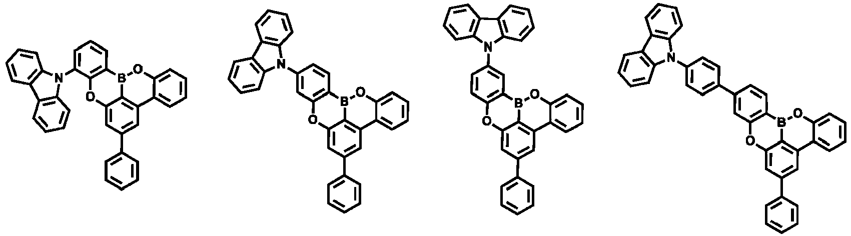 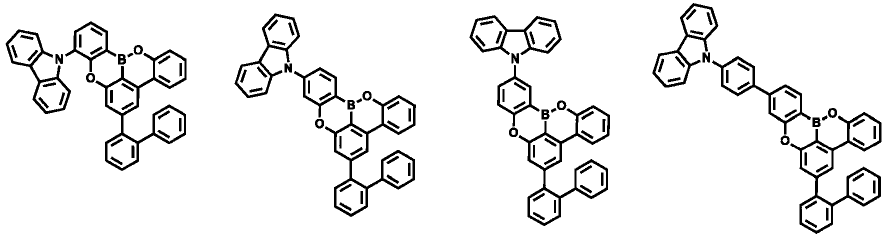 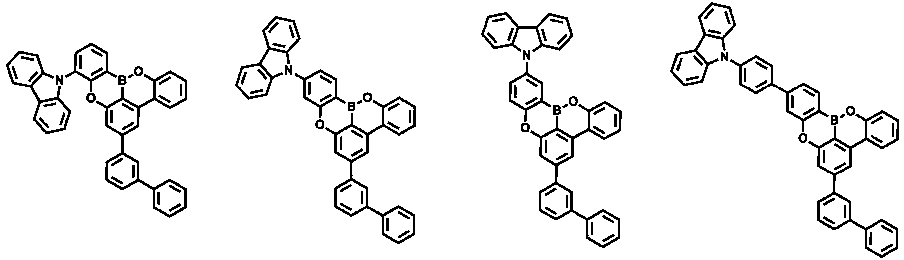 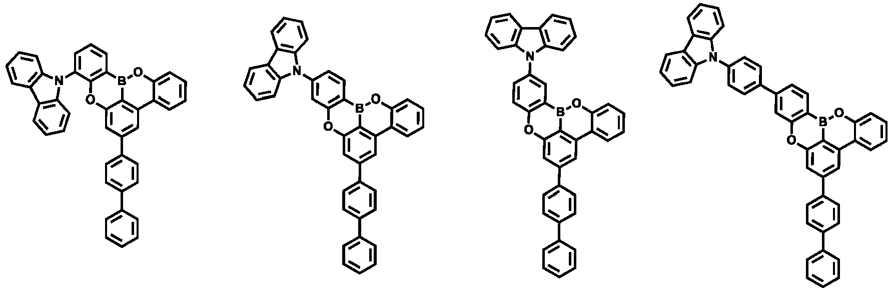 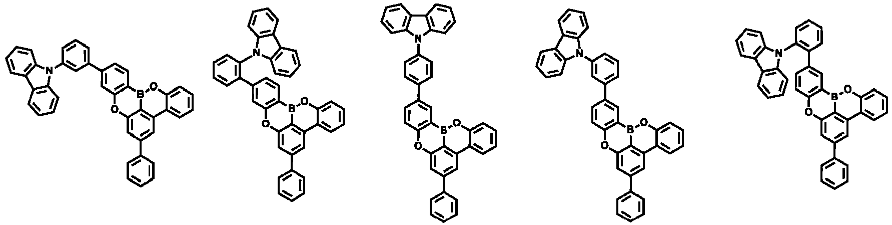 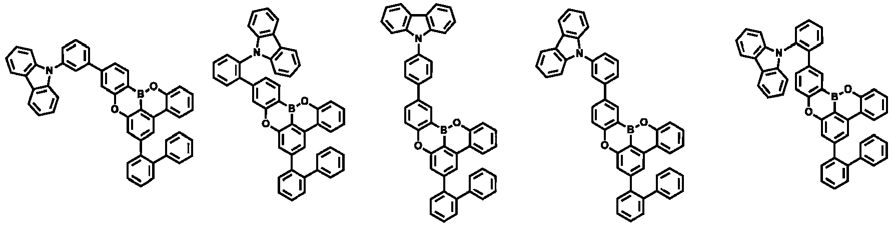 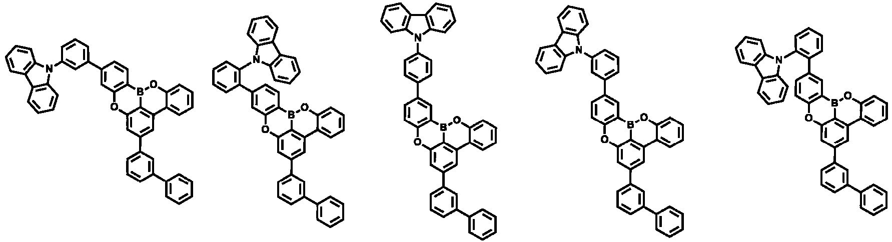 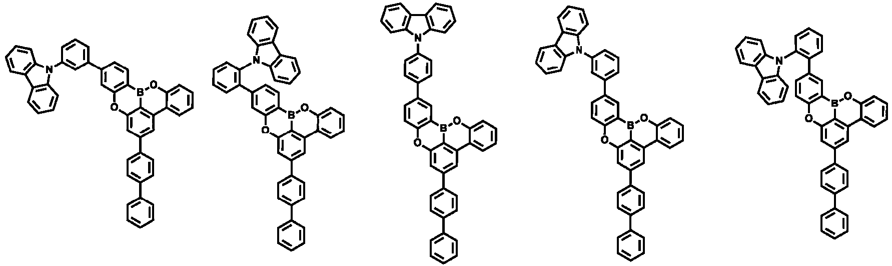 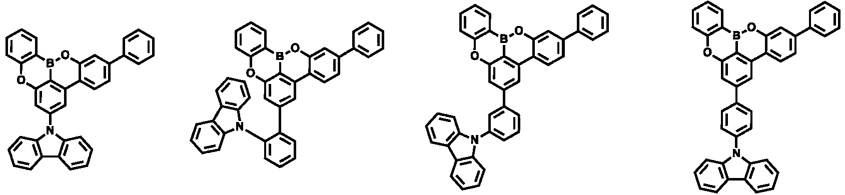 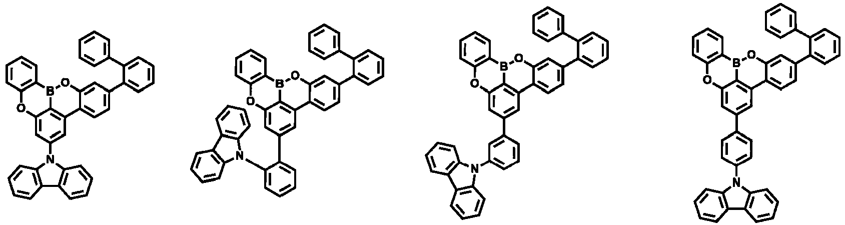 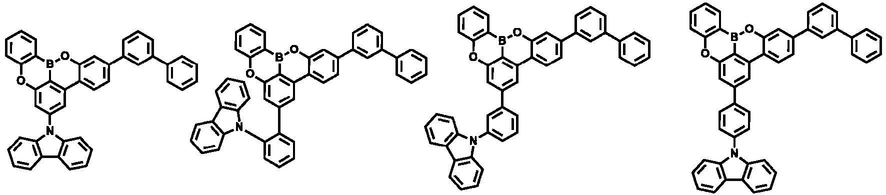 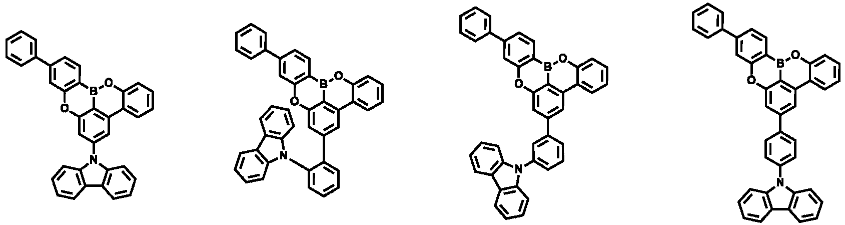 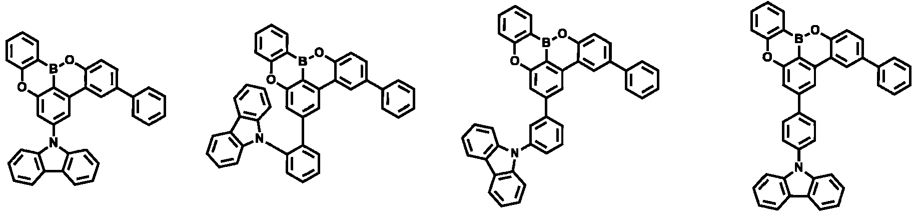 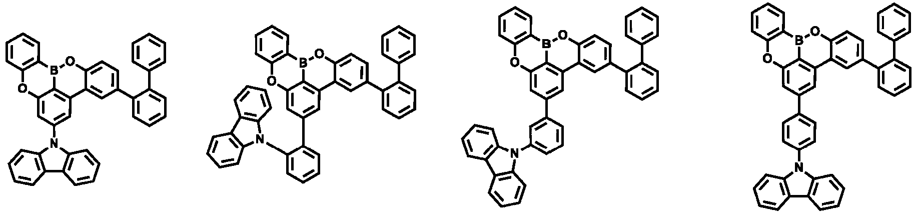 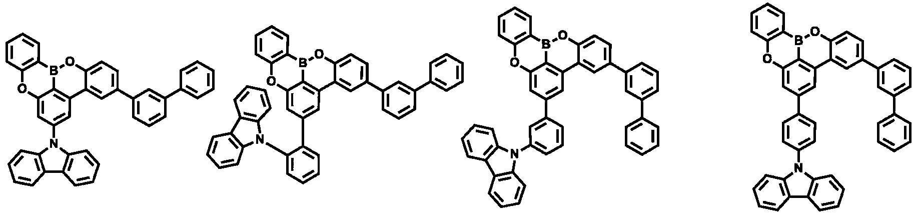 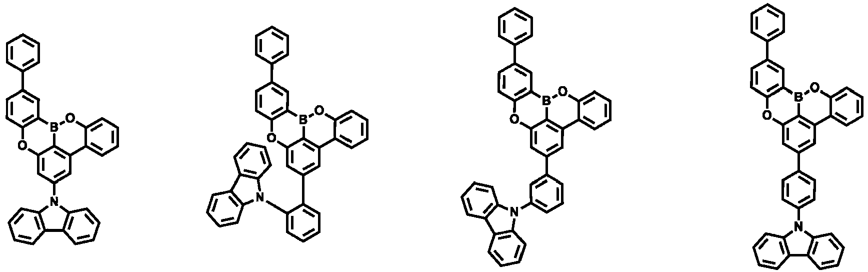 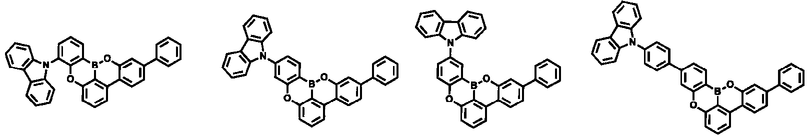 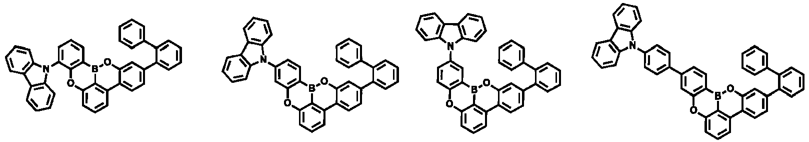 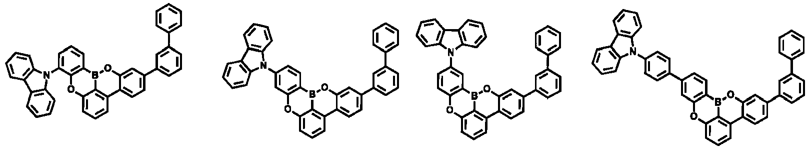 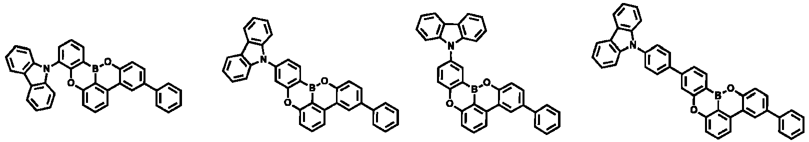 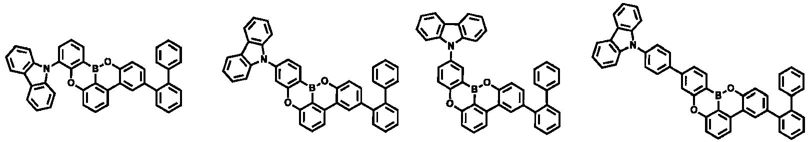 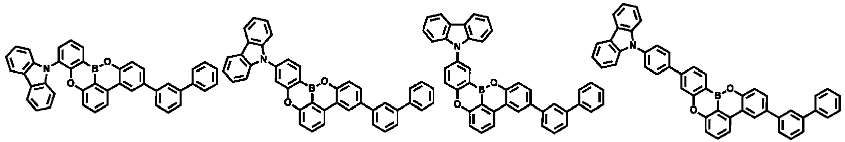 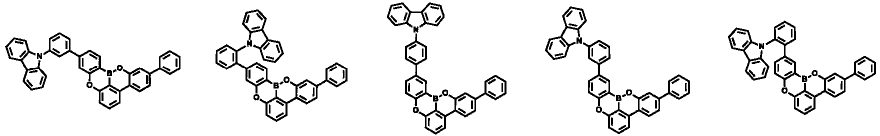 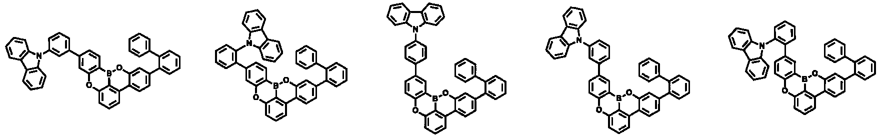 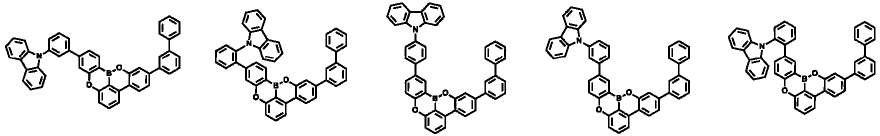 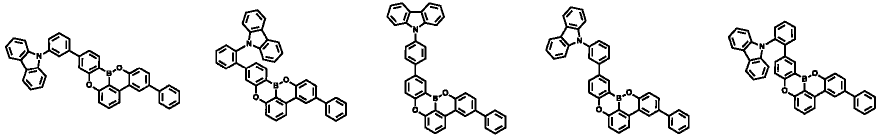 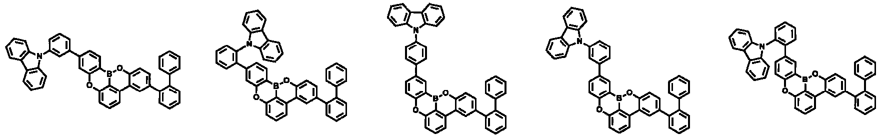 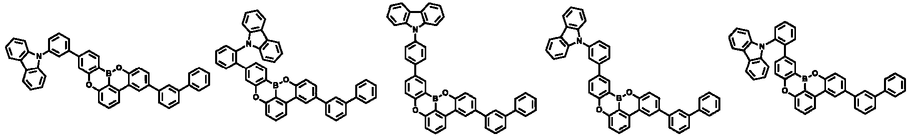 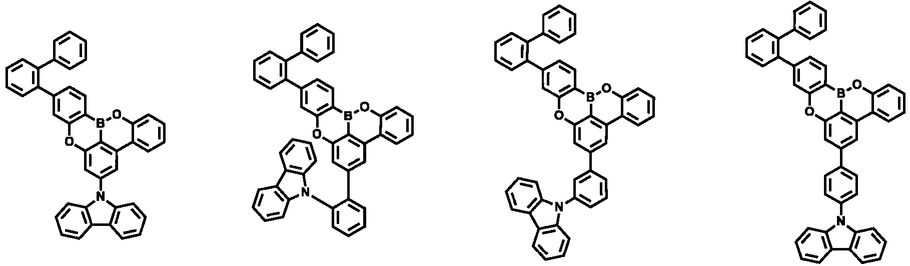 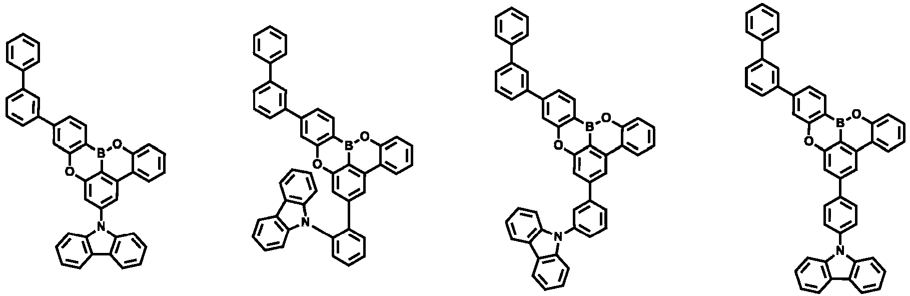 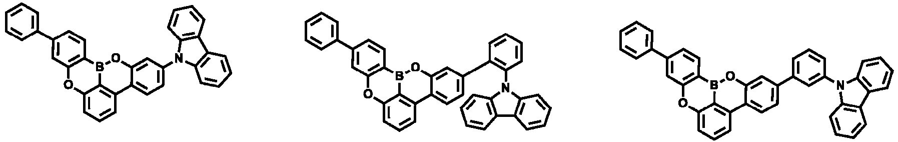 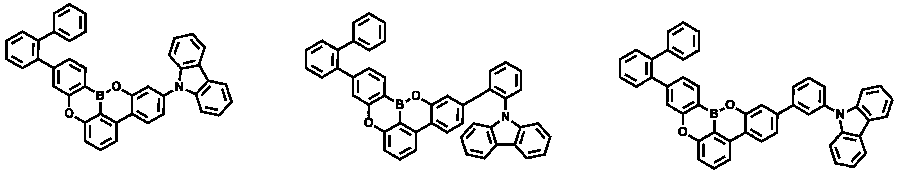 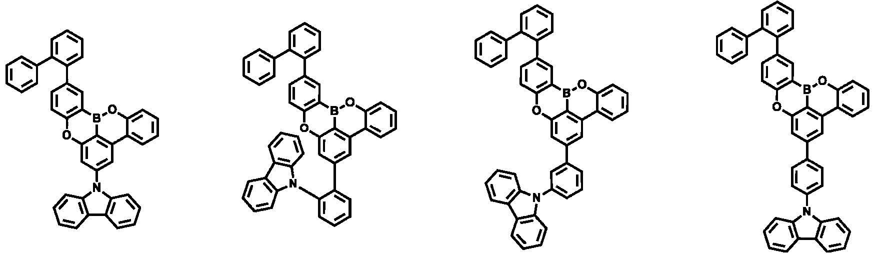 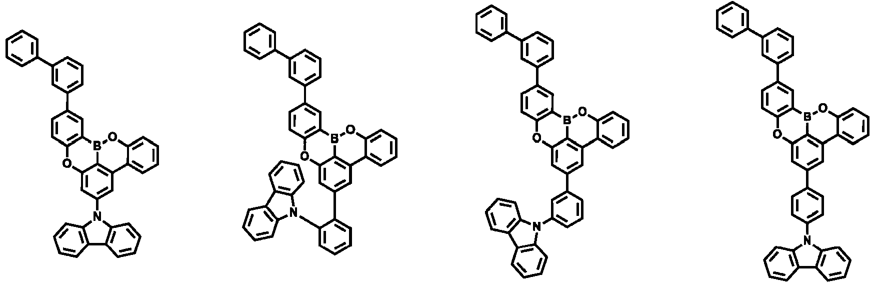 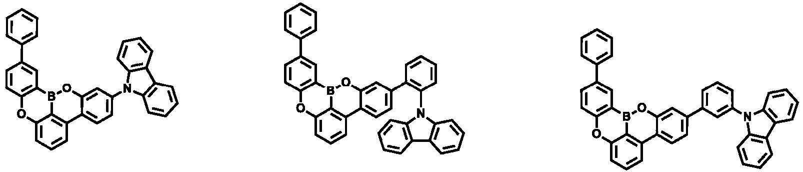 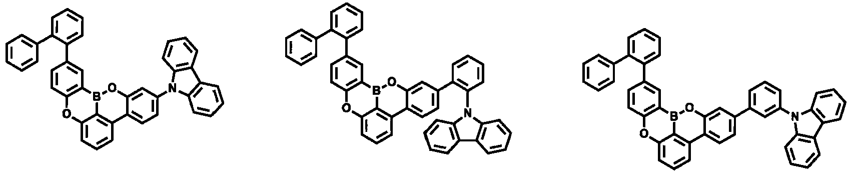 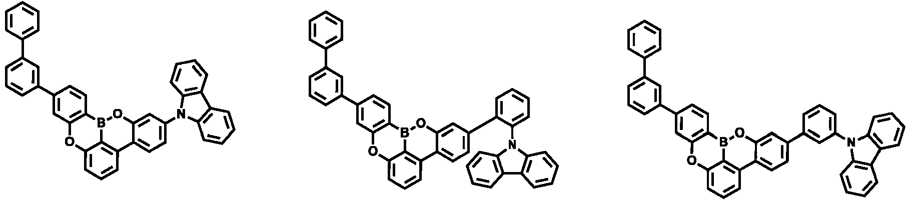 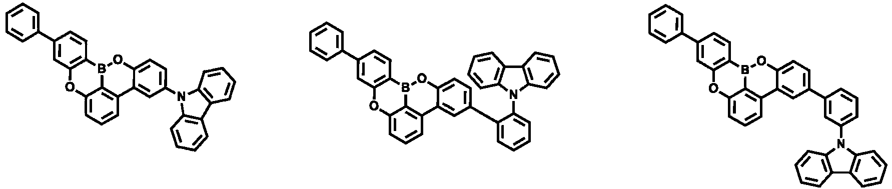 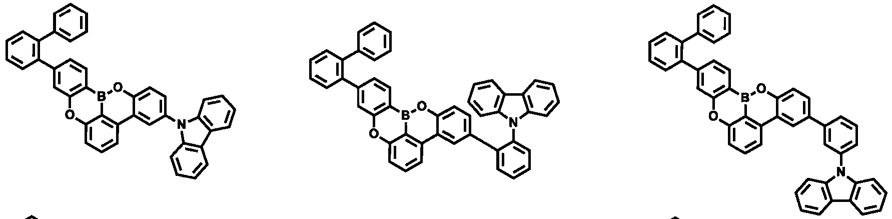 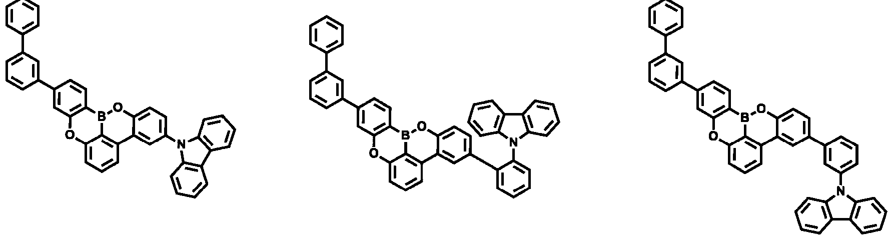 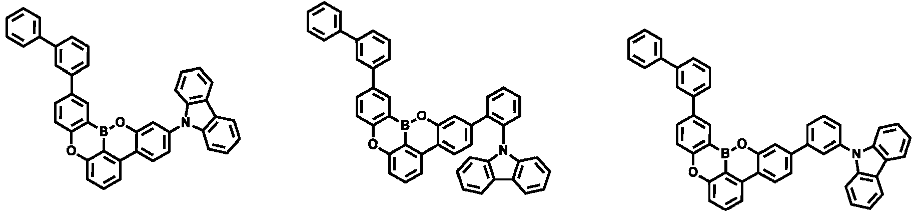 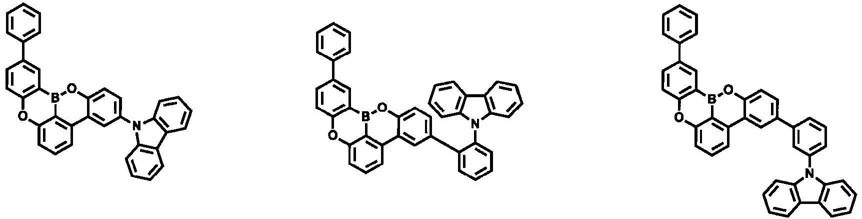 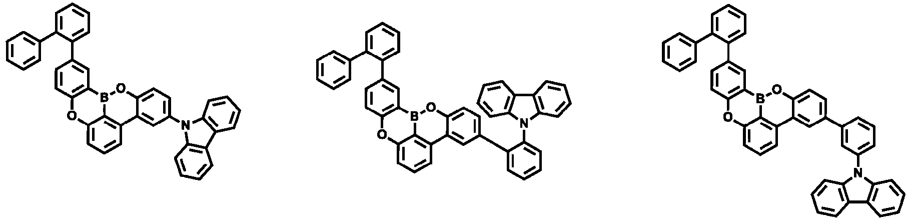 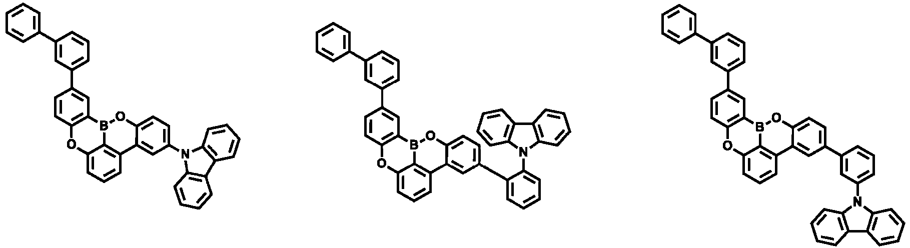 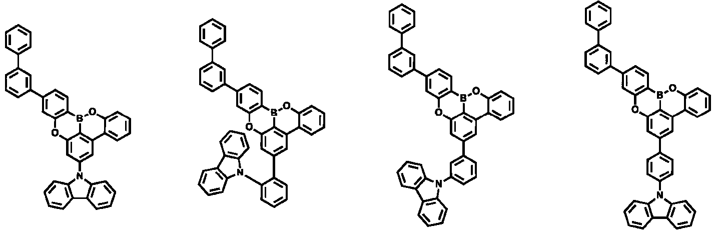 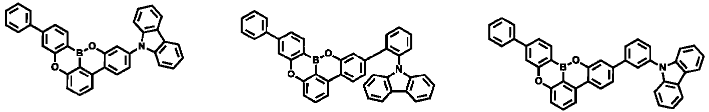 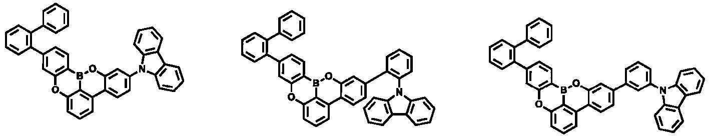 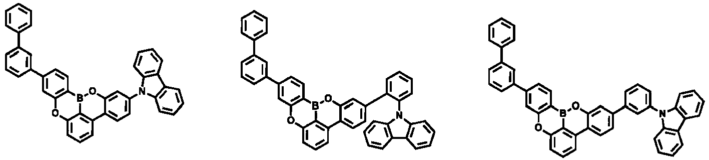 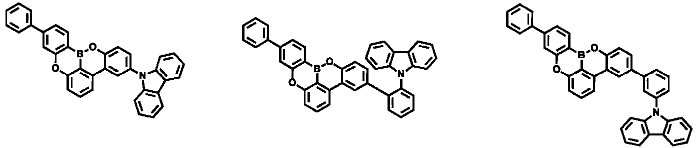 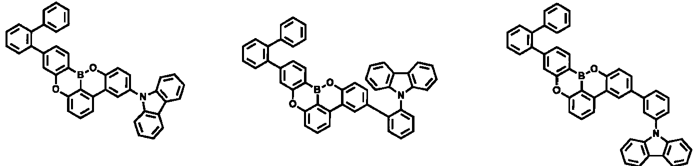 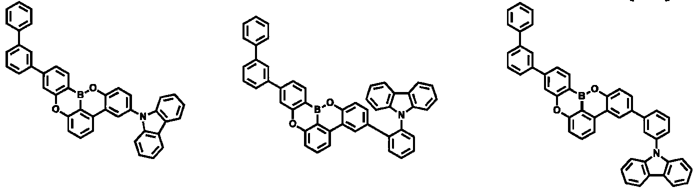 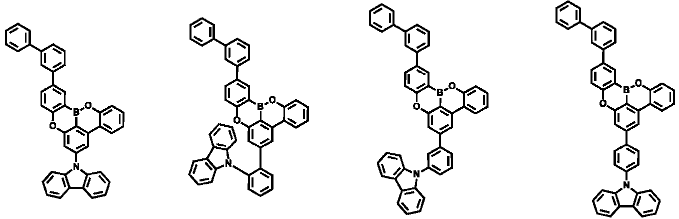 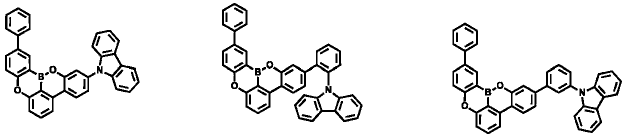 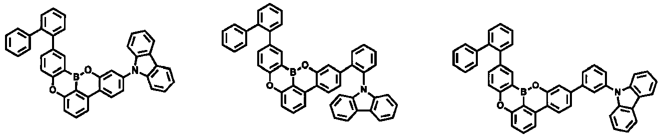 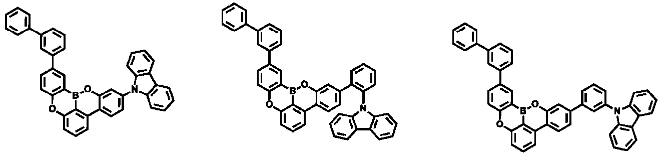 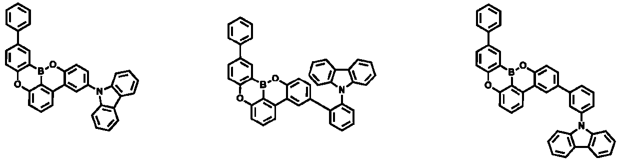 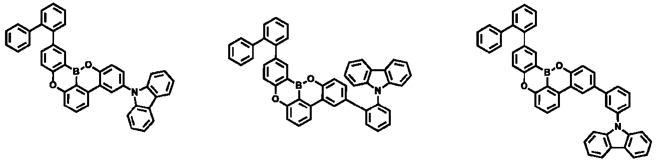 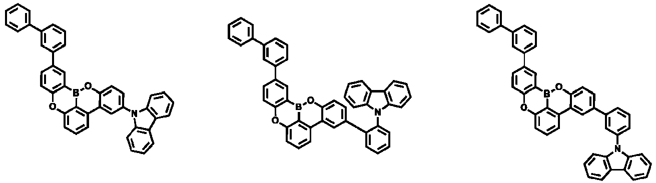 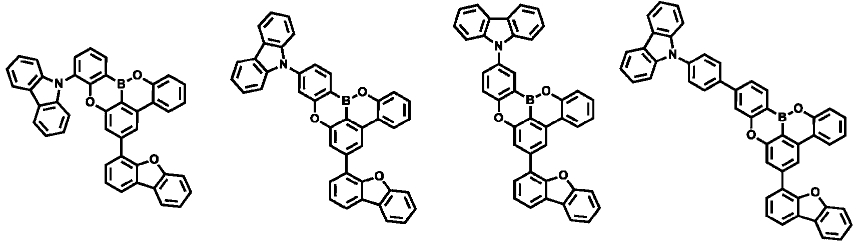 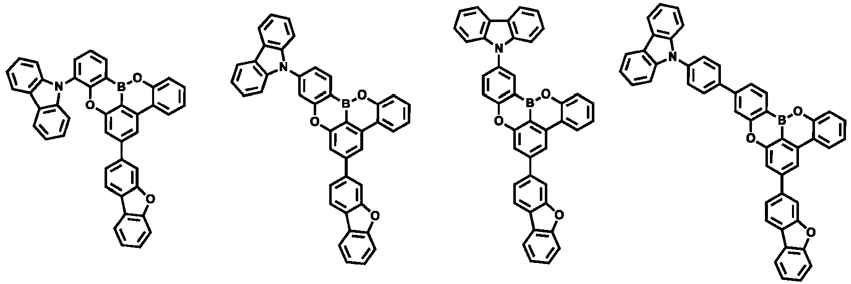 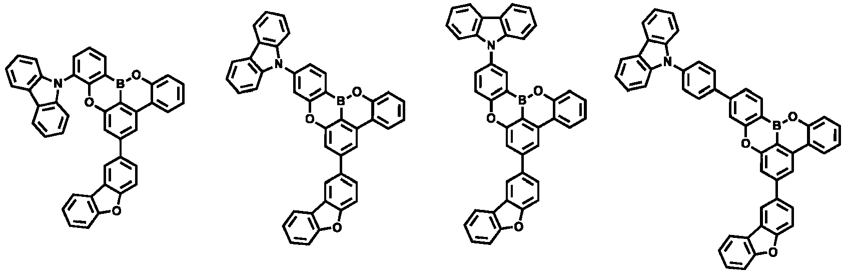 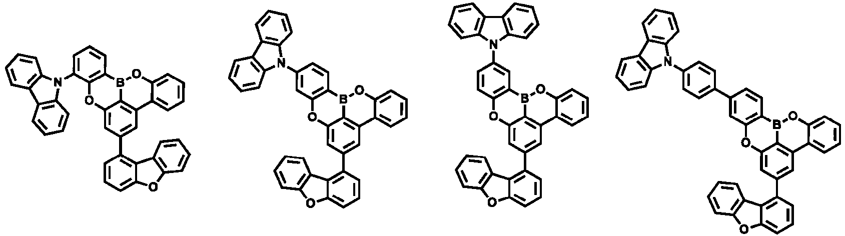 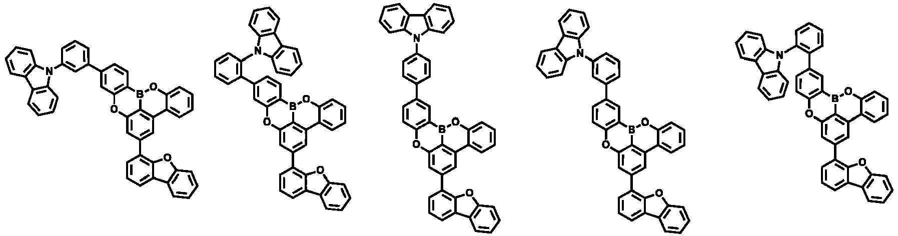 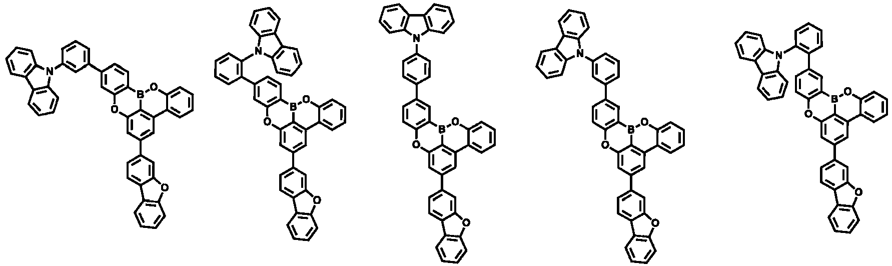 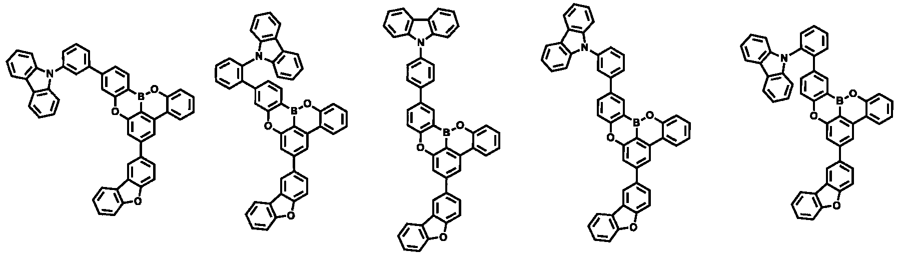 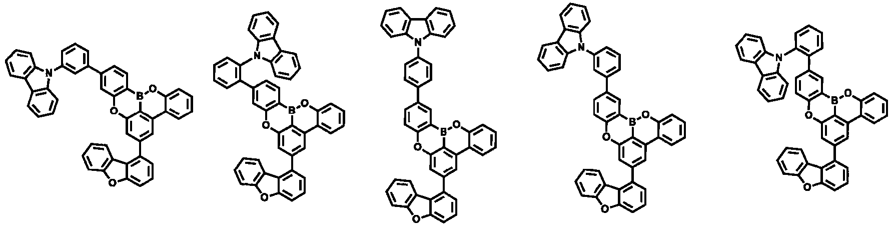 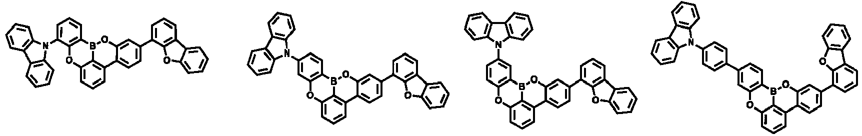 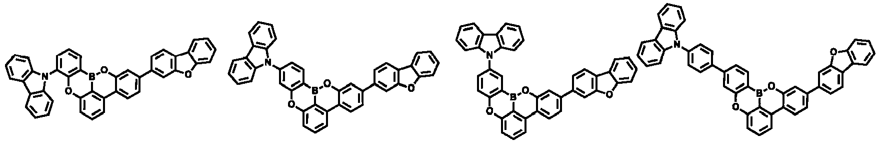 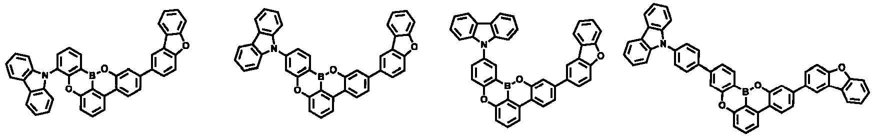 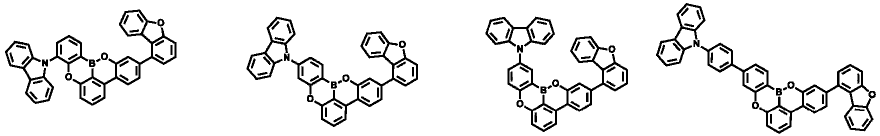 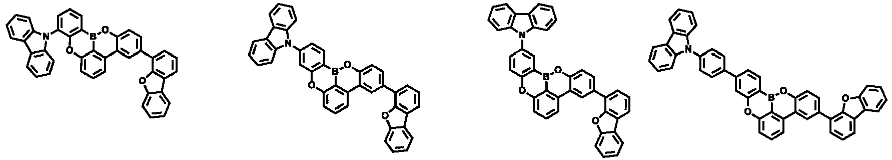 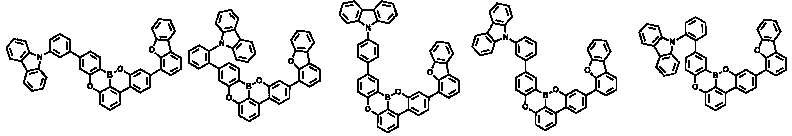 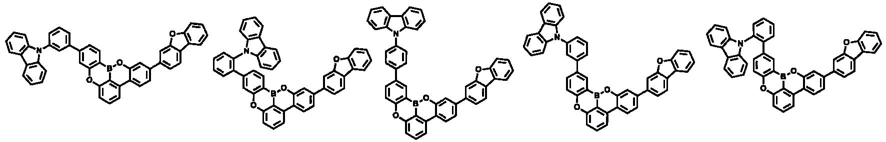 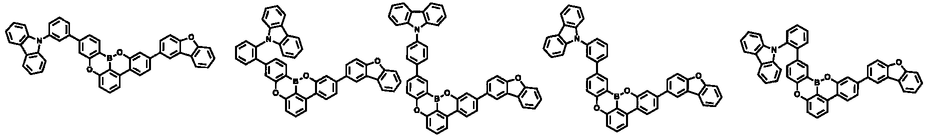 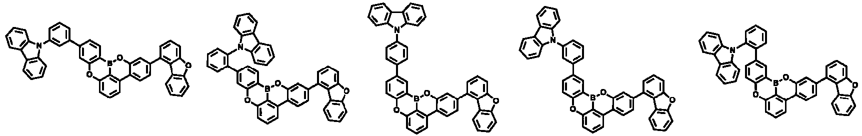 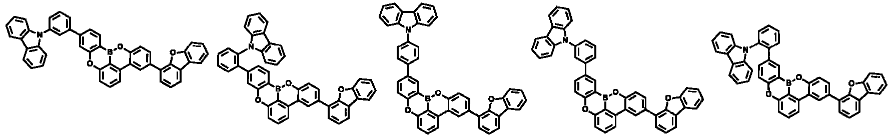 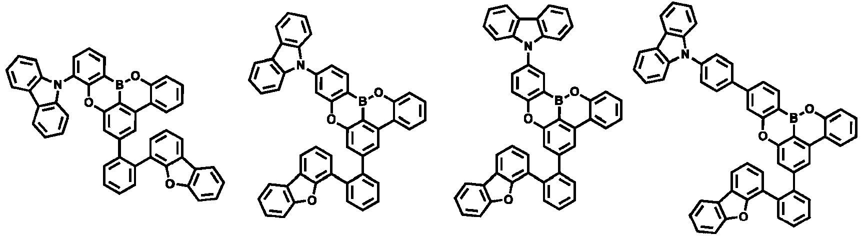 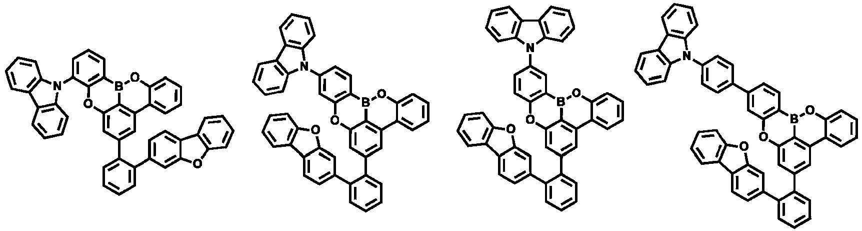 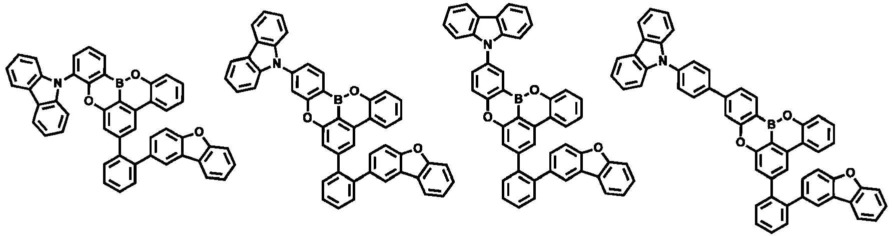 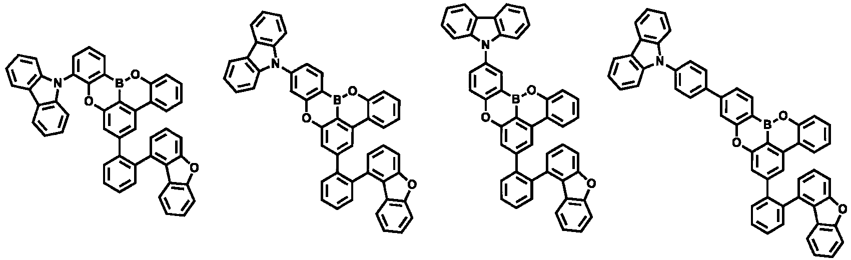 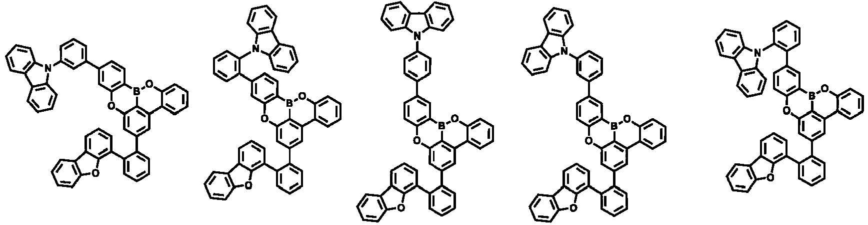 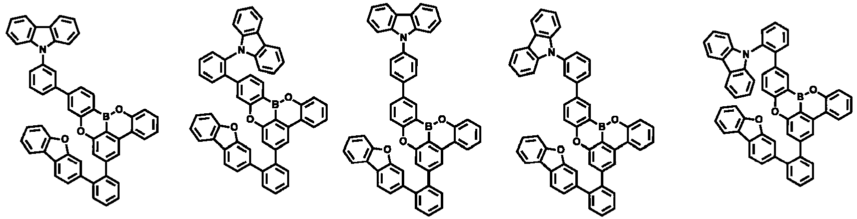 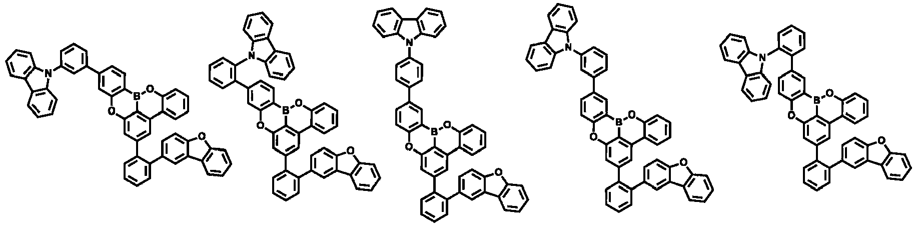 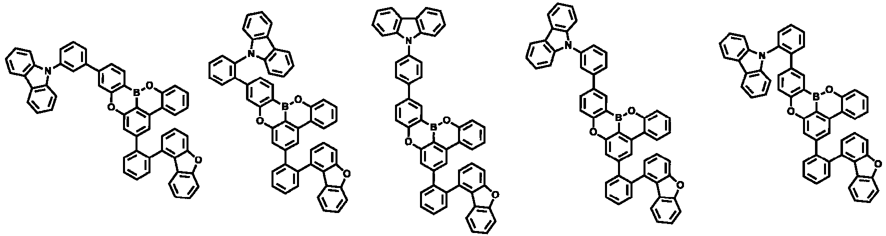 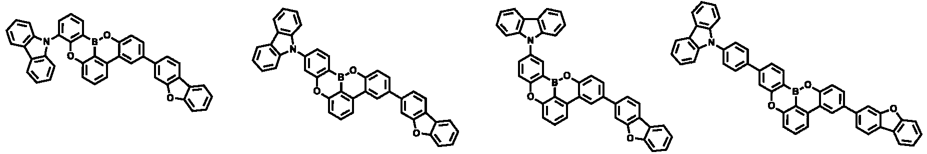 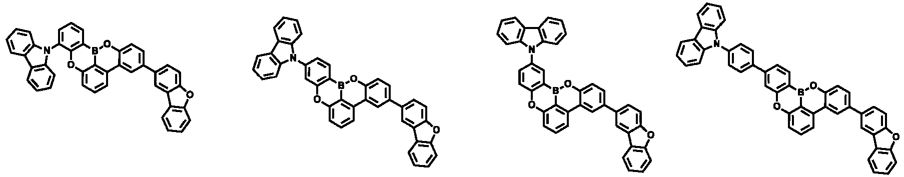 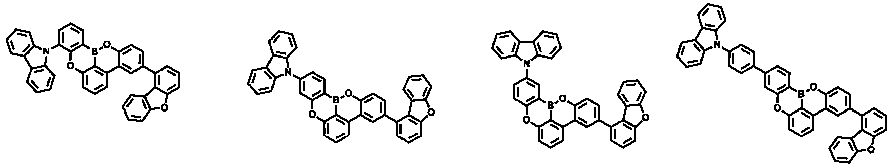 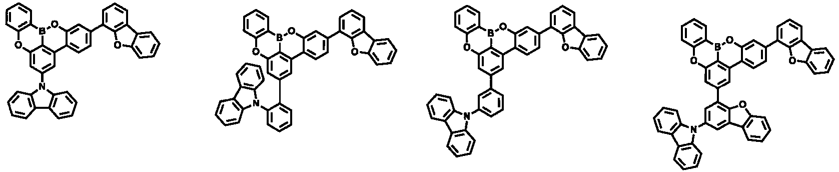 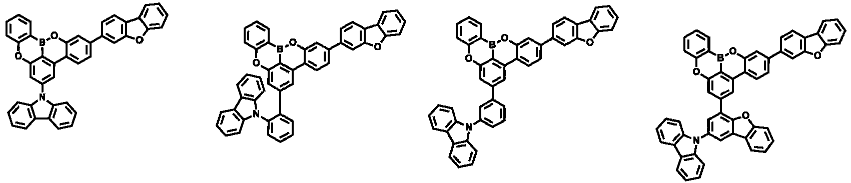 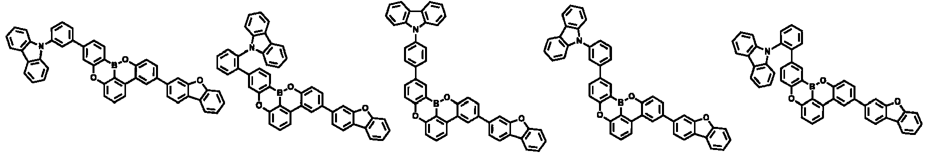 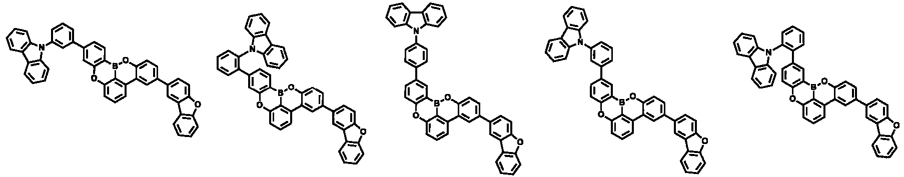 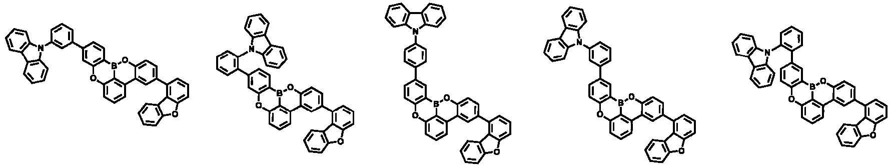 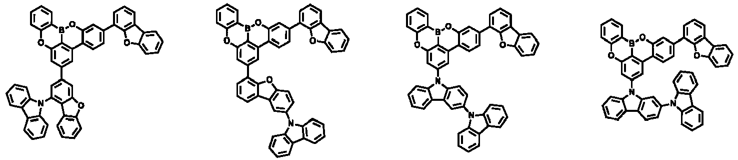 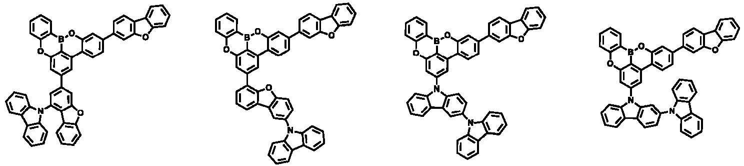 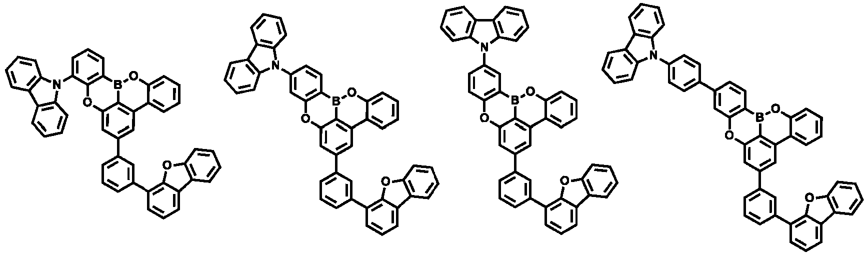 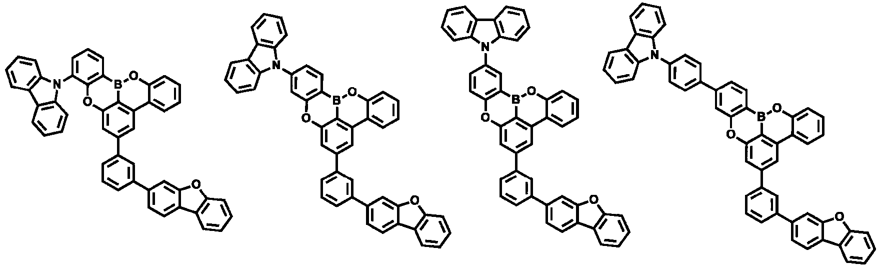 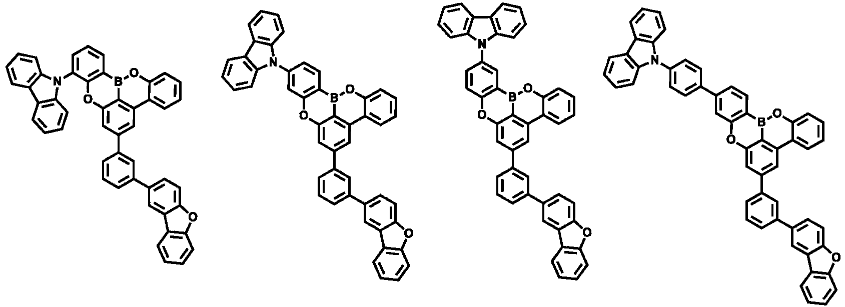 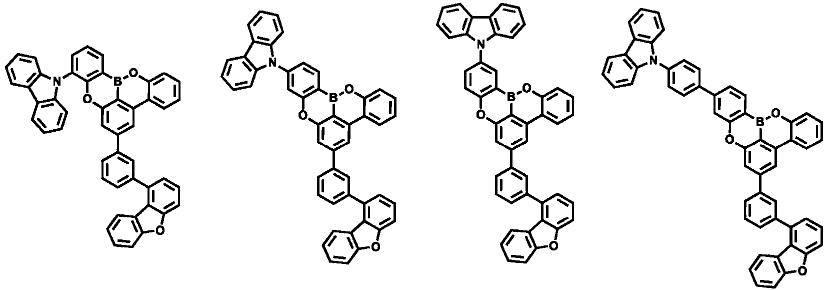 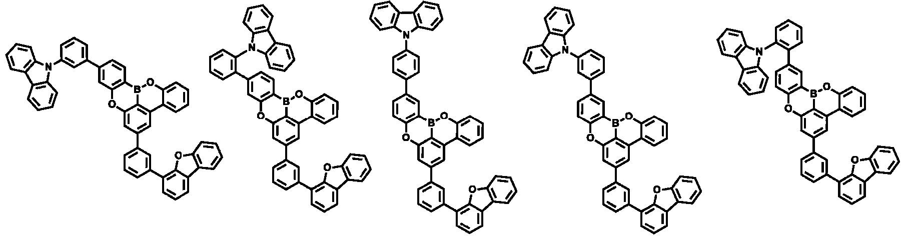 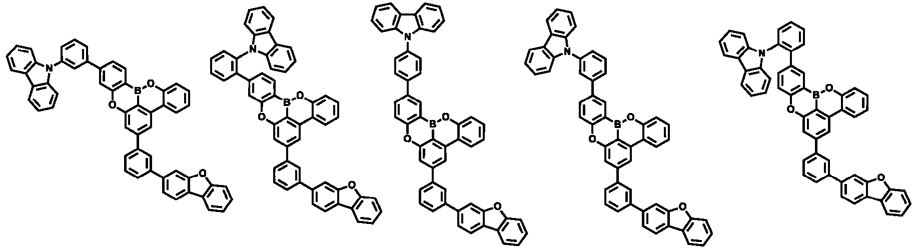 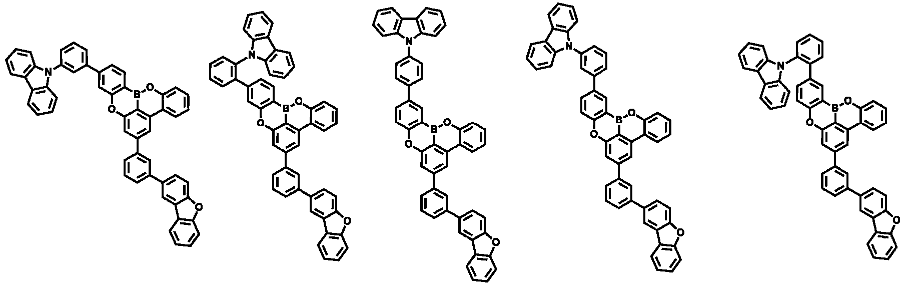 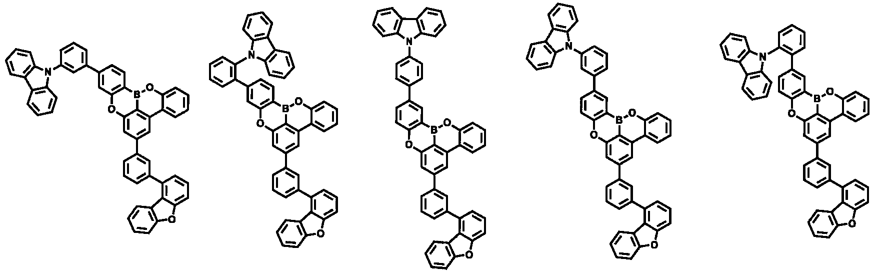 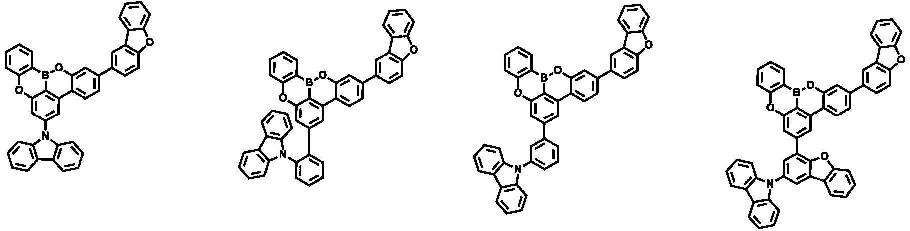 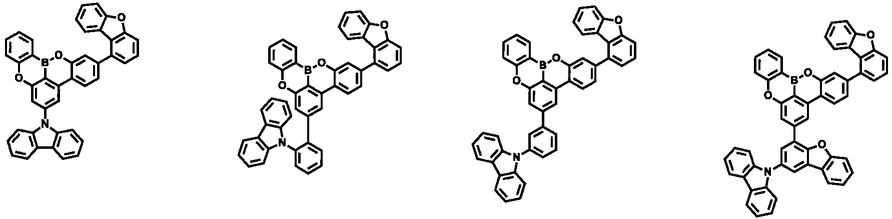 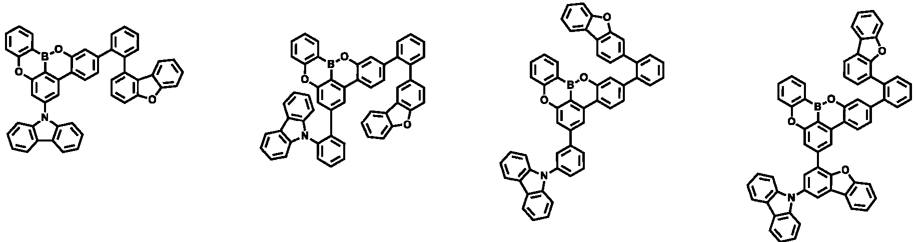 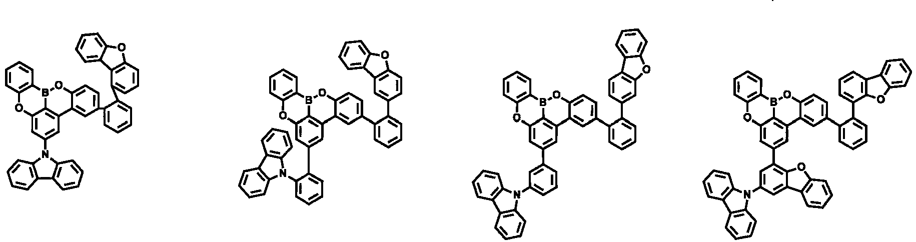 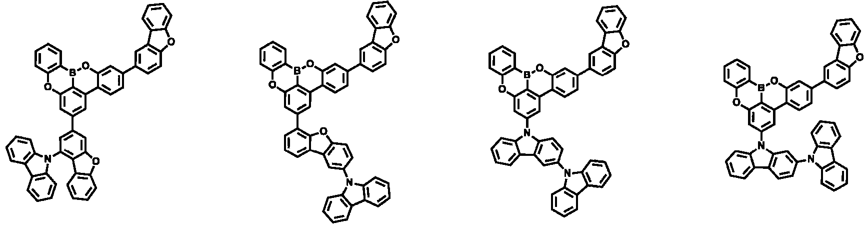 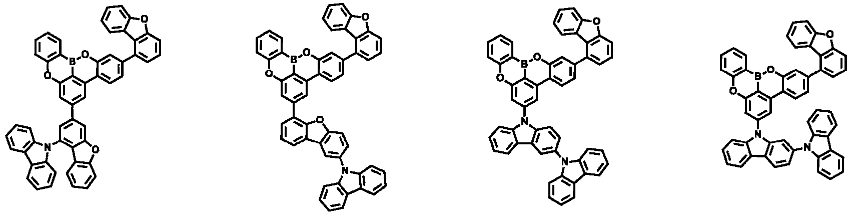 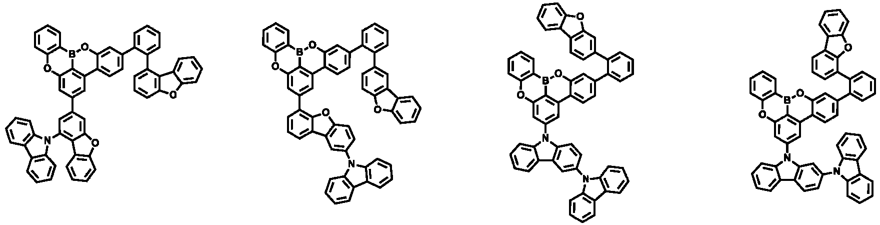 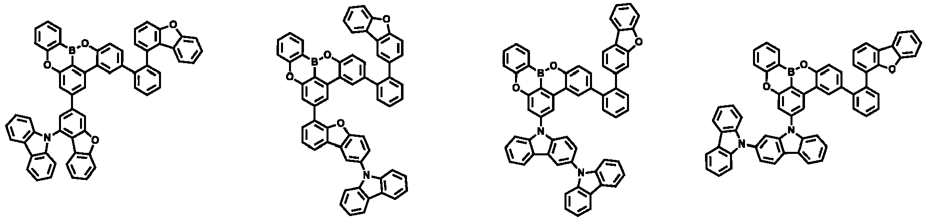 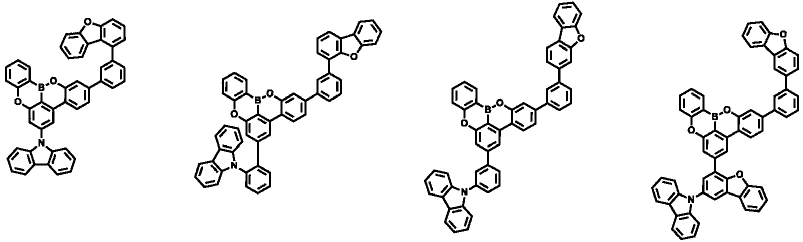 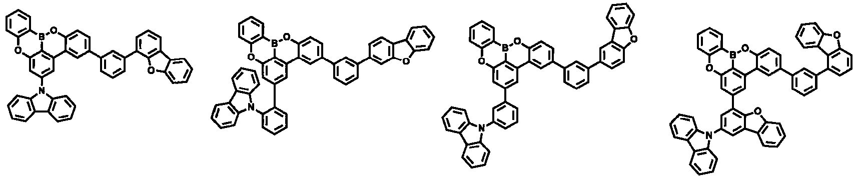 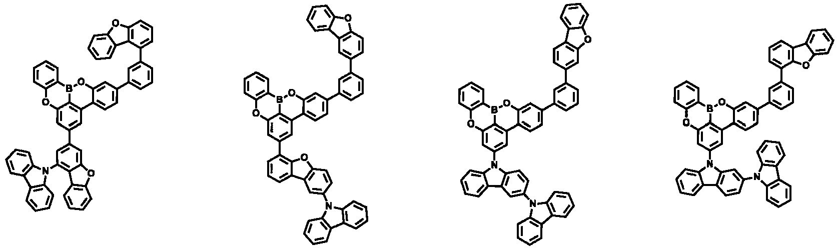 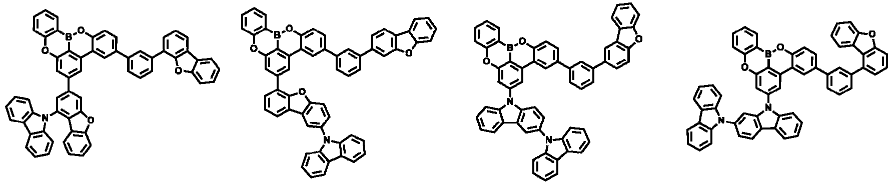 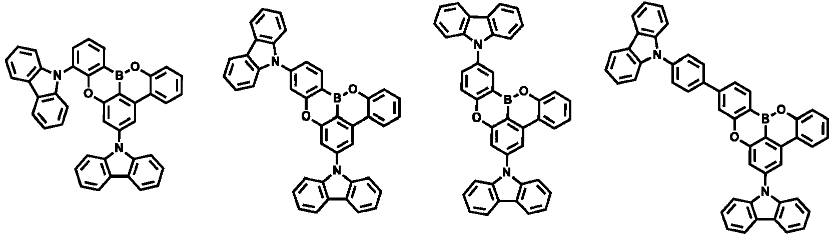 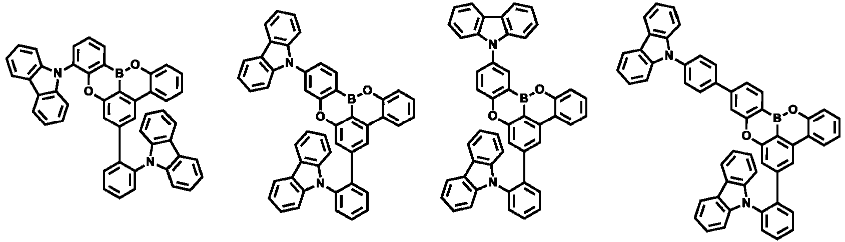 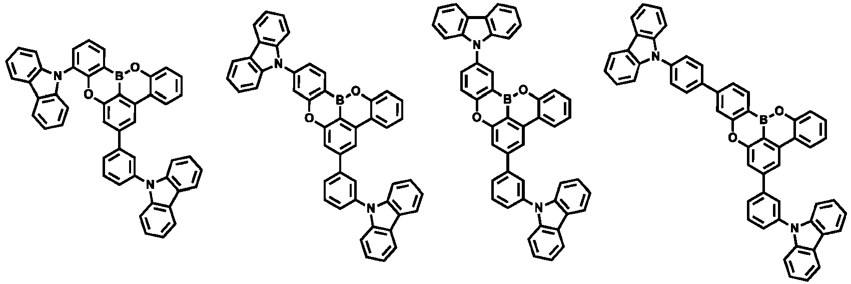 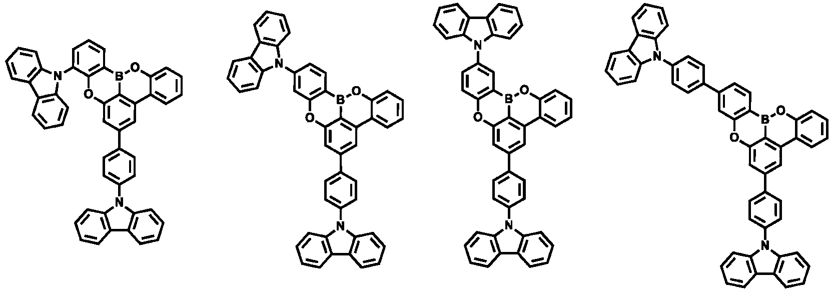 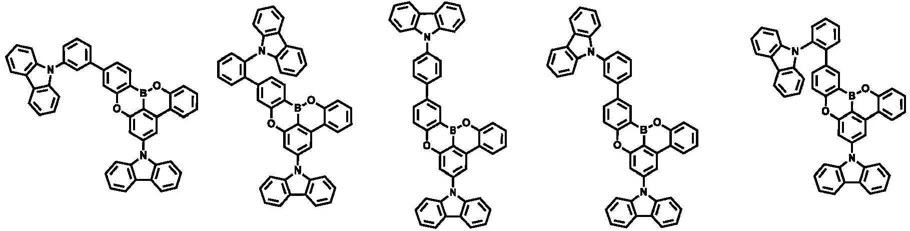 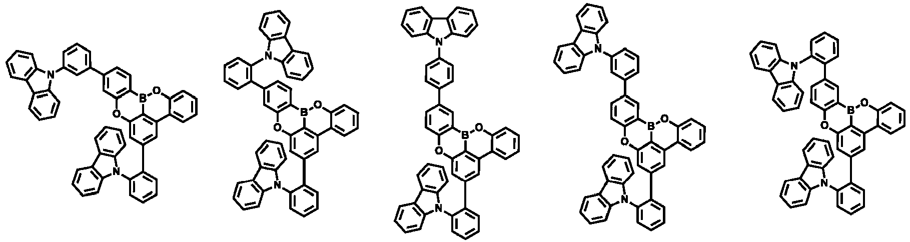 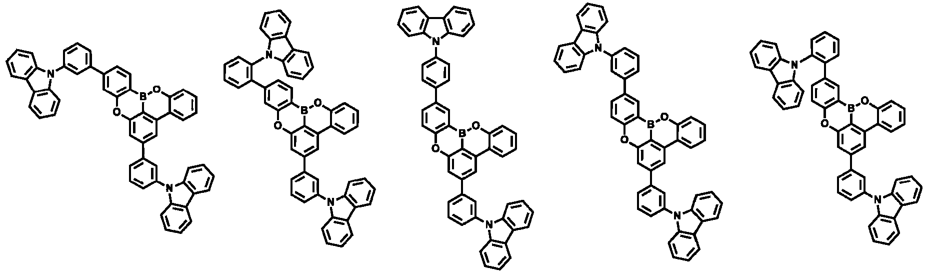 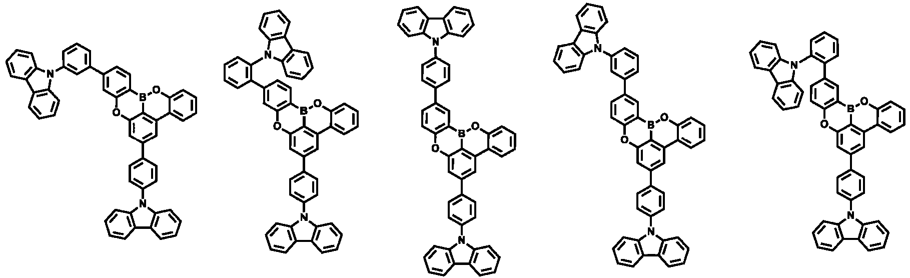 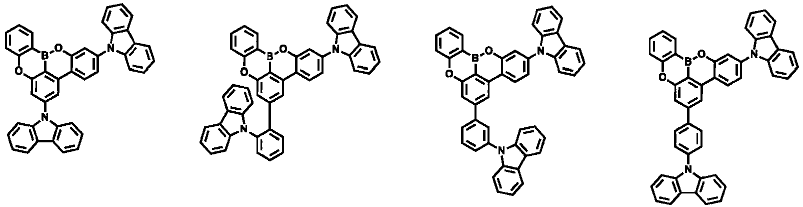 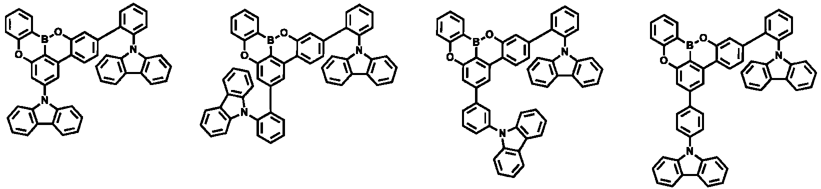 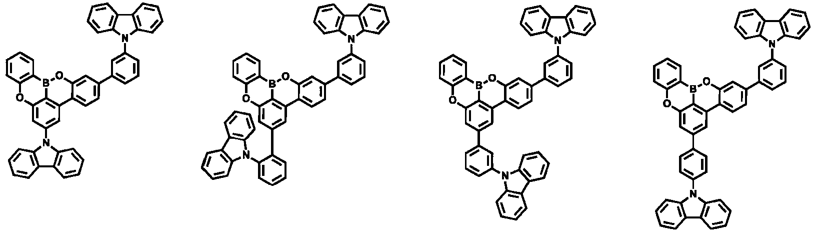 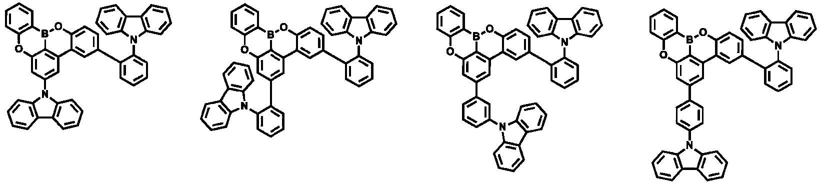 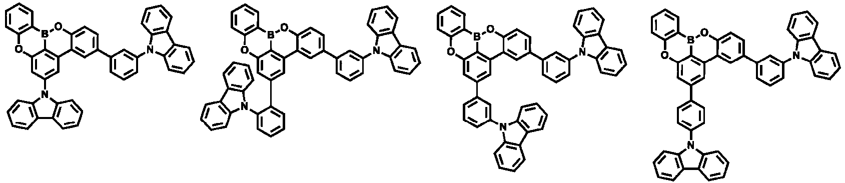 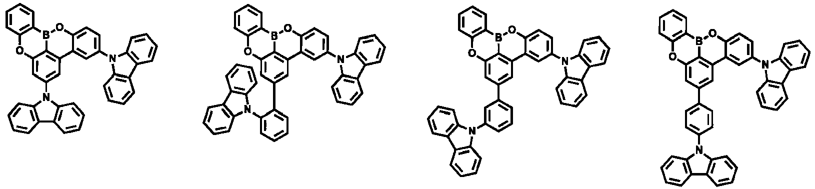 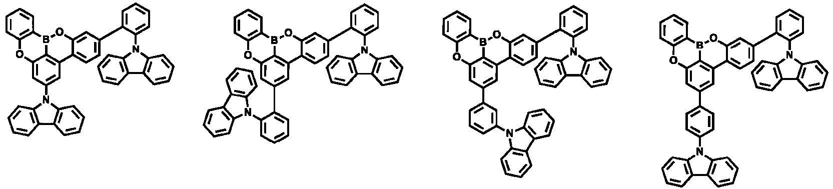 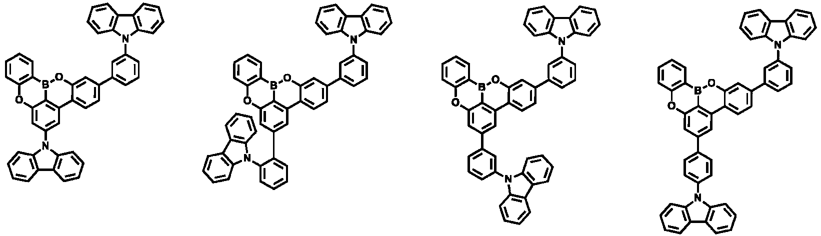 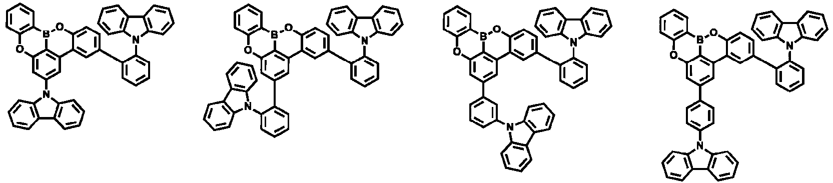 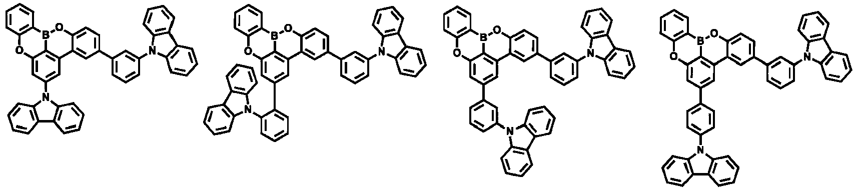 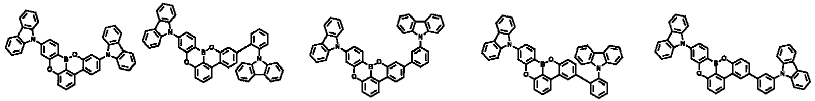 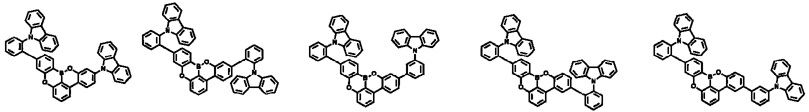 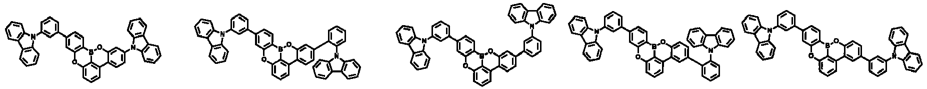 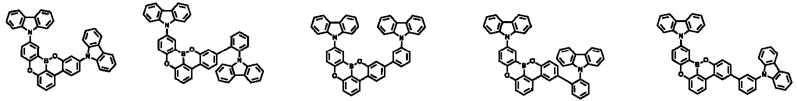 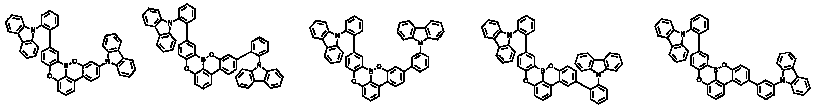 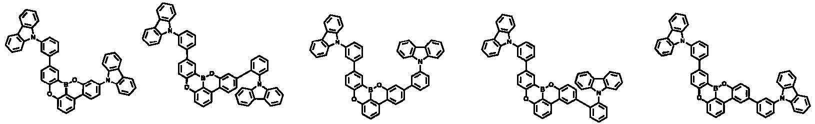 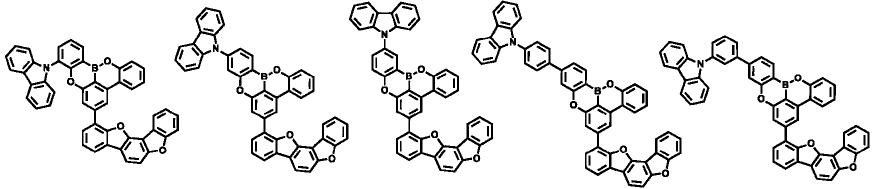 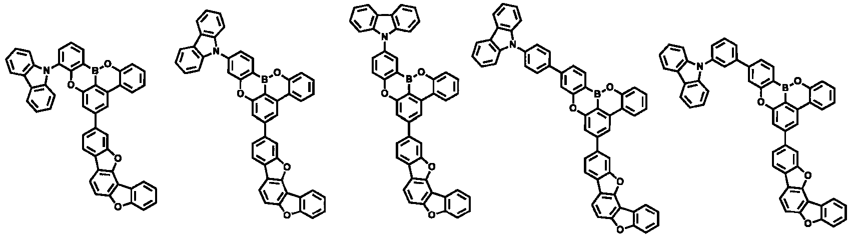 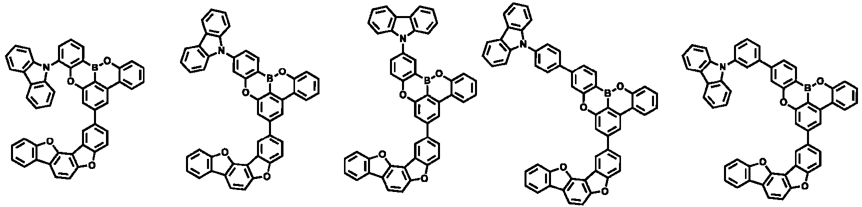 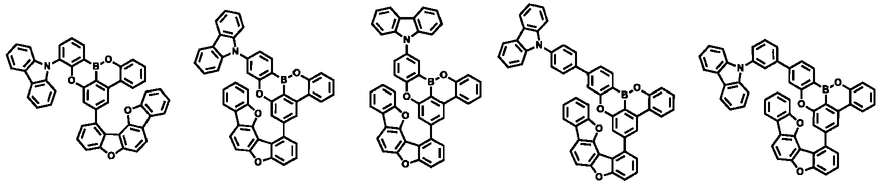 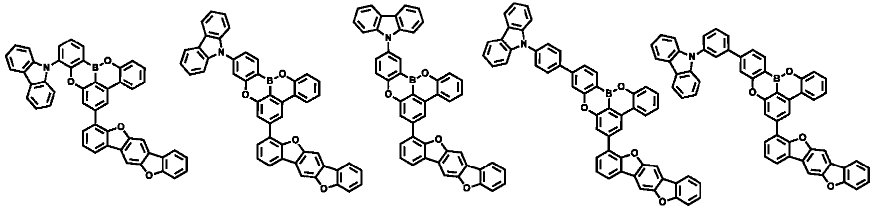 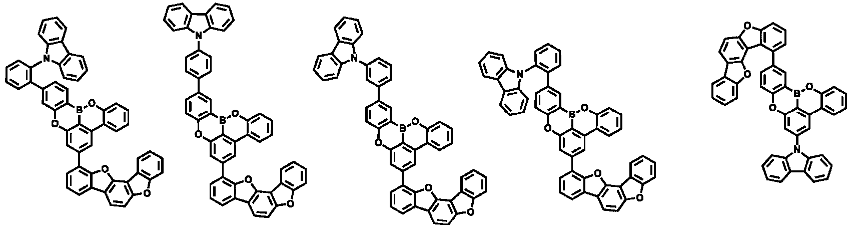 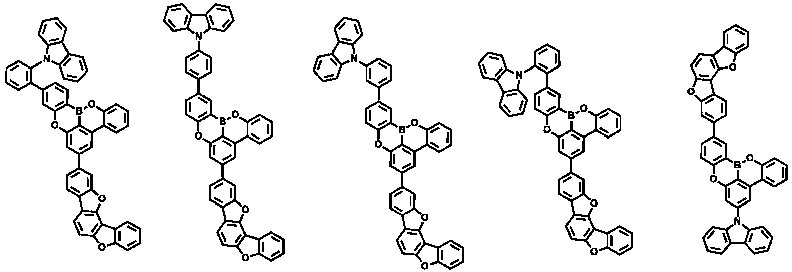 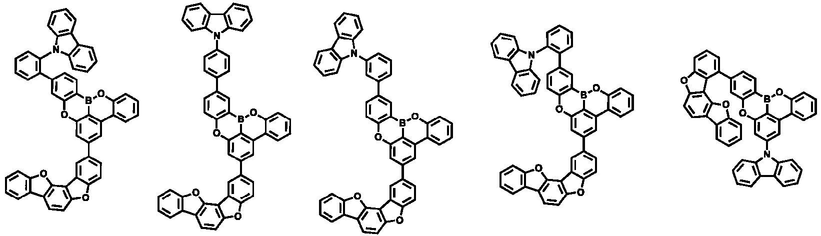 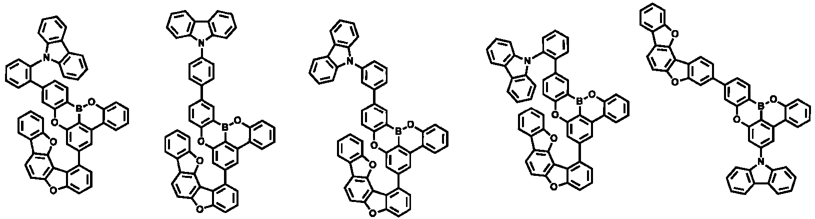 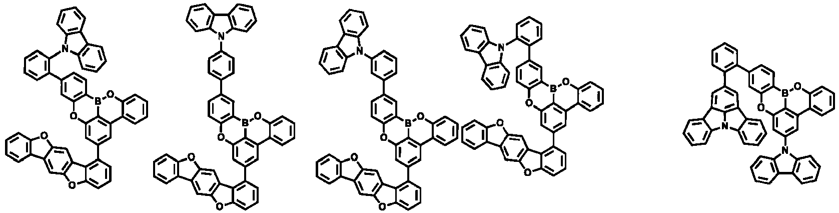 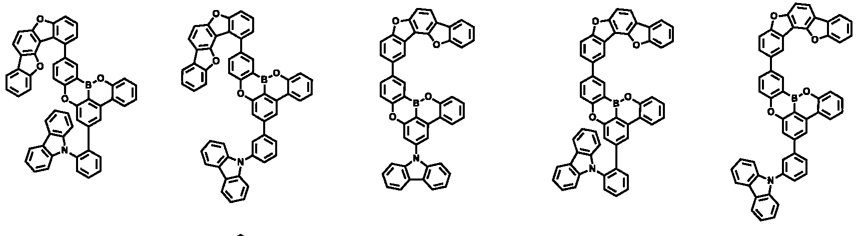 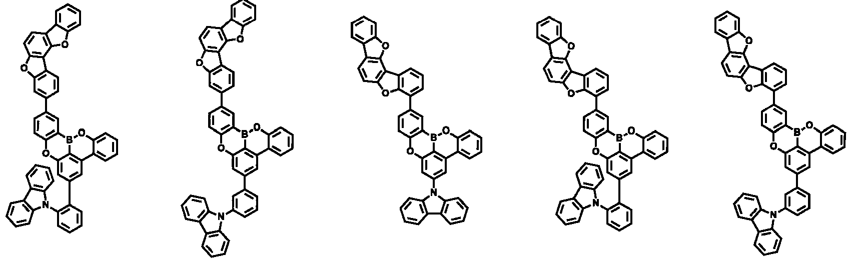 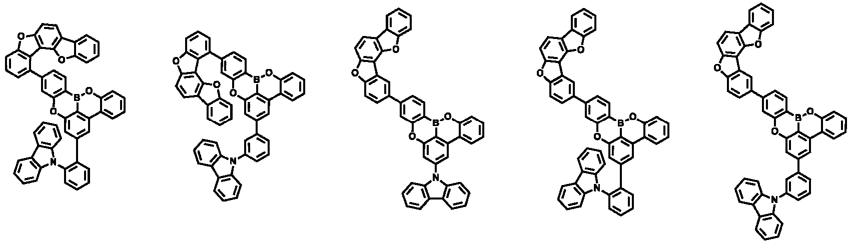 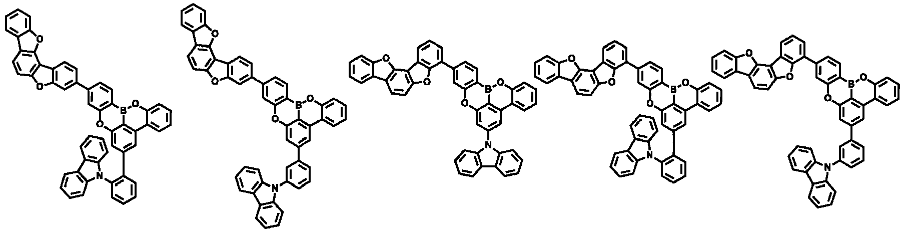 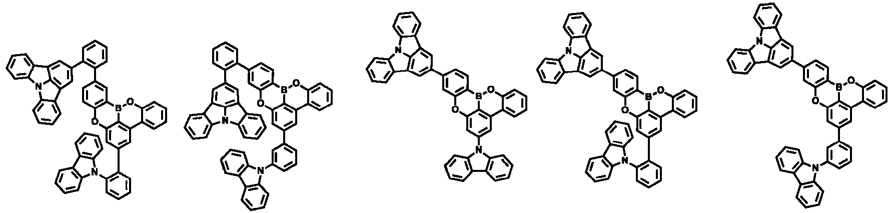 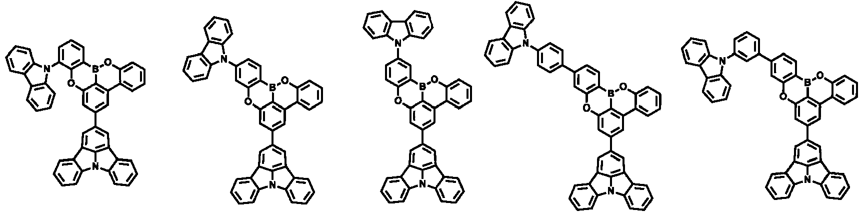 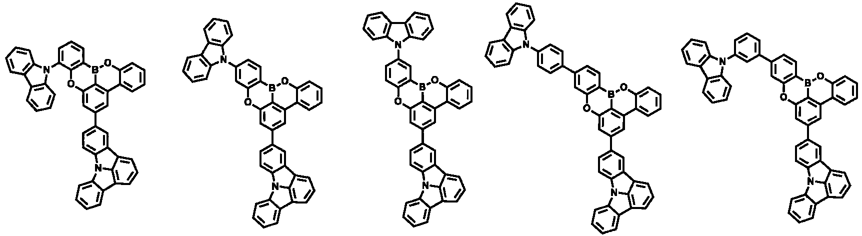 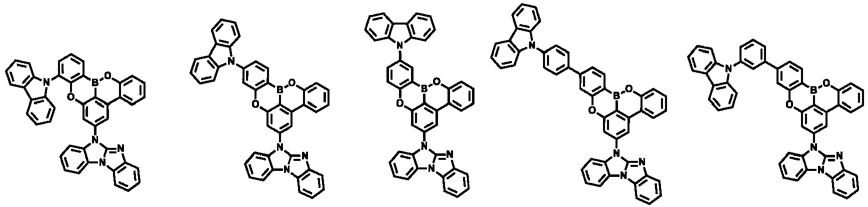 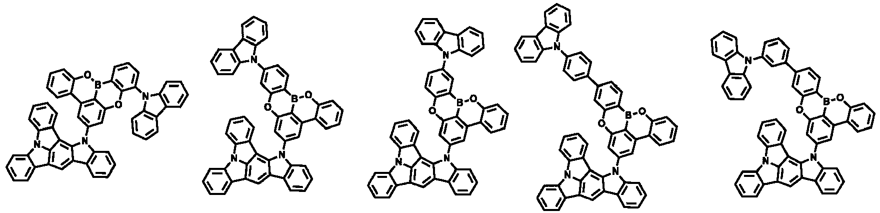 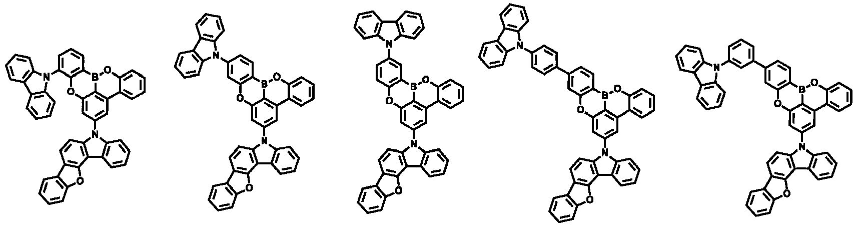 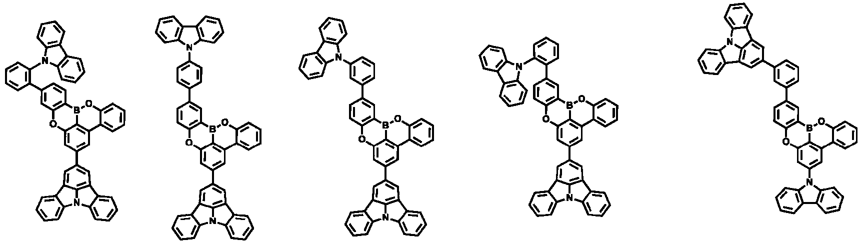 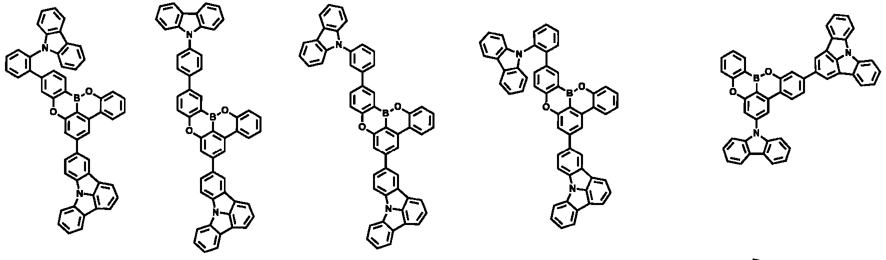 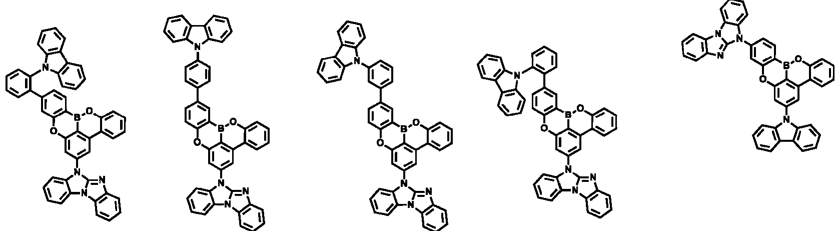 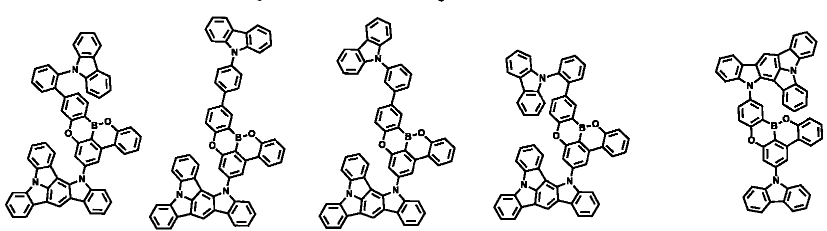 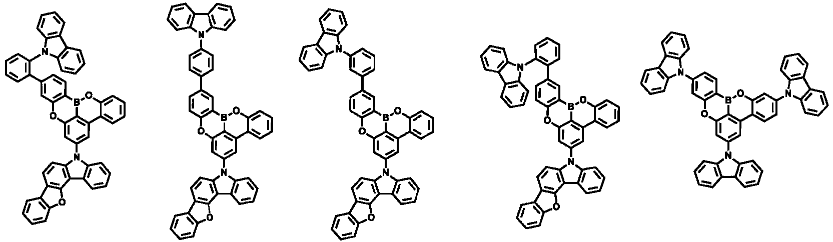 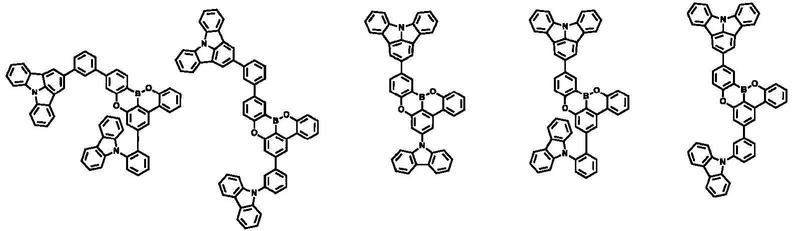 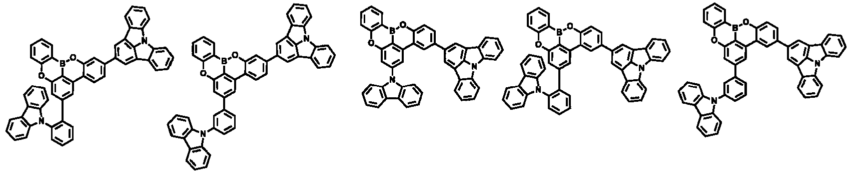 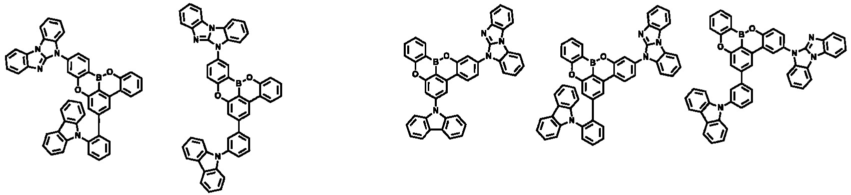 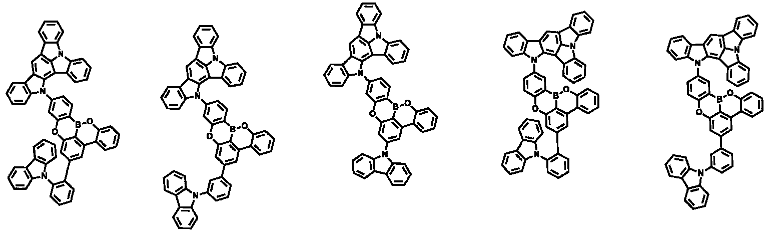 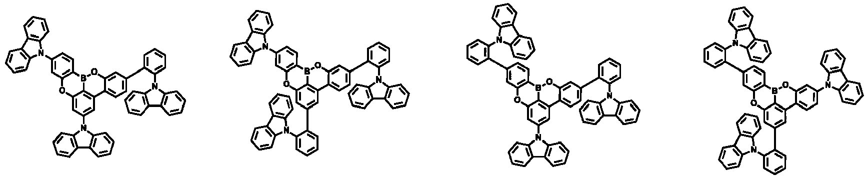 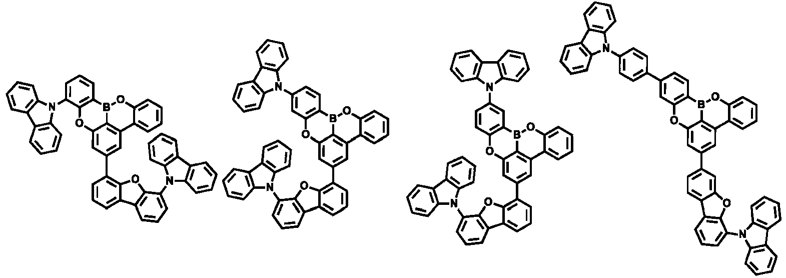 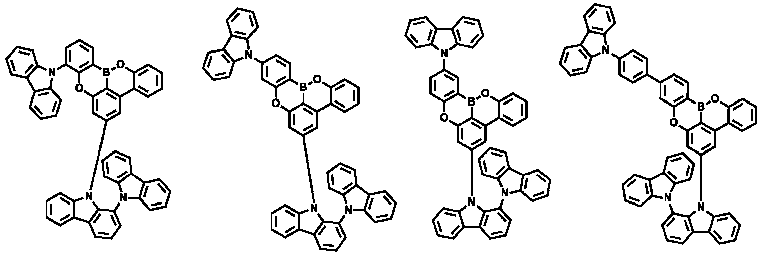 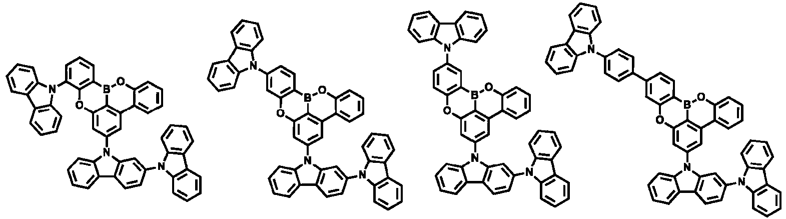 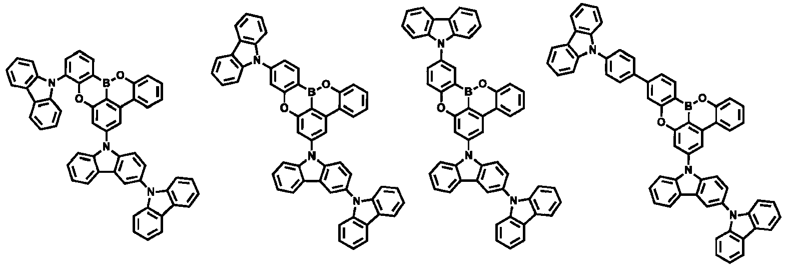 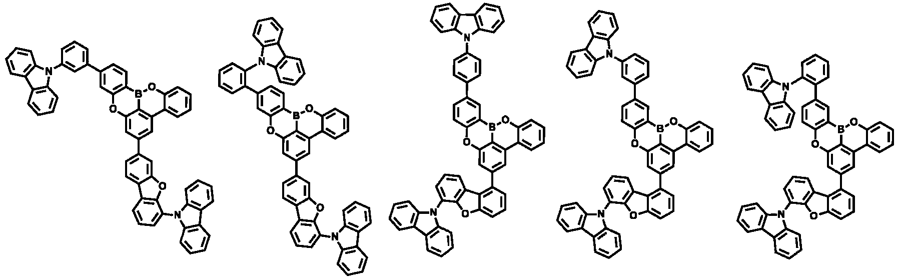 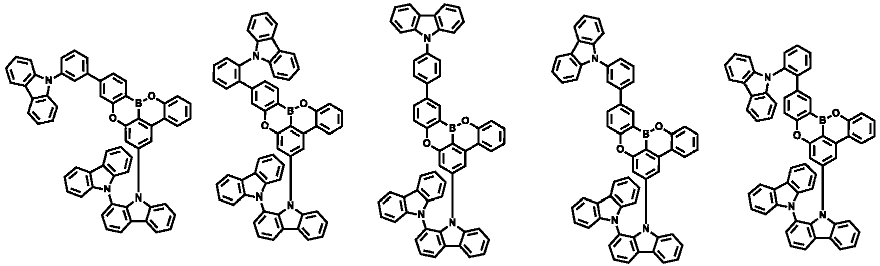 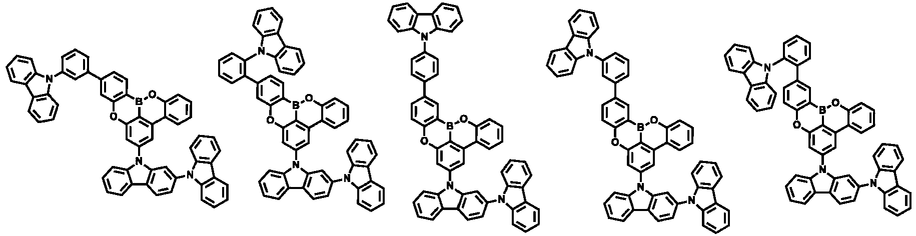 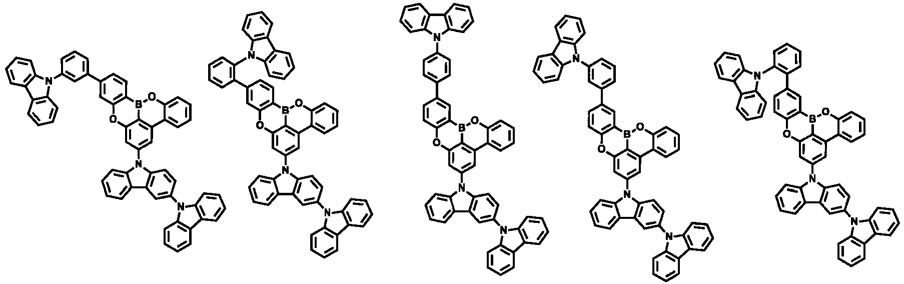 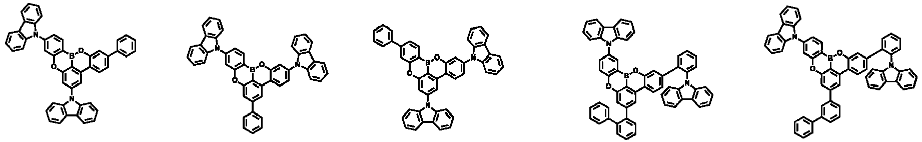 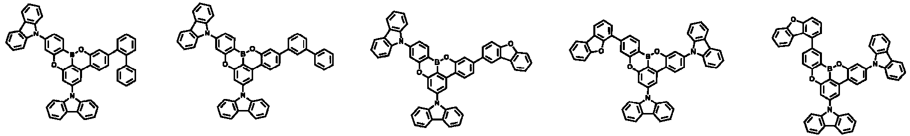 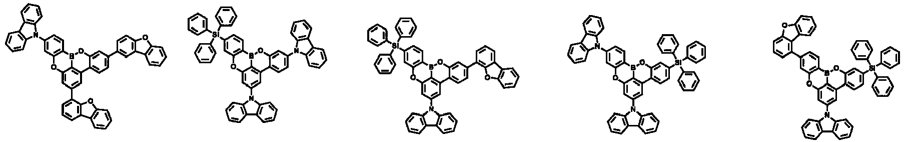 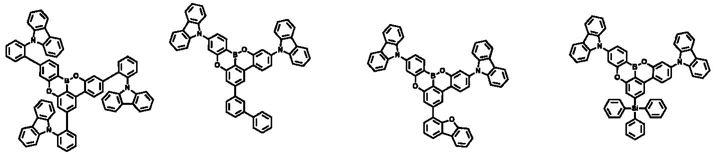 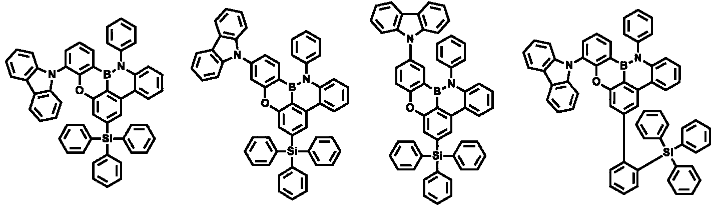 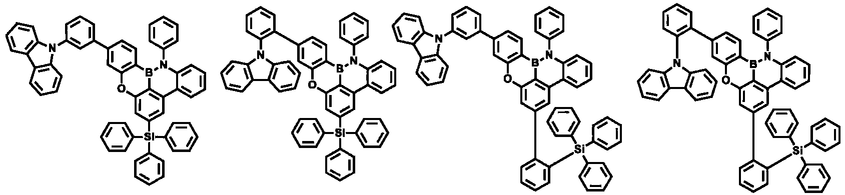 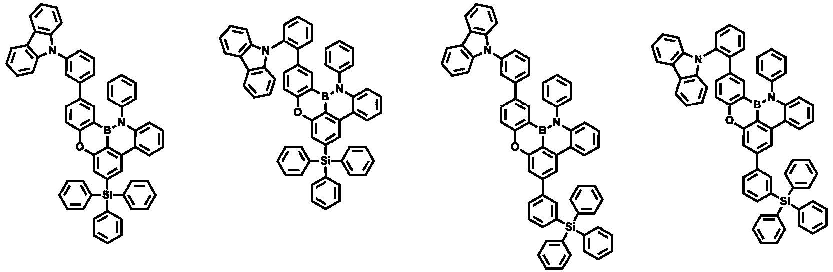 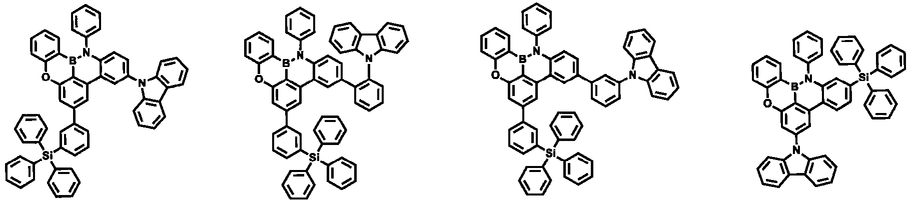 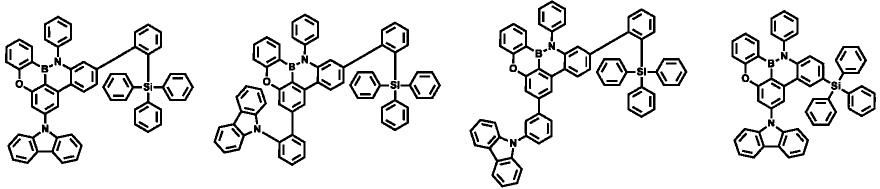 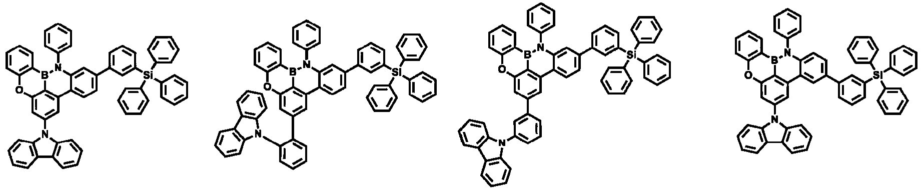 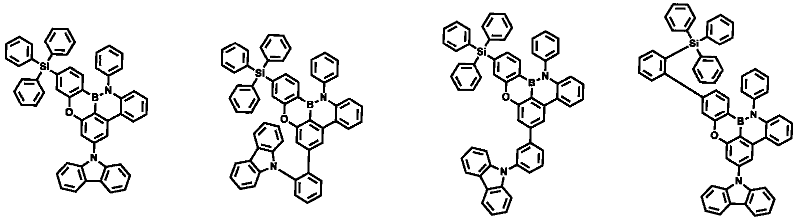 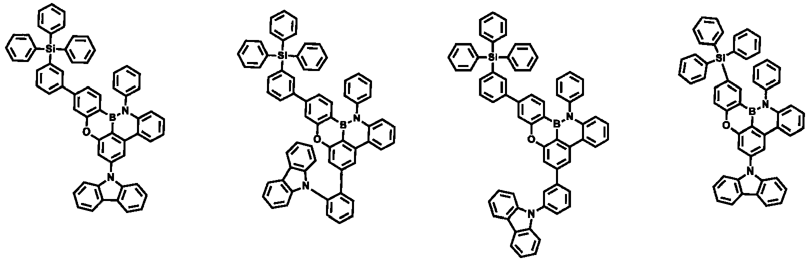 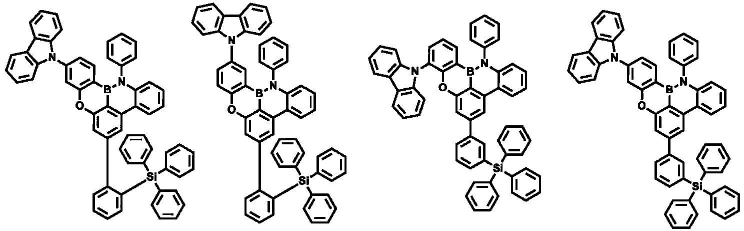 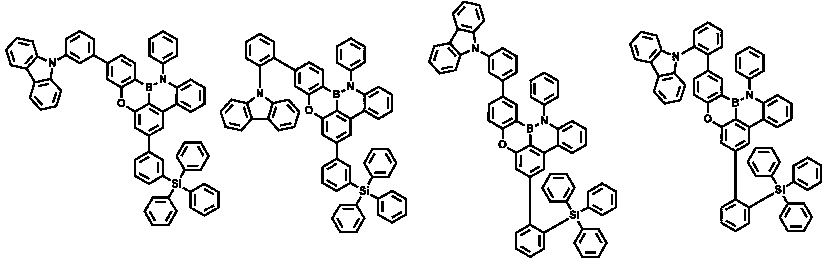 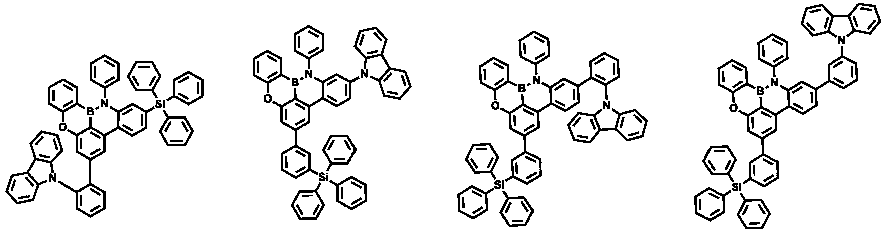 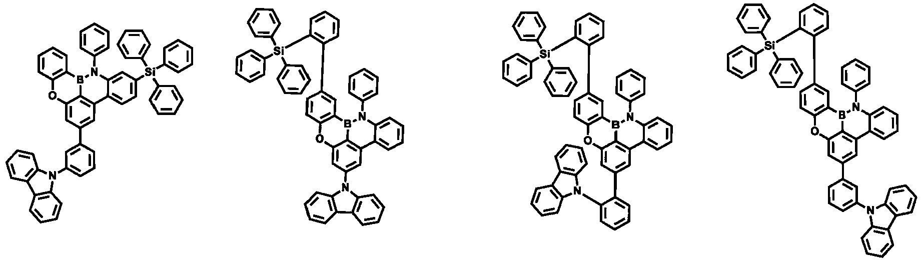 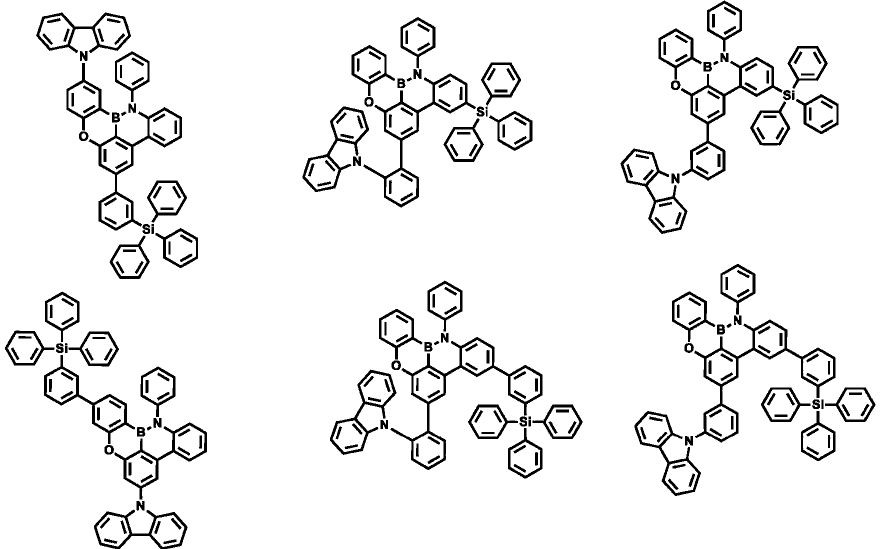 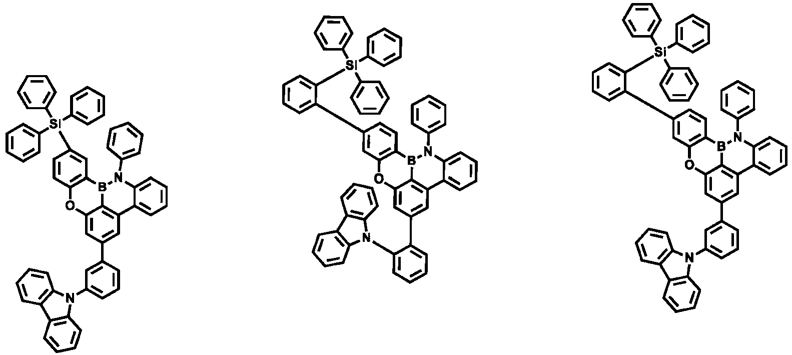 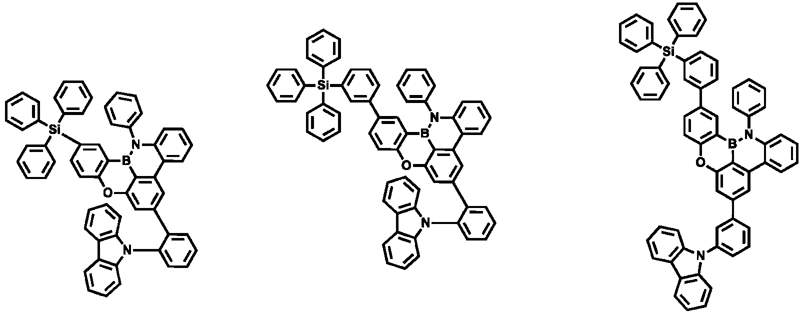 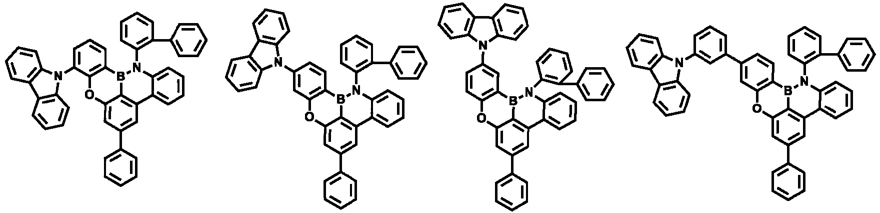 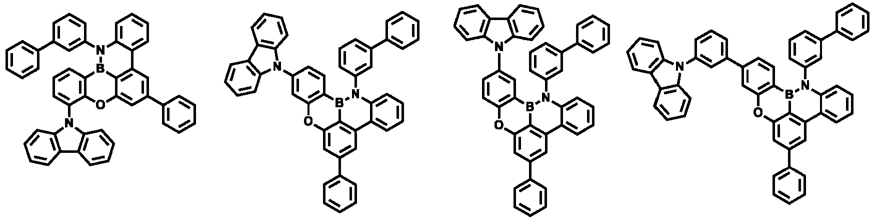 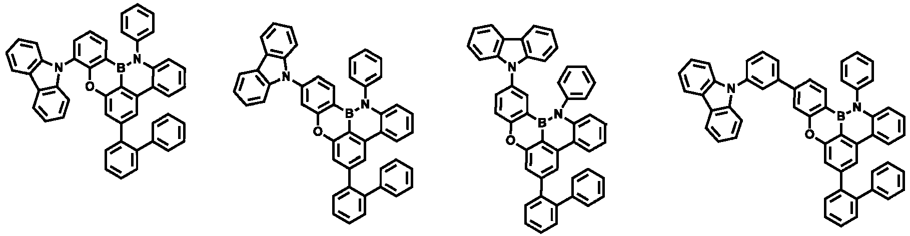 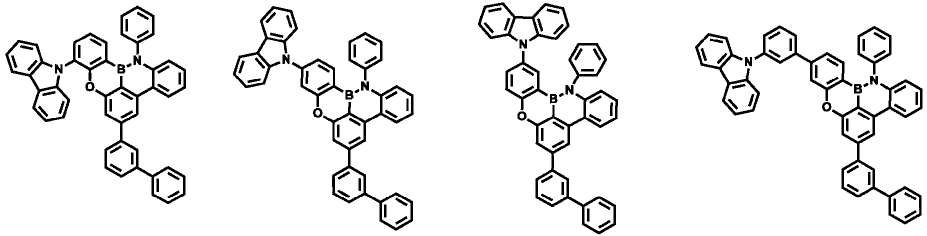 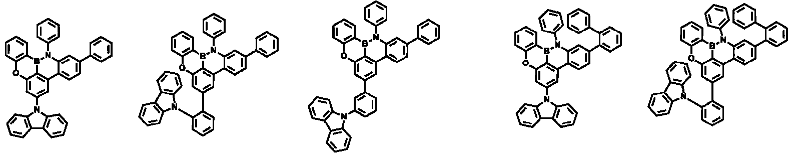 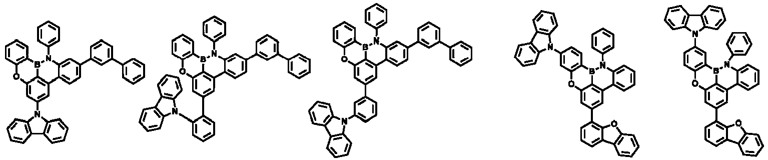 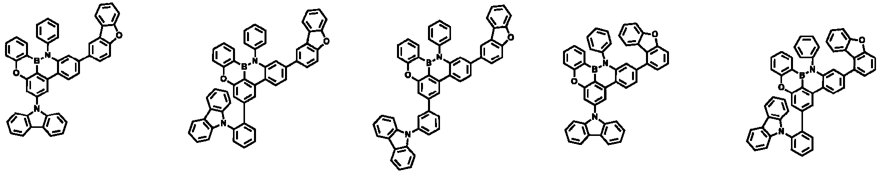 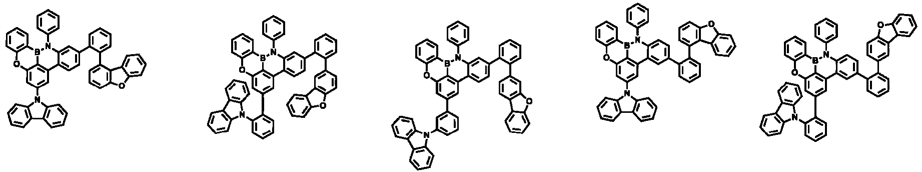 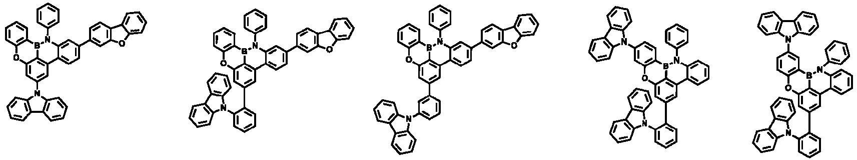 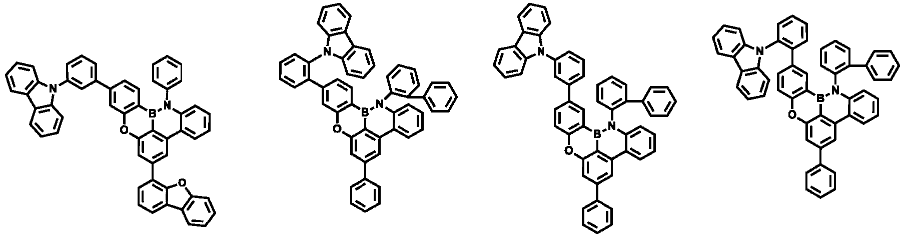 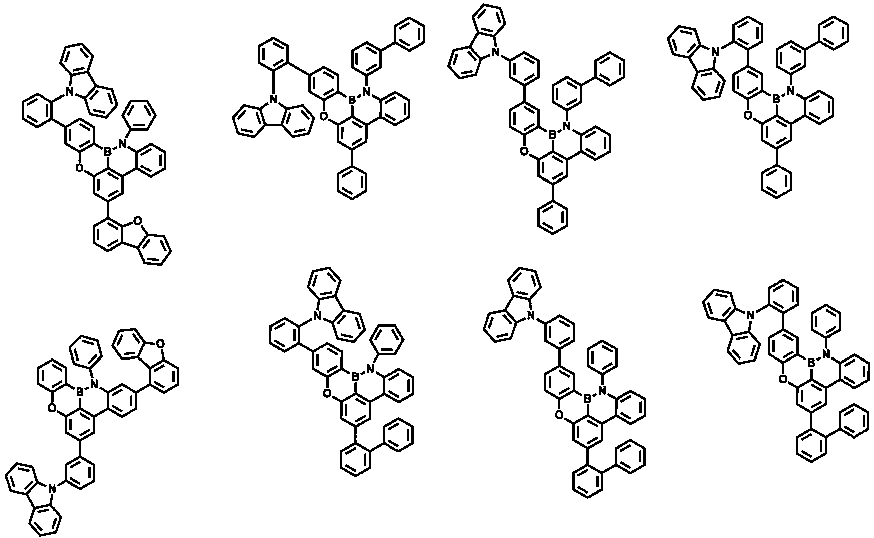 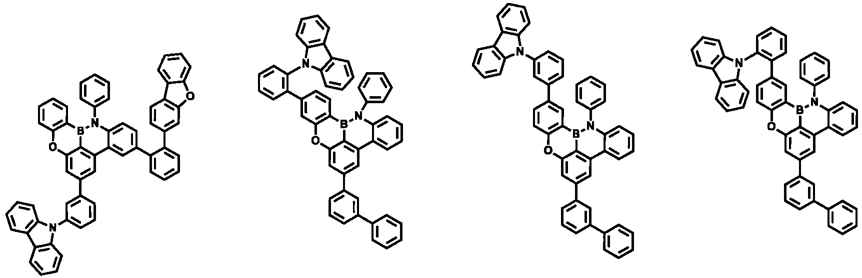 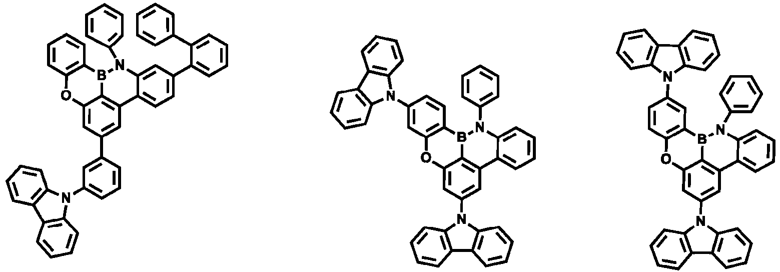 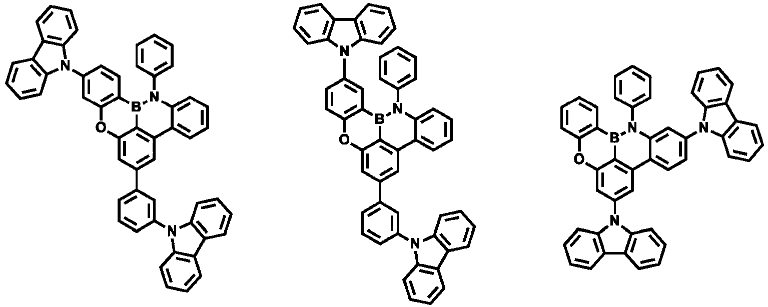 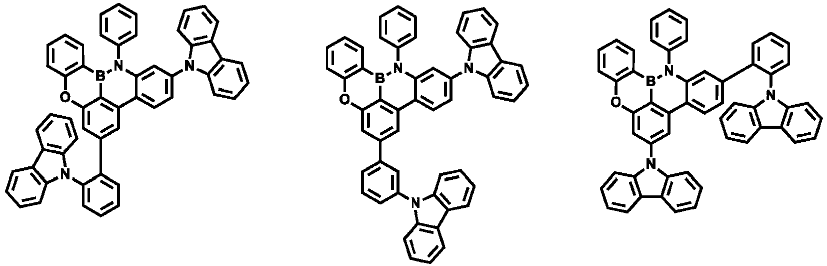 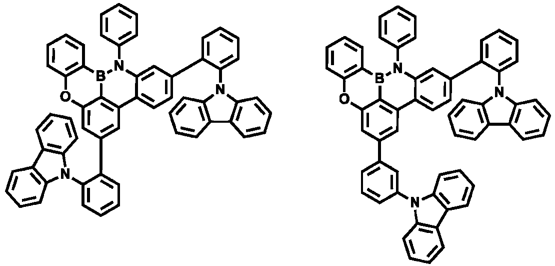 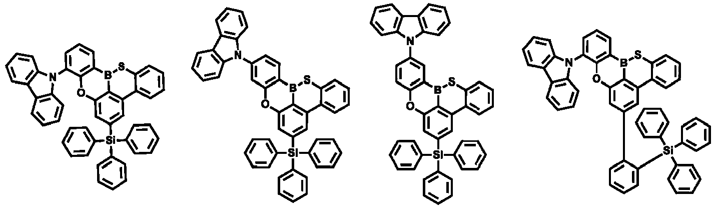 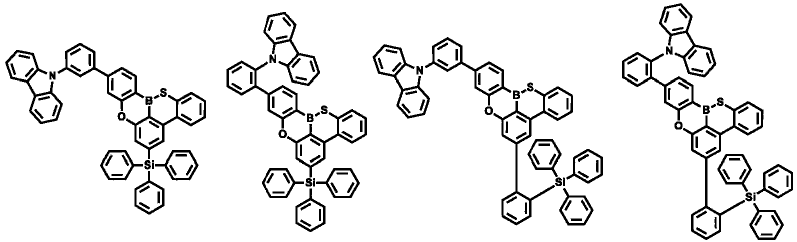 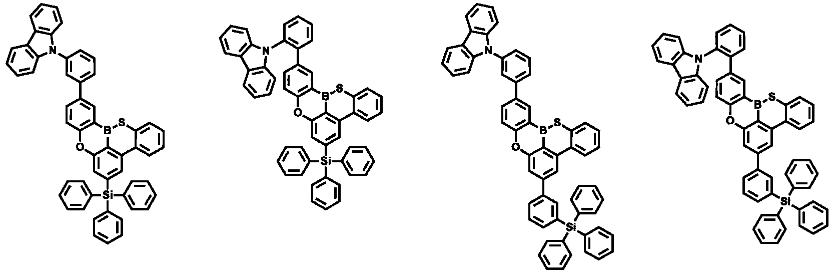 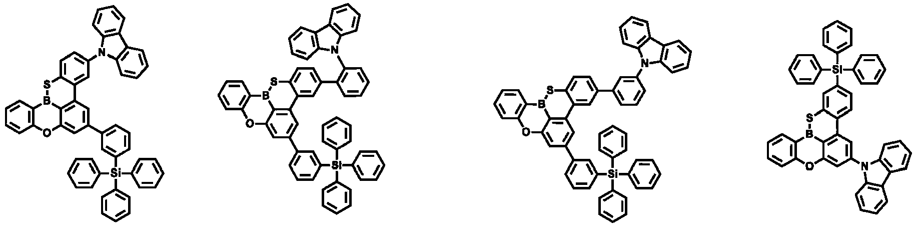 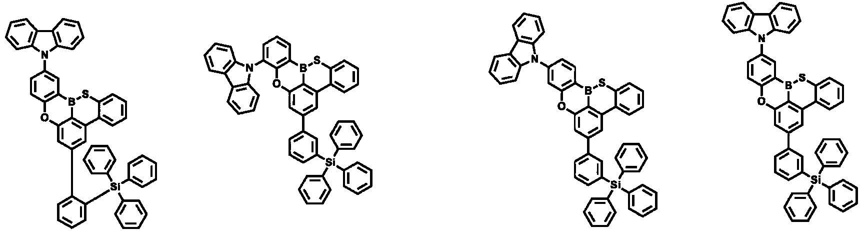 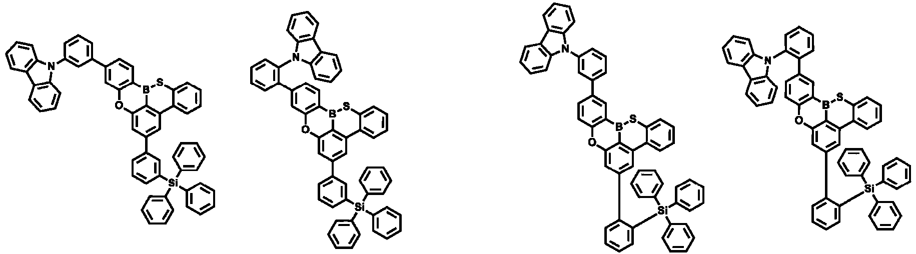 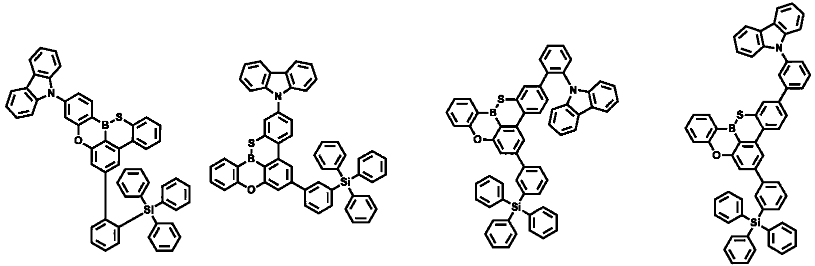 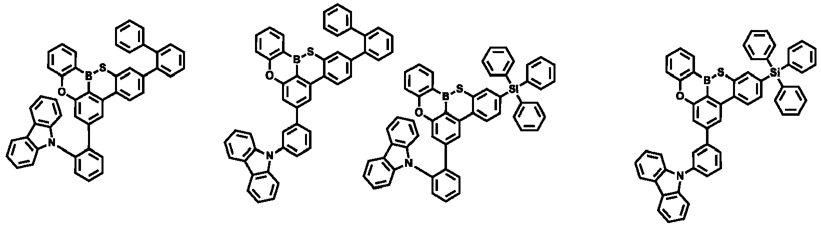 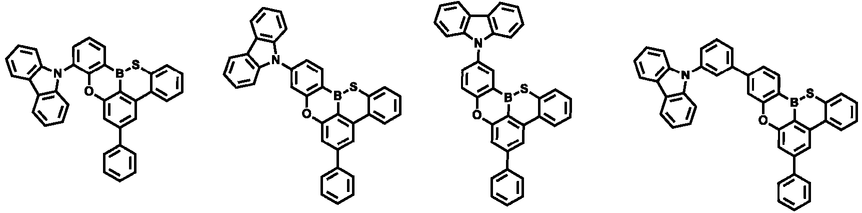 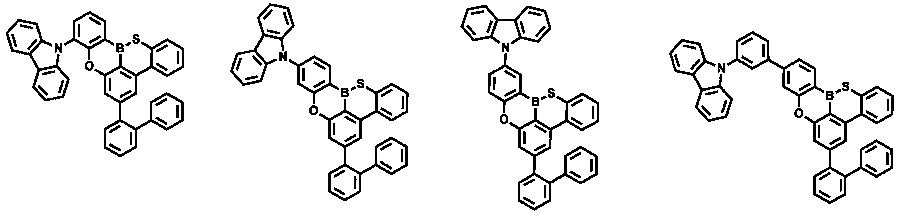 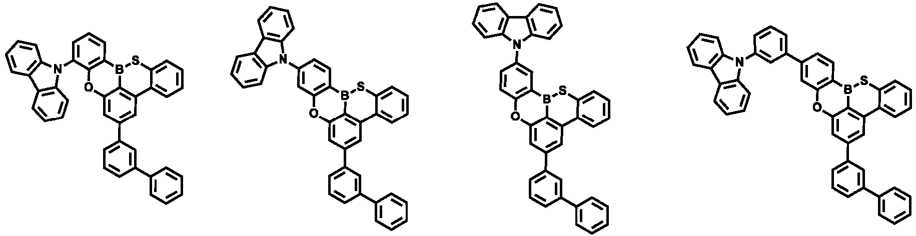 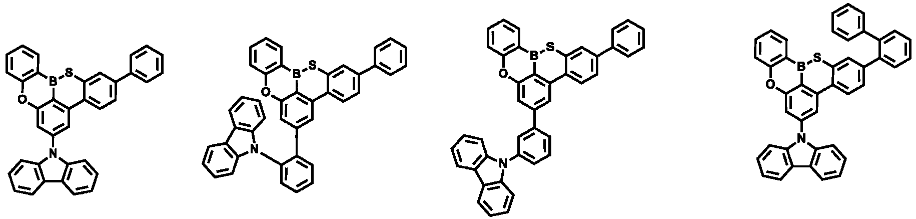 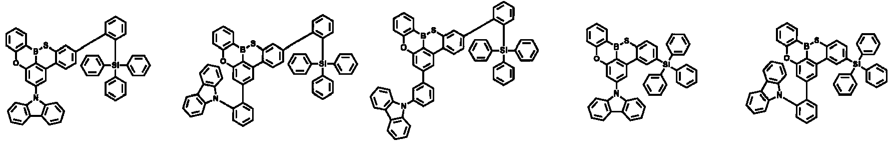 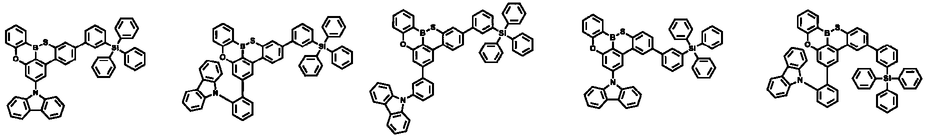 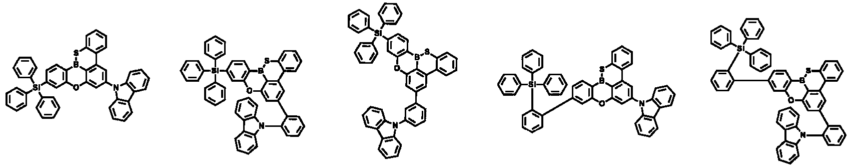 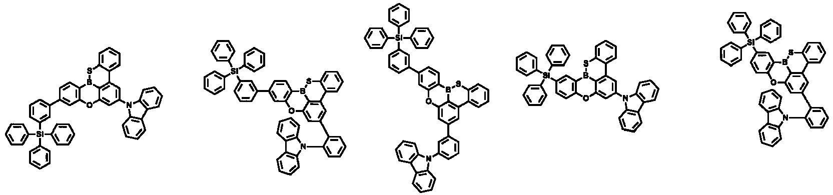 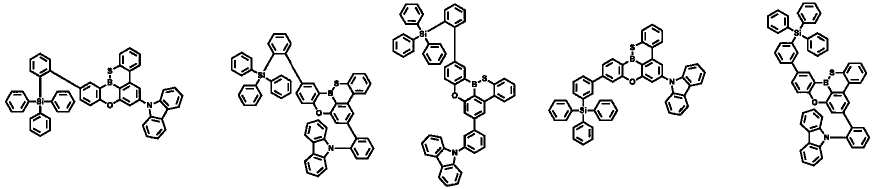 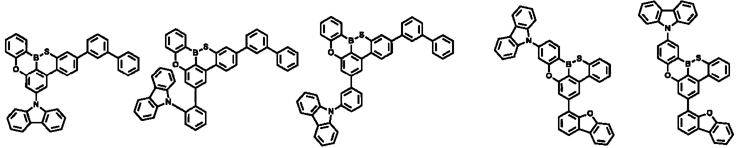 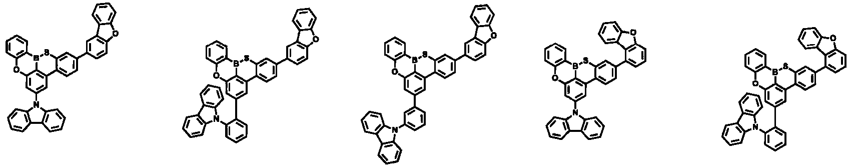 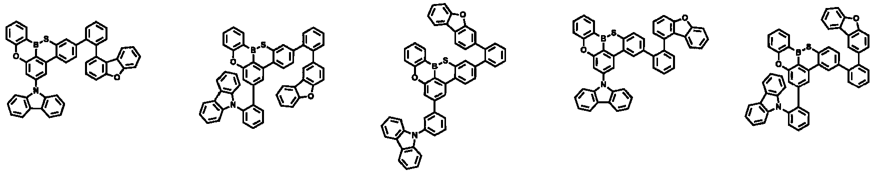 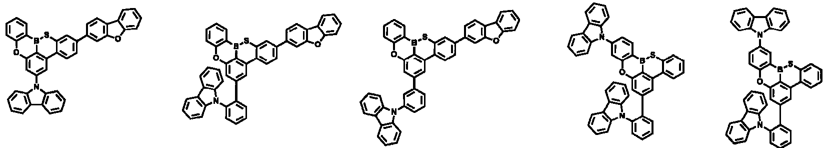 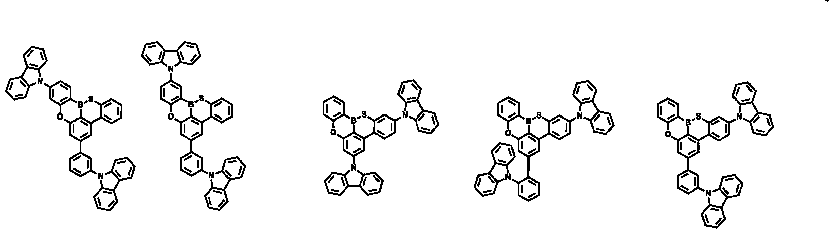 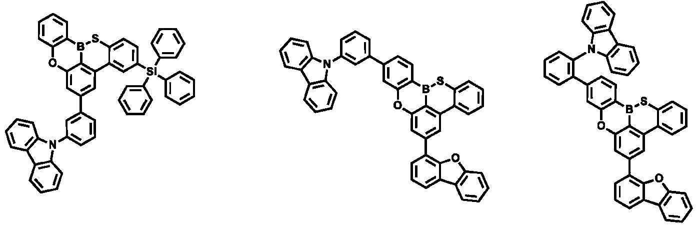 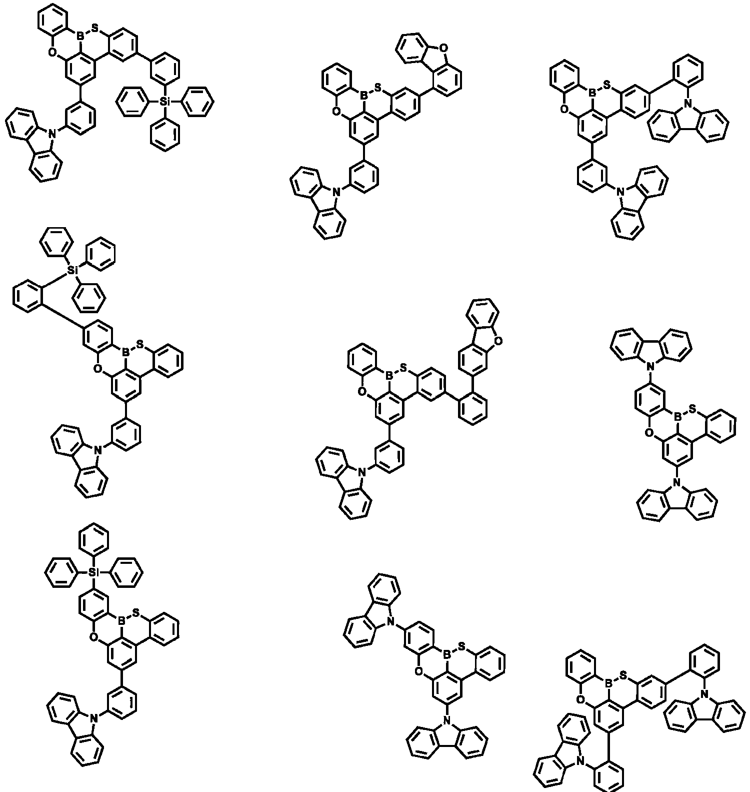 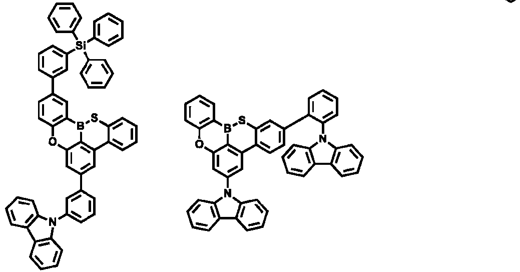 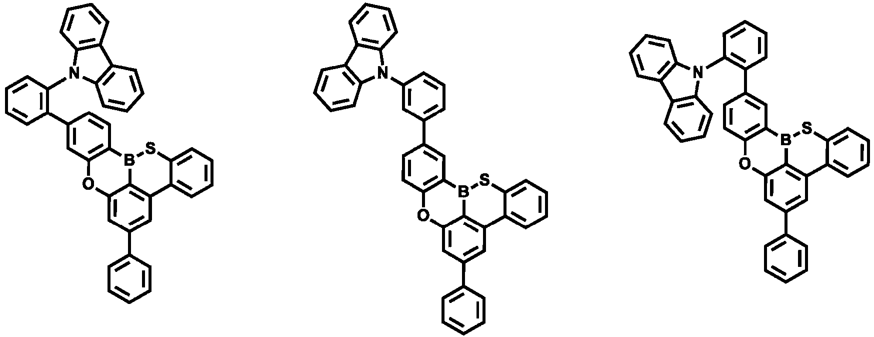 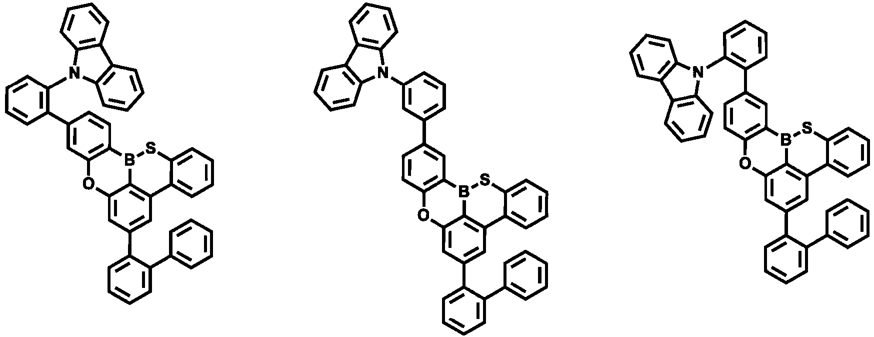 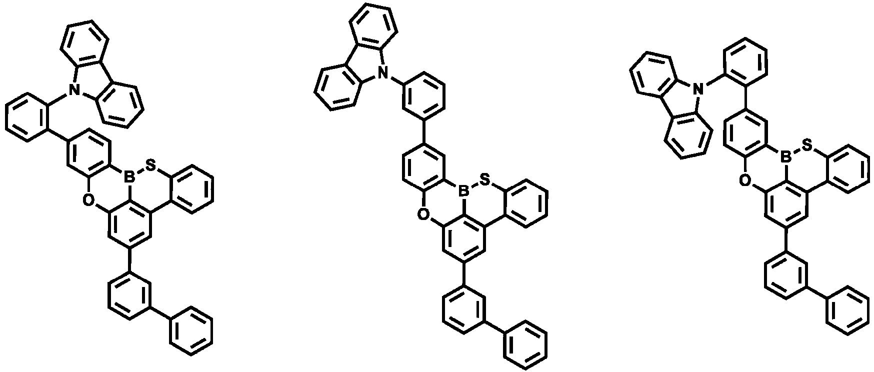 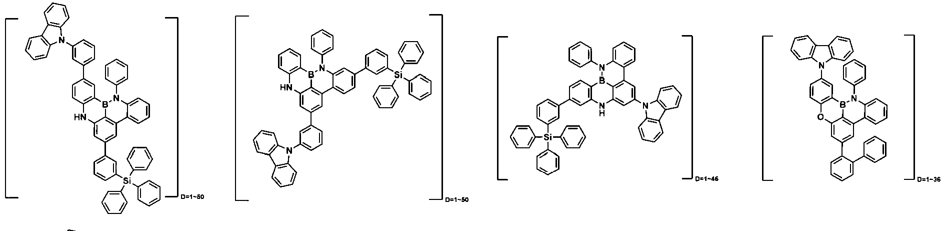 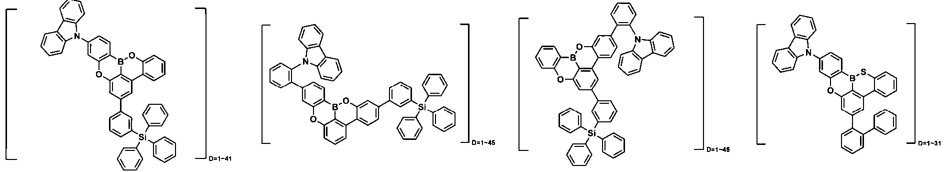 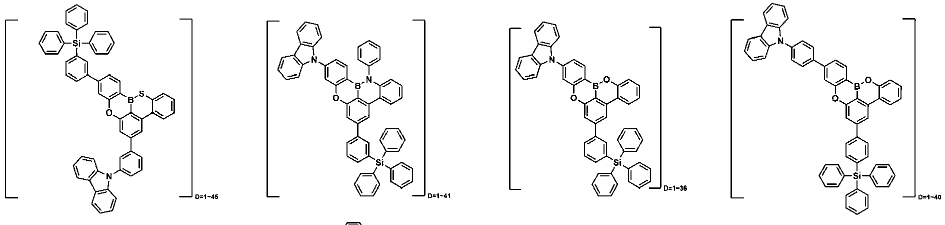 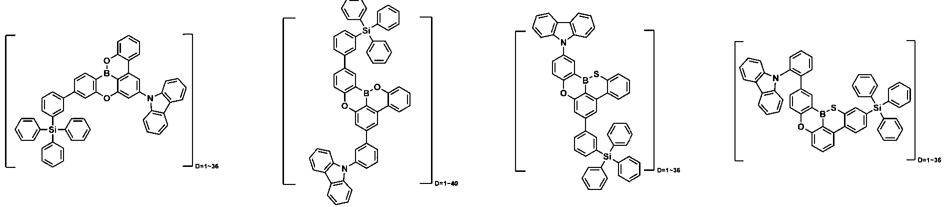 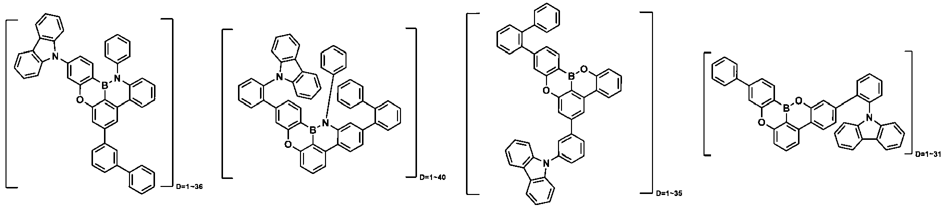 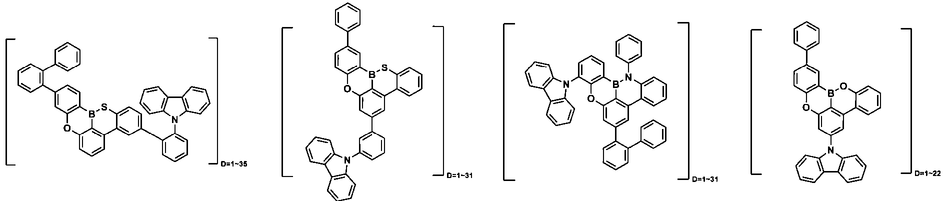 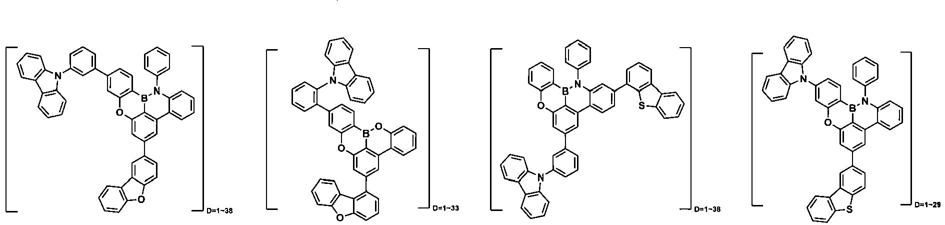 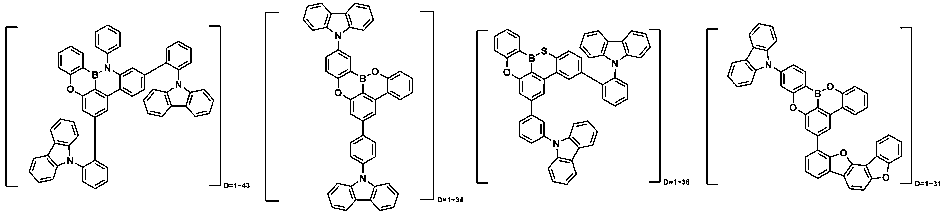 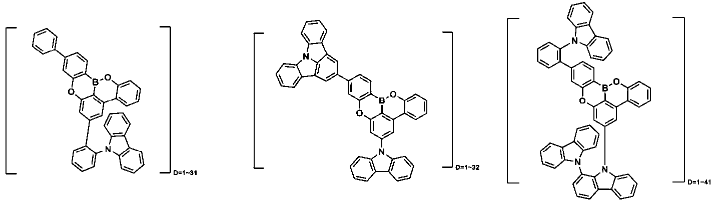 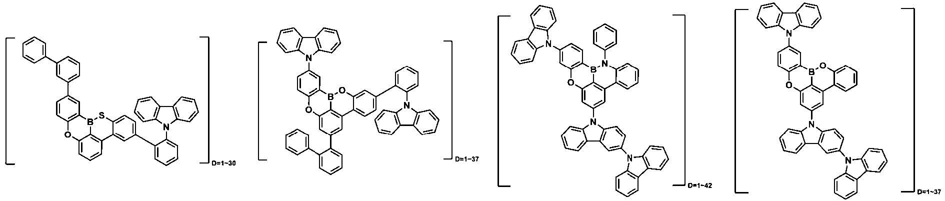 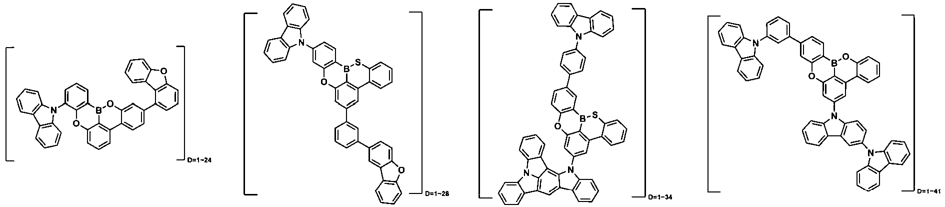 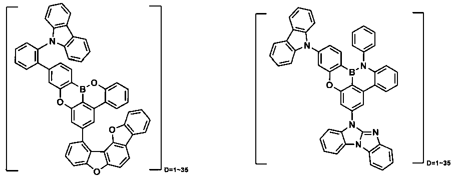 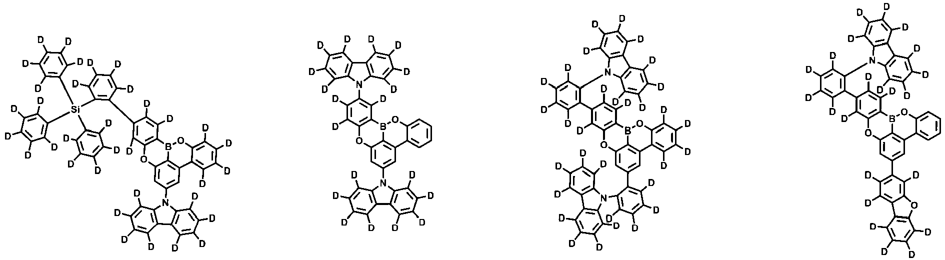 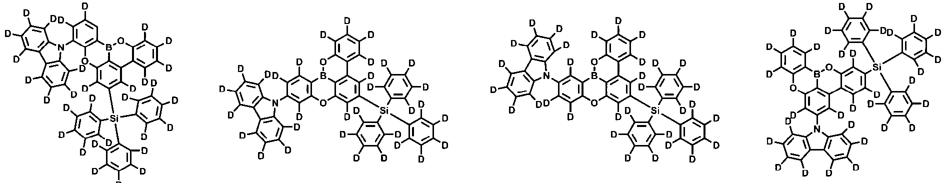 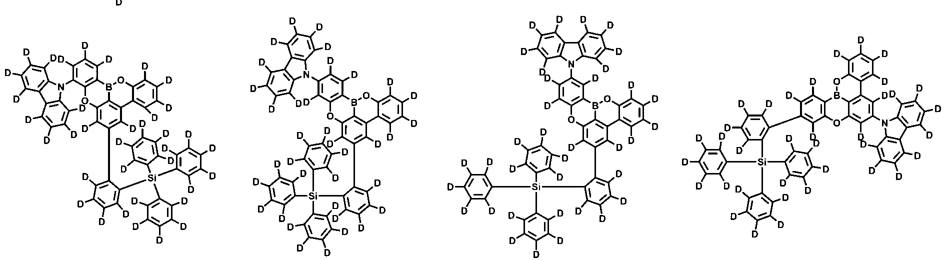 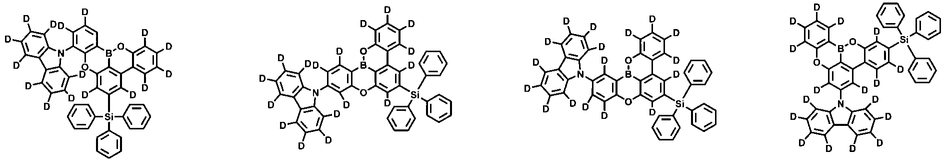 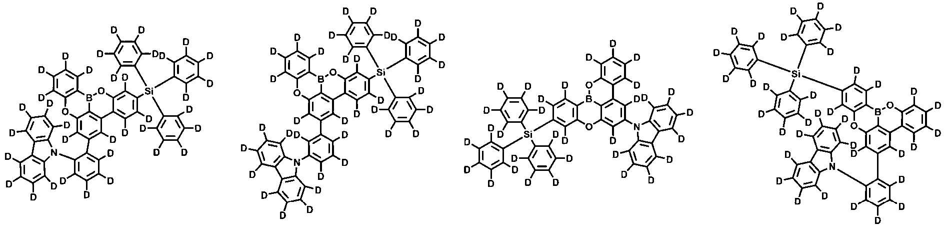 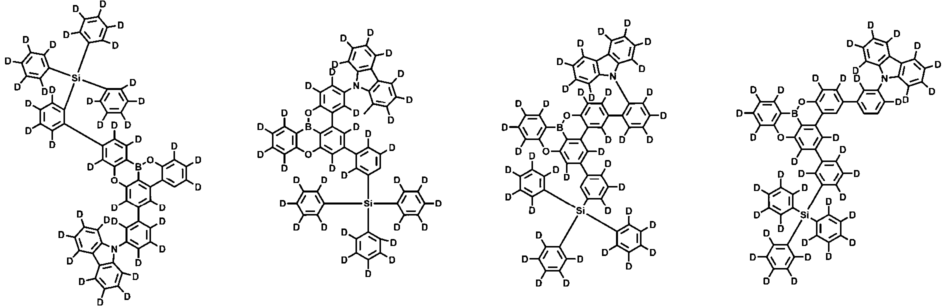 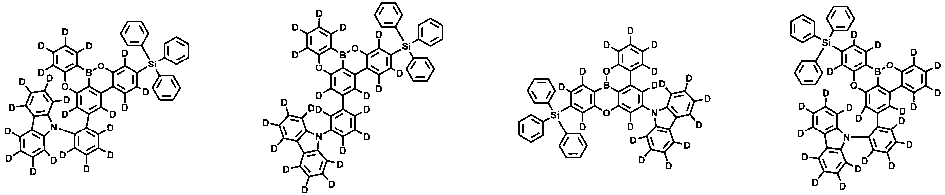 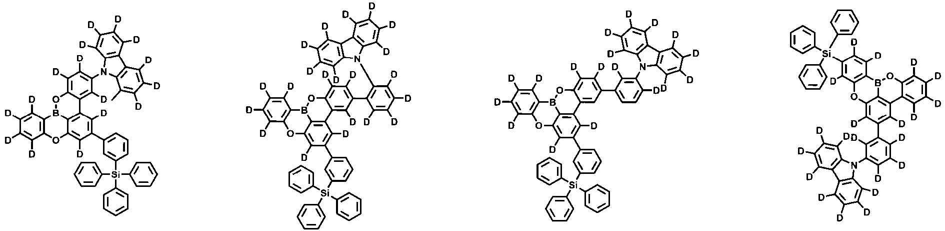 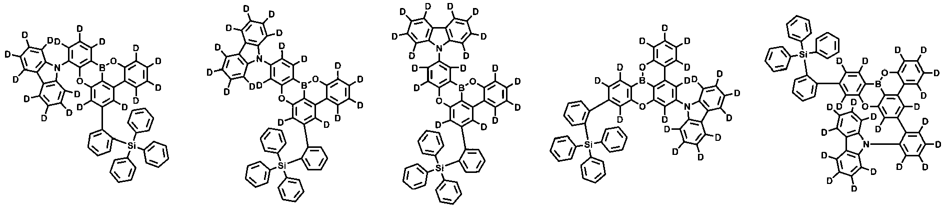 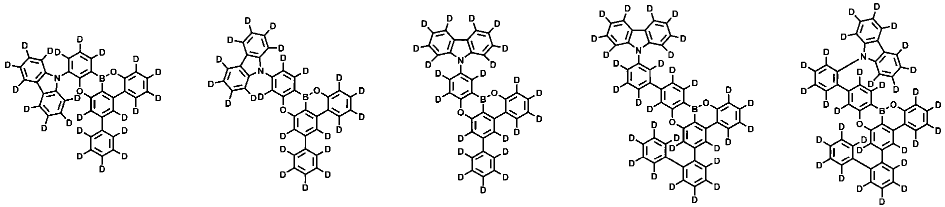 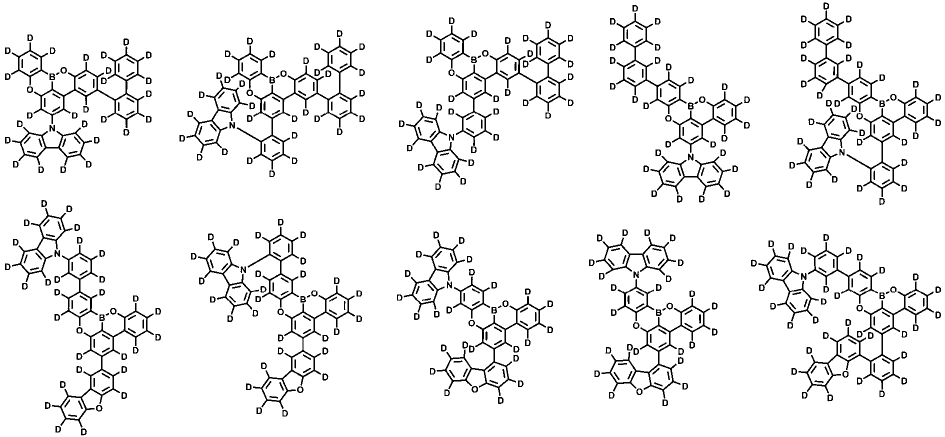 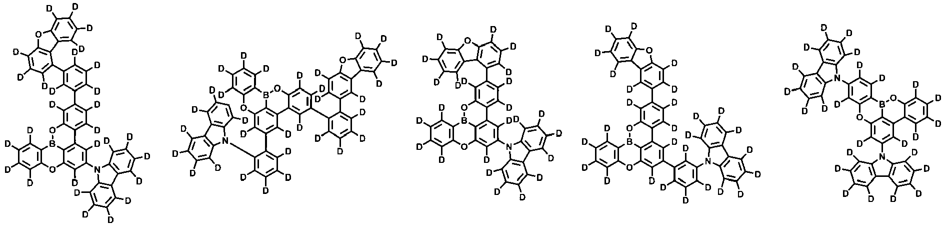 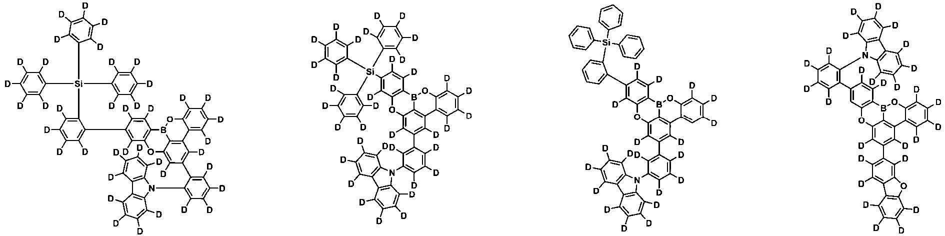 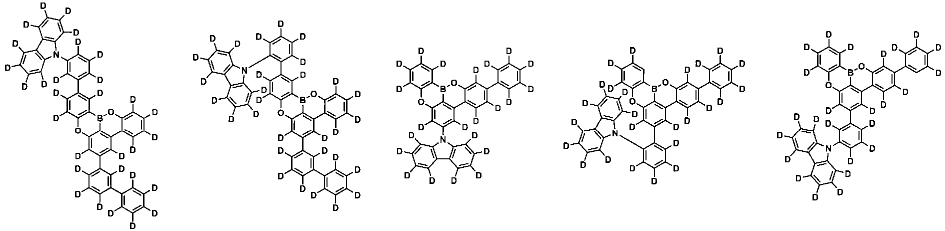 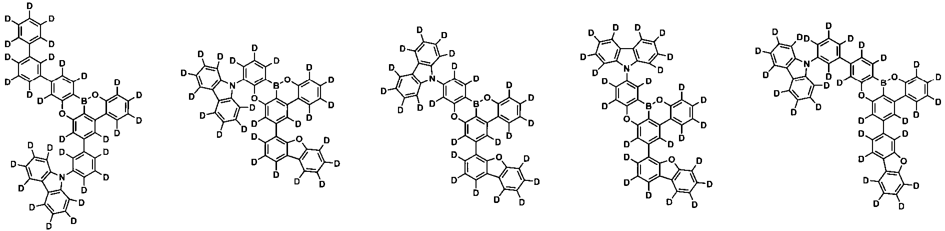 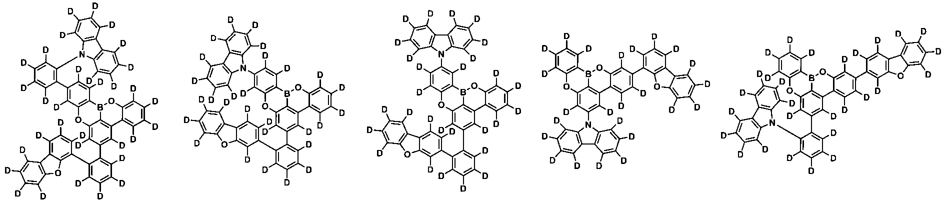 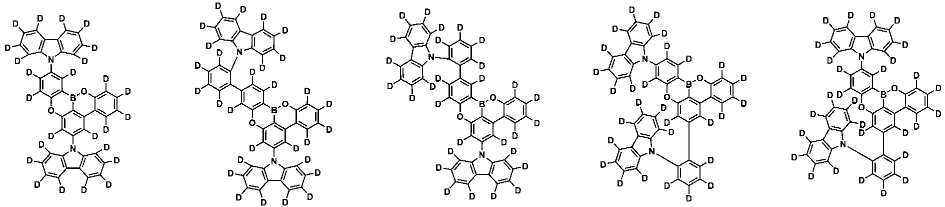 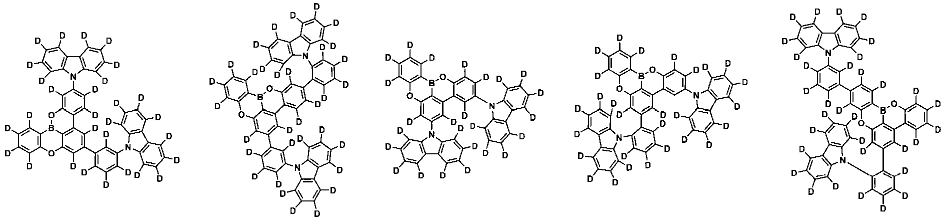 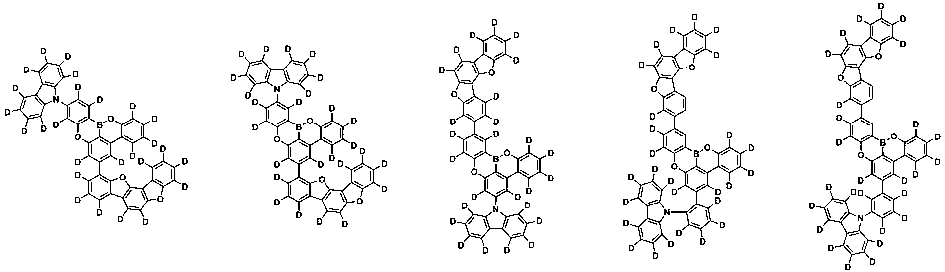 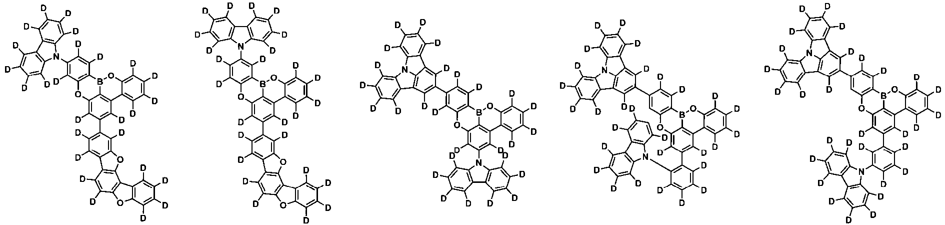 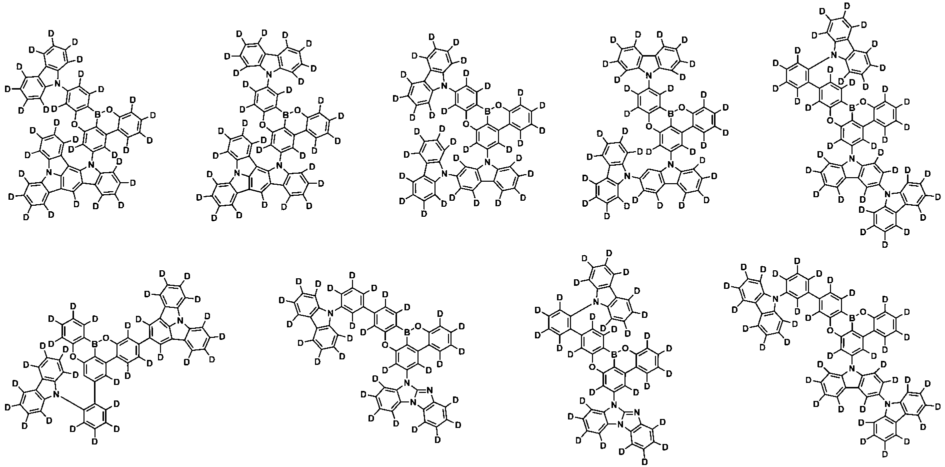 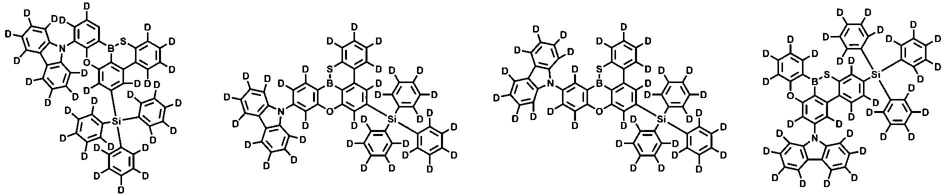 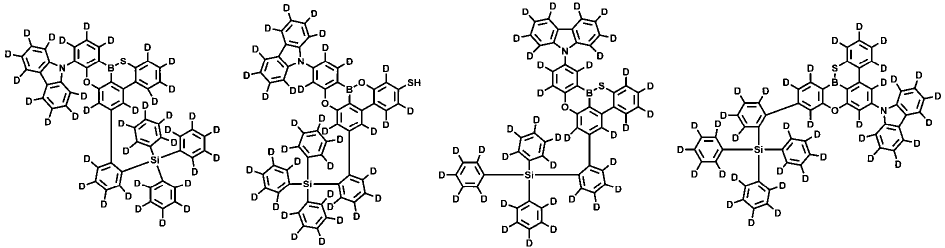 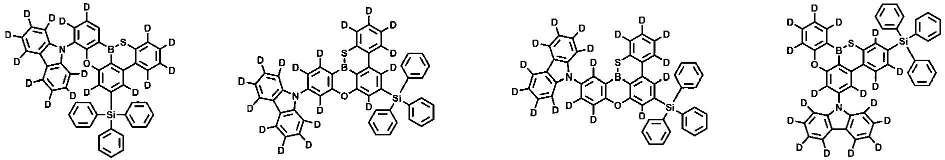 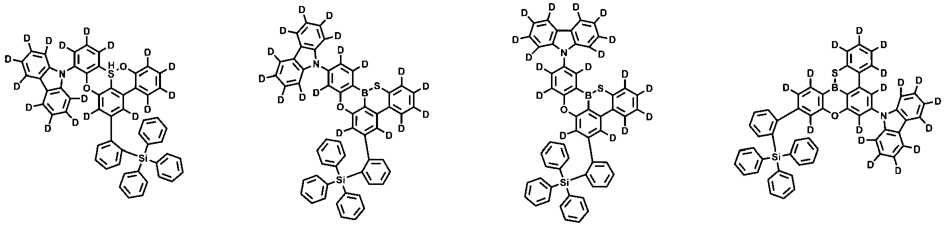 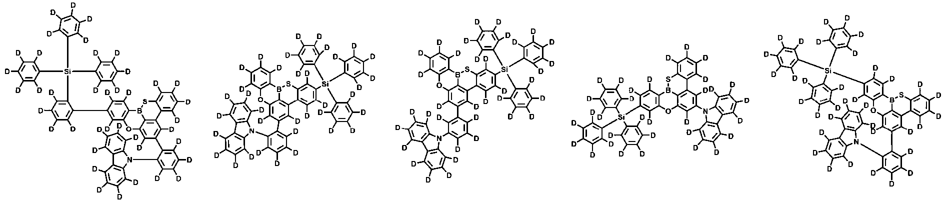 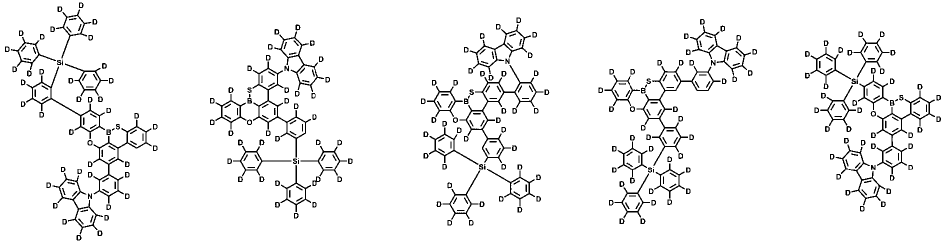 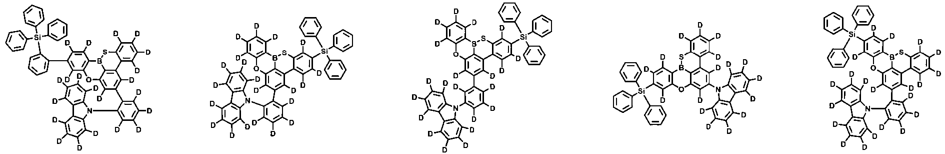 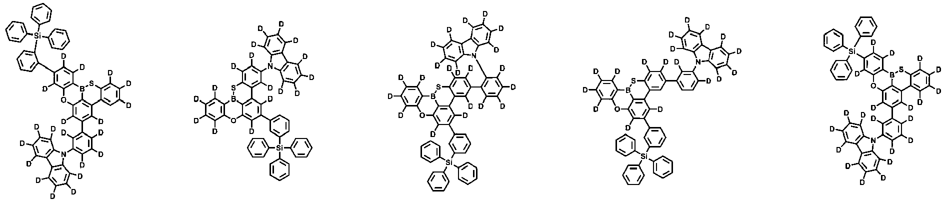 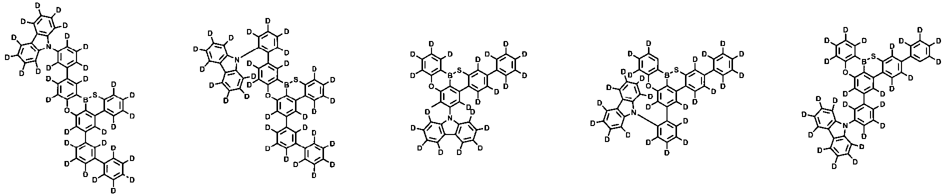 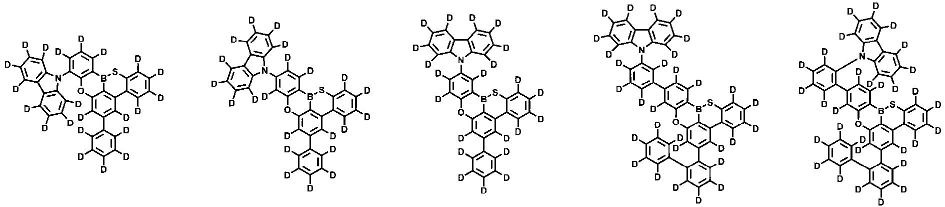 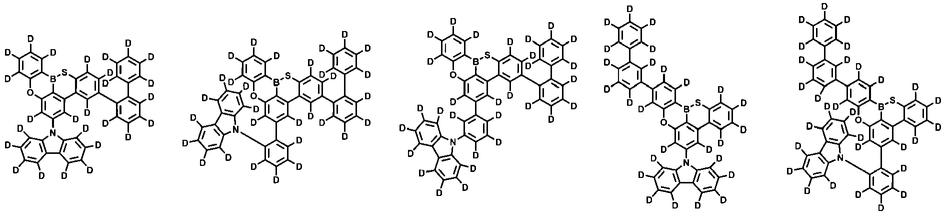 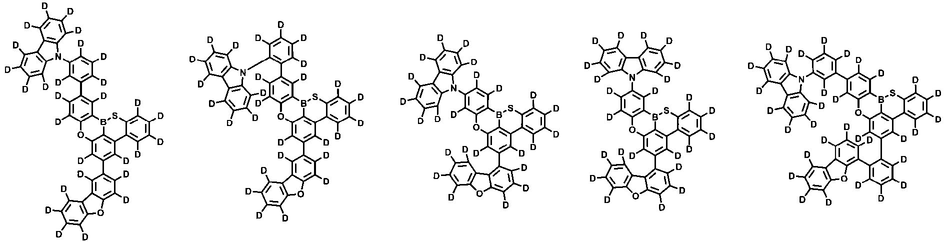 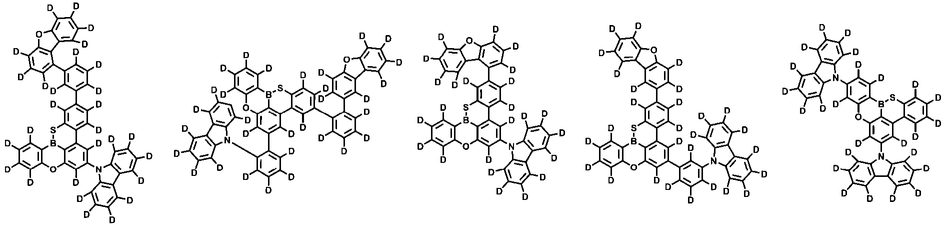 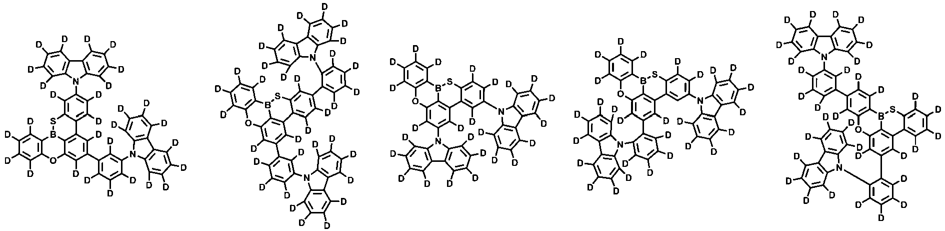 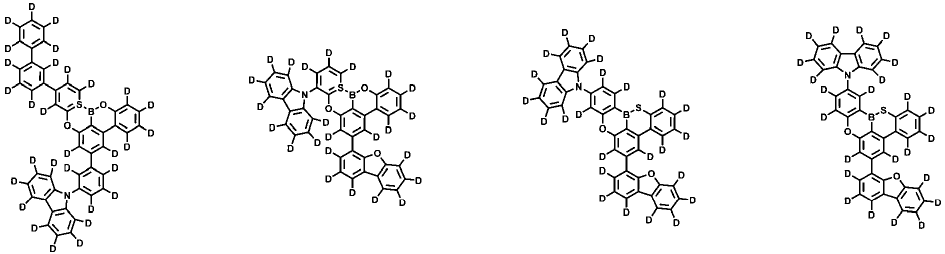 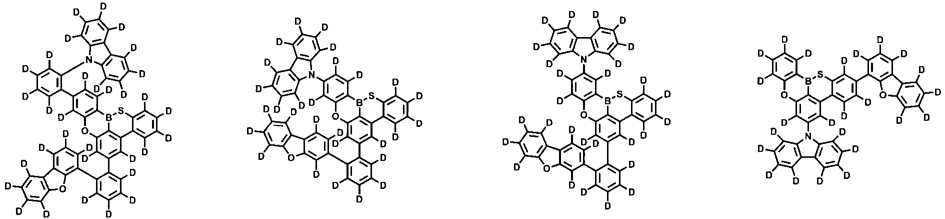 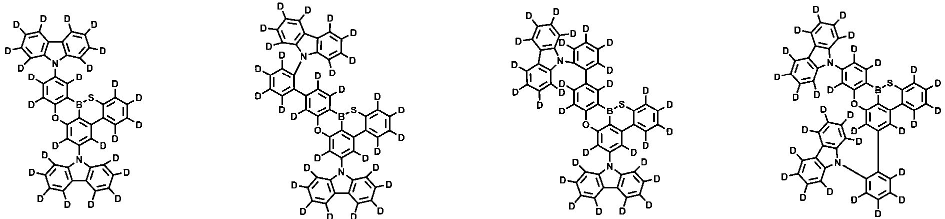 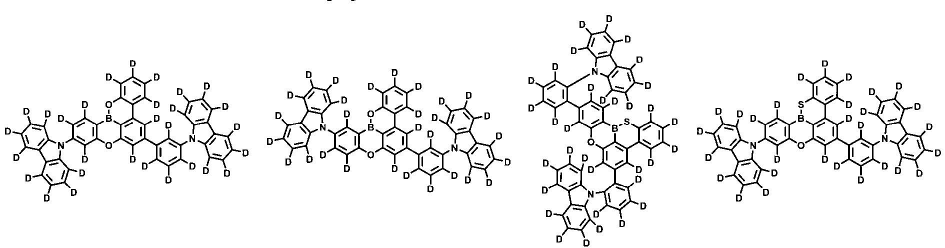 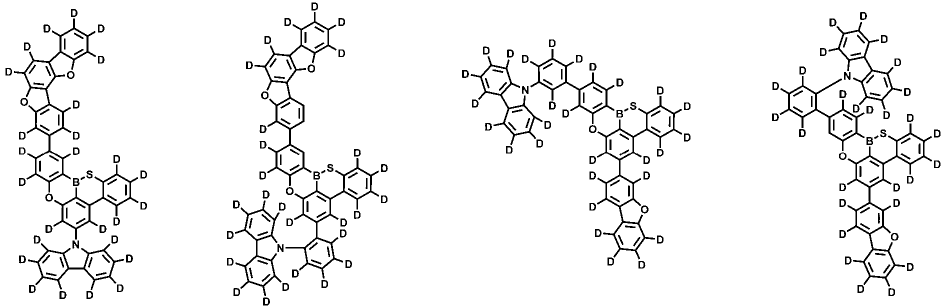 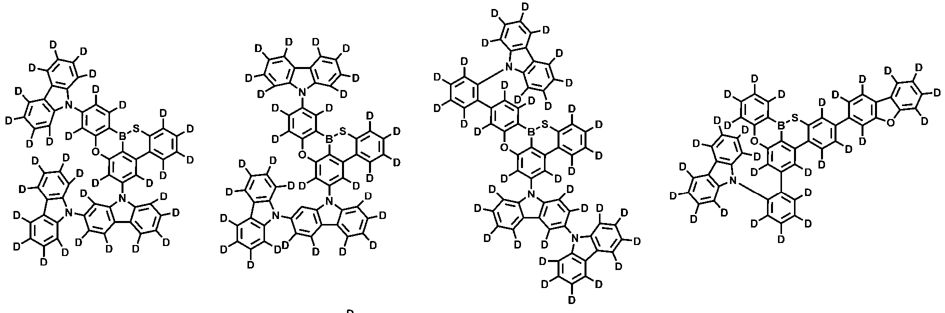 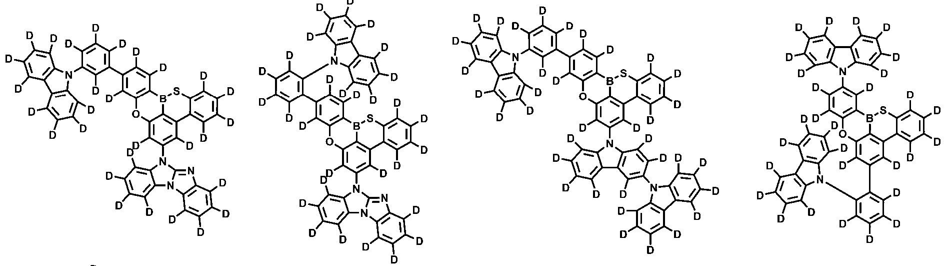 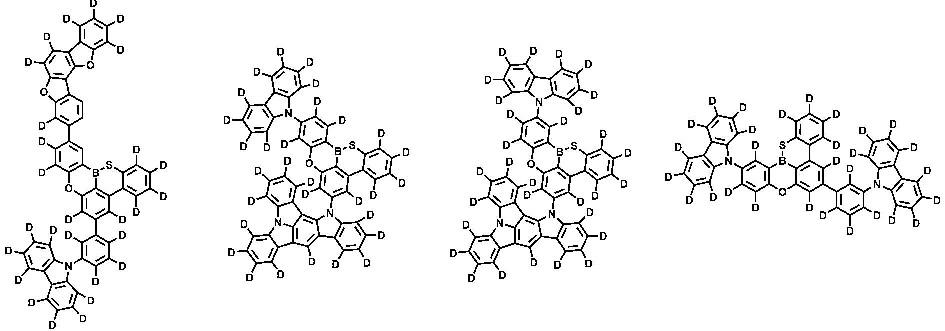 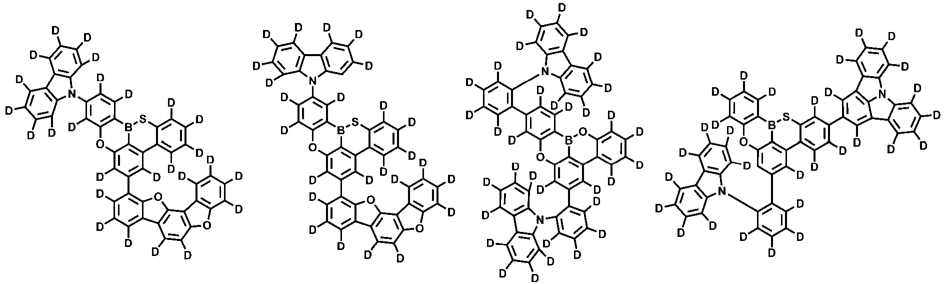 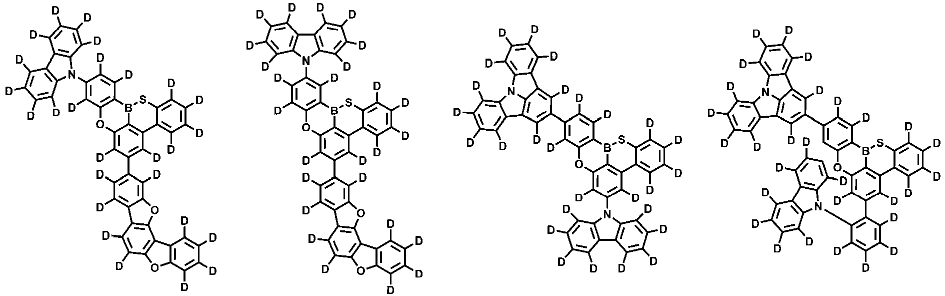 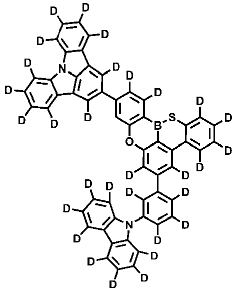 [ ] _{D} = _{x1 to x2} means that the structure within the brackets contains x1 to x2 deuteriums, wherein x1 and x2 are integers. For example, [ ] _{D} = _{1 to 41} means that the structure contains 1 to 41 deuteriums.

The compound represented by Chemical Formula 1 according to an exemplary embodiment of the present specification can be prepared into a core structure according to Scheme 1. The substituents can be bonded by methods known in the art, and the type, position or number of the substituents can be changed according to techniques known in the art.

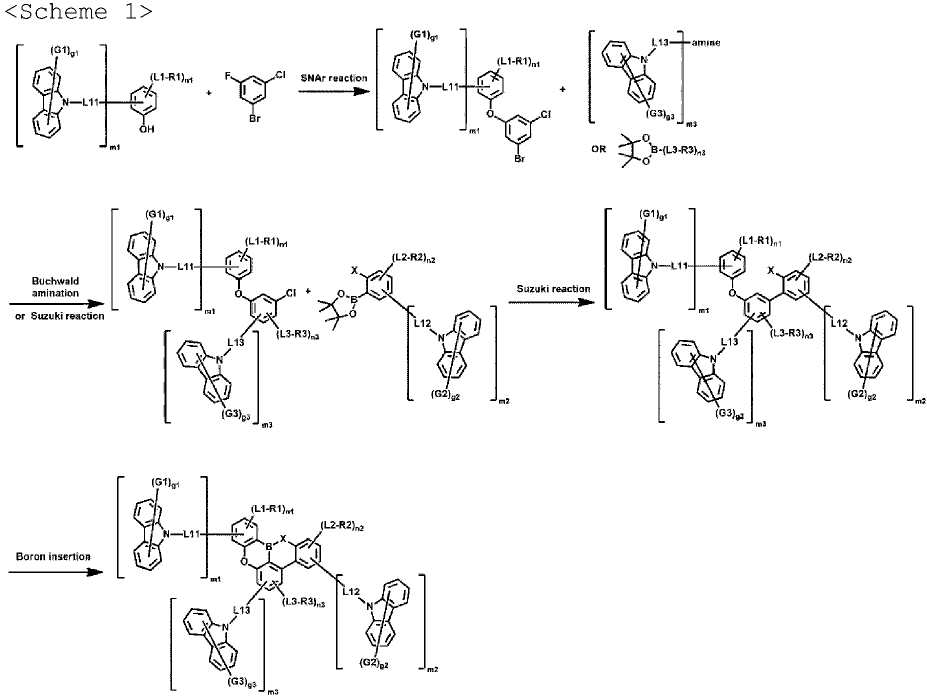

In this specification, it is possible to synthesize compounds with various energy band gaps by introducing various substituents into the core structure of the compound represented by Chemical Formula 1. In addition, in this specification, the HOMO and LUMO energy levels of the compound can also be adjusted by introducing various substituents into the core structure of the structure as described above.

Additionally, this specification provides an organic light-emitting device containing the compound described above.

In an exemplary embodiment, the present disclosure provides an organic light-emitting device including an anode; a cathode; and one or more organic layers provided between the anode and the cathode, wherein at least one layer of the organic layers contains the compound represented by Chemical Formula 1.

The organic layer of the organic light-emitting device according to this specification may be formed as a single-layer structure, but it may also be formed as a multi-layer structure with two or more organic layers stacked.

In an exemplary embodiment of the present specification, the organic layer may include one or more of a hole transport layer, a hole injection layer, an electron blocking layer, a hole injection and transport layer, a light-emitting layer, an electron transport layer, an electron injection layer, a hole blocking layer, and an electron injection and transport layer.

In an exemplary embodiment of the present specification, the organic layer includes an electron injection layer, an electron transport layer, or an electron injection and transport layer, and the electron injection layer, electron transport layer, or electron injection and transport layer contains the compound represented by Chemical Formula 1.

In an exemplary embodiment of the present specification, the organic layer includes an electron control layer, and the electron control layer contains the compound represented by Chemical Formula 1.

In an exemplary embodiment of the present specification, the organic layer includes a hole blocking layer, and the hole blocking layer contains the compound represented by Chemical Formula 1.

In an exemplary embodiment of the present specification, the organic layer includes a hole blocking layer and a light-emitting layer, and the hole blocking layer and the light-emitting layer contain the compound represented by Chemical Formula 1. The compound represented by Chemical Formula 1 contained in the light-emitting layer and the hole blocking layer may be the same or different.

In an exemplary embodiment of the present specification, the organic layer may include a light-emitting layer, and the light-emitting layer may contain the compound represented by Chemical Formula 1.

In an exemplary embodiment of the present specification, the organic layer may include a light-emitting layer, and the light-emitting layer may contain the compound represented by Chemical Formula 1 as a host.

In an exemplary embodiment of the present specification, the organic layer may include a light-emitting layer, and the light-emitting layer may contain the compound represented by Chemical Formula 1 as an n-type phosphorescent host of the light-emitting layer.

In an exemplary embodiment of the present specification, the organic layer may include a light-emitting layer, and the light-emitting layer may contain the compound represented by Chemical Formula 1 as a host and may further contain a host and a dopant.

In an exemplary embodiment of the present specification, the organic layer may include a light-emitting layer, and the light-emitting layer may contain two or more compounds represented by Chemical Formula 1 as hosts.

In an exemplary embodiment of the present specification, the organic layer may include a light-emitting layer, and the light-emitting layer may contain the compound represented by Chemical Formula 1 as a first host and may further contain an additional second host.

In an exemplary embodiment of the present specification, the first host is an n-type phosphorescent host, and the second host is a p-type phosphorescent host. At this time, the weight ratio of the first host to the second host can be 2:8 to 8:2, 4:6 to 6:4, or 5:5. The n-type refers to a material that can draw electrons from the matrix material (the material of the organic layer), and generally known materials can be used, although not being limited thereto. In other words, the n-type can be defined as a material that has the characteristic of being able to provide electrons to the LUMO (lowest unoccupied molecular orbital) energy level of a matrix. Conversely, the p-type refers to a material, when a single layer is formed solely with p-type material, which receives electrons from the HOMO (highest occupied molecular orbital) energy level of the material located in the adjacent cathode direction, thereby creating holes in the material in the adjacent cathode direction. Alternatively, when the p-type material is doped into an arbitrary matrix, it receives electrons from the HOMO of the matrix material, thereby creating holes in the HOMO of the matrix. For this purpose, when a single layer is formed solely with p-type material, the closer the HOMO level of the material located in the cathode direction is to the LUMO of the p-type material, the easier it is to take electrons from the HOMO of the adjacent layer and create holes in the HOMO of the adjacent layer. Additionally, when the p-type material is doped into an arbitrary matrix, the closer the LUMO of the p-type material is to the HOMO of the matrix, the easier it is to take electrons and create holes in the matrix.

The p-type host may be compounds generally known in the art. For example, it may have a structure including a N-containing monocyclic ring; dibenzofuran; and/or carbazole.

In an exemplary embodiment of the present specification, the second host is a carbazole-based compound.

In an exemplary embodiment of the present specification, the second host is a biscarbazole-based compound.

In an exemplary embodiment of the present specification, the second host is an aryl-substituted biscarbazole compound.

In an exemplary embodiment of the present specification, the light-emitting layer may contain a first host and a second host and may further contain a dopant, wherein the dopant may be a phosphorescent dopant. In an exemplary embodiment of the present specification, the light-emitting layer may be a blue light-emitting layer, a red light-emitting layer, or a green light-emitting layer.

In an exemplary embodiment of the present specification, the light-emitting layer may be a blue light-emitting layer.

In an exemplary embodiment of the present specification, the light-emitting layer may contain a host and a dopant. Specifically, the dopant may be a fluorescent dopant or a phosphorescent dopant.

In an exemplary embodiment of the present specification, the dopant is contained in an amount of 1 to 20 parts by weight based on 100 parts by weight of the host.

In an exemplary embodiment of the present specification, the light-emitting layer contains a host and a dopant at a weight ratio of 99:1 to 1:99. Specifically, they are contained at a weight ratio of 99:1 to 50:50, 99:1 to 70:30, 99:1 to 80:20, 99:1 to 90:10, or 99:1 to 95:5.

In an exemplary embodiment of the present specification, the dopant may include an arylamine-based compound, a heterocyclic compound containing boron and nitrogen, a metal complex compound, a platinum complex compound, an iridium complex compound, an iridium-based compound, etc.

For example, when the light-emitting layer emits red light, a phosphorescent material such as PIQIr(acac) (bis(1-phenylisoquinoline)acetylacetonateiridium), PQIr(acac) (bis(1-phenylquinoline)acetylacetonate iridium), PQIr (tris(1-phenylquinoline)iridium), PtOEP (platinum octaethylporphyrin), or a fluorescent material such as Alq₃(tris(8-hydroxyquinolino)aluminum) may be used as a light-emitting dopant, although not being limited thereto. When the light-emitting layer emits green light, a phosphorescent material such as Ir(ppy)₃ (tris (2-phenylpyridine) iridium) or a fluorescent material such as Alq₃ (tris (8-hydroxyquinolino) aluminum) may be used as a light-emitting dopant, although not being limited thereto. When the light-emitting layer emits blue light, a platinum complex compound, a phosphorescent material such as (4,6-F2ppy)2Irpic, or a fluorescent material such as spiro-DPVBi, spiro-6P, distyrylbenzene (DSB), distyrylarylene (DSA), a PFO-based polymer, a PPV-based polymers, etc. may be used as a light-emitting dopant, although not being limited thereto.

In an exemplary embodiment of the present specification, the dopant is a metal complex compound.

In an exemplary embodiment of the present specification, the dopant is a platinum complex compound.

In an exemplary embodiment of the present specification, the dopant is an iridium complex compound.

In an exemplary embodiment of the present specification, the dopant is an iridium-based compound.

In an exemplary embodiment of the present specification, the dopant compound may be selected from the following structural formulas, although not being limited thereto.

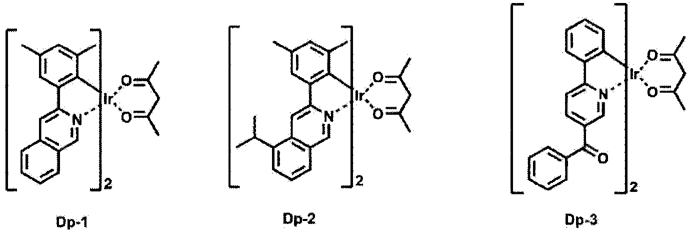

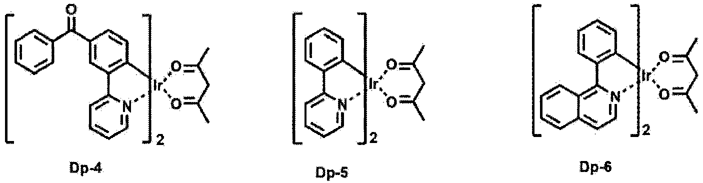

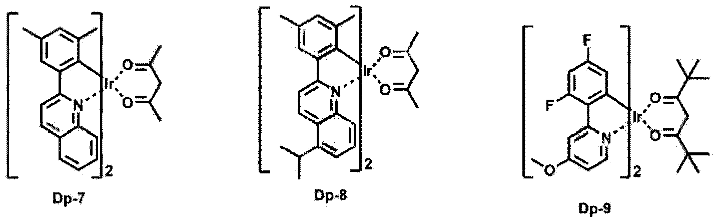

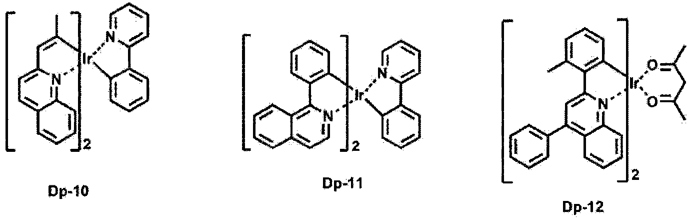

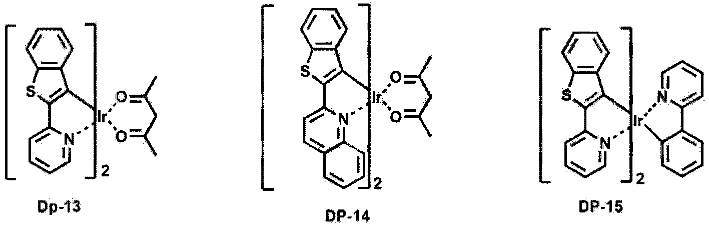

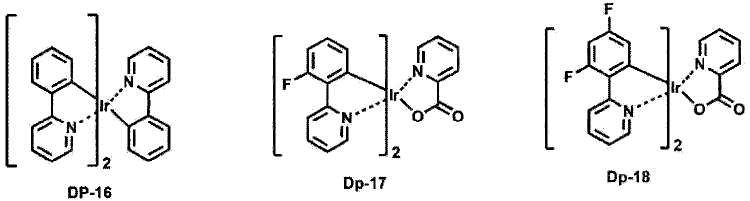

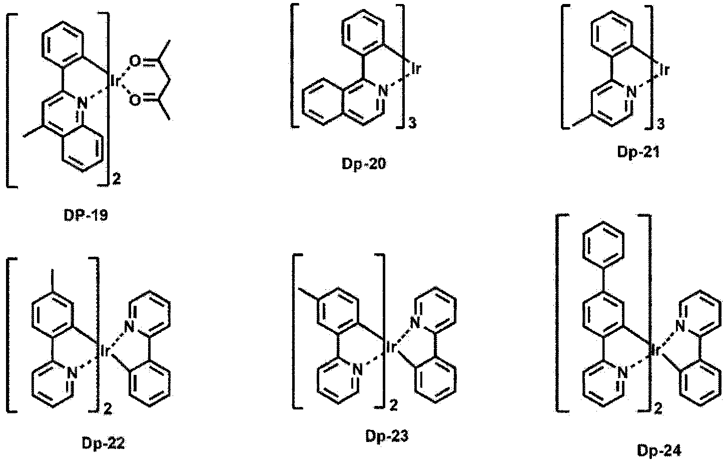

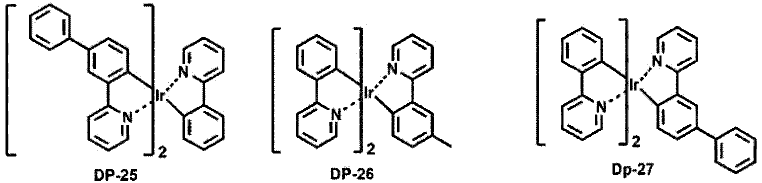

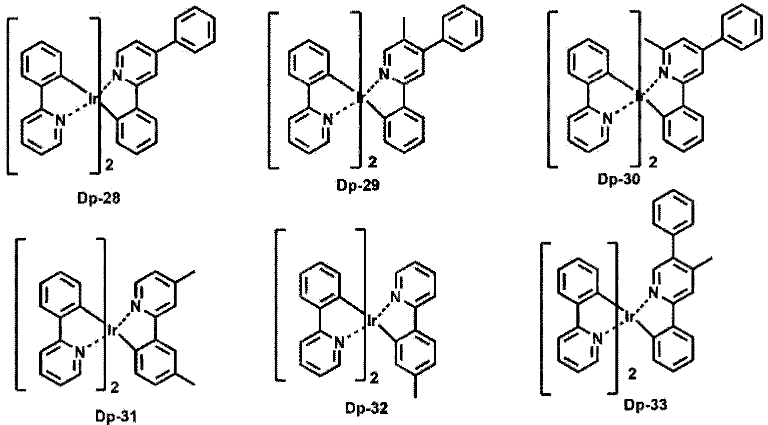

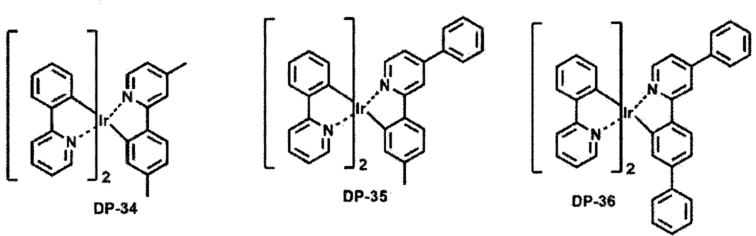

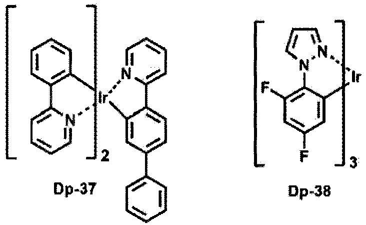

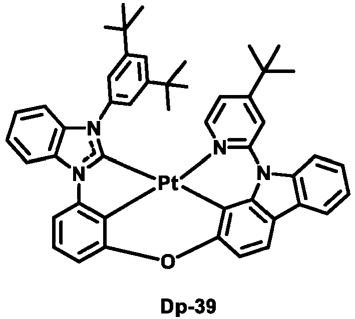

In an exemplary embodiment of the present specification, the organic layer includes two or more electron transport layers, and at least one of the two or more electron transport layers contains the compound represented by Chemical Formula 1. Specifically, in an exemplary embodiment of the present specification, the compound represented by Chemical Formula 1 may be contained in one of the two or more electron transport layers, and may be contained in each of the two or more electron transport layers.

In an exemplary embodiment of the present specification, when the compound is contained in each of the two or more electron transport layers, materials other than the compound represented by Chemical Formula 1 may be identical or different.

When the organic layer containing the compound represented by Chemical Formula 1 is an electron transport layer, an electron injection layer, or an electron injection and transport layer, the electron transport layer, electron injection layer, or electron injection and transport layer may further contain an n-type dopant or an organometallic compound. The n-type dopant or organometallic compound may be one known in the art. For example, a metal or a metal complex may be used.

For example, the n-type dopant or organometallic compound may be LiQ, although not being limited thereto. The electron transport layer, electron injection layer, or electron injection and transport layer containing the compound represented by Chemical Formula 1 may further contain LiQ (lithium quinolate).

According to an exemplary embodiment, the compound represented by Chemical Formula 1 and the n-type dopant or organometallic compound may be contained at a weight ratio of 2:8 to 8:2, e.g., 4:6 to 6:4. According to an exemplary embodiment, the compound represented by Chemical Formula 1 and the n-type dopant or organometallic compound may be contained at a weight ratio of 1:1.

In an exemplary embodiment of the present disclosure, the organic layer may further contain other organic compounds, metals, or metal compounds in addition to the compound represented by Chemical Formula 1.

In an exemplary embodiment of the present specification, the organic layer may further include a hole injection layer or a hole transport layer containing a compound including an arylamine group, a carbazolyl group or a benzocarbazolyl group, in addition to the organic layer containing the compound represented by Chemical Formula 1.

In an exemplary embodiment of the present specification, the thickness of the organic layer containing the compound of Chemical Formula 1 may be 5 Å to 2000 Å, or 5 Å to 500 Å, and specifically 10 Å to 400 Å.

In an exemplary embodiment of the present specification, the organic light-emitting device may be an organic light-emitting device with a structure in which an anode, one or more organic layers, and a cathode are stacked sequentially on a substrate (normal type) .

In an exemplary embodiment of the present specification, the organic light-emitting device may be an organic light-emitting device with a structure in which a cathode, one or more organic layers, and an anode are stacked sequentially on a substrate (inverted type) .

The organic light-emitting device may have a stacked structure as described below, although not being limited thereto.
(1) anode/hole transport layer/light-emitting layer/cathode
(2) anode/hole injection layer/hole transport layer/light-emitting layer/cathode
(3) anode/hole injection layer/hole buffer layer/hole transport layer/light-emitting layer/cathode
(4) anode/hole transport layer/light-emitting layer/electron transport layer/cathode
(5) anode/hole transport layer/light-emitting layer/electron transport layer/electron injection layer/cathode
(6) anode/hole injection layer/hole transport layer/light-emitting layer/electron transport layer/cathode
(7) anode/hole injection layer/hole transport layer/light-emitting layer/electron transport layer/electron injection layer/cathode
(8) anode/hole injection layer/hole buffer layer/hole transport layer/light-emitting layer/electron transport layer/cathode
(9) anode/hole injection layer/hole buffer layer/hole transport layer/light-emitting layer/electron transport layer/electron injection layer/cathode
(10) anode/hole transport layer/electron blocking layer/light-emitting layer/electron transport layer/cathode
(11) anode/hole transport layer/electron blocking layer/light-emitting layer/electron transport layer/electron injection layer/cathode
(12) anode/hole injection layer/hole transport layer/electron blocking layer/light-emitting layer/electron transport layer/cathode
(13) anode/hole injection layer/hole transport layer/electron blocking layer/light-emitting layer/electron transport layer/electron injection layer/cathode
(14) anode/hole injection layer/hole transport layer/electron blocking layer/light-emitting layer/hole blocking layer/electron transport layer/electron injection layer/cathode
(15) anode/hole transport layer/light-emitting layer/hole blocking layer/electron transport layer/cathode
(16) anode/hole transport layer/light-emitting layer/hole blocking layer/electron transport layer/electron injection layer/cathode
(17) anode/hole injection layer/hole transport layer/ light-emitting layer/hole blocking layer/electron transport layer/cathode
(18) anode/hole injection layer/hole transport layer/ light-emitting layer/hole blocking layer/electron transport layer/electron injection layer/cathode
(19) anode/hole injection layer/hole transport layer/electron blocking layer/light-emitting layer/hole blocking layer/electron injection and transport layer/cathode

The organic light-emitting device of this specification may have a structure as shown in FIGS. 1 to 3, although not being limited thereto.

FIG. 1 shows an example of an organic light-emitting device in which a substrate 1, an anode 2, a light-emitting layer 6, and a cathode 10 are stacked sequentially. In such a structure, the compound may be contained in the light-emitting layer 6.

FIG. 2 shows an example of an organic light-emitting device in which a substrate 1, an anode 2, a hole injection layer 3, a hole transport layer 4, an electron blocking layer 5, a light-emitting layer 6, a hole blocking layer 7, an electron transport layer 8, an electron injection layer 9, and a cathode 10 are stacked sequentially. In such a structure, the compound may be contained in the hole injection layer 3, hole transport layer 4, electron blocking layer 5, light-emitting layer 6, hole blocking layer 7, electron transport layer 8, or electron injection layer 9.

FIG. 3 shows an example of an organic light-emitting device in which a substrate 1, an anode 2, a hole injection layer 3, a hole transport layer 4, an electron blocking layer 5, a light-emitting layer 6, a hole blocking layer 7, an electron injection and transport layer 11, and a cathode 10 are stacked sequentially. In such a structure, the compound may be contained in the hole injection layer 3, hole transport layer 4, electron blocking layer 5, light-emitting layer 6, hole blocking layer 7, or electron injection and transport layer 11.

In an exemplary embodiment of the present specification, the hole blocking layer and the light-emitting layer may be provided adjacent to each other. For example, the hole blocking layer and the light-emitting layer may be provided to be in physical contact with each other.

The organic light-emitting device according to this specification can be manufactured with common materials and manufacturing methods for organic light-emitting devices, except that at least one of the organic material layers contains the compound represented by Chemical Formula 1.

When the organic light-emitting device includes a plurality of organic layers, the organic layers may be formed of identical or different materials.

For example, the organic light-emitting device according to this specification can be manufactured by forming an anode by depositing a metal, a conductive metal oxide or an alloy thereof on a substrate by a PVD (physical vapor deposition) method such as sputtering or e-beam evaporation, forming an organic layer including a hole injection layer, a hole transport layer, a light-emitting layer, a hole blocking layer, an electron transport layer, and an electron injection layer thereon, and then depositing a material that can be used as a cathode thereon. In addition to this method, an organic light-emitting device can be manufactured by sequentially depositing a cathode material, an organic layer and an anode material on a substrate.

In addition, when manufacturing an organic light-emitting device, the compound of Chemical Formula 1 can be formed into an organic layer not only by a vacuum deposition method but also by a solution coating method. Here, the solution coating method refers to spin coating, dip coating, doctor blading, inkjet printing, screen printing, spraying, roll coating, etc., although not being limited thereto.

In addition to this method, an organic light-emitting device can also be prepared by sequentially depositing a cathode material, an organic layer and an anode material on a substrate. However, the manufacturing method is not limited thereto.

The anode is an electrode which injects holes and, specifically, a material with a high work function may be used as the anode material for better hole injection into the organic layer. Specific examples of the anode material that can be used in the present disclosure include a metal such as vanadium, chromium, copper, zinc and gold, or an alloy thereof; a metal oxide such as zinc oxide, indium oxide, indium tin oxide (ITO), indium zinc oxide (IZO) ; a combination of a metal and an oxide such as ZnO:Al or SnO₂:Sb; a conductive polymer such as poly(3-methylthiophene), poly[3,4-(ethylene-1,2-dioxy)thiophene] (PEDOT), polypyrrole and polyaniline, although not being limited thereto.

The cathode is an electrode that injects electrons and, specifically, a material with a low work function may be used as the cathode material for better electron injection into the organic layer. Specific examples of the cathode material include a metal such as magnesium, calcium, sodium, potassium, titanium, indium, yttrium, lithium, gadolinium, aluminum, silver, tin and lead, or an alloy thereof; a multi-layer structured material such as LiF/Al, LiO₂/Al, etc., although not being limited thereto.

The hole injection layer is a layer that receives holes from the electrode. Specifically, since a hole injection material has the ability of transporting holes, it has an excellent hole injection effect from the anode to the light-emitting layer or a light-emitting material. Also, a material with excellent ability to prevent the movement of excitons generated in the light-emitting layer to the electron injection layer or an electron injection material is desirable. Also, a material with excellent thin film-forming ability is desirable. Additionally, it is desirable that the HOMO (highest occupied molecular orbital) of the hole injection material is between the work function of the anode material and the HOMO of the surrounding organic layer. Specific examples of the hole injection material include a metal porphyrin, an oligothiophene, an arylamine-based organic material; a hexanitrilehexaazatriphenylene-based organic material; a quinacridone-based organic material; a perylene-based organic material; a polythiophene-based conductive polymer such as anthraquinone and polyaniline, etc., although not being limited thereto.

In an exemplary embodiment of the present specification, the hole injection layer contains a compound represented by Chemical Formula HI-1, although not being limited thereto.

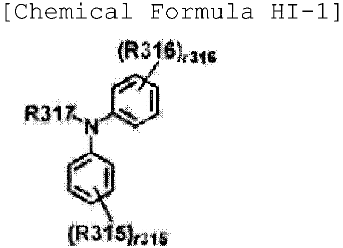

In Chemical Formula HI-1,
each of R315 to R317, which are identical or different, is independently selected from a group consisting of hydrogen; deuterium; a substituted or unsubstituted alkyl group; a substituted or unsubstituted aryl group; a substituted or unsubstituted heteroaryl group; and a combination thereof, or is bonded to an adjacent group to form a substituted or unsubstituted ring,
r315 is an integer from 1 to 5, and two or more R315's are identical or different if r315 is 2 or greater, and
r316 is an integer from 1 to 5, and two or more R316's are identical or different if r316 is 2 or greater.

In an exemplary embodiment of the present specification, R317 is any one selected from a group consisting of a substituted or unsubstituted aryl group; a substituted or unsubstituted heteroaryl group; and a combination thereof.

In an exemplary embodiment of the present specification, R317 is any one selected from a group consisting of a carbazole group; a phenyl group; a biphenyl group; a triphenylene group; and a combination thereof.

In an exemplary embodiment of the present specification, each of R315 and R316, which are identical or different, is independently a substituted or unsubstituted aryl group, or is bonded to an adjacent group to form an aromatic hydrocarbon ring substituted with an alkyl group.

In an exemplary embodiment of the present specification, each of R315 and R316, which are identical or different, is independently a phenyl group or a biphenyl group, or is bonded to an adjacent group to form an indene group substituted with a methyl group.

In an exemplary embodiment of the present specification, Chemical Formula HI-1 is represented by any one of the following compounds.

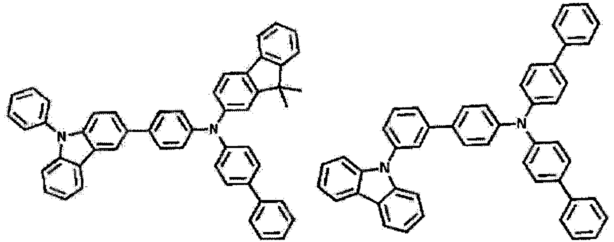

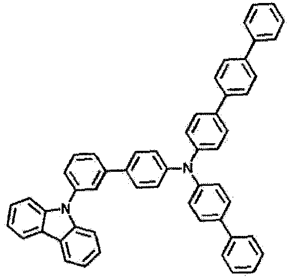

In an exemplary embodiment of the present specification, the hole injection layer contains a compound represented by Chemical Formula HI-2, although not being limited thereto.

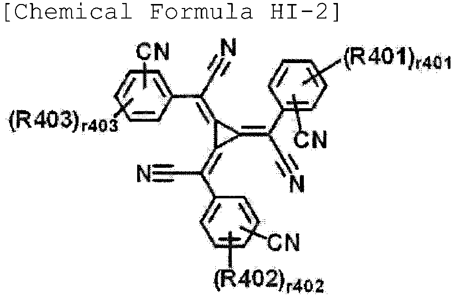

In Chemical Formula HI-2,
each of R401 to R403, which are identical or different, is independently a halogen group, and
r401 to r403 are 4.

In an exemplary embodiment of the present specification, R401 to R403 are F.

In an exemplary embodiment of the present specification, Chemical Formula HI-2 is represented by the following compound.

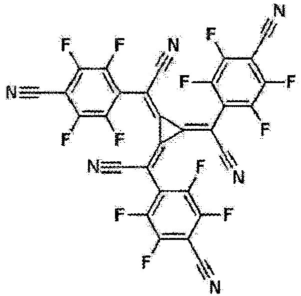

In an exemplary embodiment of the present specification, the hole injection layer contains the compounds represented by Chemical Formulas HI-1 and HI-2.

In an exemplary embodiment of the present specification, the hole injection layer contains the compounds represented by Chemical Formulas HI-1 and HI-2 at a weight ratio of 1:99 to 99:1.

The hole injection layer may have a thickness of 1 nm to 150 nm. If the thickness of the hole injection layer is 1 nm or greater, there is an advantage that the deterioration of hole injection characteristics can be prevented. And, if it is 150 nm or smaller, there is an advantage that the problem of the increase of driving voltage to improve the movement of holes due to the excessively large thickness of the hole injection layer can be prevented.

In an exemplary embodiment of the present specification, the hole injection layer may contain an arylamine compound containing a carbazole group and a p-type dopant. According to an exemplary embodiment, the amine compound may be represented as Het101-L101-N(Ar101) (Ar102), where Het101 is a substituted or unsubstituted carbazole group, L101 is a direct bond or a substituted or unsubstituted arylene group, and each of Ar101 and Ar102, which are identical or different, is independently a substituted or unsubstituted aryl group. The amine compound and the p-type dopant may be contained at an appropriate molar ratio. According to an exemplary embodiment, the amine compound and the p-type dopant may be contained at a molar ratio of 99.9: 0.1 to 90:10.

The hole transport layer is a layer that receives holes from the hole injection layer and transports them to the light-emitting layer. As a hole transport material, a material with high mobility for holes is desirable, which can receive holes from the anode or the hole injection layer and transfer them to the light-emitting layer. Specific examples include an arylamine-based organic material, a conductive polymer, and a block copolymer with both conjugated and non-conjugated segments, although not being limited thereto.

In an exemplary embodiment of the present specification, the hole transport layer may contain an arylamine compound containing a carbazole group.

In an exemplary embodiment of the present specification, the hole transport layer contains the compound represented by Chemical Formula HI-1, although not being limited thereto.

The hole injection and transport layer is a layer that transports holes to the light-emitting layer. The materials exemplified for the hole transport layer and the hole injection layer can be used, although not being limited thereto.

A hole buffer layer may be additionally provided between the hole injection layer and the hole transport layer, and it may contain a hole injection or transport material known in the art.

An electron blocking layer may be provided between the electron transport layer and the light-emitting layer. The compounds described above or materials known in the art may be used in the electronic blocking layer.

The electron blocking layer is a layer that can improve the lifespan and efficiency of a device by preventing electrons injected from the electron injection layer from entering the hole injection layer through the light-emitting layer. Any known material can be used without restriction, and the materials exemplified in the description of the hole injection layer can be used, although not being limited thereto. The electron blocking layer can be formed between the light-emitting layer and the hole transport layer, between the light-emitting layer and the hole injection layer, or between the light-emitting layer and the hole injection and transport layer.

In an exemplary embodiment of the present specification, the electron blocking layer contains a compound represented by Chemical Formula EB-1, although not being limited thereto.

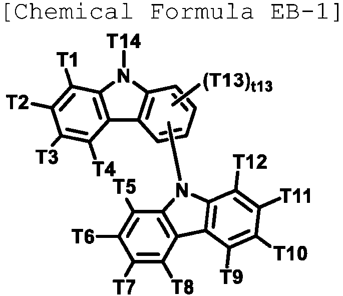

In Chemical Formula EB-1,
each of T1 to T14, which are identical or different, is independently hydrogen; deuterium; a substituted or unsubstituted aryl group; or a substituted or unsubstituted heteroaryl group, and
t13 is an integer from 1 to 3, and two or more t13's are identical or different if t13 is 2 or greater.

In an exemplary embodiment of the present specification, each of T1 to T14, which are identical or different, is independently hydrogen; deuterium; or a monocyclic or polycyclic aryl group having 6 to 30 carbon atoms.

In an exemplary embodiment of the present specification, each of T1 to T14, which are identical or different, is independently hydrogen; deuterium; or a monocyclic or polycyclic aryl group having 6 to 20 carbon atoms.

In an exemplary embodiment of the present specification, each of T1 to T14, which are identical or different, is independently hydrogen; deuterium; a phenyl group; a biphenyl group; or a naphthyl group.

In an exemplary embodiment of the present specification, each of T1 to T13, which are identical or different, is independently hydrogen; or deuterium.

In an exemplary embodiment of the present specification, T14 is a monocyclic or polycyclic aryl group having 6 to 30 carbon atoms.

In an exemplary embodiment of the present specification, T14 is a monocyclic or polycyclic aryl group having 6 to 20 carbon atoms.

In an exemplary embodiment of the present specification, T14 is a phenyl group; a biphenyl group; or a naphthyl group.

In an exemplary embodiment of the present specification, the compound represented by Chemical Formula EB-1 may include the following compound, although not being limited thereto.

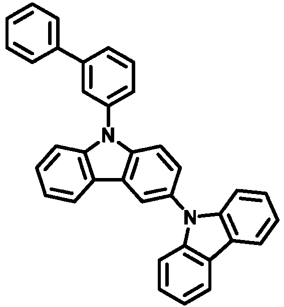

In an exemplary embodiment of the present specification, the compound represented by Chemical Formula EB-1 may also be used as a second host material of the light-emitting layer.

The light-emitting layer can emit red, green or blue light, and can be made of a phosphorescent or fluorescent material. Specifically, a material with good quantum efficiency for fluorescence or phosphorescence, which can emit light in the visible region by receiving holes and electrons from the hole transport layer and the electron transport layer, respectively, and combining them is desirable as a light-emitting material. Specific examples include an 8-hydroxyquinoline aluminum complex (Alq₃); a carbazole-based compound; a dimerized styryl compound; BAlq; a 10-hydroxybenzoquinoline-metal compound; a benzoxazole-, benzothiazole- or benzimidazole-based compound; a poly (p-phenylenevinylene) (PPV)-based polymer; a spiro compound; polyfluorene, rubrene, etc., although not being limited thereto.

The light-emitting layer may contain a host material and a dopant material. When the organic light-emitting device according to an exemplary embodiment of the present specification contains an additional light-emitting layer in addition to the light-emitting layer containing the compound represented by Chemical Formula 1, the host material may include a condensed aromatic ring derivative, a heterocycle-containing compound, etc. Specifically, the condensed aromatic ring derivative includes an anthracene derivative, a pyrene derivative, a naphthalene derivative, a pentacene derivative, a phenanthrene compound, a fluoranthene compound, etc., and the heterocycle-containing compound includes a dibenzofuran derivative, a ladder-type furan compound, a pyrimidine derivative, etc., although not being limited thereto.

The dopant material includes an aromatic amine derivative, a styrylamine compound, a boron complex, a fluoranthene compound, a metal complex, etc. Specifically, the aromatic amine derivative is a condensed aromatic ring derivative having a substituted or unsubstituted arylamine group, and includes pyrene, anthracene, chrysene, periflanthene, etc. having an arylamine group. And, the styrylamine compound is a compound in which at least one arylvinyl group is substituted on a substituted or unsubstituted arylamine. One or more substituent selected from a group consisting of an aryl group, a silyl group, an alkyl group, a cycloalkyl group and an arylamine group is substituted or unsubstituted. Specifically, the styrylamine compound may be styrylamine, styryldiamine, styryltriamine, styryltetramine, etc., although not being limited thereto. And, the metal complex may include an iridium complex, a platinum complex, etc., although not being limited thereto.

The hole blocking layer is a layer that prevents holes from reaching the cathode, and can generally be formed under the same condition as the electron injection layer. When the organic light-emitting device according to an exemplary embodiment of the present specification includes an additional hole blocking layer in addition to the hole blocking layer containing the compound represented by Chemical Formula 1, it may contain specifically an oxadiazole derivative, a triazole derivative, a phenanthroline derivative, an aluminum complex, etc., although not being limited thereto.

A hole blocking layer may be provided between the electron transport layer and the light-emitting layer, and materials known in the art may be used.

In an exemplary embodiment of the present specification, the hole blocking layer may contain a compound containing an N-containing heterocyclic group and a fluorene ring.

The electron transport layer is a layer that receives electrons from the electron injection layer and transports them to the light-emitting layer. As an electron transport material, it is desirable to have a material with high mobility for electrons, which can efficiently receive electrons from the cathode and transfer them to the light-emitting layer. Specific examples include an Al complex of 8-hydroxyquinoline; a complex including Alq₃; an organic radical compound; a hydroxyflavone-metal complex, etc., although not being limited thereto. The electron transport layer can be used together with any desired cathode material, as used in the prior art. In particular, a suitable cathode material is a conventional material having a low work function and followed by an aluminum layer or a silver layer. Specifically, it may be cesium, barium, calcium, ytterbium, samarium, etc., and is followed by an aluminum layer or a silver layer for each case.

The electron transport layer may have a thickness of 1 nm to 50 nm. If the thickness of the electron transport layer is 1 nm or greater, there is an advantage that the deterioration of electron transport characteristics can be prevented. And, if it is 50 nm or smaller, there is an advantage that the problem of the increase of driving voltage to improve the movement of electrons due to the excessively large thickness of the electron transport layer can be prevented.

In an exemplary embodiment of the present specification, the electron transport layer may contain a compound containing two N-containing heterocyclic groups, and may further contain an n-type dopant or an organometallic compound. According to an exemplary embodiment, the n-type dopant or the organometallic compound may be LiQ, and the compound containing two N-containing heterocyclic groups and the n-type dopant (or organometallic compound) may be contained at a weight ratio of 2:8 to 8:2, e.g., 4:6 to 6:4.

The electron injection layer is a layer that receives electrons from the electrode. As an electron injection material, one having excellent electron transport ability, superior effect of receiving electrons from the second electrode, and superior electron injection effect for the light-emitting layer or the light-emitting material is desirable. Additionally, it is desirable that it is a material that prevents excitons generated in the light-emitting layer from moving to the hole injection layer and having excellent thin-film forming ability. Specifically, it may be fluorenone, anthraquinodimethane, diphenoquinone, thiopyran dioxide, oxazole, oxadiazole, triazole, imidazole, perylenetetracarboxylic acid, fluorenylidenemethane, anthrone, etc., derivatives thereof, a metal complex compound, a nitrogen-containing five-membered ring derivative, etc., although not being limited thereto.

The metal complex compound may be 8-hydroxyquinolinatolithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato) (o-cresolato)gallium, bis(2-methyl-8-quinolinato) (1-naphtholato)aluminum, bis(2-methyl-8-quinolinato) (2-naphtholato)gallium, etc., although not being limited thereto.

In an exemplary embodiment of the present specification, the electron injection and transport layer is a layer that transports electrons to the light-emitting layer. The materials exemplified in the electron transport layer and electron injection layer can be used, although not being limited thereto.

In an exemplary embodiment of the present specification, the electron injection and transport layer contains a compound represented by Chemical Formula ET-1, although not being limited thereto.

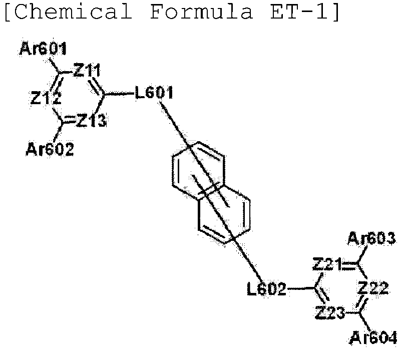

In Chemical Formula ET-1,
at least one of Z11 to Z13 is N, and the rest are CH,
at least one of Z21 to Z23 is N, and the rest are CH,
each of L601 and L602, which are identical or different, is independently a direct bond; a substituted or unsubstituted arylene group; or a substituted or unsubstituted heteroarylene group, and
each of Ar601 to Ar604, which are identical or different, is independently a substituted or unsubstituted aryl group; or a substituted or unsubstituted heteroaryl group.

In an exemplary embodiment of the present specification, each of L601 and L602, which are identical or different, is independently a substituted or unsubstituted monocyclic or polycyclic arylene group having 6 to 30 carbon atoms.

In an exemplary embodiment of the present specification, L601 and L602 are phenylene groups.

In an exemplary embodiment of the present specification, each of Ar601 to Ar604, which are identical or different, is independently a substituted or unsubstituted monocyclic or polycyclic aryl group having 6 to 30 carbon atoms.

In an exemplary embodiment of the present specification, Ar601 to Ar604 are phenyl groups.

In an exemplary embodiment of the present specification, the compound represented by Chemical Formula ET-1 includes the following compound.

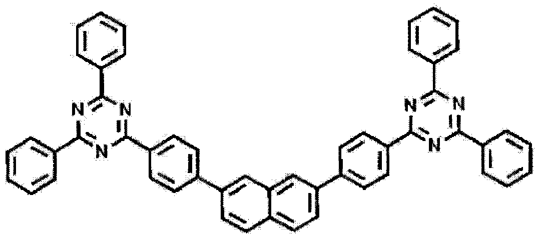

In an exemplary embodiment of the present specification, the electron injection and transport layer may further contain a metal complex compound. The metal complex compound is the same as described above.

The organic light-emitting device according to the present disclosure may be of a front-emission type, a rear-emission type or a double-emission type, depending on the material used.

The organic light-emitting device according to this specification can be included and used in various electronic devices. For example, the electronic device may be a display panel, a touch panel, a solar module, a lighting device, etc., although not being limited thereto.

Hereinafter, the present specification will be explained specifically using examples. However, the examples according to the present specification can be modified into various other forms, and the scope of the present application should not be construed as being limited to the examples described below. The examples of this application are provided to more fully explain this specification to those having ordinary skill in the art.

### [Mode for Invention]

### <Preparation Examples>

### Preparation of compound 1

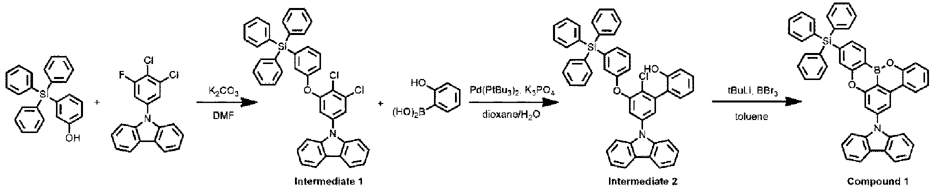

### Synthesis of intermediate 1

Under nitrogen atmosphere, 24 g of 3-(triphenylsilyl) phenol as a starting material, 20 g of 9-(3,4-dichloro-5-fluorophenyl)-9H-carbazole, 17 g of potassium carbonate, and 500 mL of dimethylformamide (DMF) were heated at 160 °C and stirred for 5 hours. After the reaction was completed, the reaction solution was cooled to room temperature, and water and ethyl acetate were added for separation. Then, the reaction solution was filtered by treating with anhydrous MgSO₄. The filtered solution was distilled off under reduced pressure and purified by recrystallization (toluene/hexane) to obtain 28 g of an intermediate 1 (yield 70%, mass [M⁺] = 663).

### Synthesis of intermediate 2

Under nitrogen atmosphere, 28 g of the intermediate 1, 7.0 g of 2-hydroxyphenylboronic acid, 27 g of potassium phosphate, 320 mL of dioxane, and 80 mL of water were added and then 0.4 g of bis(tri-tert-butylphosphine)palladium(0) (Pd(PtBu₃)₂) was added. Then, the mixture was heated at 120 °C and stirred for 8 hours. After the reaction was completed, the reaction mixture was cooled to room temperature, and then water and toluene were added for separation. Then, the reaction mixture was treated with MgSO₄ (anhydrous) and filtered. The filtered solution was distilled off under reduced pressure and purified by recrystallization (toluene/hexane) to obtain 23 g of an intermediate 2 (yield 76%, mass [M⁺] = 721).

### Synthesis of compound 1

In a flask containing 23 g of the intermediate 2 dissolved in 300 mL of toluene (anhydrous) cooled to 0 °C under nitrogen atmosphere, 47 mL of t-butyllithium (1.7 M in hexane) was slowly added, and then the mixture was stirred for 5 hours at 70 °C. When the lithium-halogen exchange reaction was completed, the reaction mixture was cooled again to 0 °C. After slowly adding 9.2 mL of boron tribromide, the reaction mixture was heated to 70 °C and stirred for 10 hours. After the reaction was completed, the reaction mixture was cooled to room temperature, and water and aq. NH₄Cl were added for separation. Then, the reaction mixture was filtered by treating with MgSO₄ (anhydrous). The filtered solution was distilled off under reduced pressure and purified twice by recrystallization (toluene/hexane) to obtain 3.8 g of a compound 1 (yield 17%, mass [M⁺] = 694) .

### Preparation of compound 2

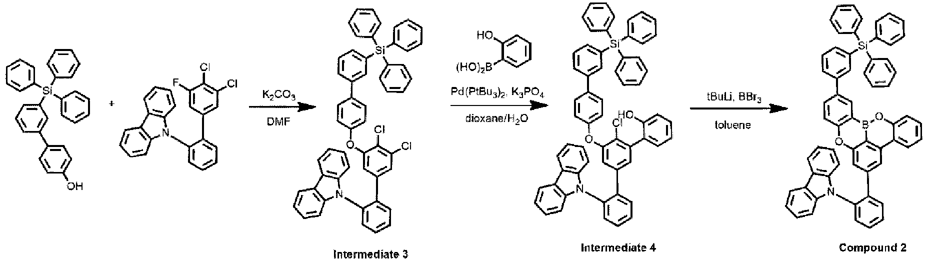

### Synthesis of intermediate 3

23 g of an intermediate 3 was prepared in the same manner as in the preparation of the intermediate 1 in Synthesis Example 1, except that 23 g of 3'-(triphenylsilyl)-[1,1'-biphenyl]-4-ol was used instead of 3-(triphenylsilyl)phenol and 20 g of 9-(3',4'-dichloro-5'-fluoro-[1,1'-biphenyl]-2-yl)-9H-carbazole was used instead of 9-(3,4-dichloro-5-fluorophenyl)-9H-carbazole as the starting materials (yield 57%, mass [M⁺] = 815).

### Synthesis of intermediate 4

18 g of an intermediate 4 was prepared in the same manner as in the preparation of the intermediate 2 in Synthesis Example 1, except that 23 g of the intermediate 3 was used instead of the intermediate 1 (yield 73%, mass [M⁺] = 873).

### Synthesis of compound 2

2.7g of a compound 2 was prepared in the same manner as in the preparation of the compound 1 in Synthesis Example 1, except that 18 g of the intermediate 4 was used instead of the intermediate 2 (yield 15%, mass [M⁺] = 846) .

### Preparation of compound 3

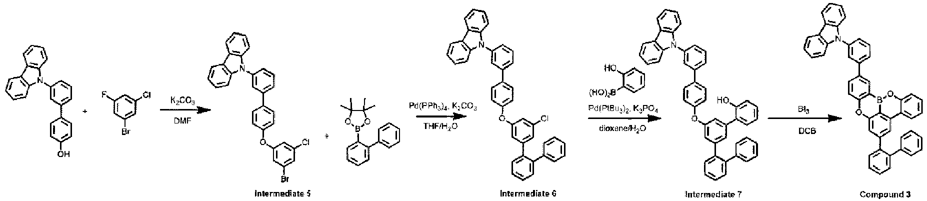

### Synthesis of intermediate 5

28 g of an intermediate 5 was prepared in the same manner as in the preparation of the intermediate 1 in Synthesis Example 1, except that 26 g of 3'-(9H-carbazol-9-yl)-[1,1'-biphenyl]-4-ol was used instead of the 3-(triphenylsilyl)phenol and 15 g of 1-bromo-3-chloro-5-fluorobenzene was used instead of 9-(3,4-dichloro-5-fluorophenyl)-9H-carbazole as starting materials (yield 74%, mass [M⁺] = 525).

### Synthesis of intermediate 6

Under nitrogen atmosphere, 28 g of the intermediate 5, 18 g of
2-([1,1'-biphenyl]-2-yl)-4,4,5,5-tetramethyl-1,3,2-dioxaborola ne, 22 g of potassium carbonate, 400 mL of tetrahydrofuran and 100 mL of water were added. Then, after adding 0.6 g of tetrakis (triphenylphosphine) palladium (0) (Pd(PPh₃)₄), the mixture was heated to 80 °C and stirred for 8 hours. After the reaction was completed, the reaction mixture was cooled to room temperature, and then water and toluene were added for separation. Then, the reaction was treated with MgSO₄ (anhydrous) and filtered. The filtered solution was distilled off under reduced pressure and purified by recrystallization (toluene/hexane) to obtain 22 g of an intermediate 6 (yield 69%, mass [M⁺] = 599).

### Synthesis of intermediate 7

24 g of an intermediate 7 was prepared in the same manner as in the preparation of the intermediate 2 in Synthesis Example 1, except that 22 g of the intermediate 6 was used instead of the intermediate 1 (yield 74%, mass [M⁺] = 656).

### Synthesis of compound 3

Under nitrogen atmosphere, 17 g of boron triiodide was added to a flask containing 15 g of the intermediate 7 dissolved in 500 mL of 1,2-dichlorobenzene (DCB), and then the mixture was stirred at 120 °C for 5 hours. After the reaction was completed, the reaction mixture was cooled to room temperature. The mixture was separated by adding water and a sodium thiosulfate solution, and then filtered by treating with anhydrous MgSO₄. The filtered solution was distilled off under reduced pressure and purified by recrystallization (toluene/hexane) to obtain 4.7 g of a compound 3 (yield 31%, mass [M⁺] = 664).

### Preparation of compound 4

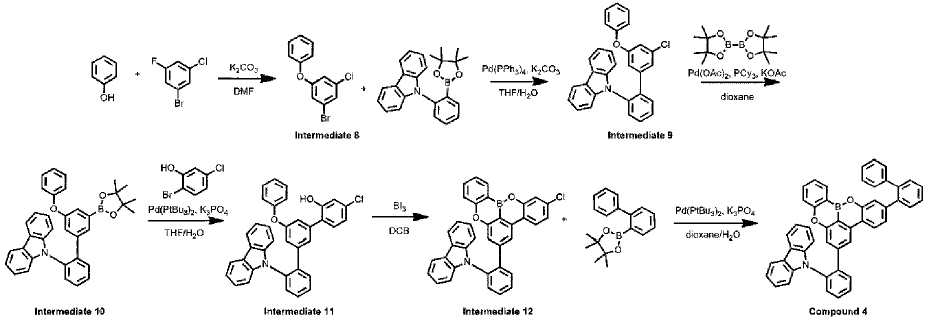

### Synthesis of intermediate 8

21 g of an intermediate 8 was prepared in the same manner as in the preparation of the intermediate 1 in Synthesis Example 1, except that 9.9 g of phenol of was used instead of the 3-(triphenylsilyl)phenol and 20 g of 1-bromo-3-chloro-5-fluorobenzene was used instead of the 9-(3,4-dichloro-5-fluorophenyl)-9H-carbazole as starting materials (yield 78%, mass [M⁺] = 284).

### Synthesis of intermediate 9

23 g of an intermediate 9 was prepared in the same manner as in the preparation of the intermediate 6 in Synthesis Example 3, except that 21 g of the intermediate 8 was used instead of the intermediate 5 and 33 g of 9-(2-(4,4,5,5-tetramethyl-1,3,2-dioxaborolan-2-yl)phenyl)-9H-c arbazole was used instead of the 2-([1,1'-biphenyl]-2-yl)-4,4,5,5-tetramethyl-1,3,2-dioxaborola ne (yield 70%, mass [M⁺] = 446).

### Synthesis of intermediate 10

Under nitrogen atmosphere, 23 g of the intermediate 9, 16 g of 4,4,4',4',5,5,5',5'-octamethyl-2,2'-bi(1,3,2-dioxaborolane), 15 g of potassium acetate and 400 mL of dioxane were added. Then, after adding 0.23 g of palladium acetate(0) (Pd(OAc)₂) and 0.58 g of tricyclohexylphosphine (PCy₃), the mixture was heated to 120 °C and stirred for 12 hours. After the reaction was completed, the reaction mixture was cooled to room temperature, and then water and toluene were added for separation. Then, the reaction was treated with MgSO₄ (anhydrous) and filtered. The filtered solution was distilled off under reduced pressure and purified by recrystallization (toluene/hexane) to obtain 20 g of an intermediate 10 (yield 72%, mass [M⁺] = 538).

### Synthesis of intermediate 11

Under nitrogen atmosphere, 20 g of the intermediate 10, 9.3 g of 2-bromo-5-chlorophenol, 24 g of potassium phosphate, 280 mL of tetrahydrofuran and 70 mL of water were added. Then, after adding 0.19 g of bis(tri-tert-butylphosphine)palladium(0) (Pd(PtBu₃)₂), the mixture was heated to 100 °C and stirred for 6 hours. After the reaction was completed, the reaction mixture was cooled to room temperature, and then water and toluene were added for separation. Then, the reaction was treated with MgSO₄ (anhydrous) and filtered. The filtered solution was distilled off under reduced pressure and purified by recrystallization (toluene/hexane) to obtain 16 g of an intermediate 11 (yield 80%, mass [M⁺] = 539).

### Synthesis of intermediate 12

8.2 g of an intermediate 12 was prepared in the same manner as in the preparation of the compound 3 in Synthesis Example 3, except that 16 g of the intermediate 11 was used instead of the intermediate 7 (yield 51%, mass [M⁺] = 546).

### Synthesis of compound 4

Under nitrogen atmosphere, 4.0 g of the intermediate 12, 2.1 g of 2-([1,1'-biphenyl]-2-yl)-4,4,5,5-tetramethyl-1,3,2-dioxaborola ne, 4.7 g of potassium phosphate, 56 mL of dioxane and 14 mL of water were added. Then, after adding 0.07 g of bis (tri-tert-butylphosphine)palladium (0) (Pd(PtBu₃)₂), the mixture was heated to 130 °C and stirred for 14 hours. After the reaction was completed, the reaction mixture was cooled to room temperature, and then water and toluene were added for separation. Then, the reaction was treated with MgSO₄ (anhydrous) and filtered. The filtered solution was distilled off under reduced pressure and purified by recrystallization (toluene/hexane) to obtain 3.8 g of a compound 4 (yield 78%, mass [M⁺] = 664).

### Preparation of compound 5

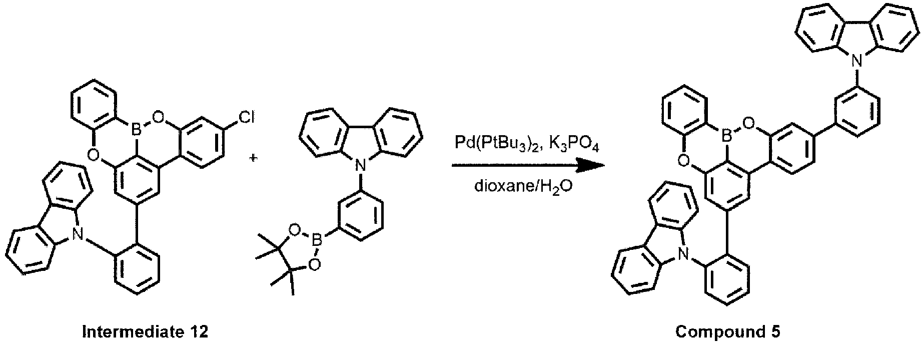

4.1 g of a compound 5 was prepared in the same manner as in the preparation of the compound 4 in Synthesis Example 4, except that 2.8 g of 9-(3-(4,4,5,5-tetramethyl-1,3,2-dioxaborolan-2-yl)phenyl)-9H-c arbazole was used instead of 2-([1,1'-biphenyl]-2-yl)-4,4,5,5-tetramethyl-1,3,2-dioxaborola ne (yield 74%, mass [M⁺] = 753).

### Preparation of compound 6

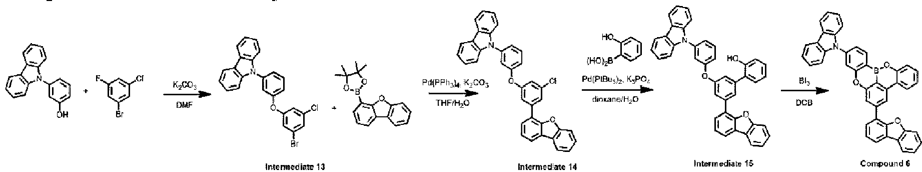

### Synthesis of intermediate 13

25 g of an intermediate 13 was prepared in the same manner as in the preparation of the intermediate 1 in Synthesis Example 1, except that 20 g of 3-(9H-carbazol-9-yl)phenol was used instead of 3-(triphenylsilyl)phenol and 15 g of 1-bromo-3-chloro-5-fluorobenzene was used instead of 9-(3,4-dichloro-5-fluorophenyl)-9H-carbazole as starting materials (yield 78%, mass [M⁺] = 449).

### Synthesis of intermediate 14

23 g of an intermediate 14 was prepared in the same manner as in the preparation of the intermediate 6 in Synthesis Example 3, except that 25 g of the intermediate 13 was used instead of the intermediate 5, and 20 g of 2-(dibenzo[b,d]furan-4-yl)-4,4,5,5-tetramethyl-1,3,2-dioxaboro lane was used instead of 2-([1,1'-biphenyl]-2-yl)-4,4,5,5-tetramethyl-1,3,2-dioxaborola ne (yield 77%, mass [M⁺] = 537).

### Synthesis of intermediate 15

19 g of an intermediate 15 was prepared in the same manner as in the preparation of the intermediate 2 in Synthesis Example 1, except that 23 g of the intermediate 14 was used instead of the intermediate 1 (yield 75%, mass [M⁺] = 594) .

### Synthesis of compound 6

4.2 g of a compound 6 was prepared in the same manner as in the preparation of the compound 3 in Synthesis Example 3, except that 10 g of the intermediate 15 was used instead of the intermediate 7 (yield 41%, mass [M⁺] = 602) .

### Preparation of compound 7

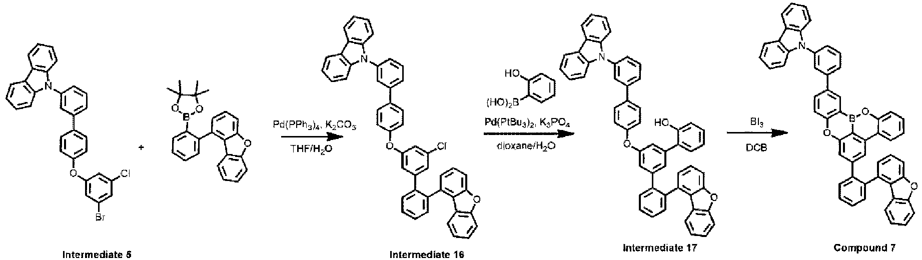

### Synthesis of intermediate 16

10 g of an intermediate 16 was prepared in the same manner as in the preparation of the intermediate 6 in Synthesis Example 3, except that 8.5 g of 2-(2-(dibenzo[b,d]furan-1-yl)phenyl)-4,4,5,5-tetramethyl-1,3,2 -dioxaborolane was used instead of 2-([1,1'-biphenyl]-2-yl)-4,4,5,5-tetramethyl-1,3,2-dioxaborola ne (yield 76%, mass [M⁺] = 689).

### Synthesis of intermediate 17

7.6 g of an intermediate 17 was prepared in the same manner as in the preparation of the intermediate 2 in Synthesis Example 1, except that 10 g of the intermediate 16 was used instead of the intermediate 1 (yield 70%, mass [M⁺] = 746).

### Synthesis of compound 7

3.1 g of a compound 7 was prepared in the same manner as in the preparation of the compound 3 in Synthesis Example 3, except that 7.6 g of the intermediate 17 was used instead of the intermediate 7 (yield 40%, mass [M⁺] = 754).

### Preparation of compound 8

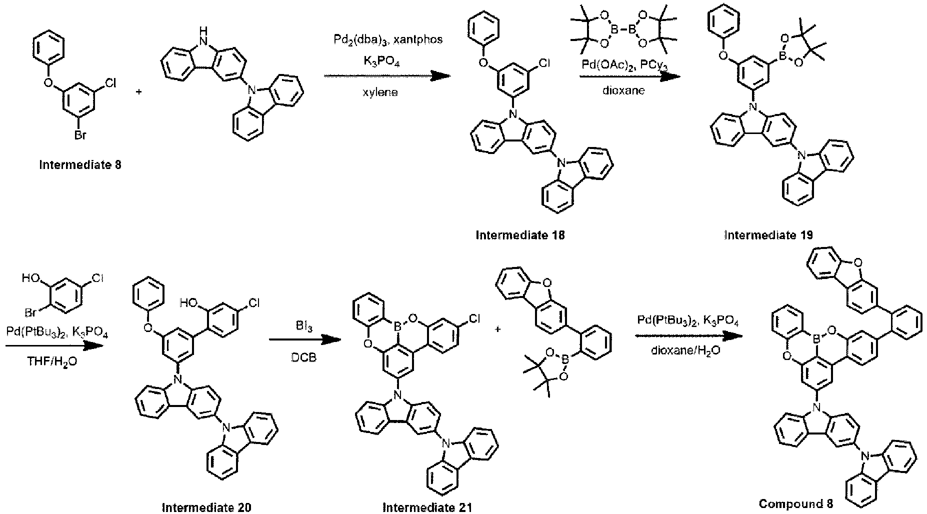

### Synthesis of intermediate 18

Under nitrogen atmosphere, 15 g of the intermediate 8, 21 g of 9H-3,9'-bicarbazole, 34 g of potassium phosphate and 500 mL of xylene were added. Then, after adding 0.97g of tris (dibenzylideneacetone) dipalladium (0) (Pd₂ (dba)₃) and 1.2 g of xantphos, the mixture was heated to 160 °C and stirred for 5 hours. After the reaction was completed, the reaction mixture was cooled to room temperature, and then water and toluene were added for separation. Then, the reaction mixture was filtered by treating with MgSO₄ (anhydrous). The filtered solution was distilled off under reduced pressure and purified by recrystallization (toluene/hexane) to obtain 24 g of an intermediate 18 (yield 85%, mass [M⁺] = 536).

### Synthesis of intermediate 19

21 g of an intermediate 19 was prepared in the same manner as in the preparation of the intermediate 10 in Synthesis Example 4, except that 24 g of the intermediate 18 was used instead of the intermediate 9 (yield 75%, mass [M⁺] = 627)

### Synthesis of intermediate 20

16 g of an intermediate 20 was prepared in the same manner as in the preparation of the intermediate 11 in Synthesis Example 4, except that 21 g of the intermediate 19 was used instead of the intermediate 10 (yield 76%, mass [M⁺] = 628).

### Synthesis of intermediate 21

7.1 g of an intermediate 21 was prepared in the same manner as in the preparation of the compound 3 in Synthesis Example 3, except that 16 g of the intermediate 20 was used instead of the intermediate 7 (yield 44%, mass [M⁺] = 635).

### Synthesis of compound 8

3.5 g of a compound 8 was prepared in the same manner as in the preparation of the compound 4 in Synthesis Example 4, except that 3.5 g of the intermediate 21 was used instead of the intermediate 12, and 2.1 g of the 2-(2-(dibenzo[b,d]furan-3-yl)phenyl)-4,4,5,5-tetramethyl-1,3,2 -dioxaborolane was used instead of 2-([1,1'-biphenyl]-2-yl)-4,4,5,5-tetramethyl-1,3,2-dioxaborola ne (yield 75%, mass [M⁺] = 843).

### Preparation of compound 9

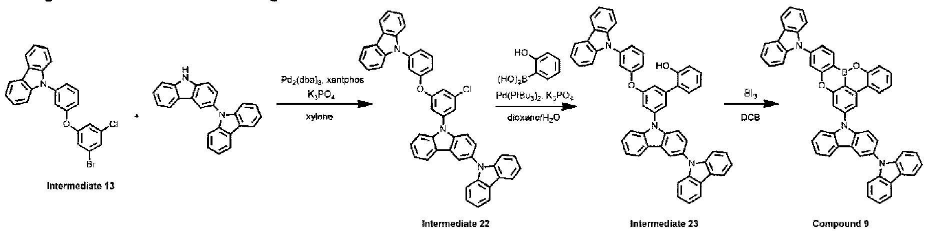

### Synthesis of intermediate 22

26 g of an intermediate 22 was prepared in the same manner as in the preparation of the intermediate 18 in Synthesis Example 8, except that 20 g of the intermediate 13 was used instead of the intermediate 8 (yield 83%, mass [M⁺] = 701) .

### Synthesis of intermediate 23

22 g of an intermediate 23 was prepared in the same manner as in the preparation of the intermediate 2 in Synthesis Example 1, except that 26 g of the intermediate 22 was used instead of the intermediate 1 (yield 78%, mass [M⁺] = 758) .

### Synthesis of compound 9

3.2 g of a compound 9 was prepared in the same manner as in the preparation of the compound 3 in Synthesis Example 3, except that 10 g of the intermediate 23 was used instead of the intermediate 7 (yield 32%, mass [M⁺] = 766) .

### Preparation of compound 10

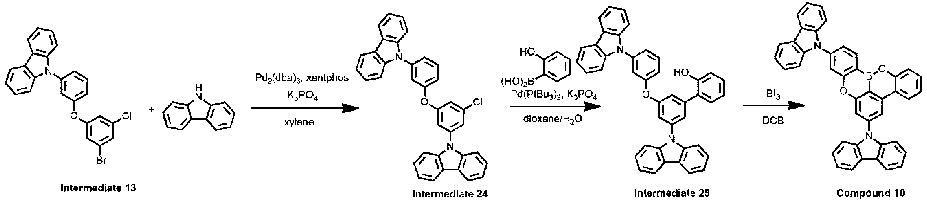

### Synthesis of intermediate 24

20 g of an intermediate 24 was prepared in the same manner as in the preparation of the intermediate 18 in Synthesis Example 8, except that 20 g of the intermediate 13 was used instead of the intermediate 8 and 9.0 g of carbazole was used instead of 9H-3, 9'-bicarbazole (yield 84%, mass [M⁺] = 536).

### Synthesis of intermediate 25

17 g of an intermediate 25 was prepared in the same manner as in the preparation of the intermediate 2 in Synthesis Example 1, except that 20 g of the intermediate 24 was used instead of the intermediate 1 (yield 77%, mass [M⁺] = 593).

### Synthesis of compound 10

4.3 g of a compound 10 was prepared in the same manner as in the preparation of the compound 3 in Synthesis Example 3, except that 10 g of the intermediate 25 was used instead of the intermediate 7 (yield 42%, mass [M⁺] = 601) .

### Preparation of compound 11

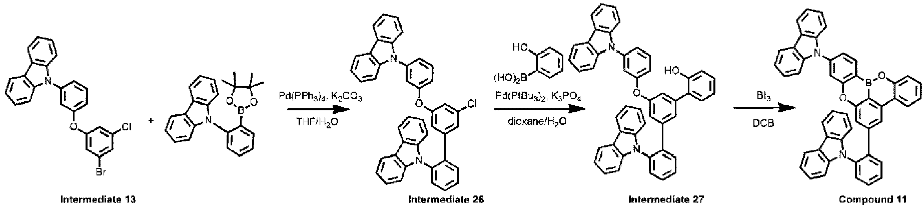

### Synthesis of intermediate 26

21 g of an intermediate 26 was prepared in the same manner as in the preparation of the intermediate 6 in Synthesis Example 3, except that 20 g of the intermediate 13 was used instead of the intermediate 5, and 20 g of 9-(2-(4,4,5,5-tetramethyl-1,3,2-dioxaborolan-2-yl)phenyl)-9H-c arbazole was used instead of 2-([1,1'-biphenyl]-2-yl)-4,4,5,5-tetramethyl-1,3,2-dioxaborola ne (yield 77%, mass [M⁺] = 612).

### Synthesis of intermediate 27

17 g of an intermediate 27 was prepared in the same manner as in the preparation of the intermediate 2 in Synthesis Example 1, except that 21 g of the intermediate 26 was used instead of the intermediate 1 (yield 74%, mass [M⁺] = 669) .

### Synthesis of compound 11

3.8 g of a compound 11 was prepared in the same manner as in the preparation of the compound 3 in Synthesis Example 3, except that 10 g of the intermediate 27 was used instead of the intermediate 7 (yield 38%, mass [M⁺] = 677) .

### Preparation of compound 12

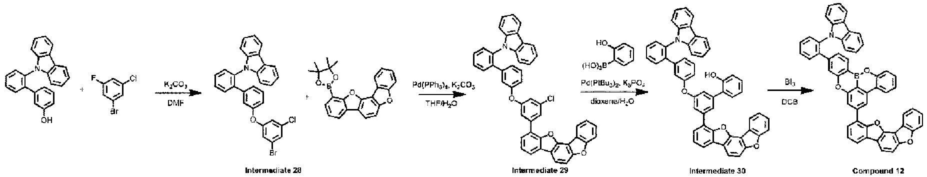

### Synthesis of intermediate 28

19 g of an intermediate 28 was prepared in the same manner as in the preparation of the intermediate 1 in Synthesis Example 1, except that 18 g of 2'-(9H-carbazol-9-yl)-[1,1'-biphenyl]-3-ol was used instead of 3-(tetraphenylsilyl)phenol, and 10 g of 1-bromo-3-chloro-5-fluorobenzene was used instead of 9-(3,4-dichloro-5-fluorophenyl)-9H-carbazole as starting materials (yield 76%, mass [M⁺] = 525).

### Synthesis of intermediate 29

16 g of an intermediate 29 was prepared in the same manner as in the preparation of the intermediate 6 in Synthesis Example 3, except that 19 g of the intermediate 28 was used instead of the intermediate 5, and 17 g of tribenzodifuran-dioxaboralane was used instead of 2-([1,1'-biphenyl]-2-yl)-4,4,5,5-tetramethyl-1,3,2-dioxaborola ne (yield 63%, mass [M⁺] = 703).

### Synthesis of intermediate 30

12 g of an intermediate 30 was prepared in the same manner as in the preparation of the intermediate 2 in Synthesis Example 1, except that 16 g of the intermediate 29 was used instead of the intermediate 1 (yield 69%, mass [M⁺] = 760).

### Synthesis of compound 12

3.1 g of a compound 12 was prepared in the same manner as in the preparation of the compound 3 in Synthesis Example 3, except that 8.0 g of the intermediate 30 was used instead of the intermediate 7 (yield 38%, mass [M⁺] = 768).

### Preparation of compound 13

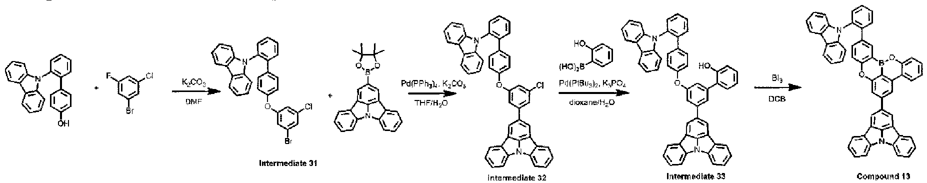

### Synthesis of intermediate 31

28 g of an intermediate 31 was prepared in the same manner as in the preparation of the intermediate 1 in Synthesis Example 1, except that 17 g of 2'-(9H-carbazol-9-yl)-[1,1'-biphenyl-4-ol was used instead of 3-(triphenylsilyl)phenol, and 10 g of 1-bromo-3-chloro-5-fluorobenzene was used instead of 9-(3,4-dichloro-5-fluorophenyl)-9H-carbazole as starting materials (yield 74%, mass [M⁺] = 525).

### Synthesis of intermediate 32

26 g of an intermediate 32 was prepared in the same manner as in the preparation of the intermediate 6 in Synthesis Example 3, except that 28 g of the intermediate 31 was used instead of the intermediate 5, and 24 g of 2-(4,4,5,5-tetramethyl-1,3,2-dioxaborolan-2-yl)indolo[3,2,1-jk ]carbazole was used instead of 2-([1,1'-biphenyl]-2-yl)-4,4,5,5-tetramethyl-1,3,2-dioxaborola ne (yield 71%, mass [M⁺] = 689).

### Synthesis of intermediate 33

20 g of an intermediate 33 was prepared in the same manner as in the preparation of the intermediate 2 in Synthesis Example 1, except that 26 g of the intermediate 32 was used instead of the intermediate 1 (yield 71%, mass [M⁺] = 743).

### Synthesis of compound 13

3.2 g of a compound 13 was prepared in the same manner as in the preparation of the compound 3 in Synthesis Example 3, except that 10 g of the intermediate 33 was used instead of the intermediate 7 (yield 32%, mass [M⁺] = 751) .

### Preparation of compound 14

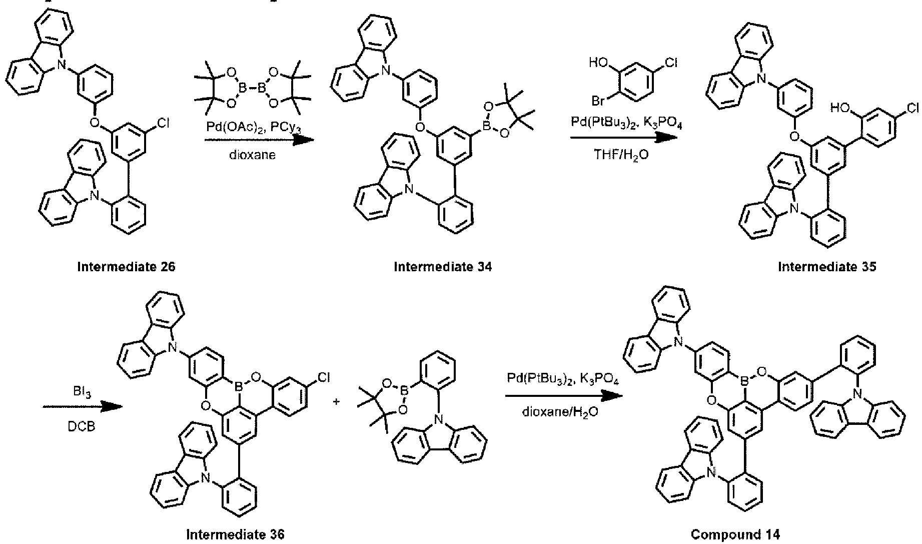

### Synthesis of intermediate 34

16 g of an intermediate 34 was prepared in the same manner as in the preparation of the intermediate 19 in Synthesis Example 8, except that 20 g of the intermediate 26 was used instead of the intermediate 18 (yield 70%, mass [M⁺] = 703).

### Synthesis of intermediate 35

12 g of an intermediate 35 was prepared in the same manner as in the preparation of the intermediate 11 in Synthesis Example 4, except that 16 g of the intermediate 34 was used instead of the intermediate 10 (yield 75%, mass [M⁺] = 704).

### Synthesis of intermediate 36

4.8 g of an intermediate 36 was prepared in the same manner as in the preparation of the compound 3 in Synthesis Example 3, except that 12 g of the intermediate 35 was used instead of the intermediate 7 (yield 40%, mass [M⁺] = 712).

### Synthesis of compound 14

4.3 g of a compound 14 was prepared in the same manner as in the preparation of the compound 4 in Synthesis Example 4, except that 4.8 g of the intermediate 36 was used instead of the intermediate 12, and 2.6 g of 9-(2-(4,4,5,5-tetramethyl-1,3,2-dioxaborolan-2-yl)phenyl)-9H-c arbazole was used instead of 2-([1,1'-biphenyl]-2-yl)-4,4,5,5-tetramethyl-1,3,2-dioxaborola ne (yield 69%, mass [M⁺] = 918).

### Preparation of compound 15

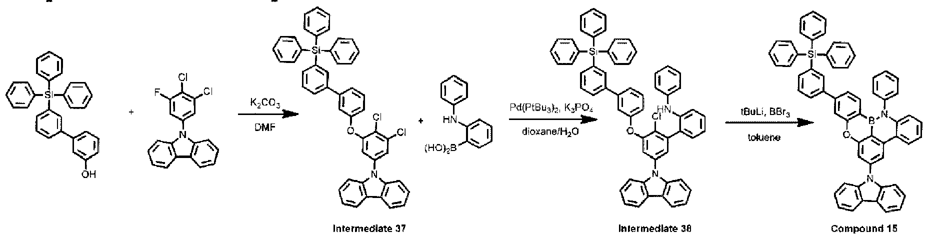

### Synthesis of intermediate 37

16 g of an intermediate 37 was prepared in the same manner as in the preparation of the intermediate 1 in Synthesis Example 1, except that 10 g of 3'-(triphenylsilyl)-[1,1'-biphenyl]-3-ol was used instead of 3-(triphenylsilyl)phenol, and 14 g of 9-(3,4-dichloro-5-fluorophenyl)-9H-carbazole was used instead of 9-(3,4-dichloro-5-fluorophenyl)-9H-carbazole as starting materials (yield 72%, mass [M⁺] = 739).

### Synthesis of intermediate 38

12 g of an intermediate 38 was prepared in the same manner as in the preparation of the intermediate 2 in Synthesis Example 1, except that 16 g of the intermediate 37 was used instead of the intermediate 1, and 5.5 g of 2- (phenylamino) phenylboronic acid was used instead of 2-hydroxyphenylboronic acid (yield 64%, mass [M⁺] = 872).

### Synthesis of compound 15

2.3 g of a compound 15 was prepared in the same manner as in the preparation of the compound 1 in Synthesis Example 1, except that 12 g of the intermediate 38 was used instead of the intermediate 2 (yield 20%, mass [M⁺] = 845) .

### Preparation of compound 16

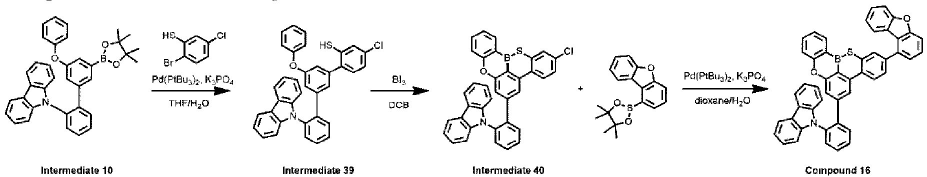

### Synthesis of intermediate 39

10 g of an intermediate 39 was prepared in the same manner as in the preparation of the intermediate 11 in Synthesis Example 4, except that 15 g of the intermediate 10 was used and 7.5 g of 2-bromo-5-chlorobenzenethiol was used instead of 2-bromo-5-chlorophenol (yield 65%, mass [M⁺] = 555).

### Synthesis of intermediate 40

3.5 g of an intermediate 40 was prepared in the same manner as in the preparation of the compound 3 in Synthesis Example 3, except that 10 g of the intermediate 39 was used instead of intermediate 7 (yield 35%, mass [M⁺] = 562).

### Synthesis of compound 16

3.4 g of a compound 16 was prepared in the same manner as in the preparation of the compound 4 in Synthesis Example 4, except that 3.5 g of the intermediate 40 was used instead of the intermediate 12, and 1.9 g of 2-(dibenzo[b,d]furan-1-yl)-4,4,5,5-tetramethyl-1,3,2-dioxaboro lane was used instead of 2-([1,1'-biphenyl]-2-yl)-4,4,5,5-tetramethyl-1,3,2-dioxaborola ne (yield 79%, mass [M⁺] = 694).

### Preparation of compound 17

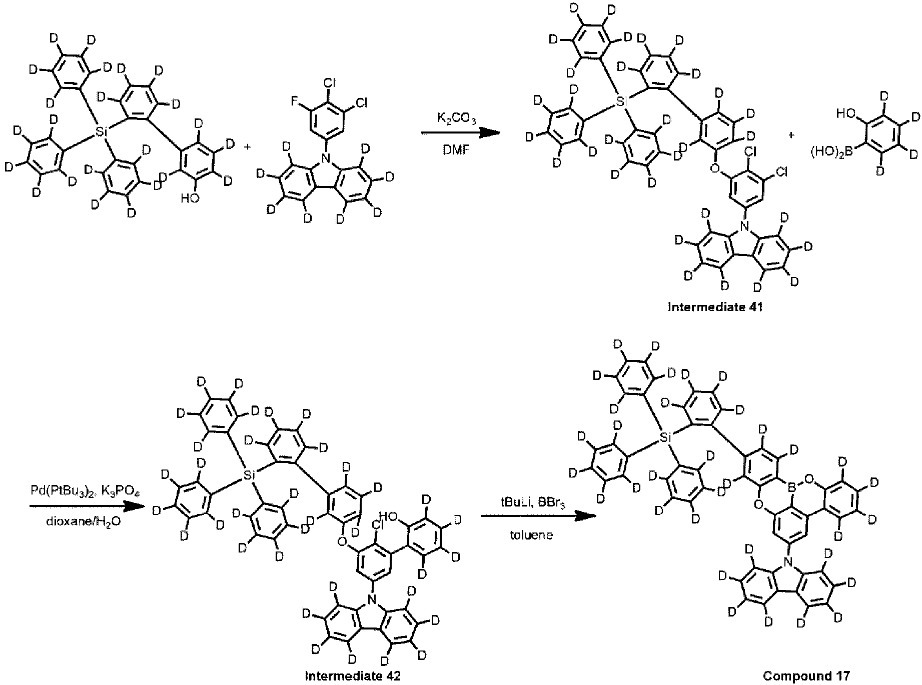

### Synthesis of intermediate 41

16 g of an intermediate 41 was prepared in the same manner as in the preparation of the intermediate 1 in Synthesis Example 1, except that 15 g of 2'-(tris(phenyl-d5)silyl)-[1,1'-biphenyl]-2,3',4,4',5,5',6,6'-d8-3-ol was used instead of 3-(triphenylsilyl)phenol, and 10 g of 9-(3,4-dichloro-5-fluorophenyl)-9H-carbazole-1,2,3,4,5,6,7,8-d 8 was used instead of 9-(3,4-dichloro-5-fluorophenyl)-9H-carbazole as starting materials (yield 70%, mass [M⁺] = 770).

### Synthesis of intermediate 42

13 g of an intermediate 42 was prepared in the same manner as in the preparation of the intermediate 2 in Synthesis Example 1, except that 16 g of the intermediate 41 was used instead of the intermediate 1 (yield 75%, mass [M⁺] = 832).

### Synthesis of compound 17

2.2 g of a compound 17 was prepared in the same manner as in the preparation of the compound 1 in Synthesis Example 1, except that 13 g of the intermediate 42 was used instead of the intermediate 2 (yield 18%, mass [M⁺] = 804).

### Preparation of compound 18

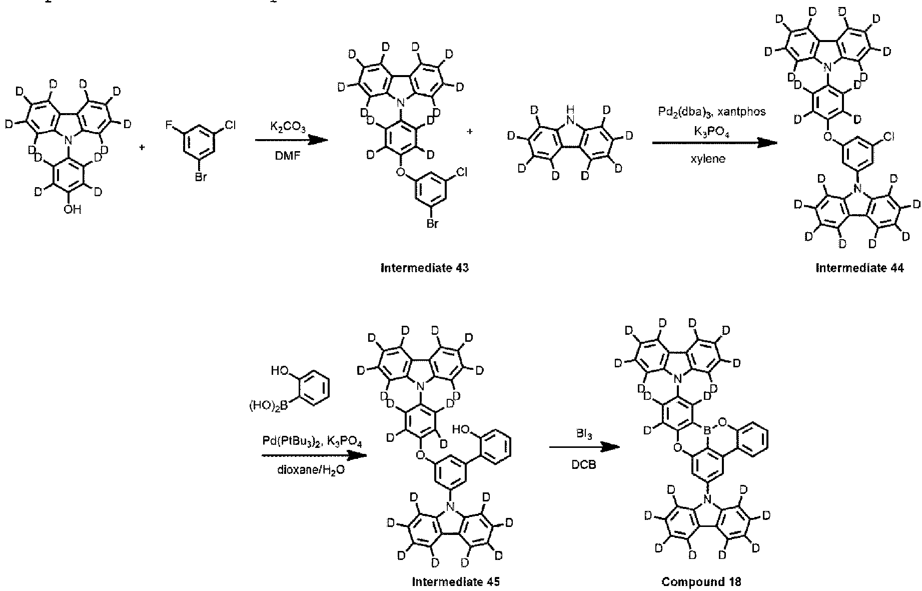

### Synthesis of intermediate 43

18 g of an intermediate 43 was prepared in the same manner as in the preparation of the intermediate 1 in Synthesis Example 1, except that 14 g of 4-(9H-carbazol-9-yl-d8)phen-2,3,5,6-d4-ol was used instead of 3-(triphenylsilyl)phenol, and 10 g of 1-bromo-3-chloro-5-fluorobenzene was used instead of 9-(3,4-dichloro-5-fluorophenyl)-9H-carbazole as starting materials (yield 82%, mass [M⁺] = 461).

### Synthesis of intermediate 44

17 g of an intermediate 44 was prepared in the same manner as in the preparation of the intermediate 18 in Synthesis Example 8, except that 18 g of the intermediate 43 was used instead of the intermediate 8, and 8.2 g of 9H-carbazole-1, 2, 3, 4, 5, 6, 7, 8-d8 was used instead of 9H-3, 9'-bicarbazole (yield 78%, mass [M⁺] = 556).

### Synthesis of intermediate 45

13 g of an intermediate 45 was prepared in the same manner as in the preparation of the intermediate 2 in Synthesis Example 1, except that 18 g of the intermediate 44 was used instead of the intermediate 1 (yield 69%, mass [M⁺] = 613).

### Synthesis of compound 18

3.5 g of a compound 18 was prepared in the same manner as in the preparation of the compound 3 in Synthesis Example 3, except that 8.0 g of the intermediate 45 was used instead of the intermediate 7 (yield 43%, mass [M⁺] = 620).

### Preparation of compound 19

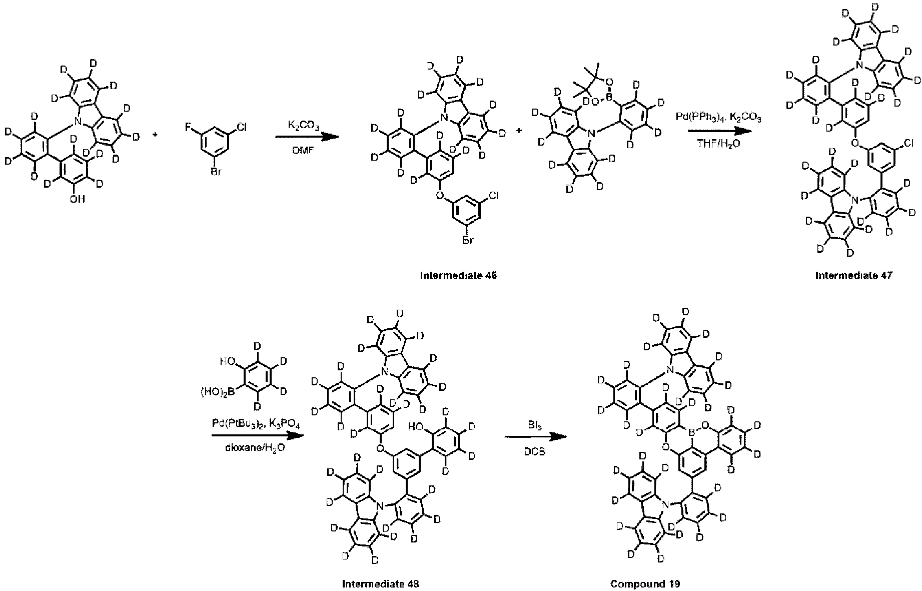

### Synthesis of intermediate 46

20 g of an intermediate 46 was prepared in the same manner as in the preparation of the intermediate 1 in Synthesis Example 1, except that 18 g of 2'-(9H-carbazol-9-yl-d8)-[1,1'-biphenyl]-2,3',4,4',5,5',6,6'-d 8-3-ol was used instead of 3-(triphenylsilyl)phenol, and 10 g of 1-bromo-3-chloro-5-fluorobenzene was used instead of 9-(3,4-dichloro-5-fluorophenyl)-9H-carbazole as starting materials (yield 78%, mass [M⁺] = 540).

### Synthesis of intermediate 47

20 g of an intermediate 47 was prepared in the same manner as in the preparation of the intermediate 6 in Synthesis Example 3, except that 20 g of the intermediate 46 was used instead of the intermediate 5, and 17 g of 9-(2-(4,4,5,5-tetramethyl-1,3,2-dioxaborolan-2-yl)phenyl-3,4,5 ,6-d4)-9H-carbazole-1,2,3,4,5,6,7,8-d8 was used instead of 2-([1,1'-biphenyl]-2-yl)-4,4,5,5-tetramethyl-1,3,2-dioxaborola ne (yield 76%, mass [M⁺] = 715).

### Synthesis of intermediate 48

16 g of an intermediate 48 was prepared in the same manner as in the preparation of the intermediate 2 in Synthesis Example 1, except that 20 g of the intermediate 47 was used instead of the intermediate 1 (yield 74%, mass [M⁺] = 777).

### Synthesis of compound 19

3.6 g of a compound 19 was prepared in the same manner as in the preparation of the compound 3 in Synthesis Example 3, except that 8.0 g of the intermediate 48 was used instead of the intermediate 7 (yield 45%, mass [M⁺] = 784).

### Preparation of compound 20

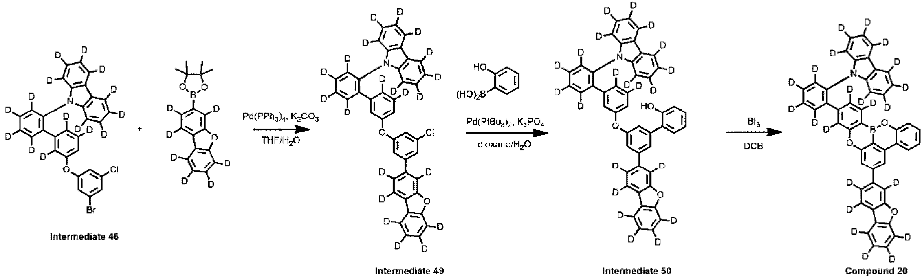

### Synthesis of intermediate 49

13 g of an intermediate 49 was prepared in the same manner as in the preparation of the intermediate 6 in Synthesis Example 3, except that 15 g of the intermediate 46 was used instead of the intermediate 5, and 10 g of 2-(dibenzo[b,d]furan-3-yl-d7)-4,4,5,5-tetramethyl-1,3,2-dioxab orolane was used instead of 2-([1,1'-biphenyl]-2-yl)-4,4,5,5-tetramethyl-1,3,2-dioxaborola ne (yield 74%, mass [M⁺] = 635).

### Synthesis of intermediate 50

11 g of an intermediate 50 was prepared in the same manner as in the preparation of the intermediate 2 in Synthesis Example 1, except that 13 g of the intermediate 49 was used instead of the intermediate 1 (yield 78%, mass [M⁺] = 692).

### Synthesis of compound 20

4.4 g of a compound 20 was prepared in the same manner as in the preparation of the compound 3 in Synthesis Example 3, except that 11 g of the intermediate 50 was used instead of the intermediate 7 (yield 40%, mass [M⁺] = 700).

### <Examples and Comparative Examples>

### Example 1

A glass substrate coated with ITO (indium tin oxide) thin film to a thickness of 800 Å was placed in distilled water in which a detergent was dissolved and cleaned using ultrasound. The detergent was acquired from Fischer Co., and the distilled water was distilled water obtained by filtering twice with a filter available from Millipore Co. The ITO was washed for 30 minutes and then subjected to ultrasonic cleaning twice repeatedly for 10 minutes using distilled water. After washing with distilled water, followed by ultrasonic cleaning using isopropyl alcohol, acetone and methanol as solvents, the substrate was transported to a plasma cleaner. And, the substrate was transported to a vacuum evaporator after cleaning for 5 minutes using oxygen plasma.

A hole injection layer was formed by thermally vacuum-depositing a compound represented by Chemical Formula HT1 and a compound represented by Chemical Formula HI1 at a molar ratio of 95:5 on the prepared transparent ITO electrode to a thickness of 100 Å. A hole transport layer was formed by vacuum-depositing the compound HT1 (300 Å) on the hole injection layer. Subsequently, an electron blocking layer was formed by vacuum-depositing a compound represented by Chemical Formula BH (p-type) to a film thickness of 50 Å on the hole transport layer. Subsequently, a light-emitting layer was formed by vacuum-depositing a mixture of the compound represented by Chemical Formula BH (p-type) and the compound 1 (n-type) synthesized in Preparation Example 1 at a 1:1 ratio as a host of the light-emitting layer and the compound represented by Chemical Formula BD as a dopant of the light-emitting layer, at a weight ratio of 86:14 on the electron blocking layer. A hole blocking layer was formed by vacuum-depositing the compound 1 (n-type) synthesized in Preparation Example 1 on the light-emitting layer to a film thickness of 50 Å. Subsequently, an electron injection and transport layer was formed by vacuum-depositing a compound represented by Chemical Formula ET1 and a compound represented by Chemical Formula LiQ at a weight ratio of 1:1 on the hole blocking layer to a thickness of 300 Å. A cathode was formed by sequentially depositing lithium fluoride (LiF) to a thickness of 10 Å and aluminum to a thickness of 800 Å on the electron injection and transport layer. 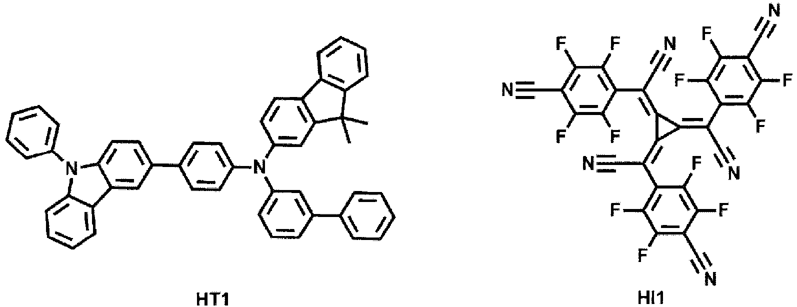 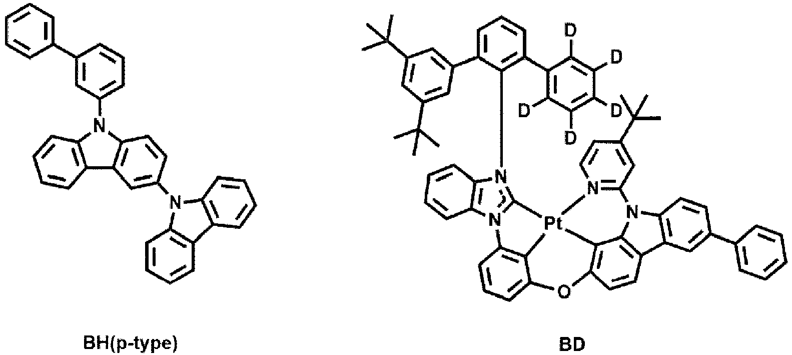 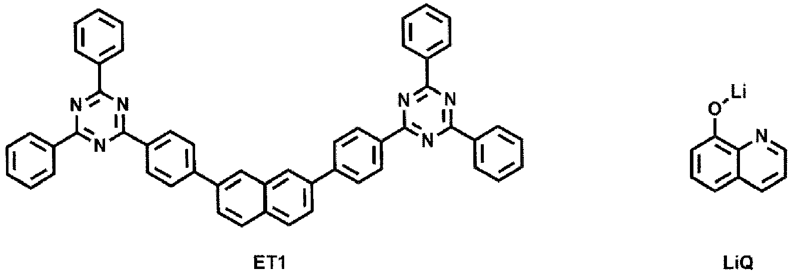 The deposition rate of the organic materials was maintained at 0.4-0.7 Å/sec, the deposition rate of the lithium fluoride for the cathode at 0.3 Å/sec, and the deposition rate of the aluminum at 2 Å/sec. An organic light-emitting device was manufactured by maintaining the degree of vacuum during the deposition at 2x10⁻⁷ to 5x10⁻⁶ torr.

### Examples 2 to 20

Organic light-emitting devices were manufactured in the same manner as in Example 1, except that the compounds listed in Table 1 were used instead of the compound 1 as the host of the light-emitting layer.

### Examples 21 and 22

Organic light-emitting devices were manufactured in the same manner as in Example 1, except that the compounds listed in Table 1 were used instead of the compound 1 as the host of the light-emitting layer, and the compound 10 was used for the hole blocking layer instead of the compound 1.

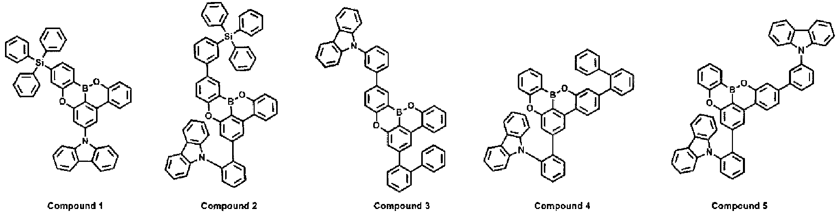

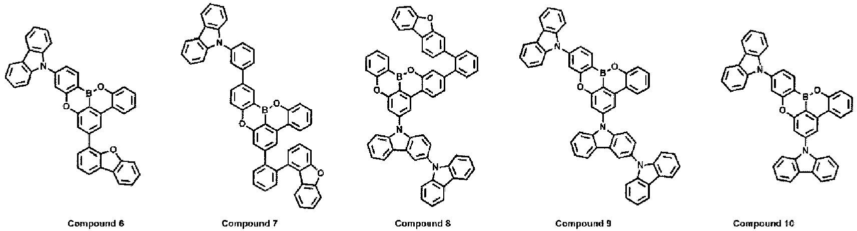

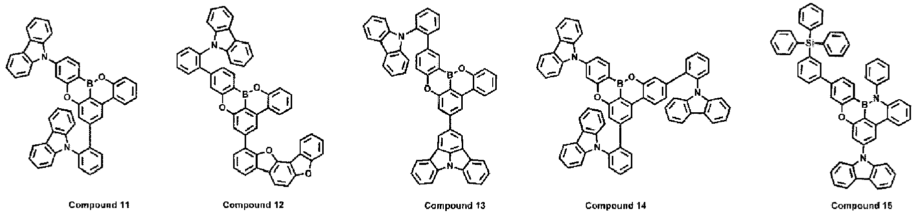

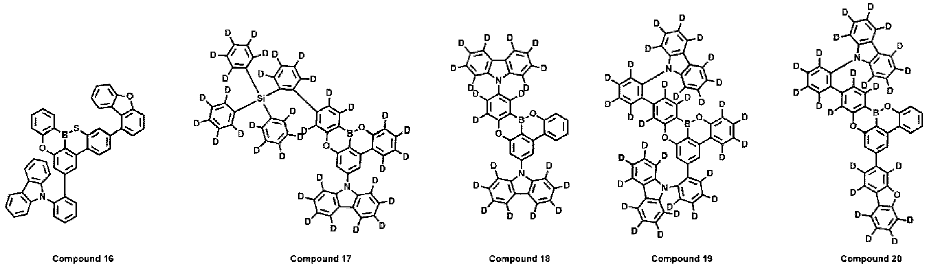

### Comparative Examples 1 to 5

Organic light-emitting devices were manufactured in the same manner as in Example 1, except that the compounds listed in Table 1 were used instead of the compound 1 as the host of the light-emitting layer.

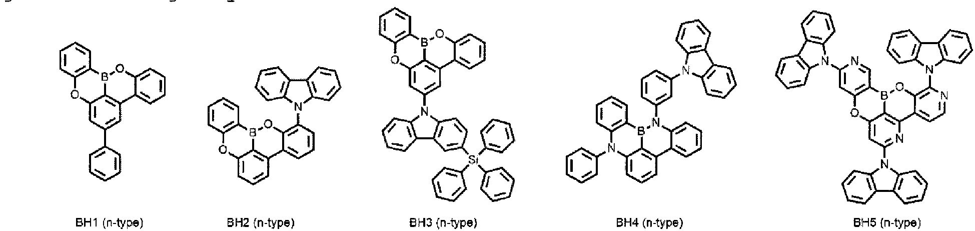

After applying current to the organic light-emitting devices manufactured in Examples 1 to 20 and Comparative Examples 1 to 5, voltage, efficiency and lifespan were measured (based on 1600 nit), and the results are shown in Table 1. The lifespan T90 refers to the time it takes for the brightness to decrease to 90% from the initial brightness (1600 nit).

**[Table 1]**

| | Host compound | Voltage (V) @ 10 mA/ cm² | Luminous efficiency (Cd/A) @ 10 mA/cm² | Lifespan, T90 (h) |
|---|---|---|---|---|
| Example 1 | Compound 1 | 3.90 | 22.3 | 114 |
| Example 2 | Compound 2 | 3.85 | 23.4 | 123 |
| Example 3 | Compound 3 | 3.87 | 23.0 | 119 |
| Example 4 | Compound 4 | 3.88 | 23.2 | 121 |
| Example 5 | Compound 5 | 3.81 | 22.5 | 125 |
| Example 6 | Compound 6 | 3.87 | 23.4 | 128 |
| Example 7 | Compound 7 | 3.87 | 22.7 | 126 |
| Example 8 | Compound 8 | 3.85 | 23.2 | 124 |
| Example 9 | Compound 9 | 3.85 | 23.4 | 122 |
| Example 10 | Compound 10 | 3.81 | 23.8 | 133 |
| Example 11 | Compound 11 | 3.83 | 24.0 | 129 |
| Example 12 | Compound 12 | 3.87 | 22.5 | 120 |
| Example 13 | Compound 13 | 3.81 | 22.1 | 123 |
| Example 14 | Compound 14 | 3.81 | 24.4 | 127 |
| Example 15 | Compound 15 | 3.90 | 23.0 | 119 |
| Example 16 | Compound 16 | 3.87 | 22.7 | 116 |
| Example 17 | Compound 17 | 3.83 | 23.4 | 136 |
| Example 18 | Compound 18 | 3.81 | 24.7 | 149 |
| Example 19 | Compound 19 | 3.83 | 24.2 | 160 |
| Example 20 | Compound 20 | 3.85 | 23.8 | 155 |
| Example 21 | Compound 4 | 3.85 | 23.4 | 125 |
| Example 22 | Compound 15 | 3.87 | 23.2 | 122 |
| Comparative Example 1 | BH1 | 4.22 | 15.5 | 84 |
| Comparative Example 2 | BH2 | 4.10 | 20.2 | 102 |
| Comparative Example 3 | BH3 | 4.14 | 18.7 | 93 |
| Comparative Example 4 | BH4 | 4.18 | 17.7 | 99 |
| Comparative Example 5 | BH5 | 4.47 | 11.2 | 32 |

Comparative Example 1 showed significantly deteriorated voltage, efficiency and lifespan as compared to Examples 1 to 20, since the benzene ring contained in the core structure of the compound BH1 used was not substituted with a carbazole group and a silyl or aryl group.

Comparative Example 2, wherein the compound BH2 used was substituted only with a carbazole group on the benzene ring contained in the core structure, could achieve high efficiency and long lifespan, but it exhibited higher voltage as compared to Examples 1 to 20.

Comparative Example 3, wherein the compound BH3 used was substituted only with a carbazole group on the benzene ring contained in the core structure and a silyl group was substituted on the carbazole group, showed significantly deteriorated voltage, efficiency and lifespan as compared to Examples 1 to 20.

Comparative Examples 4 and 5, wherein the compounds BH4 and BH5 used had different core structures, showed significantly deteriorated voltage, efficiency and lifespan as compared to Examples 1 to 20.

### [Detailed Description of Main Elements]

- 1:: Substrate
- 2:: Anode
- 3:: Hole injection layer
- 4:: Hole transport layer
- 5:: Electronic blocking layer
- 6:: Light-emitting layer
- 7:: Hole blocking layer
- 8:: Electron transport layer
- 9:: Electron injection layer
- 10:: Cathode
- 11:: Electron injection and transport layer

## Claims

1. A compound represented by Chemical Formula 1: 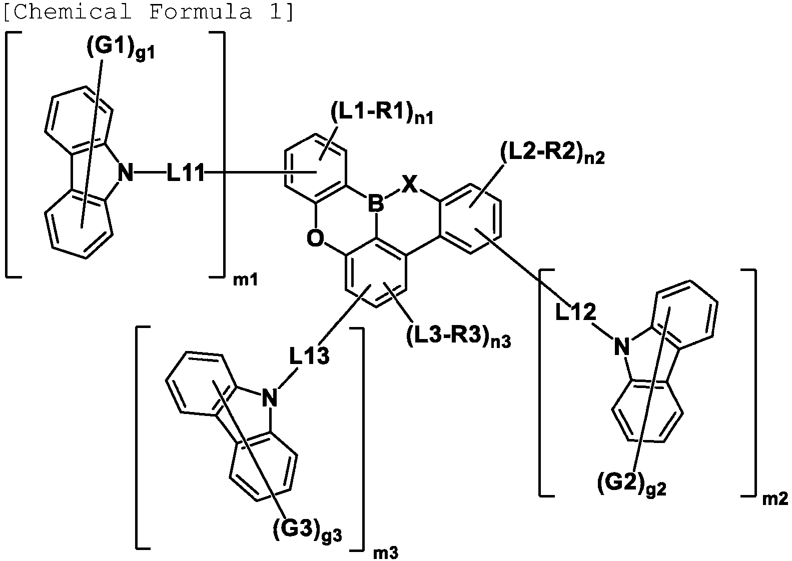 wherein
X is NR; O; or S,
at least one of R and R1 to R3 is a substituted or unsubstituted silyl group; a substituted or unsubstituted aryl group; or a substituted or unsubstituted heterocyclic group, and each of the rest, which are identical or different, is independently hydrogen; deuterium; a halogen group; a nitrile group; a substituted or unsubstituted alkyl group; or a substituted or unsubstituted cycloalkyl group,
each of L1 to L3 and L11 to L13, which are identical or different, is independently a direct bond; a substituted or unsubstituted arylene group; or a substituted or unsubstituted divalent heterocyclic group,
each of G1 to G3, which are identical or different, is independently hydrogen; deuterium; a halogen group; a nitrile group; a substituted or unsubstituted silyl group; a substituted or unsubstituted alkyl group; a substituted or unsubstituted cycloalkyl group; a substituted or unsubstituted aryl group; or a substituted or unsubstituted heterocyclic group,
each of n1 and n2 is an integer from 1 to 4, and each of m1 and m2 is an integer from 0 to 4,
n3 is an integer from 1 to 3, and m3 is an integer from 0 to 3,
each of g1 to g3 is an integer from 0 to 8,
the substituents within the parentheses are identical or different if each of n1 to n3, m1 to m3, and g1 to g3 is 2 or greater,
n1 + m1 is 4 or smaller, n2 + m2 is 4 or smaller, and n3 + m3 is 3 or smaller, and
m1 + m2 + m3 is an integer which is 1 or greater.

2. The compound according to claim 1, wherein each of L1 to L3 and L11 to L13, which are identical or different, is independently a direct bond; an arylene group; or a divalent heterocyclic group.

3. The compound according to claim 1, wherein at least one of R1 to R3 is a silyl group substituted or unsubstituted with deuterium, an alkyl group, or an aryl group; an aryl group substituted or unsubstituted with deuterium or an aryl group; or a heterocyclic group substituted or unsubstituted with deuterium or a heterocyclic group, and each of the rest, which are identical or different, is independently hydrogen; or deuterium.

4. The compound according to claim 1, wherein m1 + m2 + m3 is 1 or 2.

5. The compound according to claim 1, wherein Chemical Formula 1 is represented by any one of Chemical Formulas 1-A-1 to 1-A-3: 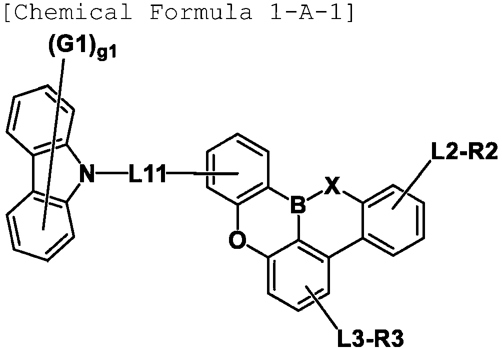 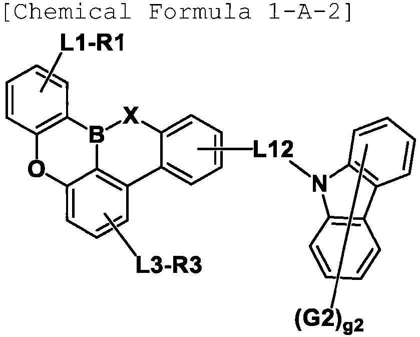 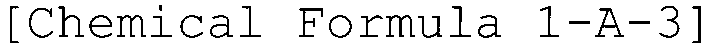 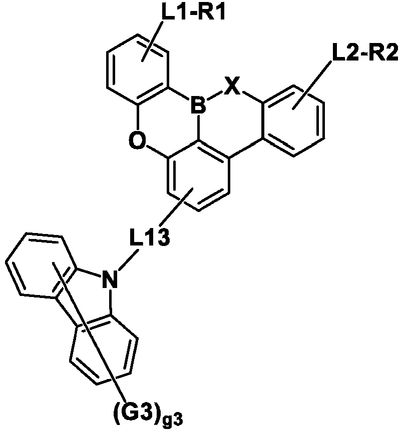 wherein
X, R1 to R3, L1 to L3, L11 to L13, G1 to G3, and g1 to g3 are the same as defined in Chemical Formula 1.

6. The compound according to claim 1, wherein Chemical Formula 1 is represented by any one of Chemical Formulas 1-B-1 to 1-B-3: 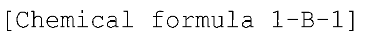 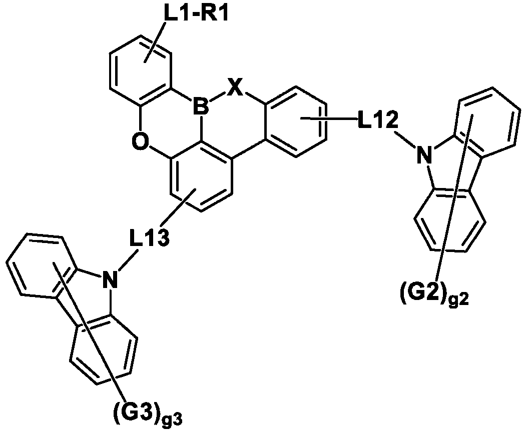 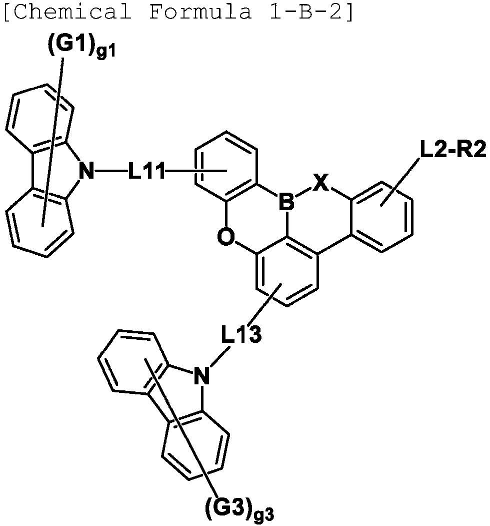 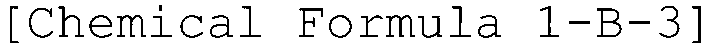 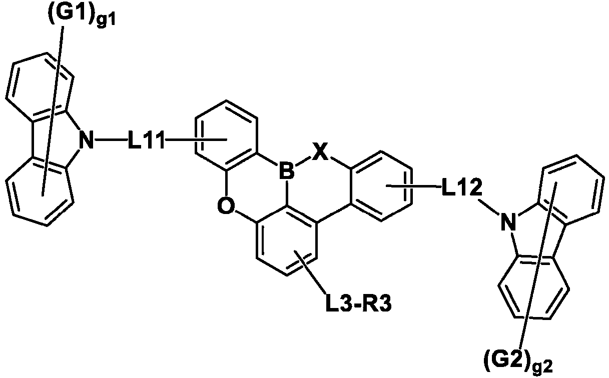 wherein
X, R1 to R3, L1 to L3, L11 to L13, G1 to G3, and g1 to g3 are the same as defined in Chemical Formula 1.

7. The compound according to claim 1, wherein
at least one of R1 to R3 is a triphenylsilyl group; a phenyl group; a biphenyl group; a carbazole group; a dibenzofuran group; a dibenzothiophene group; a benzofuranodibenzofuran group; or an indolocarbazole group, and each of the rest, which are identical or different, is independently hydrogen; or deuterium,
each of L1 to L3 and L11 to L13, which are identical or different, is independently a direct bond; or a phenylene group, and
each of G1 to G3, which are identical or different, is independently hydrogen; or deuterium.

8. The compound according to claim 1, wherein Chemical Formula 1 is represented by any one of the following compounds: 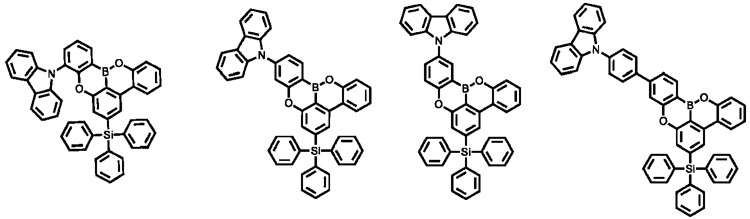 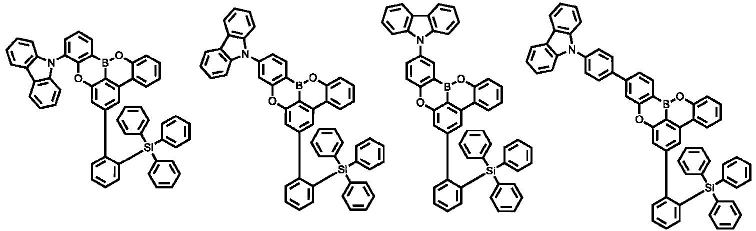 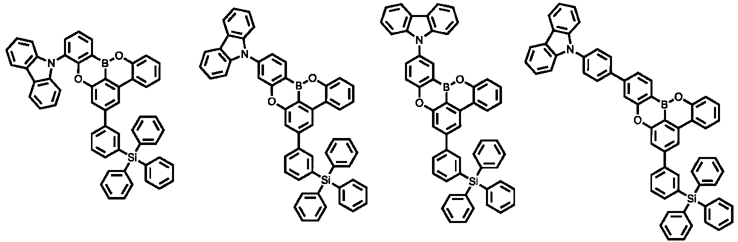 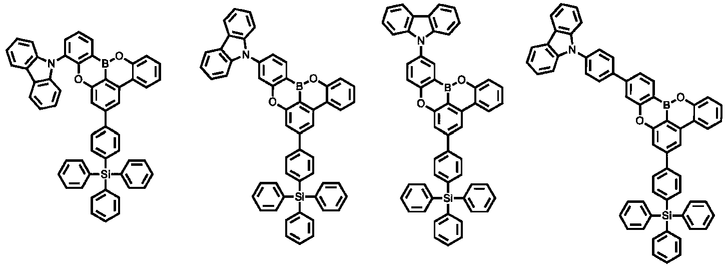 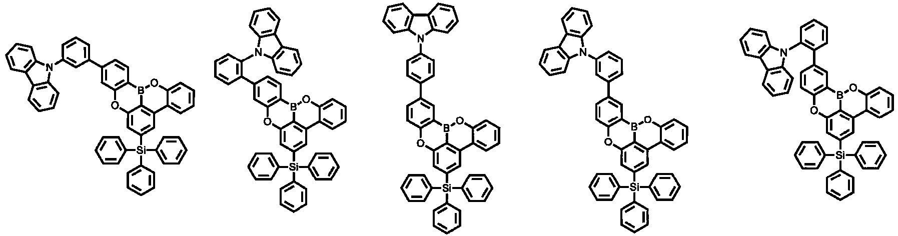 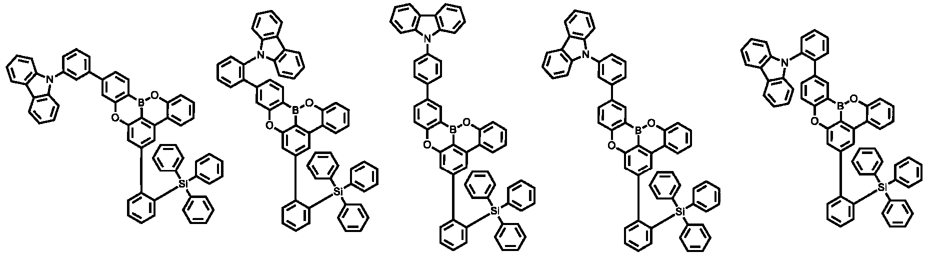 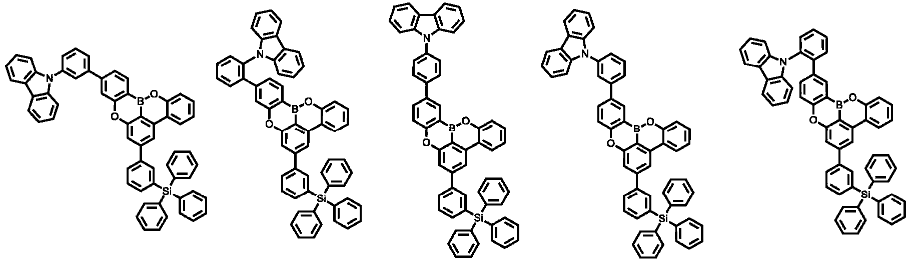 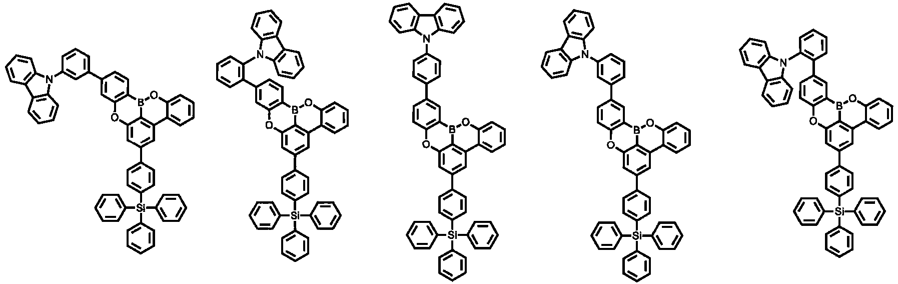 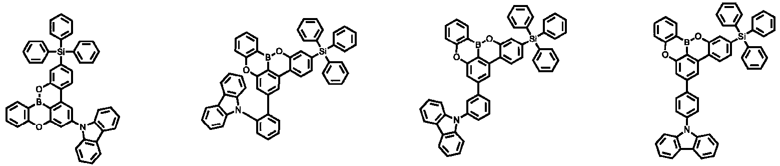 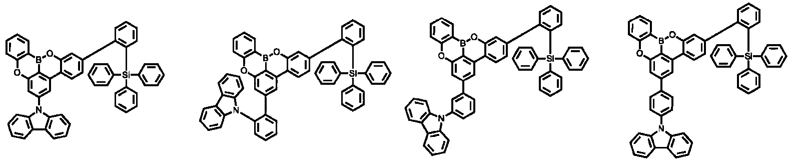 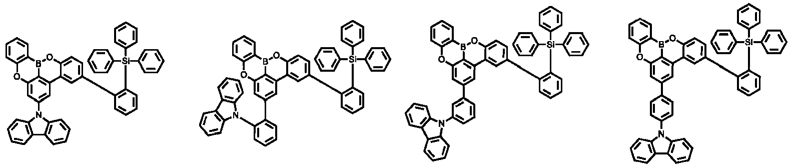 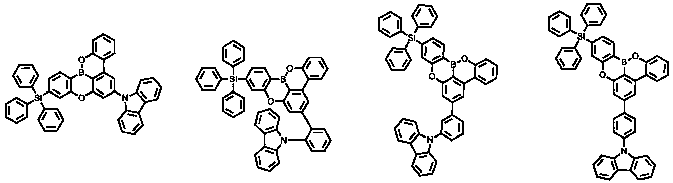 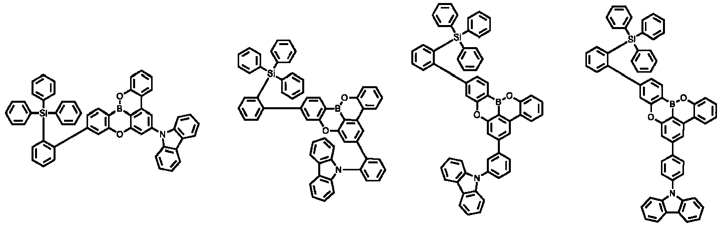 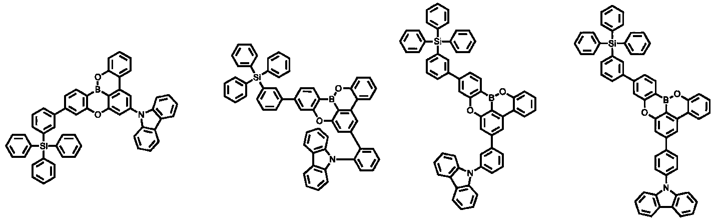 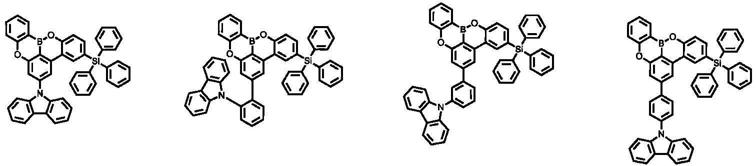 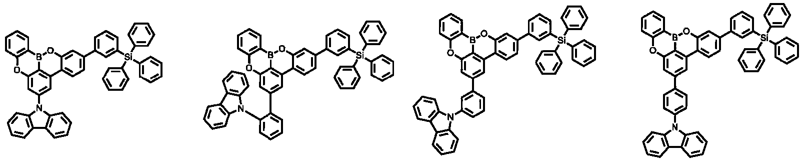 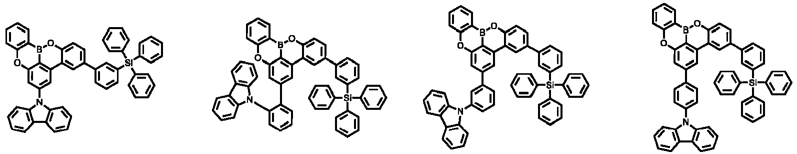 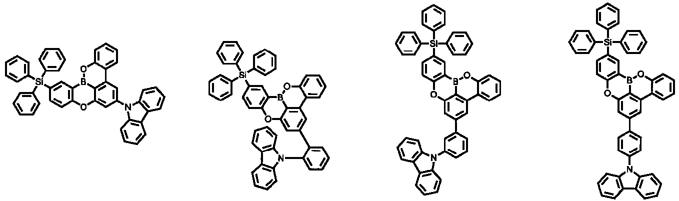 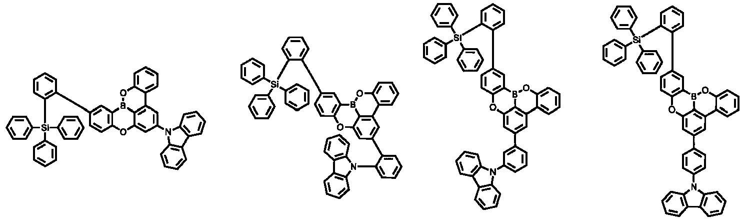 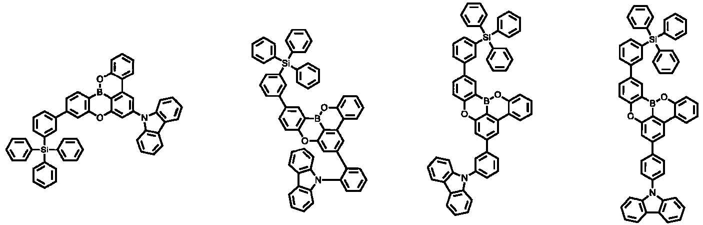 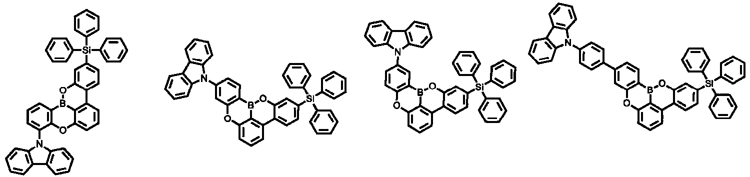 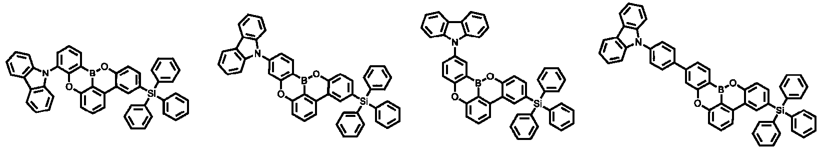 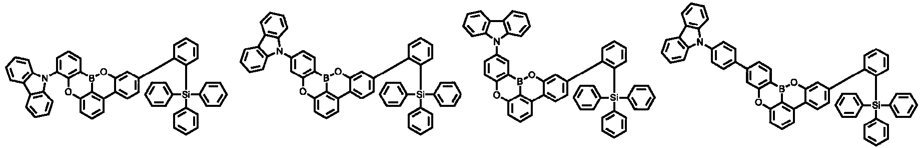 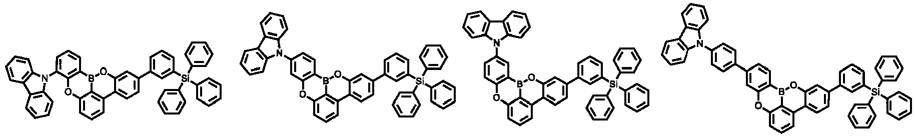 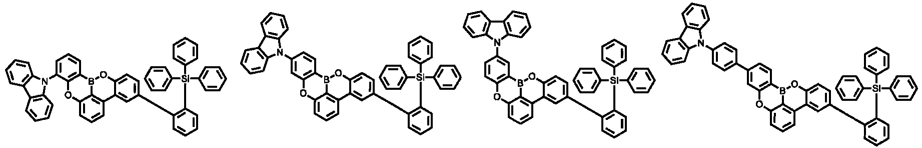 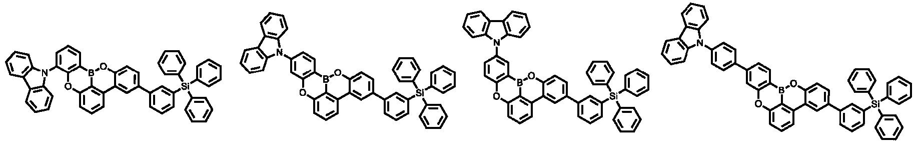 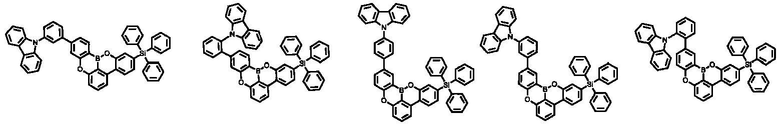 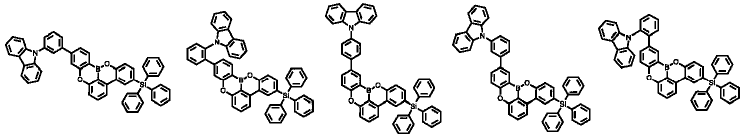 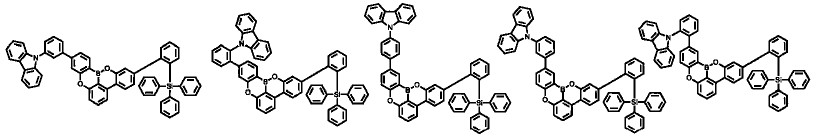 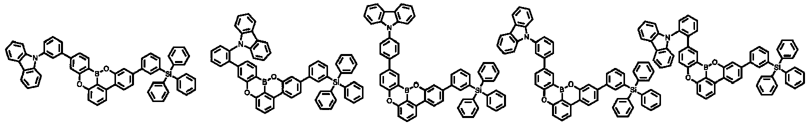 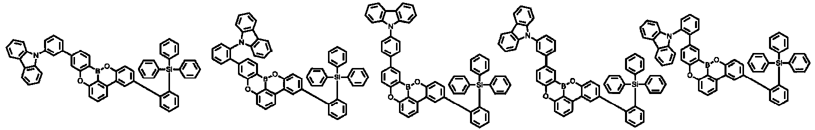 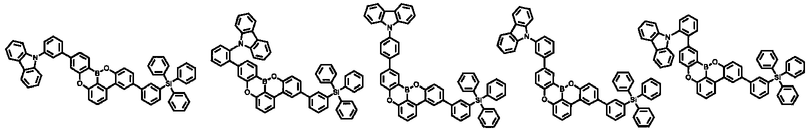 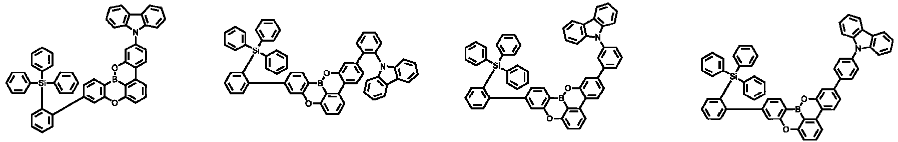 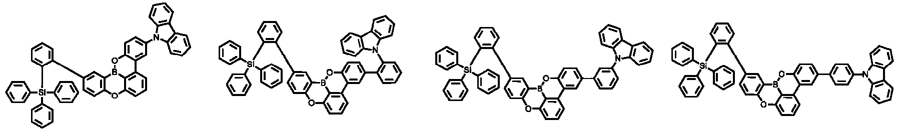 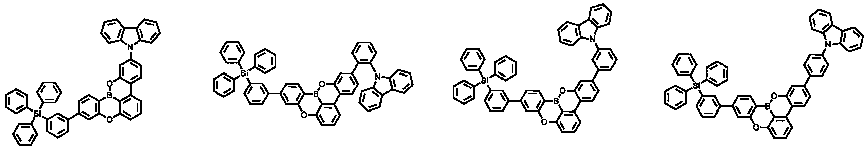 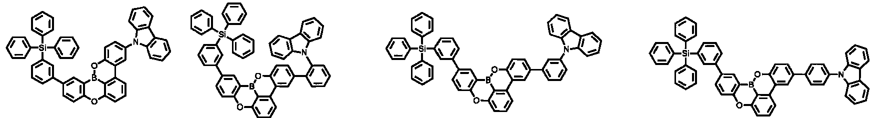 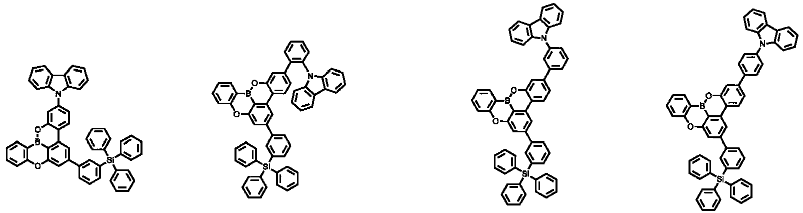 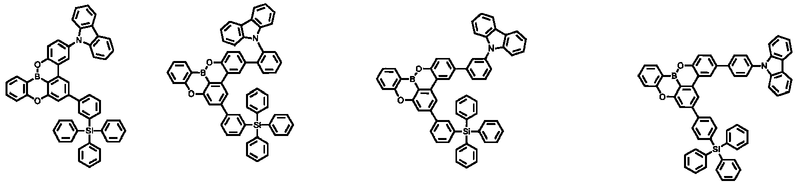 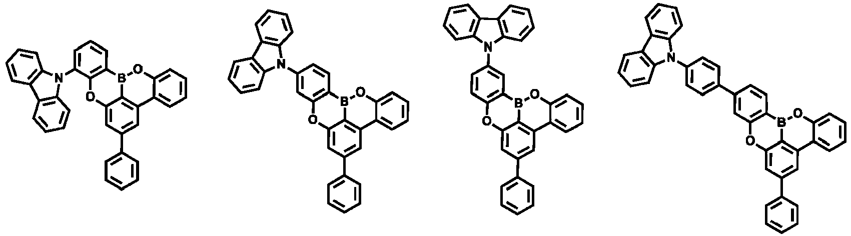 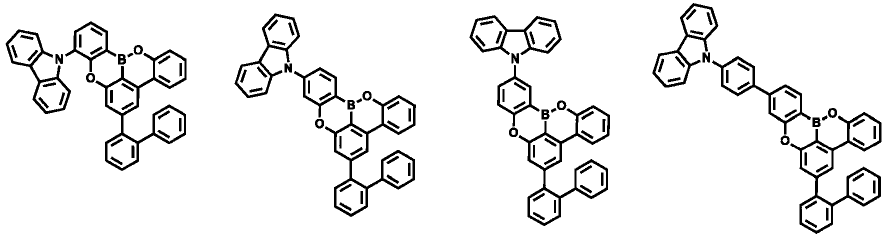 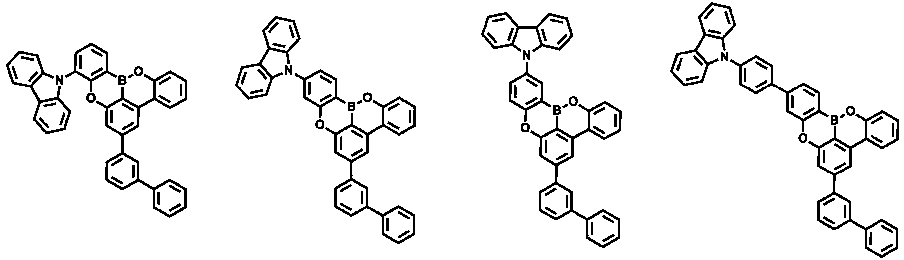 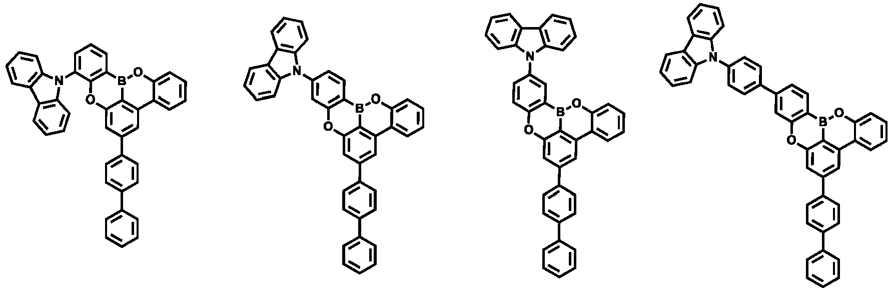 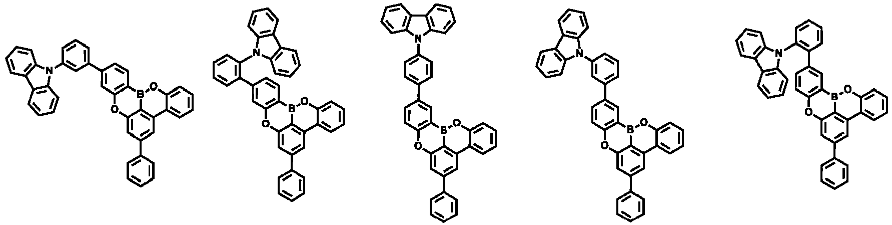 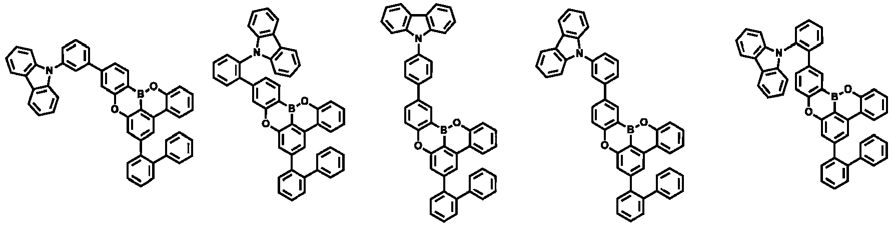 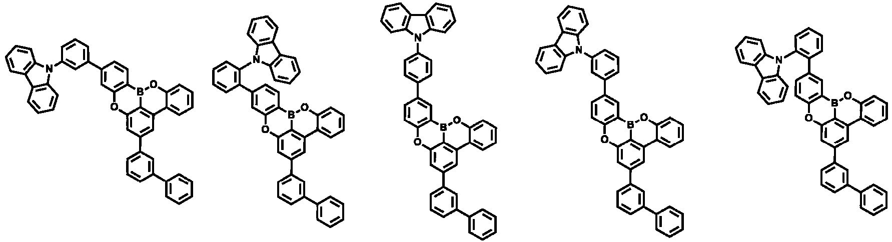 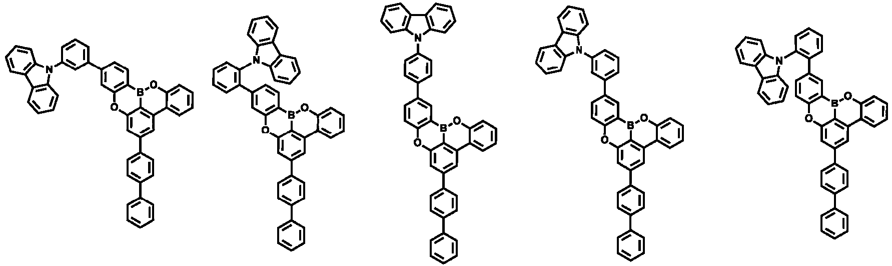 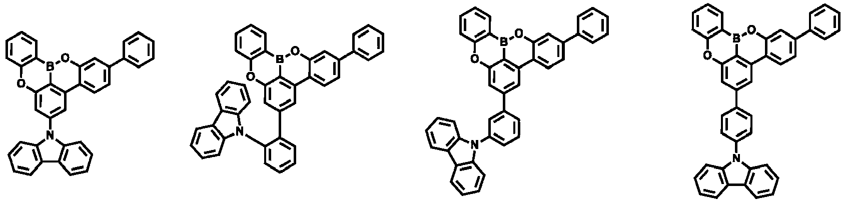 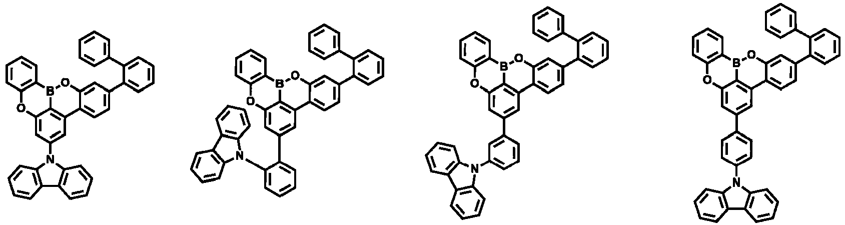 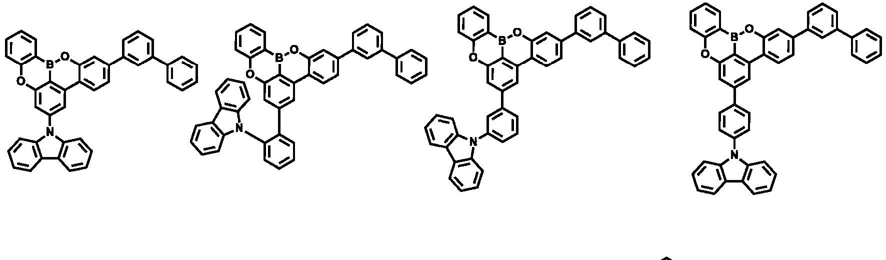 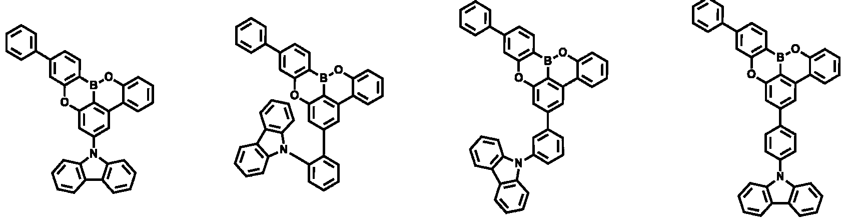 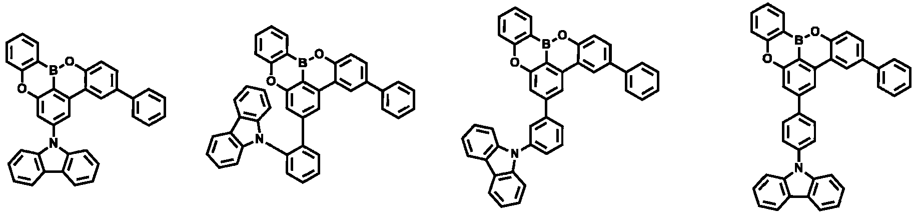 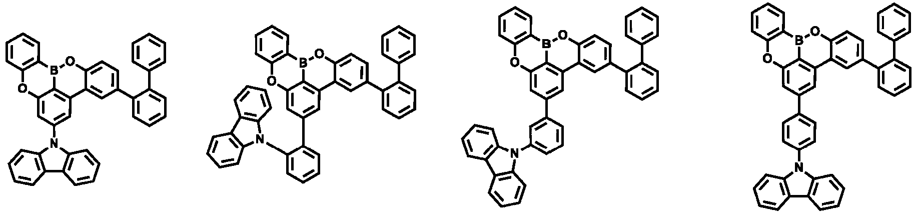 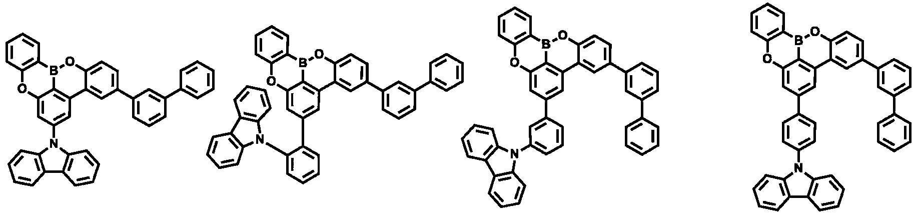 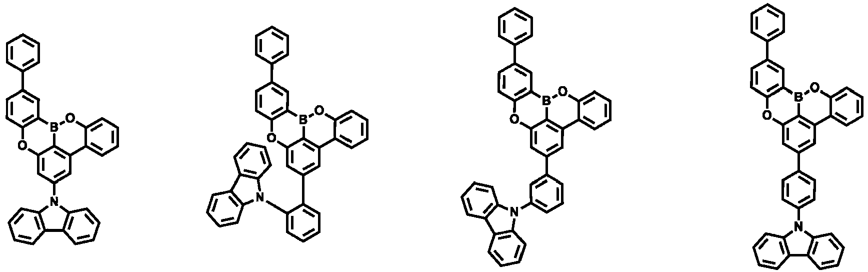 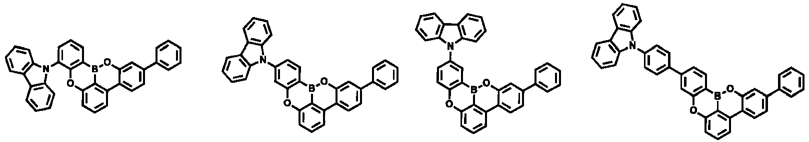 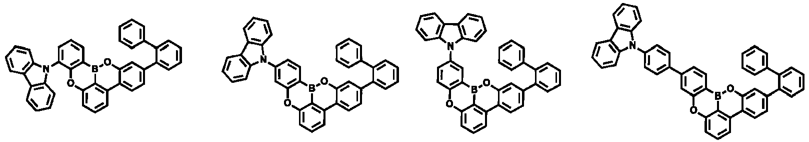 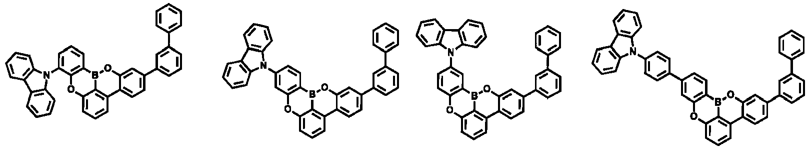 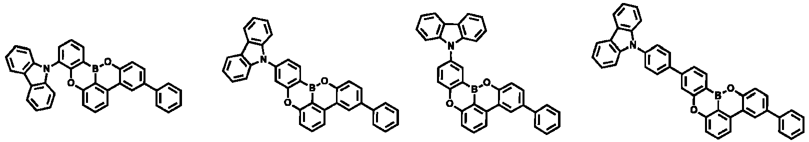 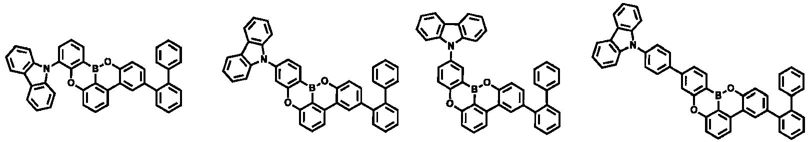 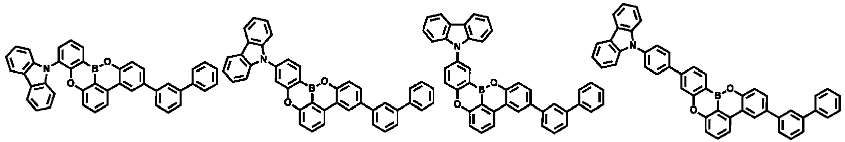 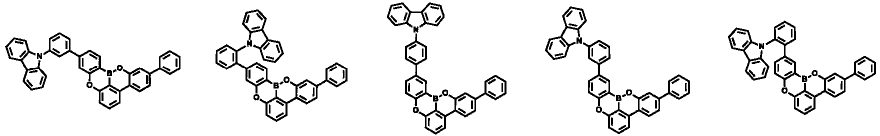 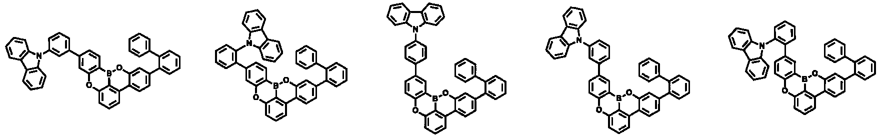 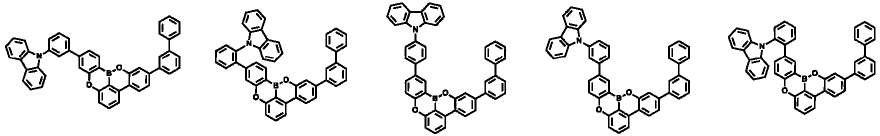 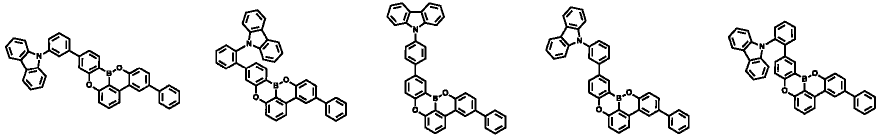 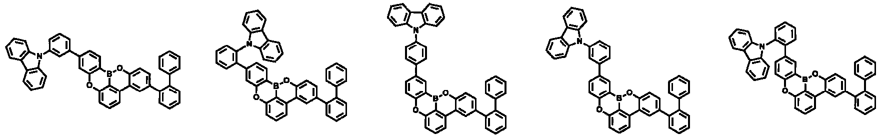 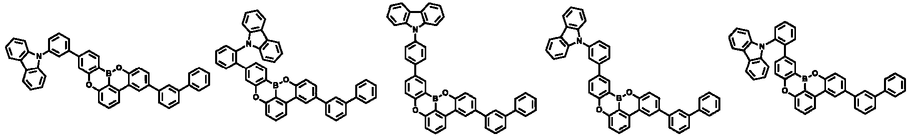 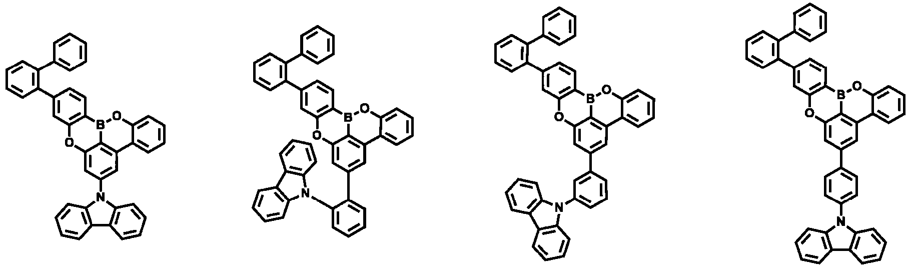 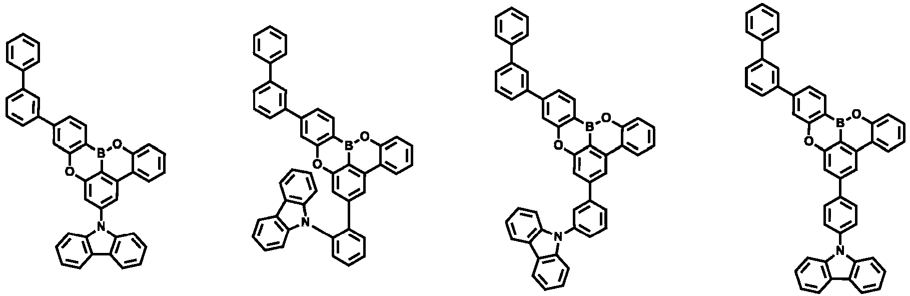 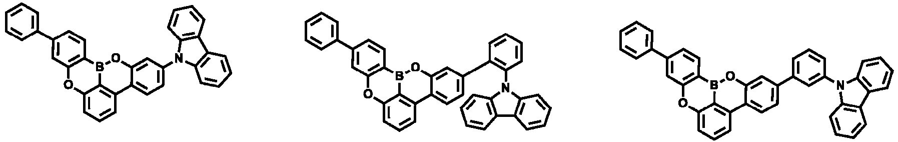 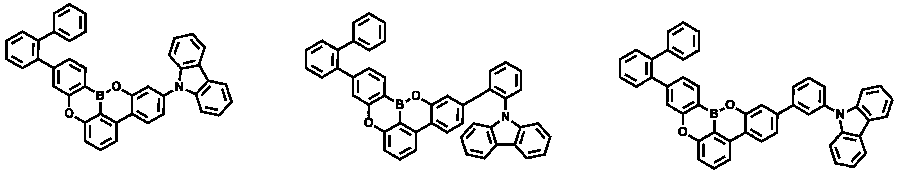 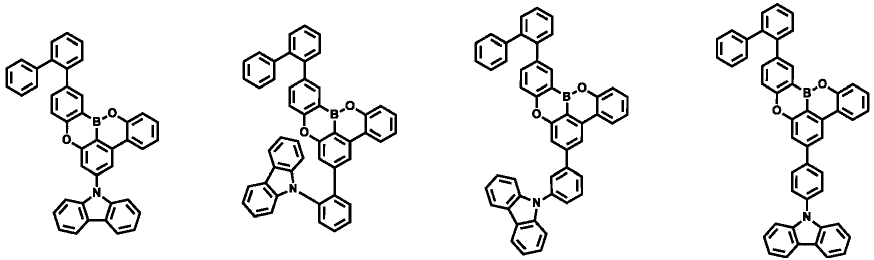 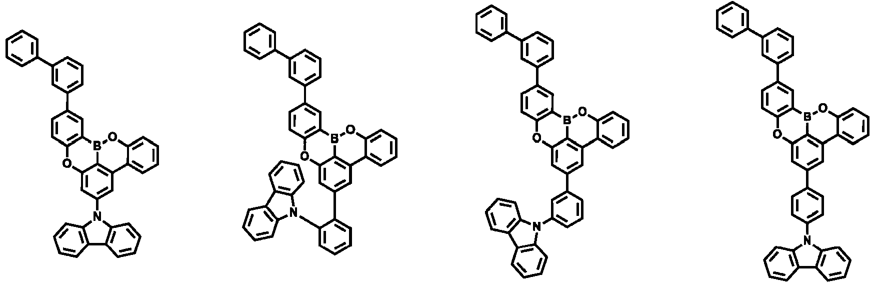 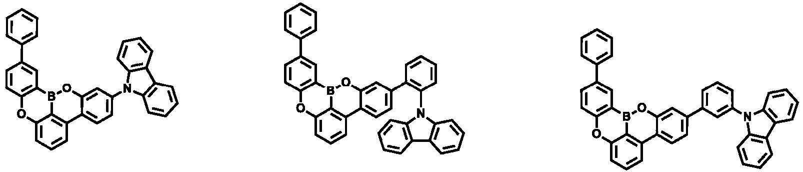 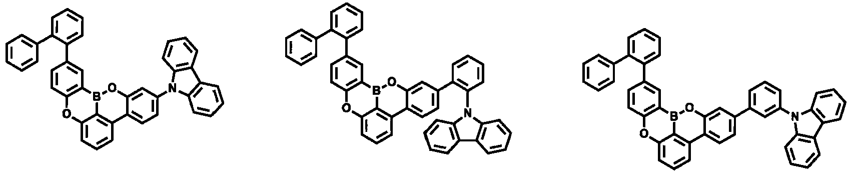 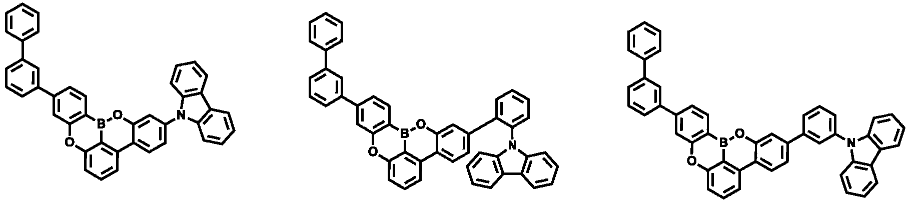 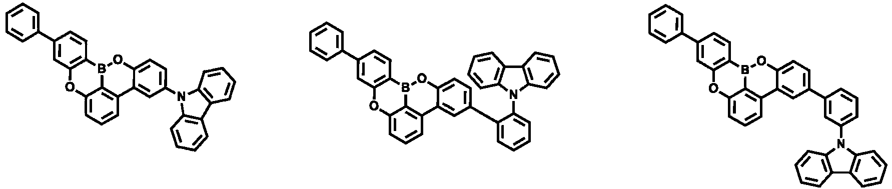 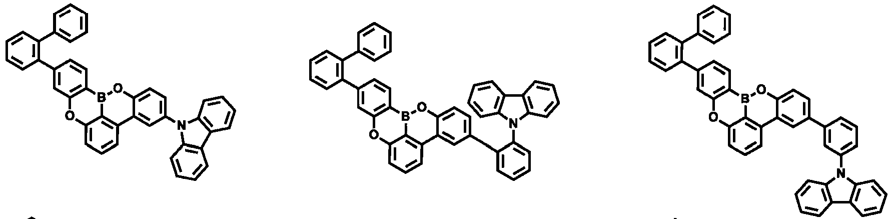 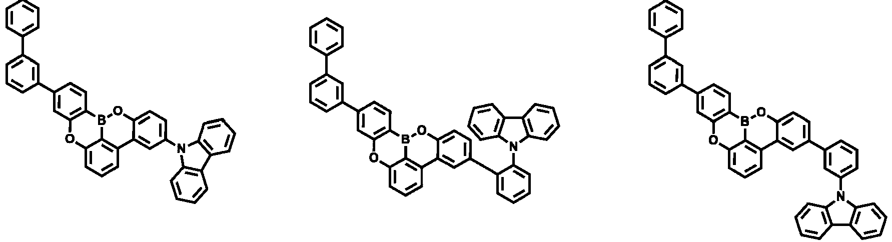 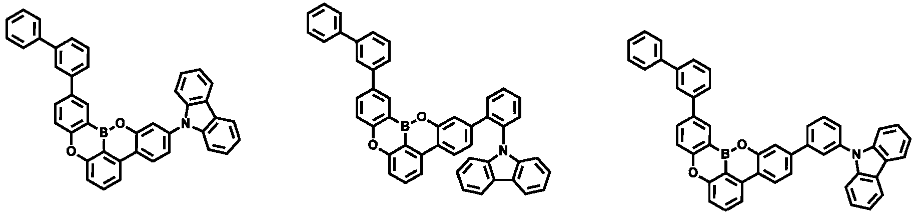 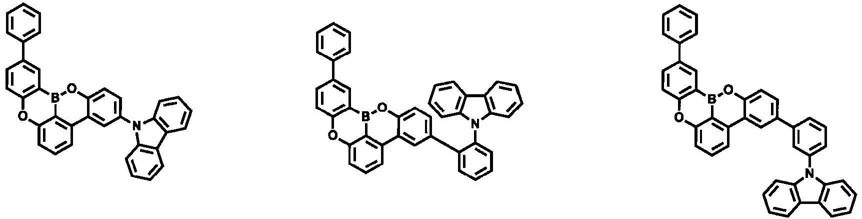 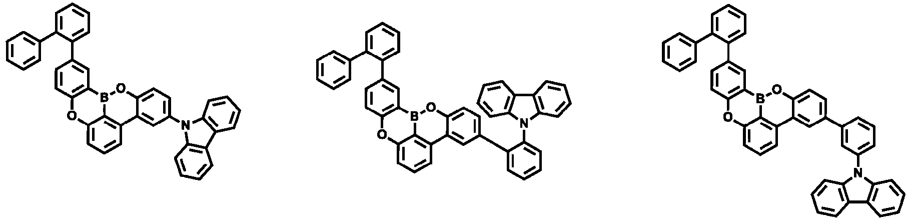 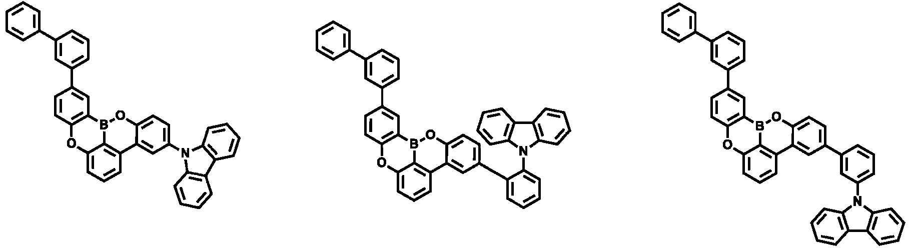 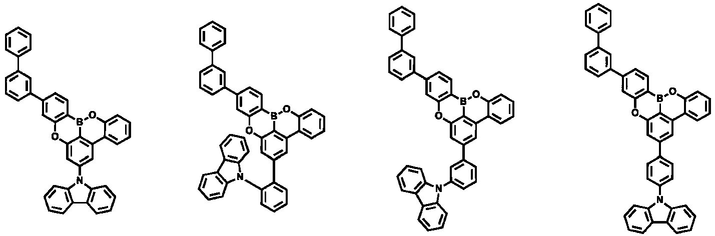 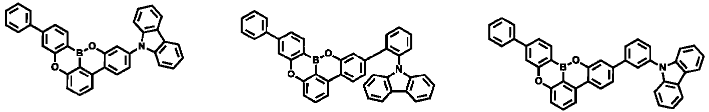 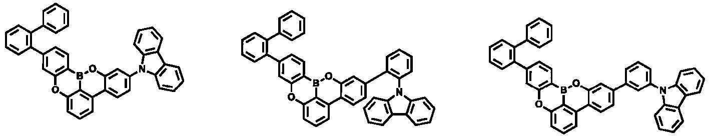 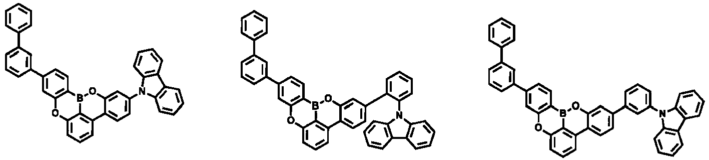 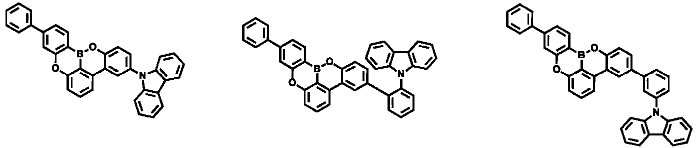 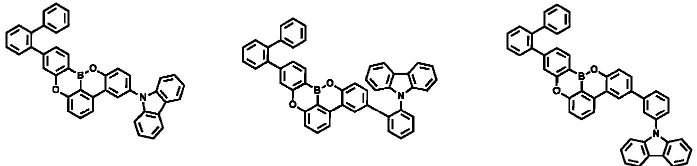 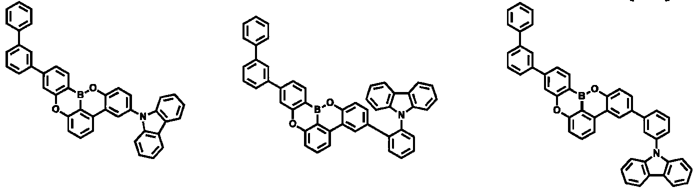 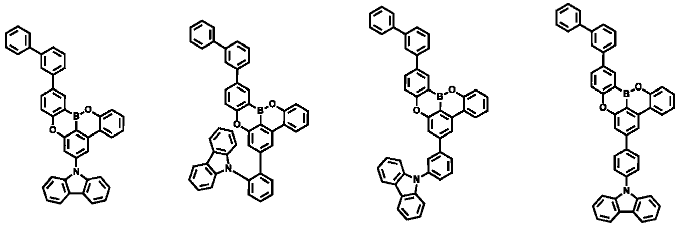 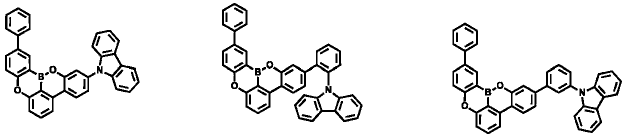 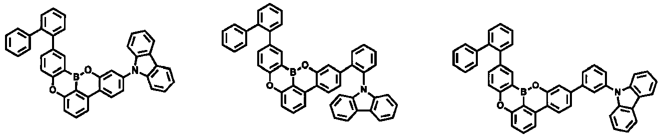 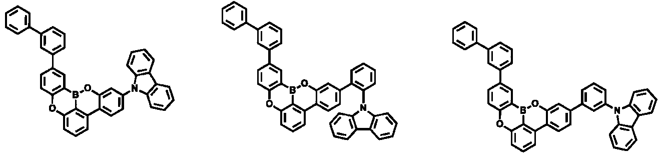 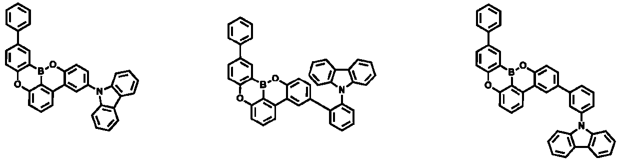 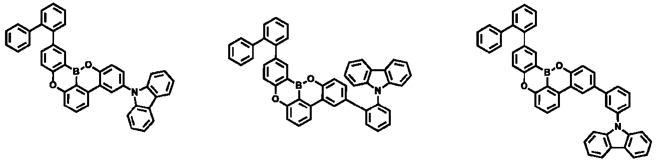 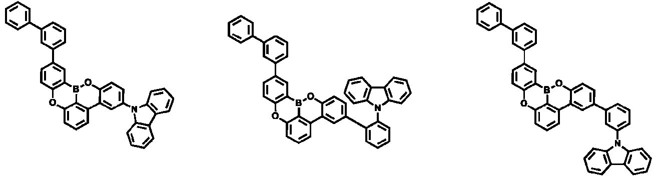 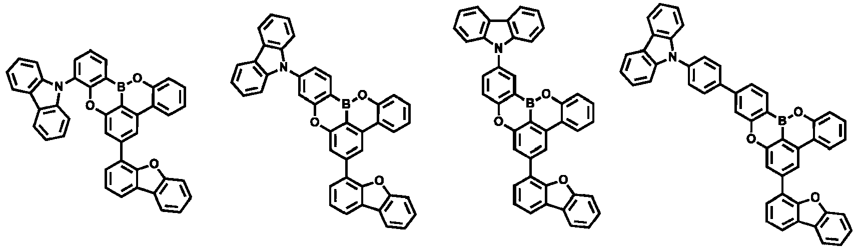 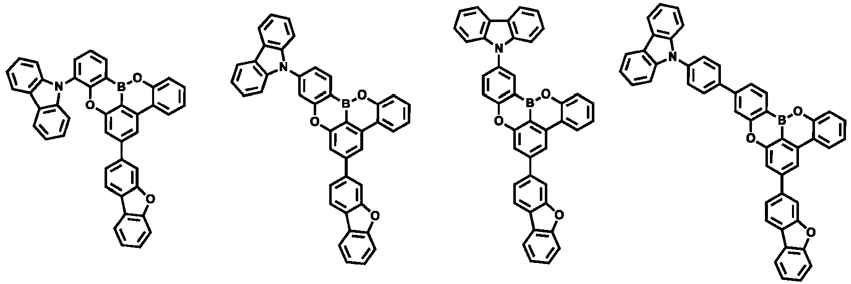 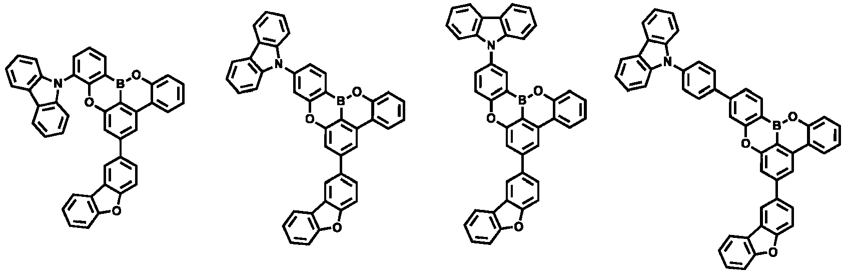 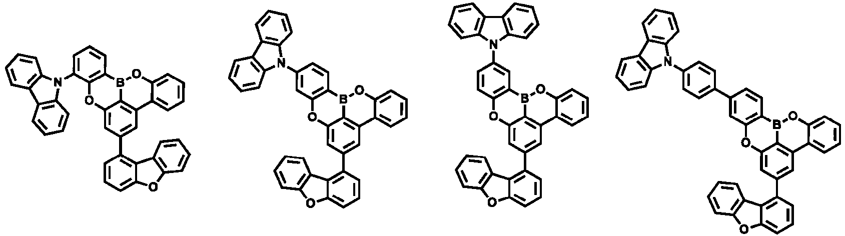 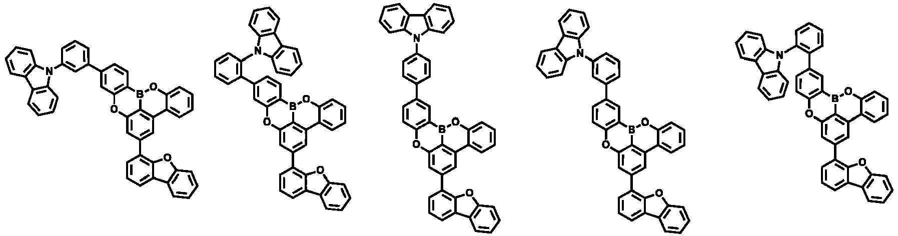 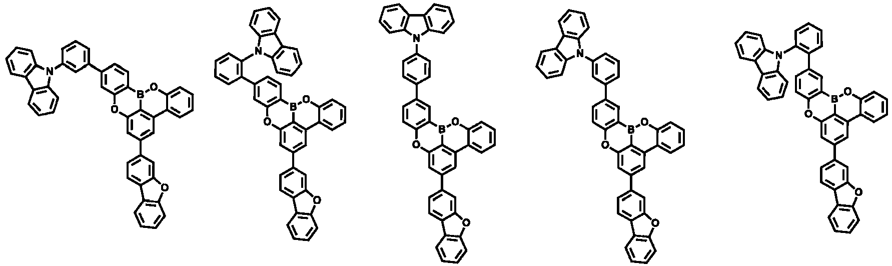 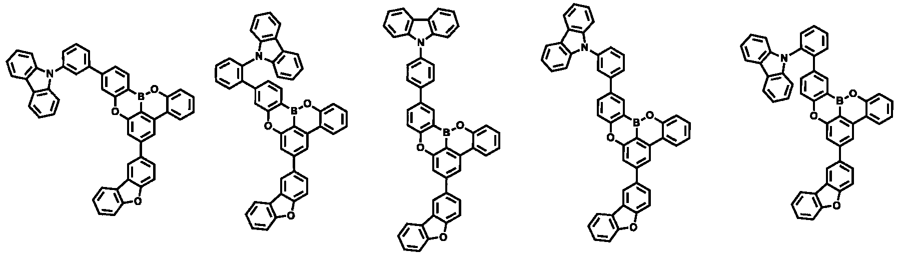 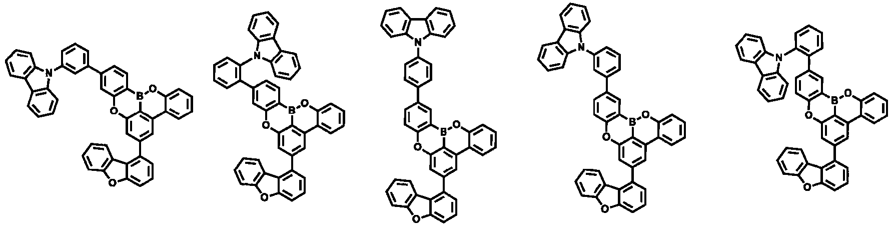 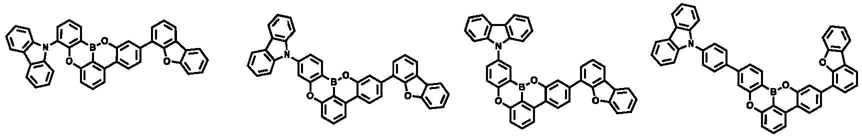 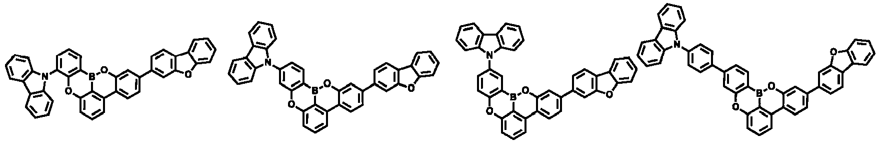 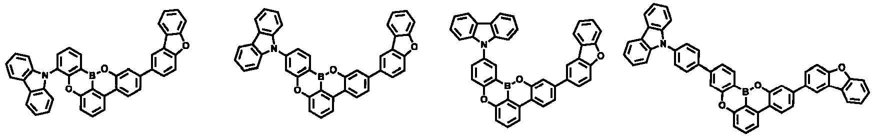 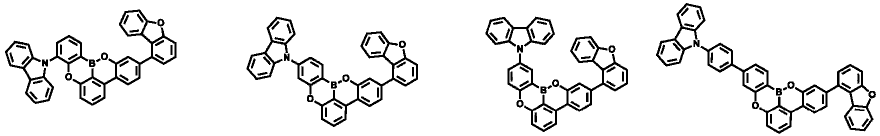 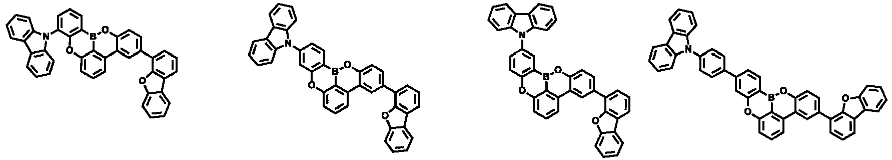 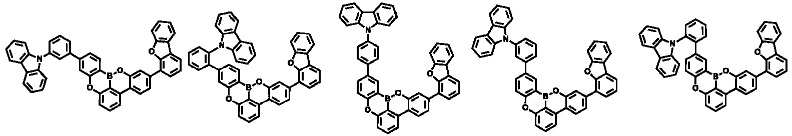 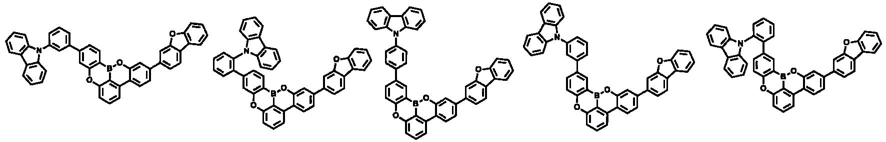 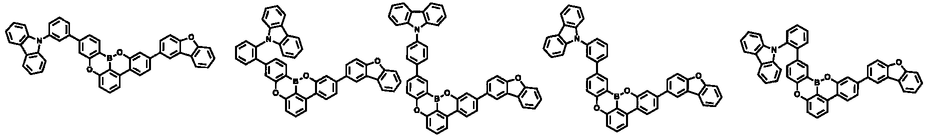 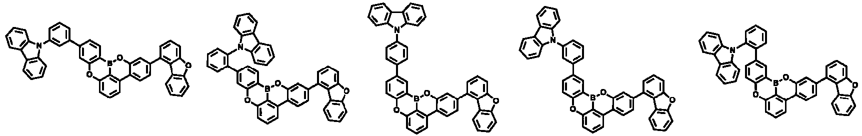 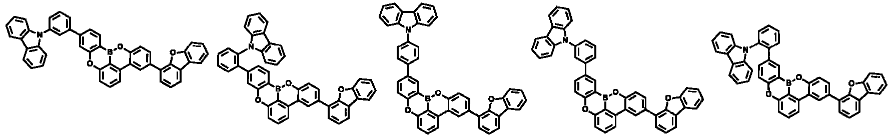 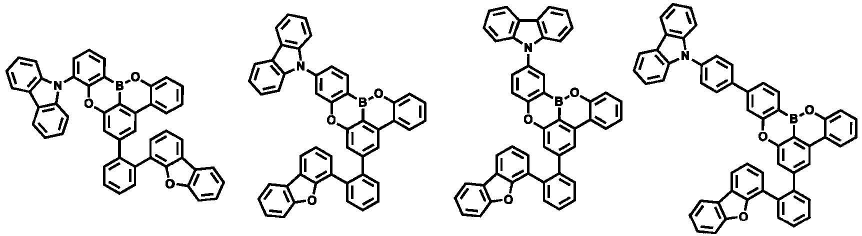 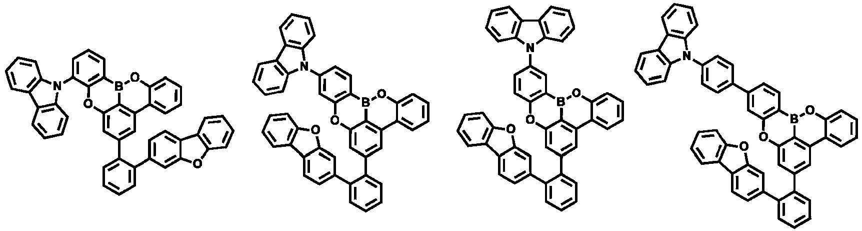 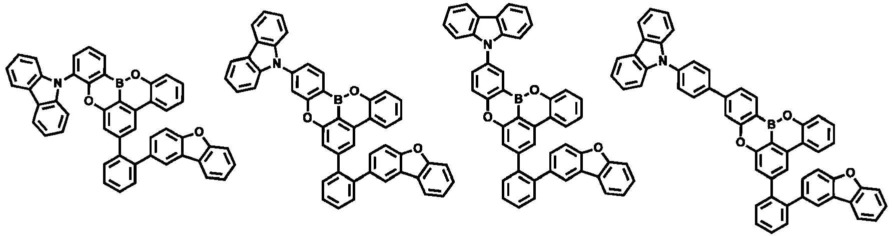 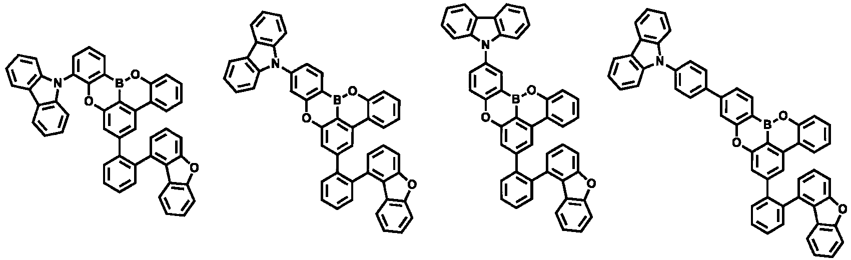 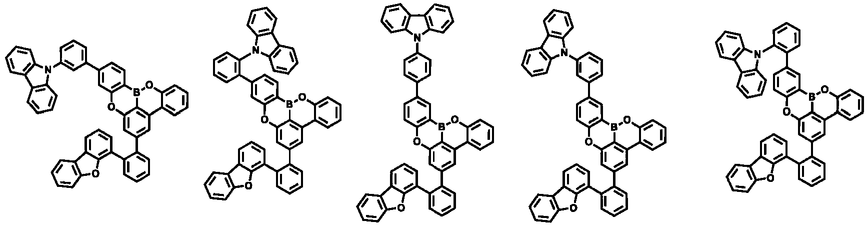 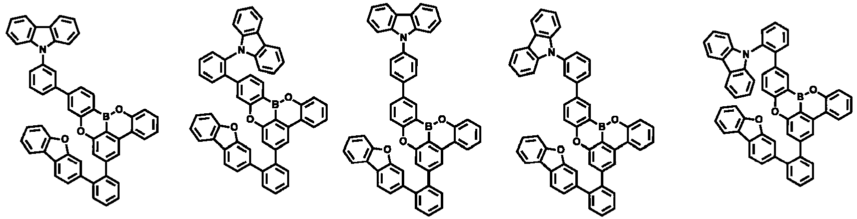 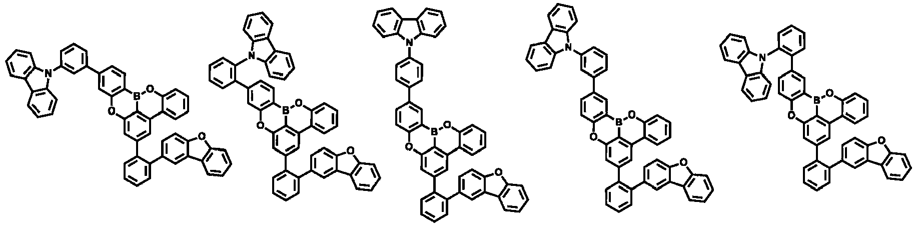 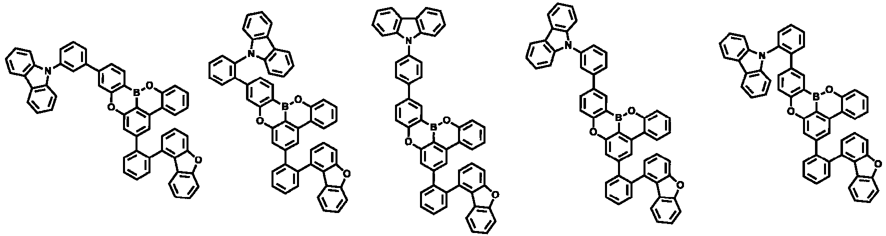 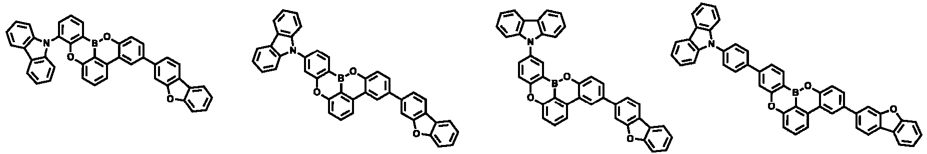 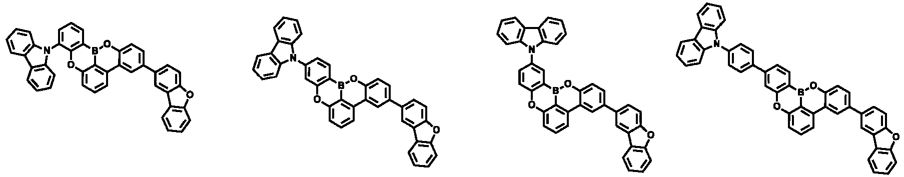 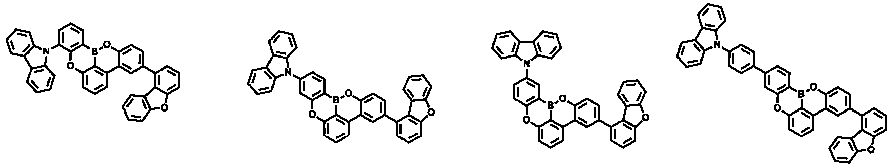 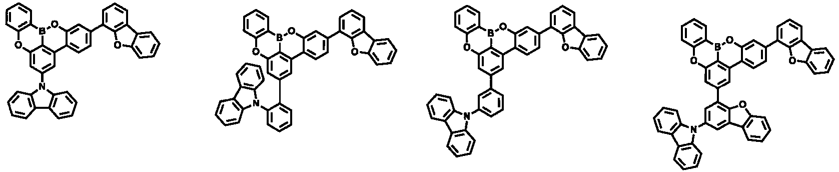 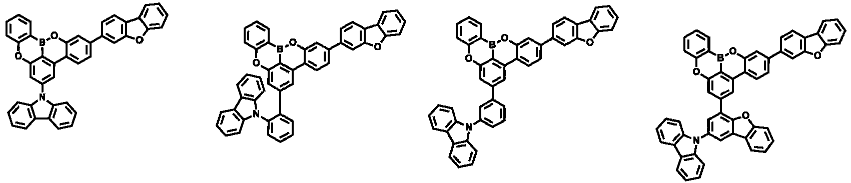 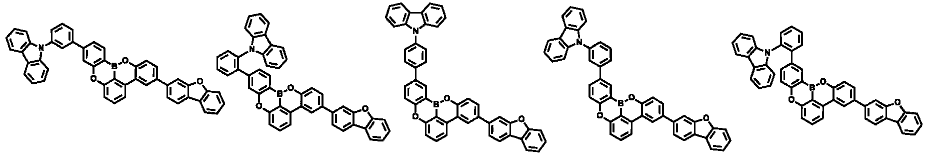 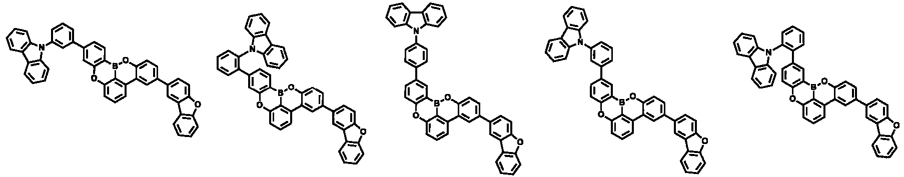 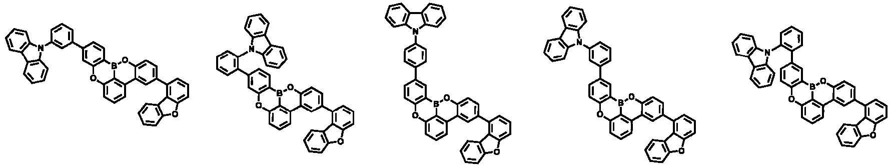 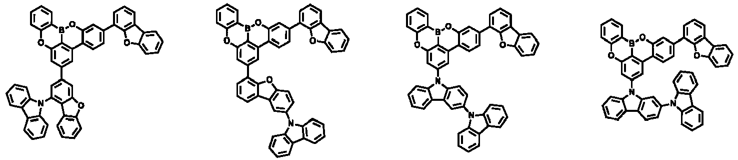 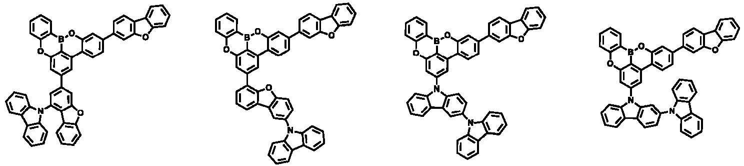 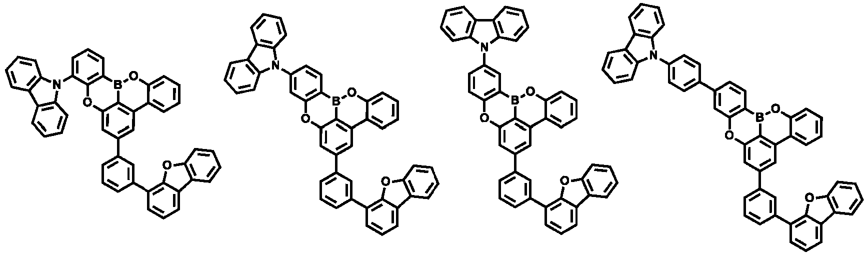 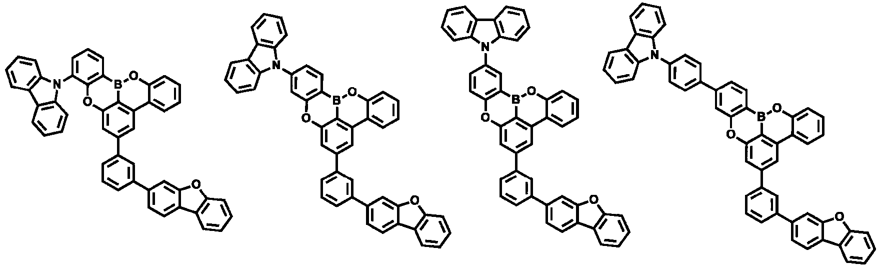 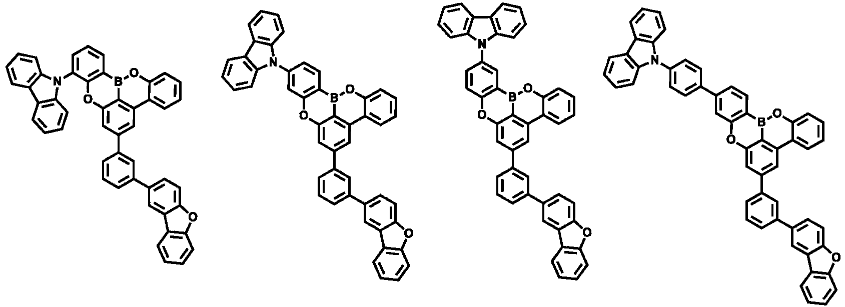 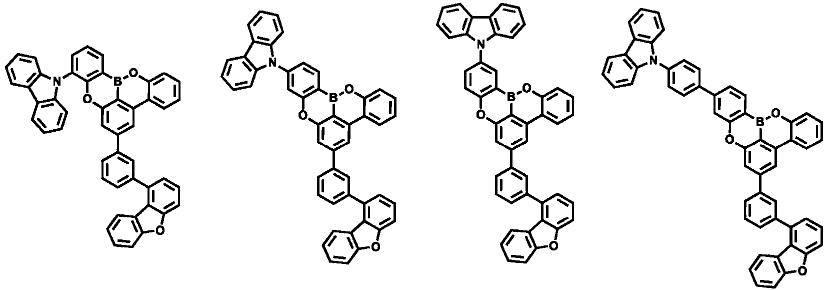 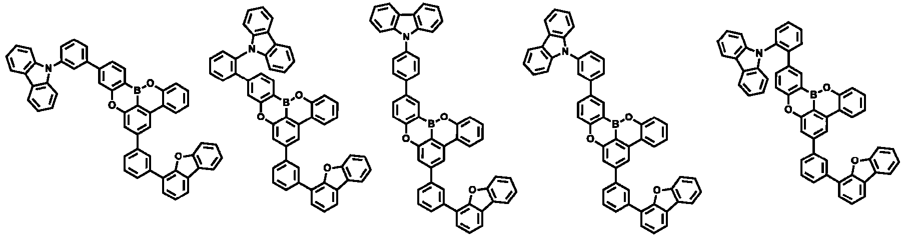 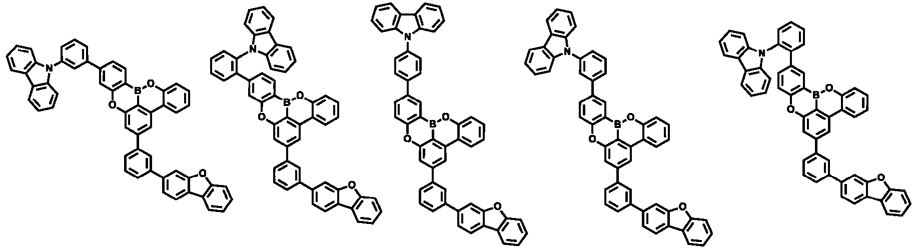 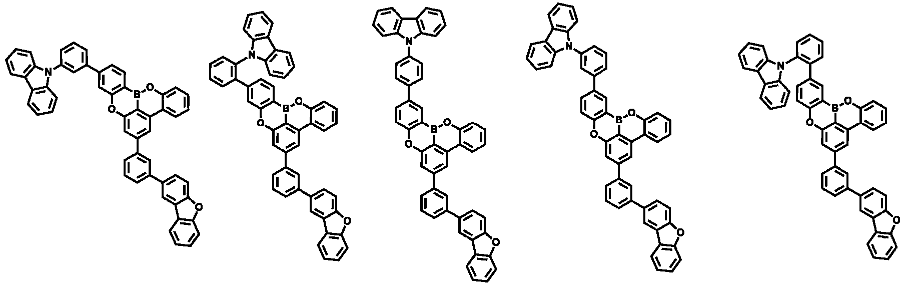 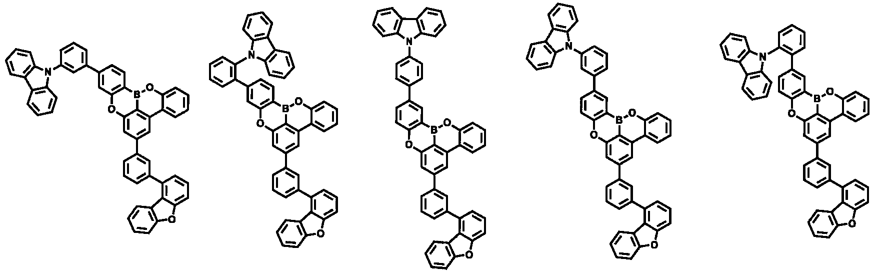 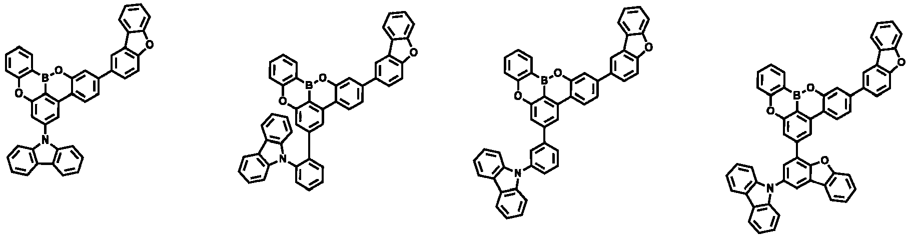 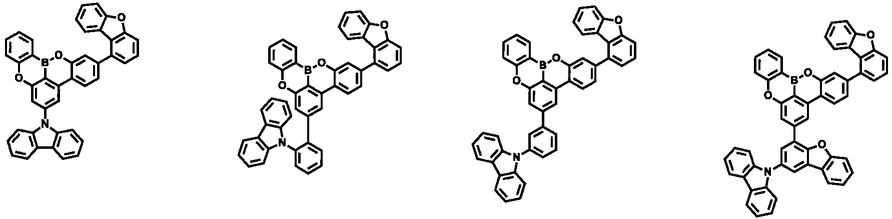 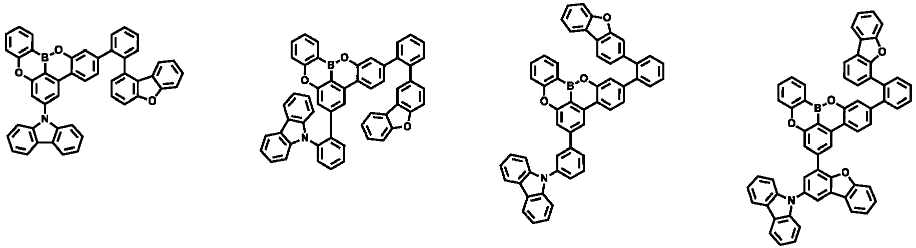 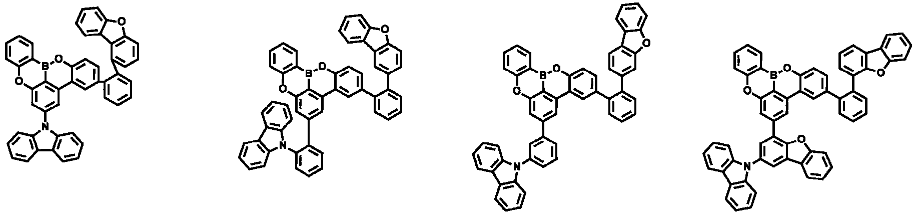 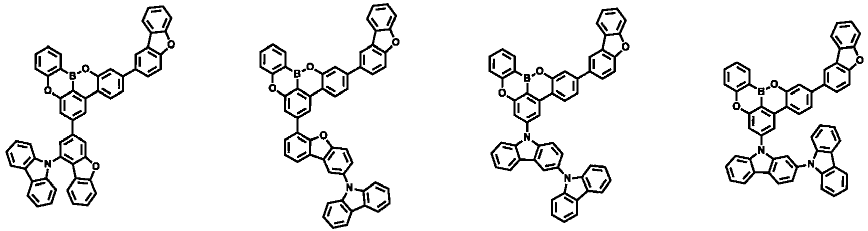 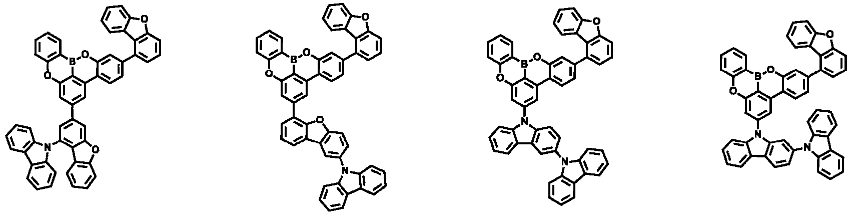 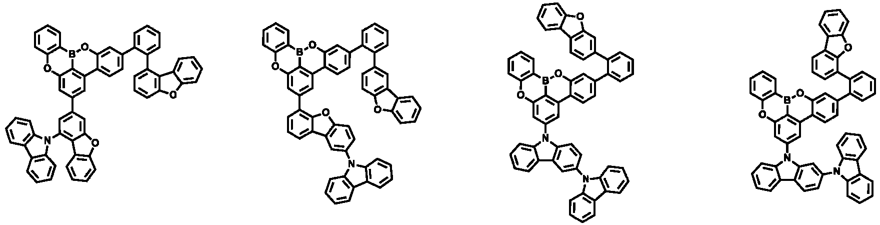 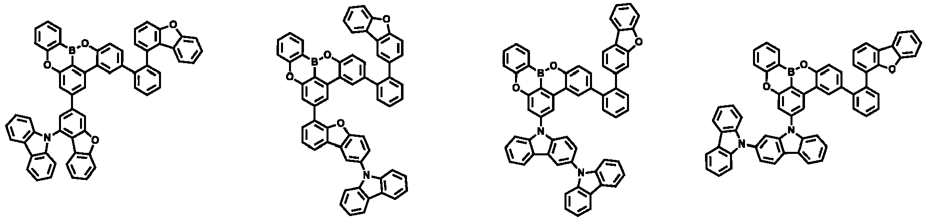 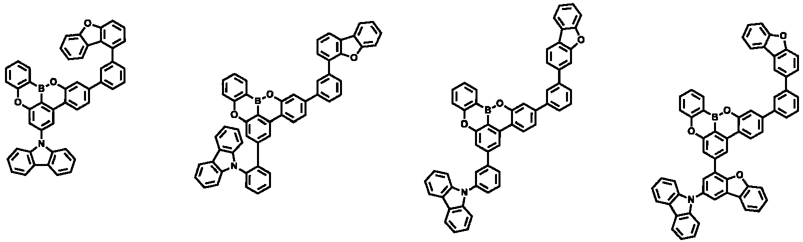 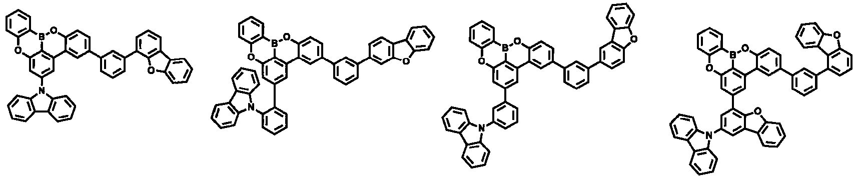 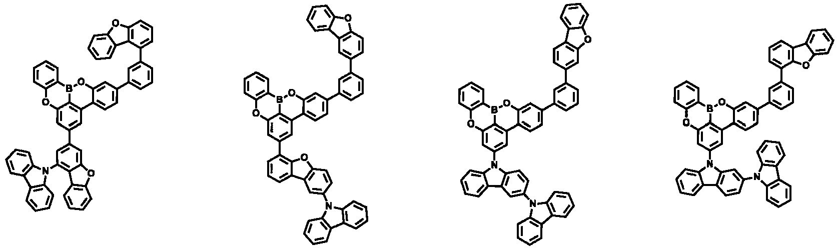 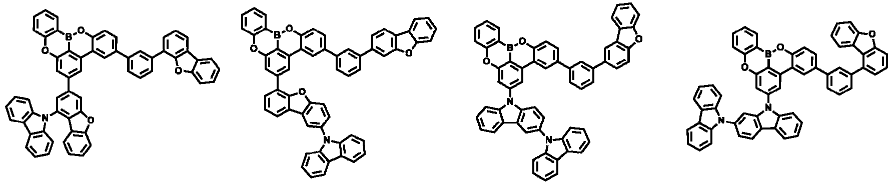 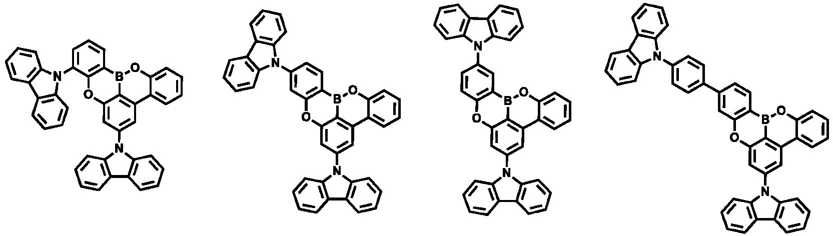 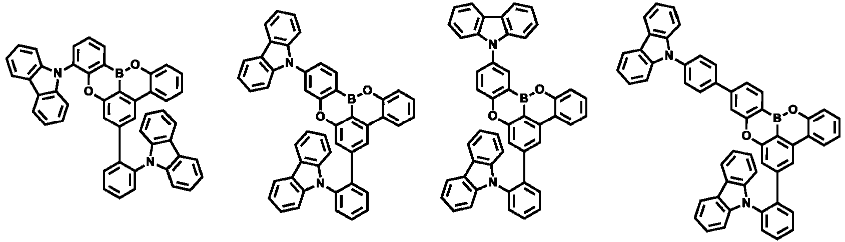 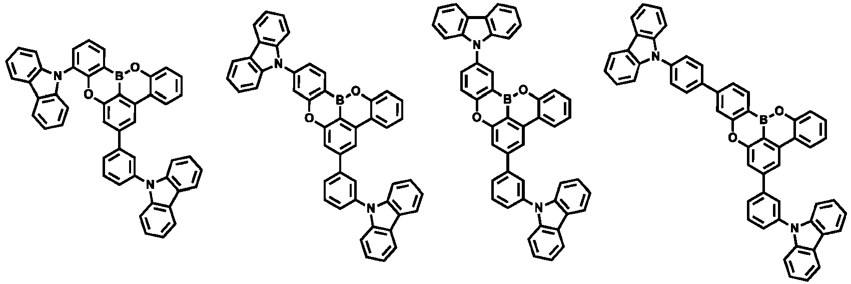 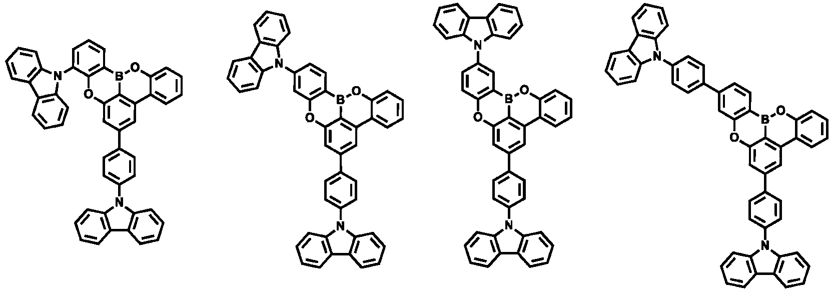 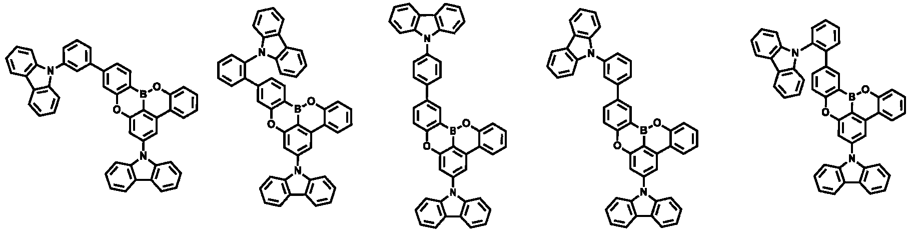 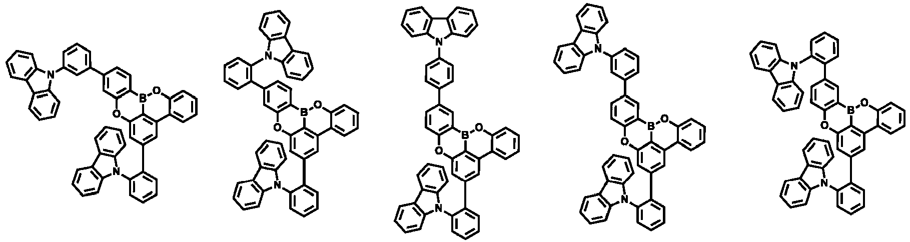 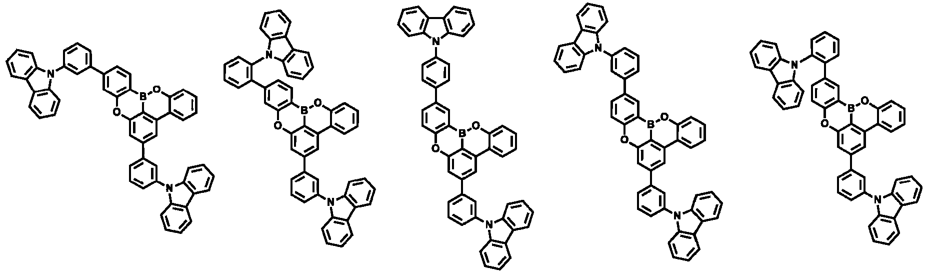 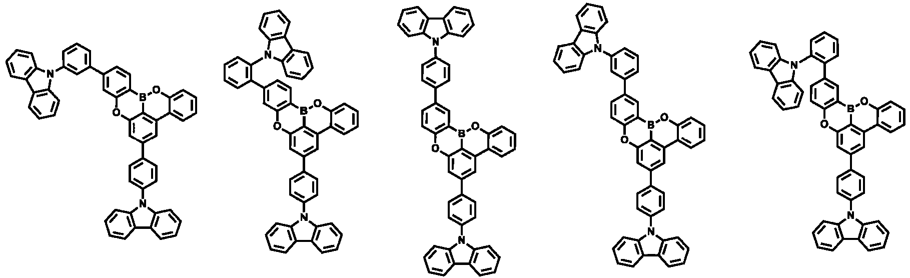 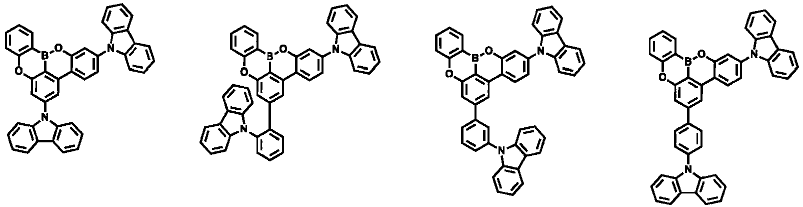 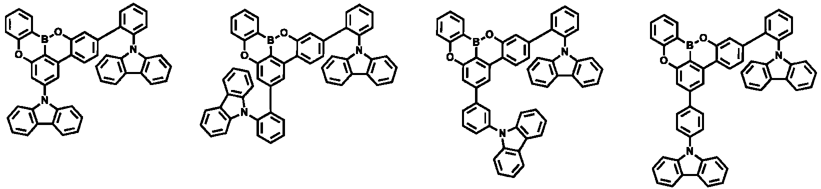 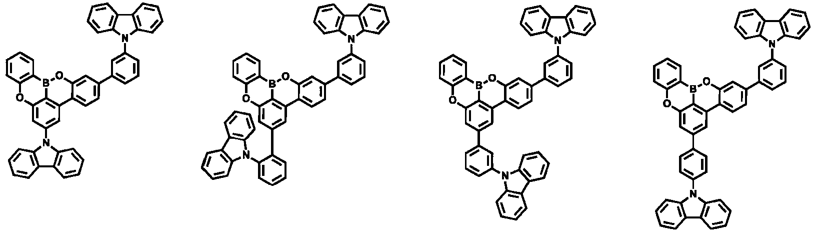 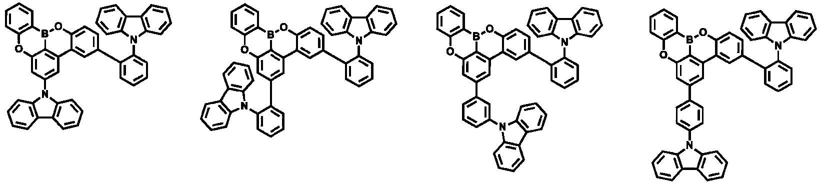 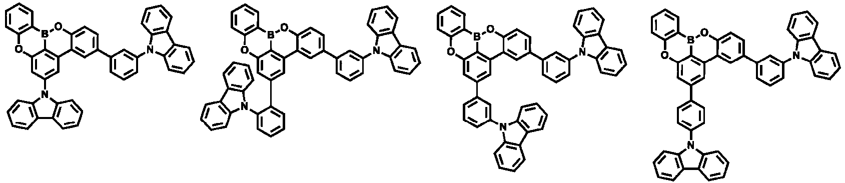 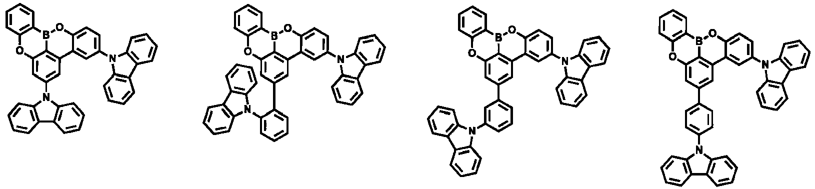 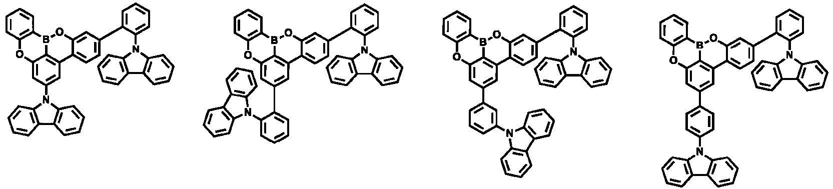 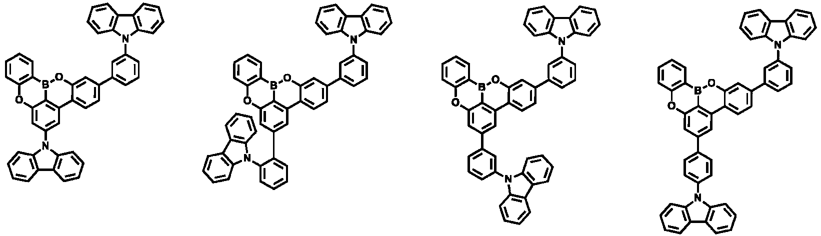 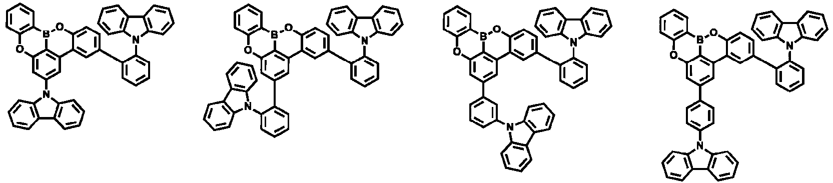 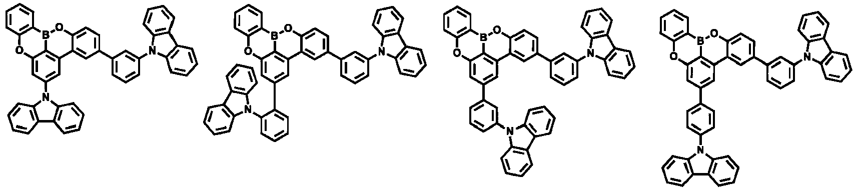 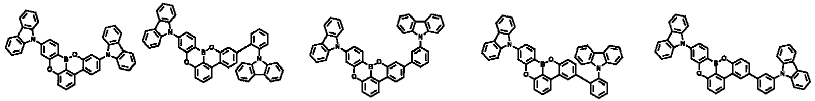 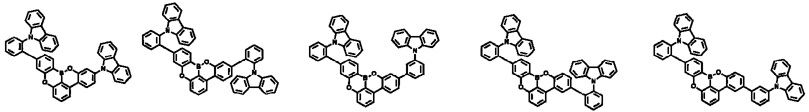 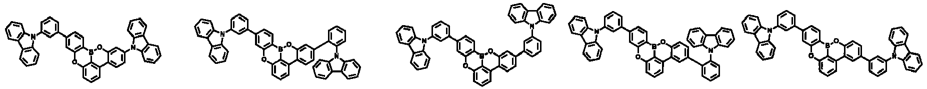 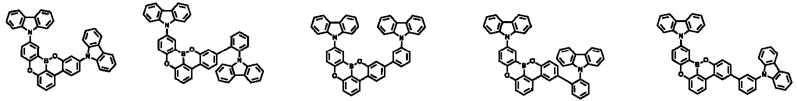 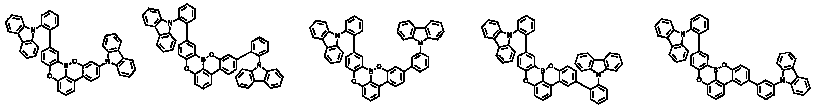 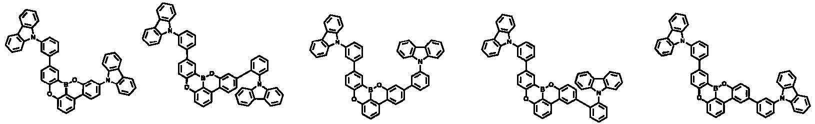 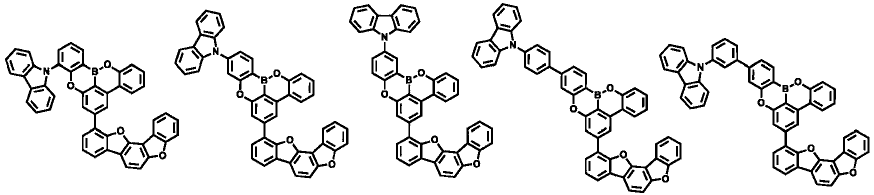 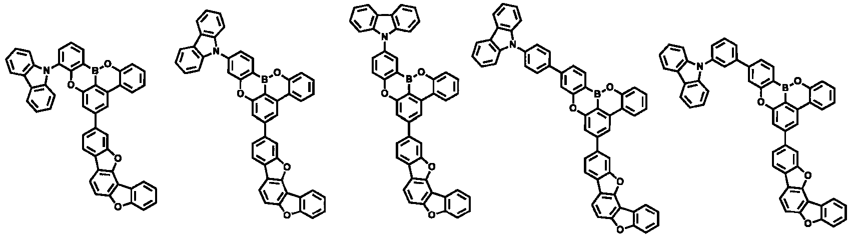 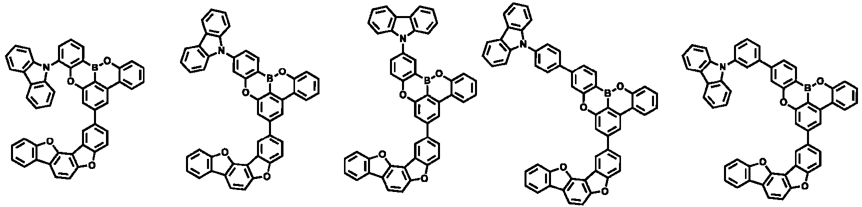 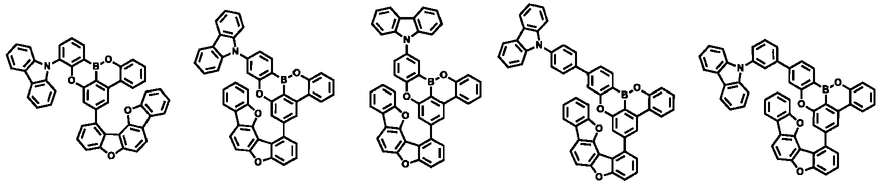 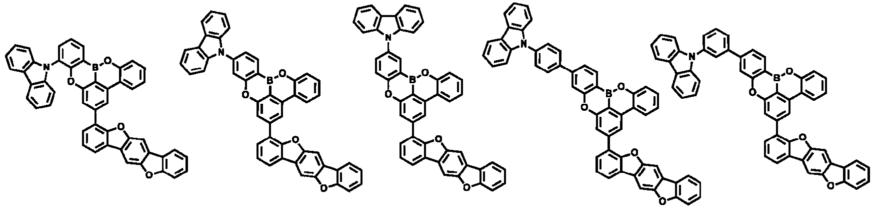 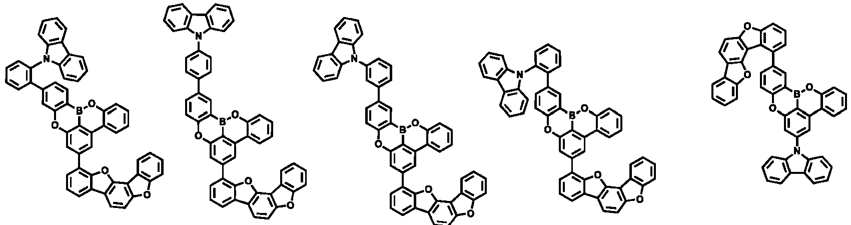 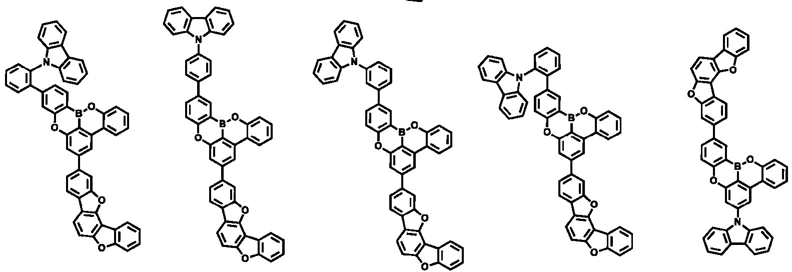 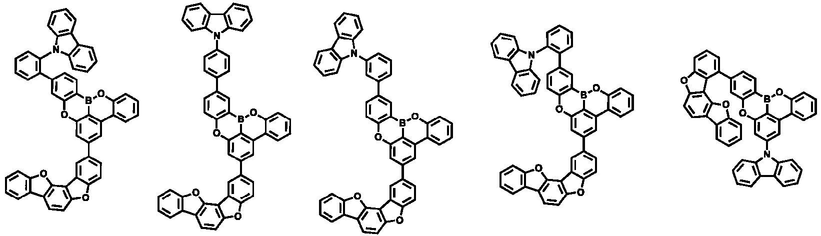 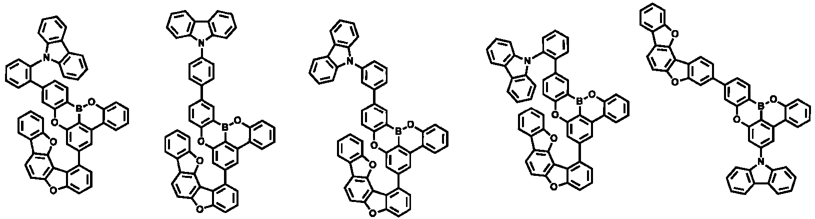 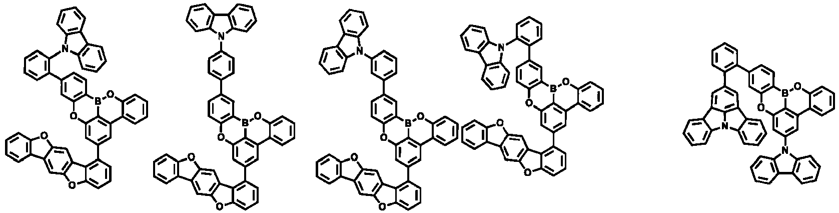 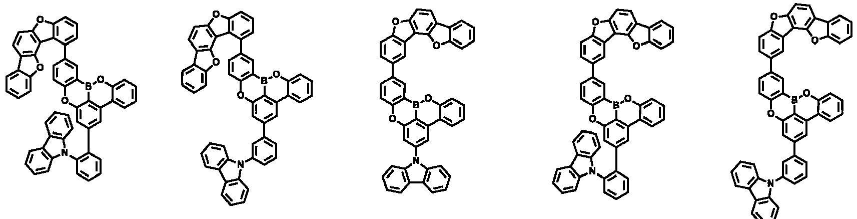 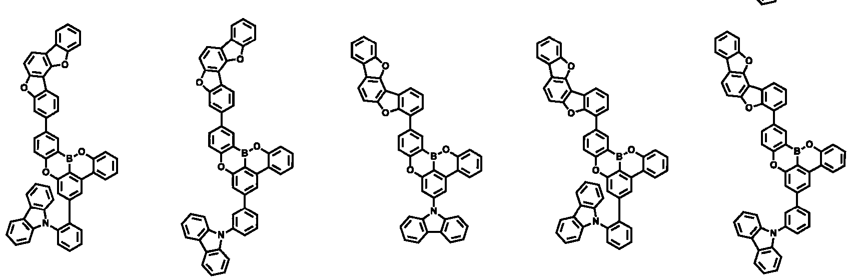 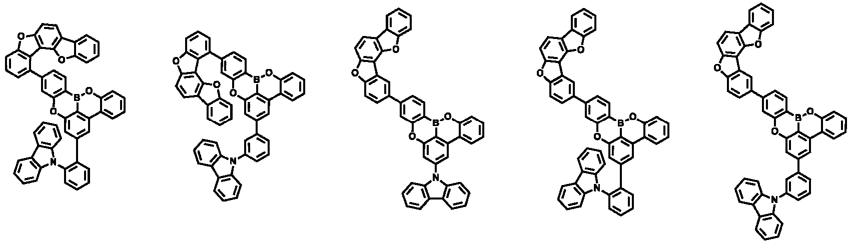 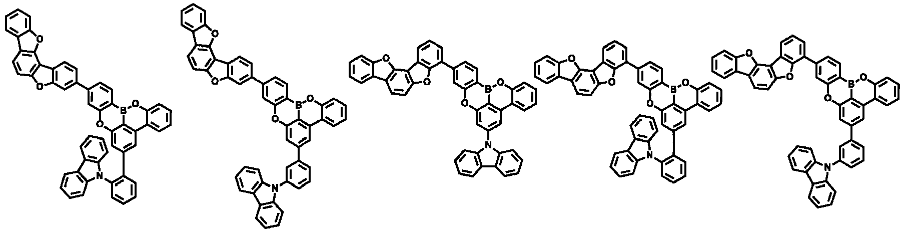 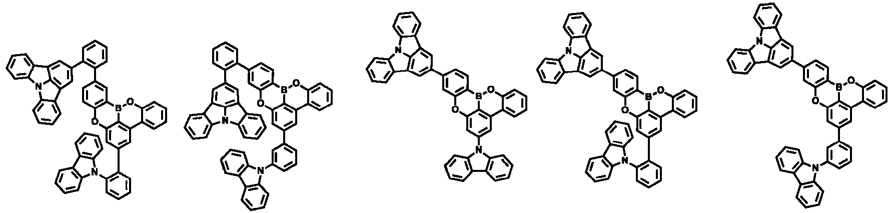 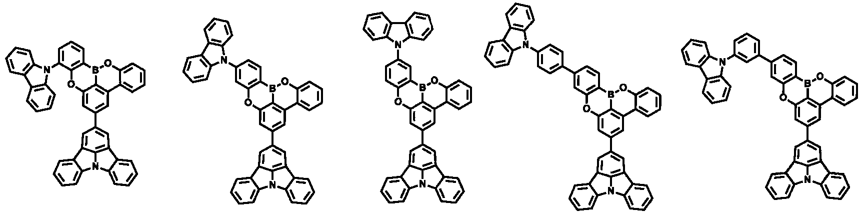 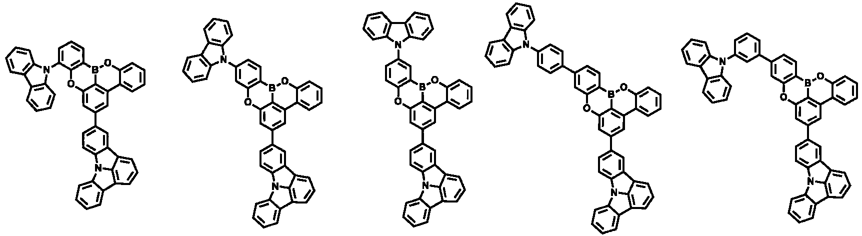 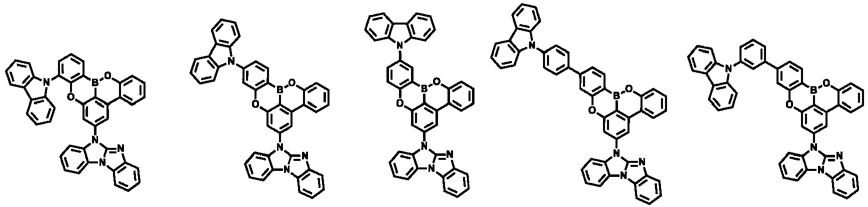 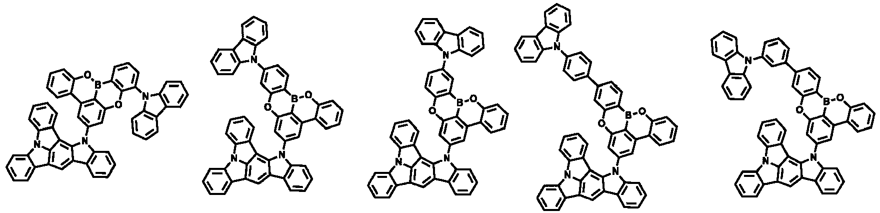 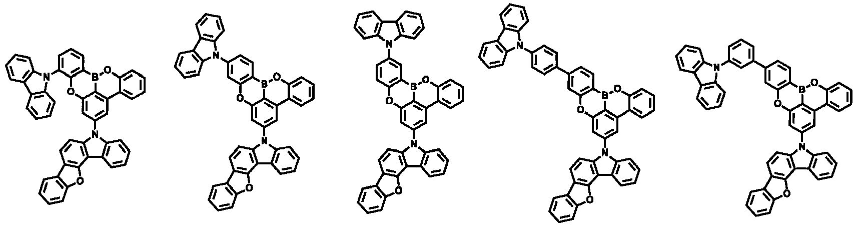 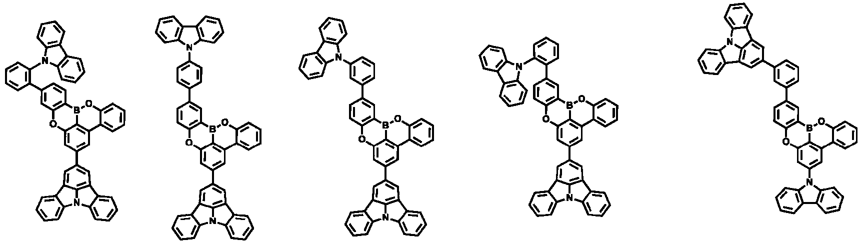 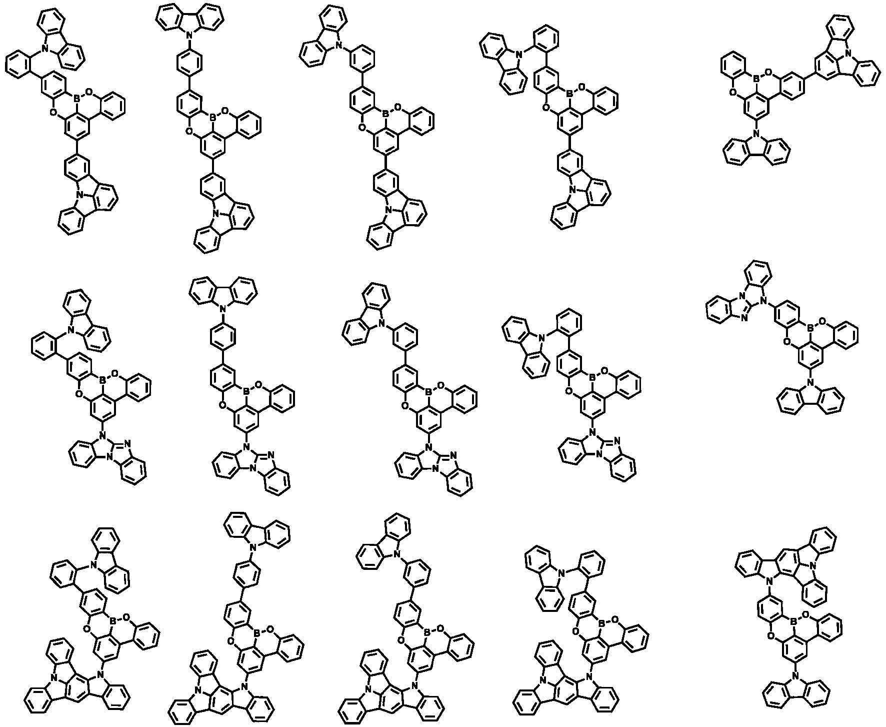 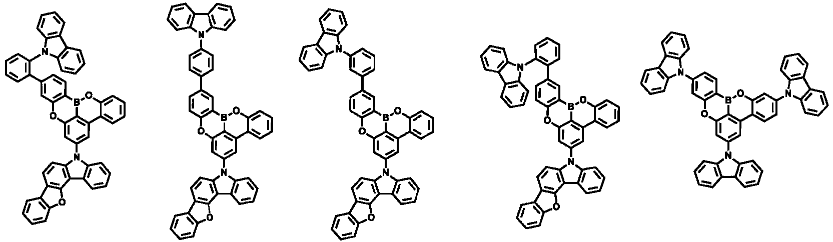 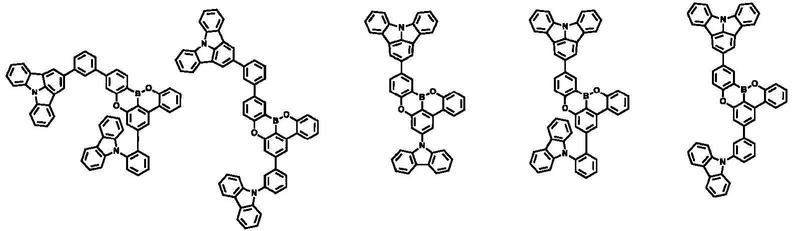 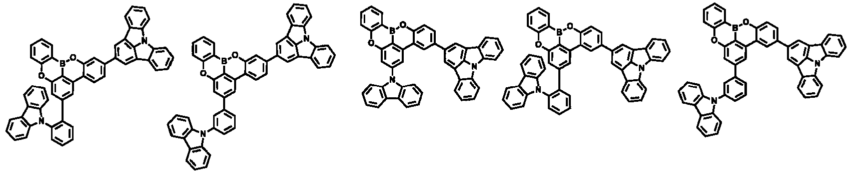 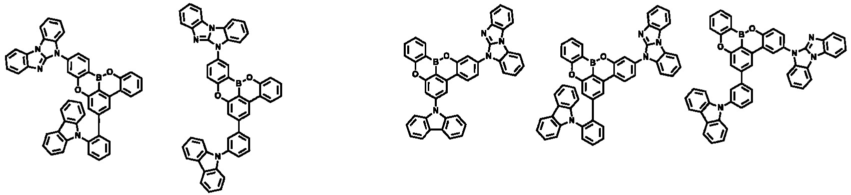 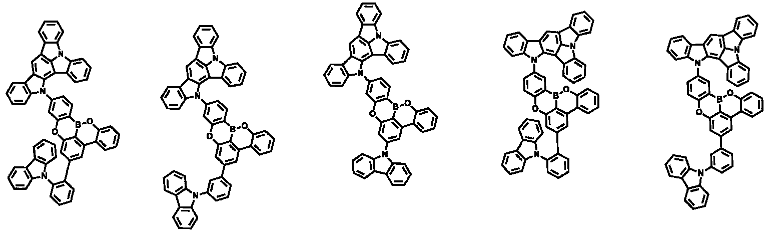 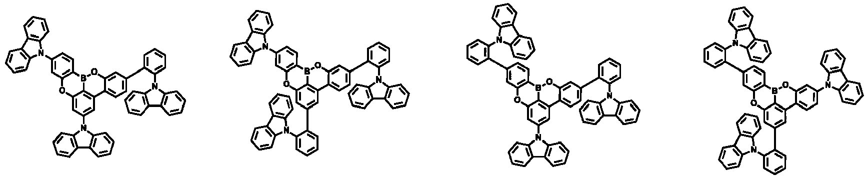 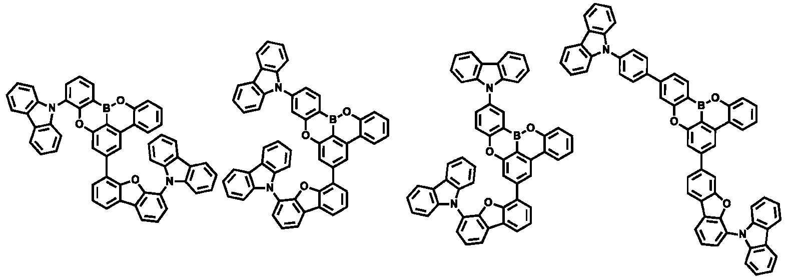 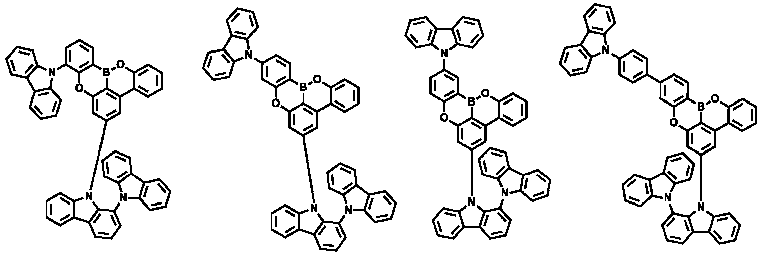 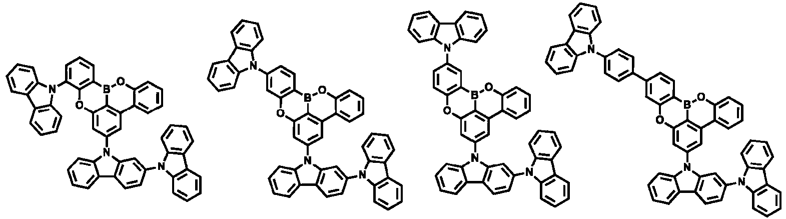 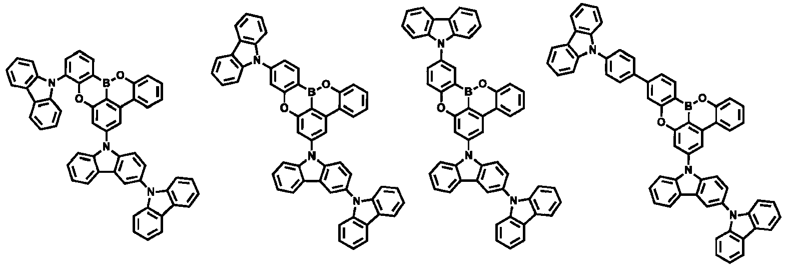 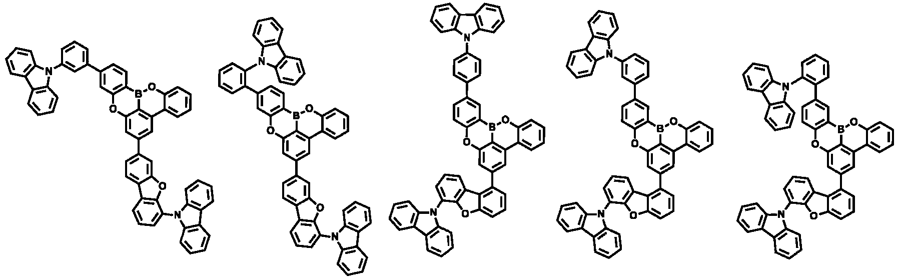 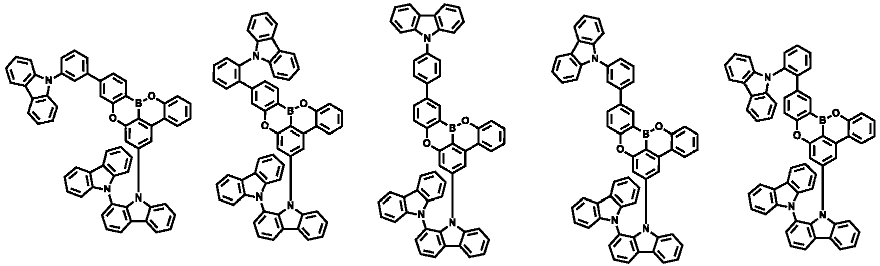 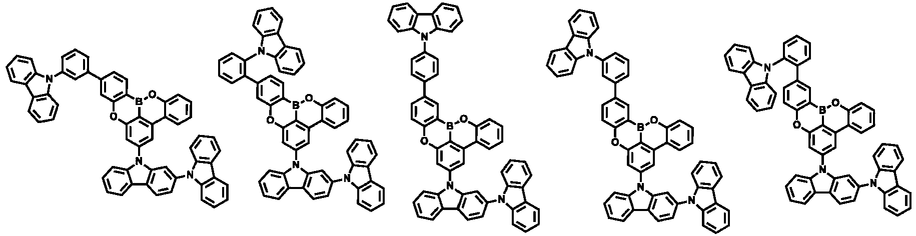 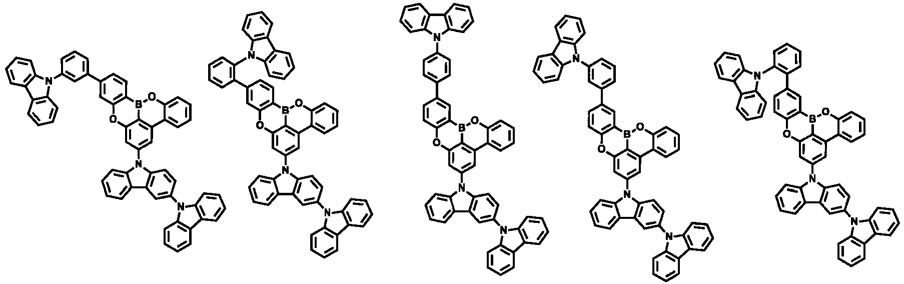 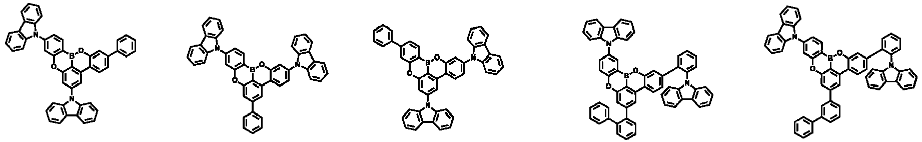 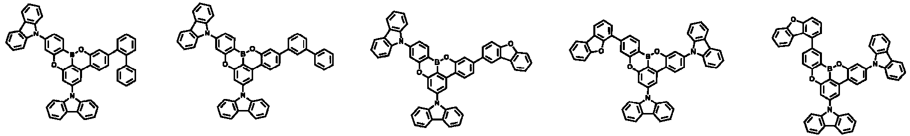 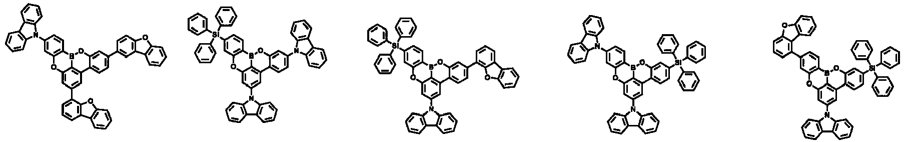 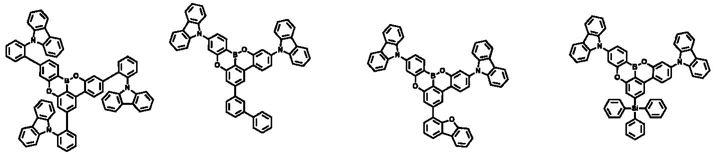 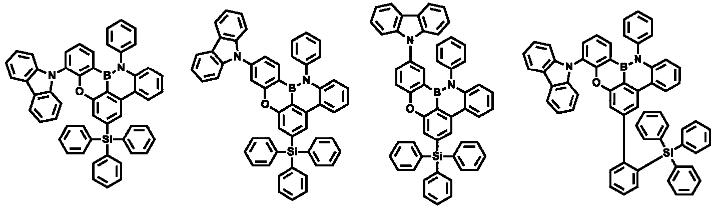 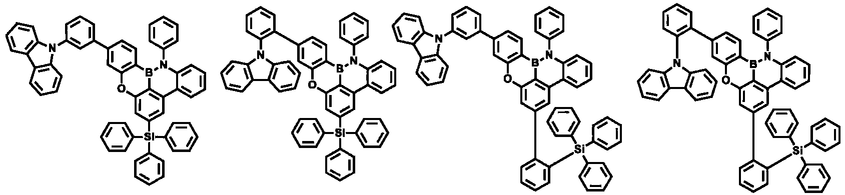 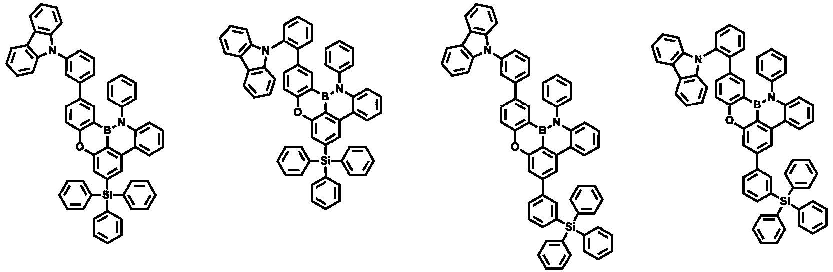 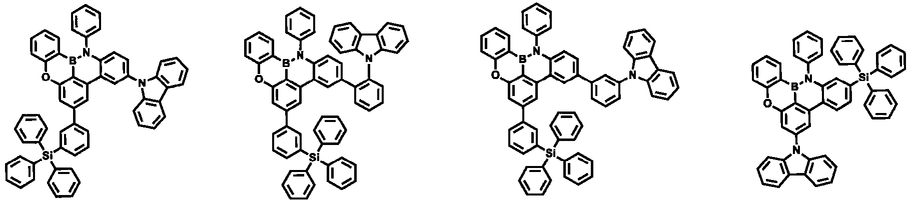 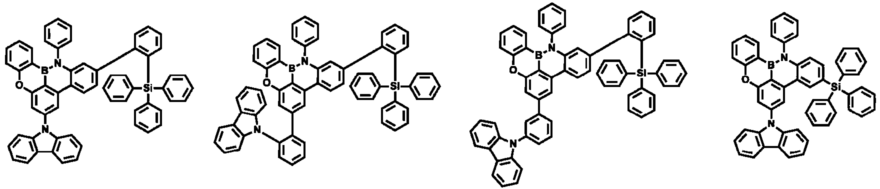 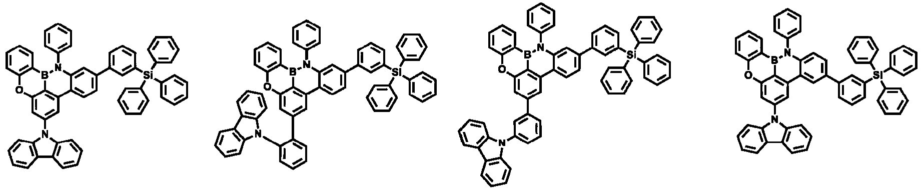 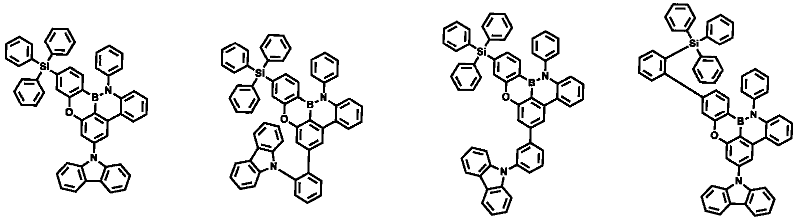 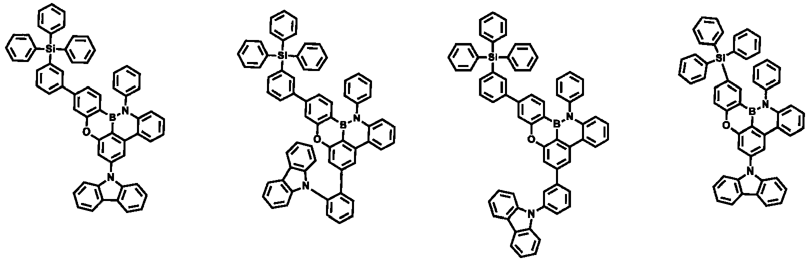 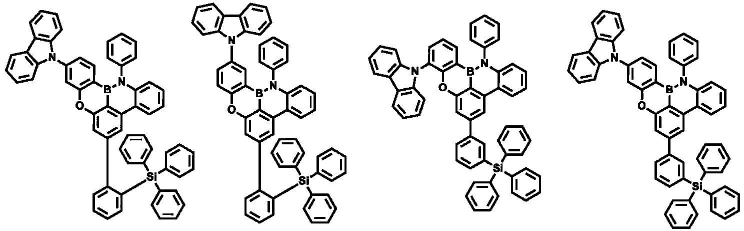 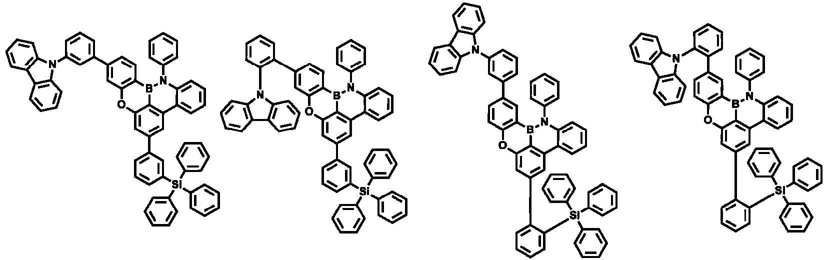 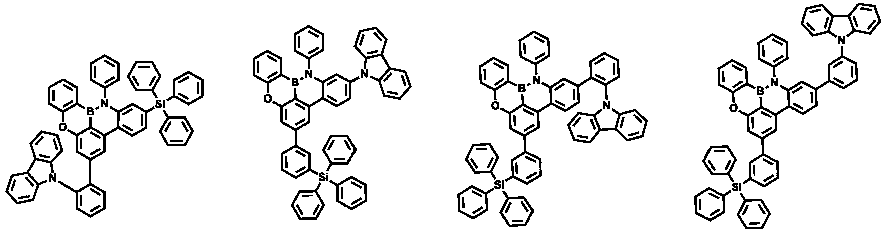 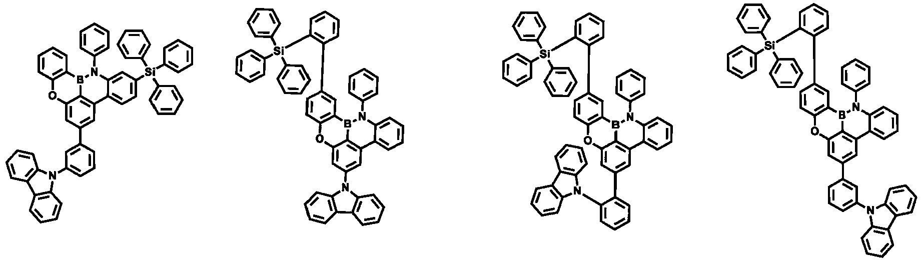 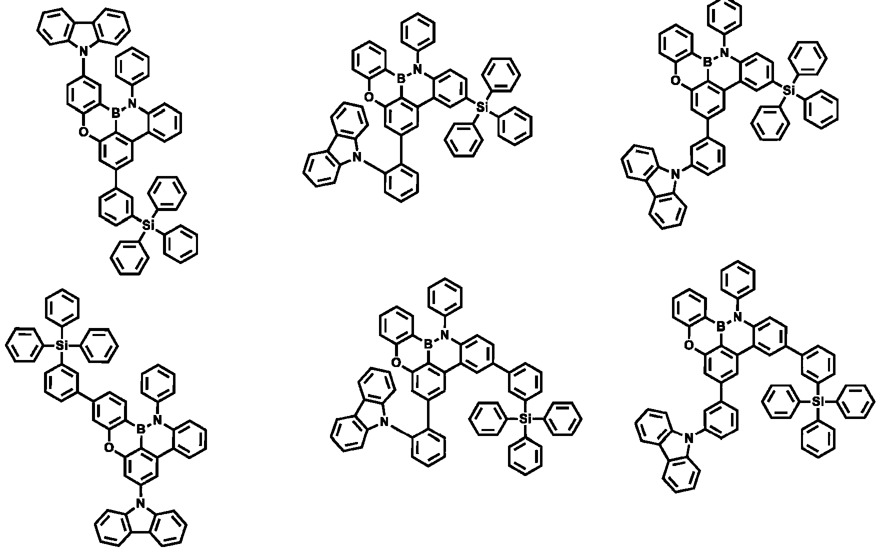 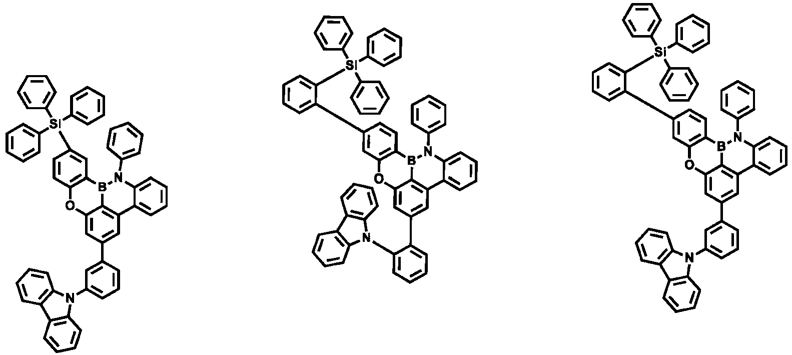 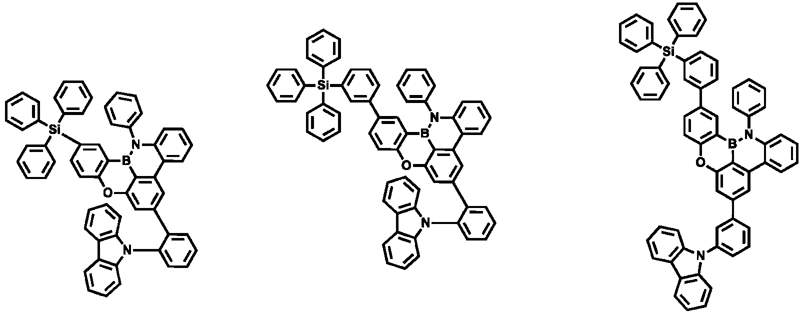 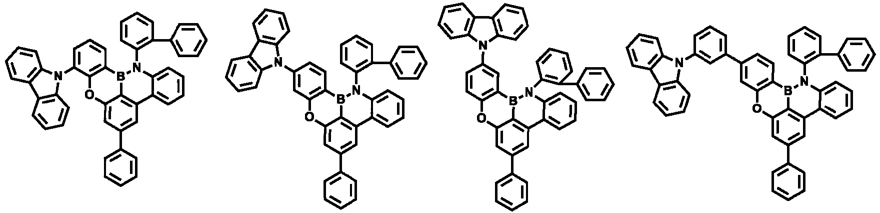 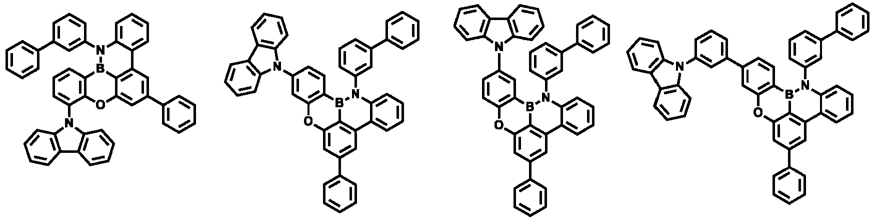 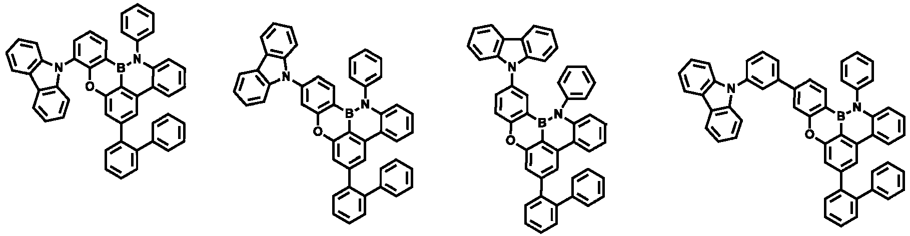 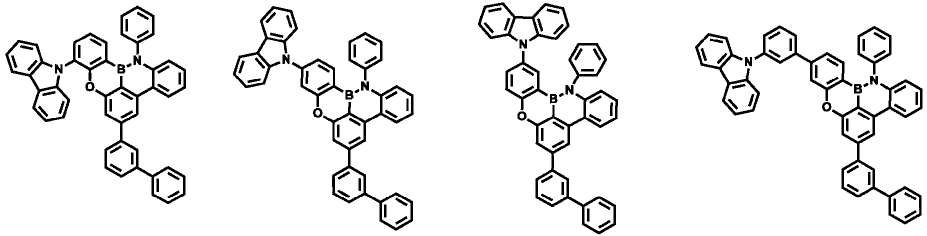 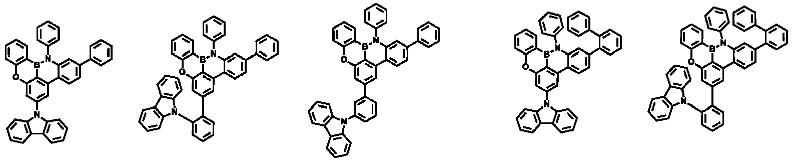 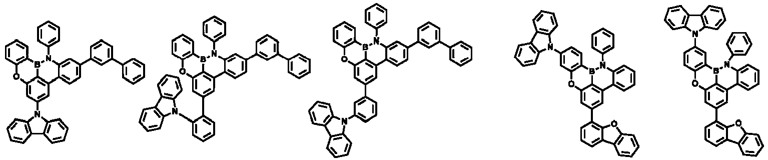 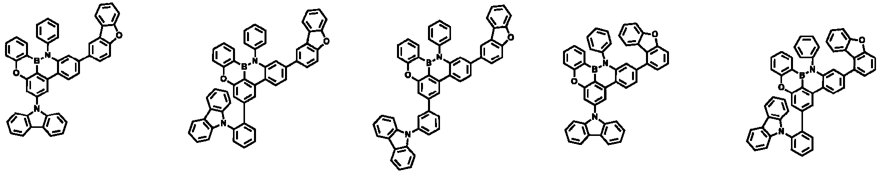 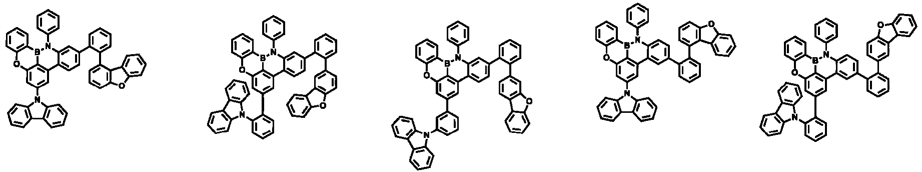 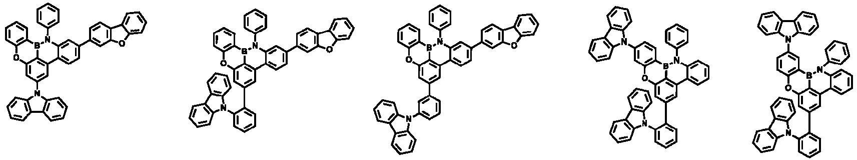 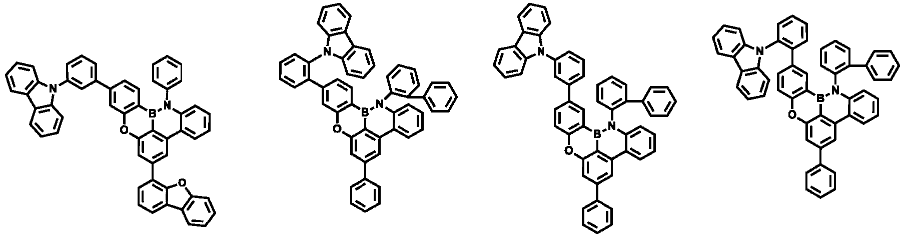 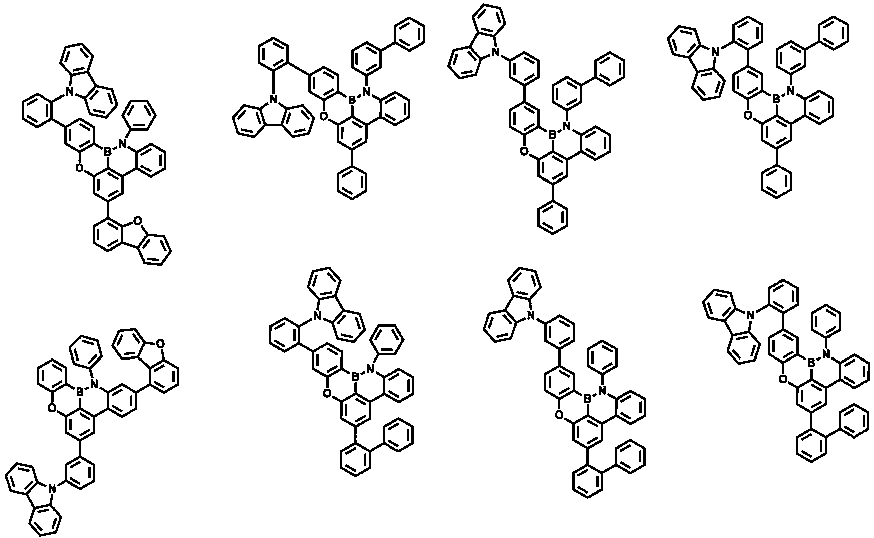 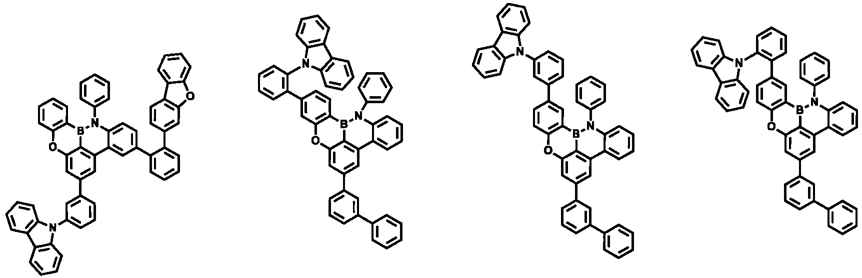 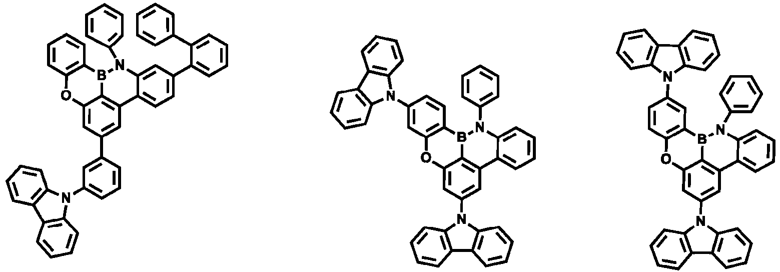 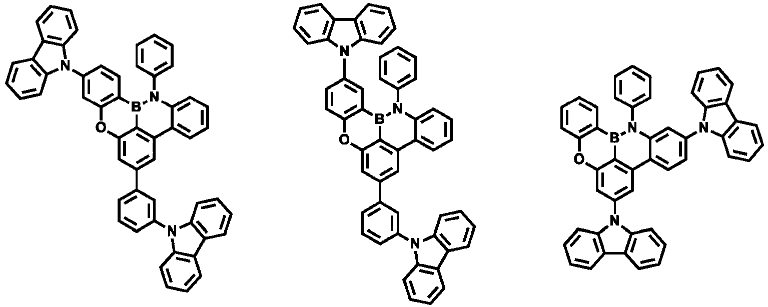 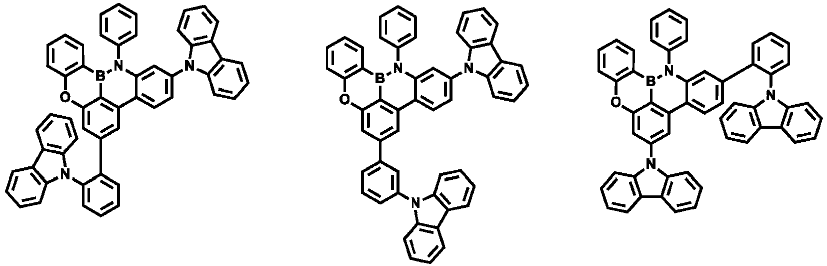 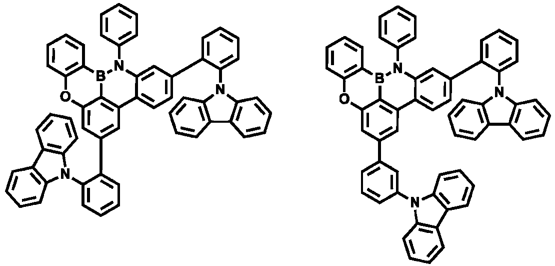 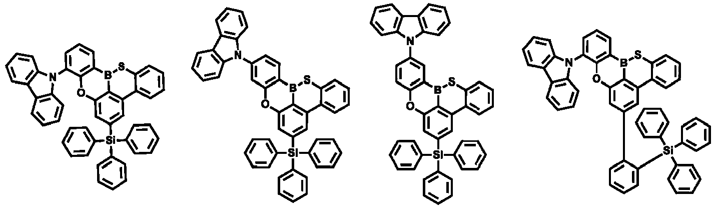 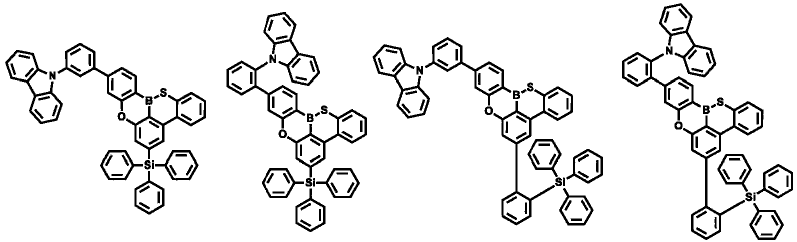 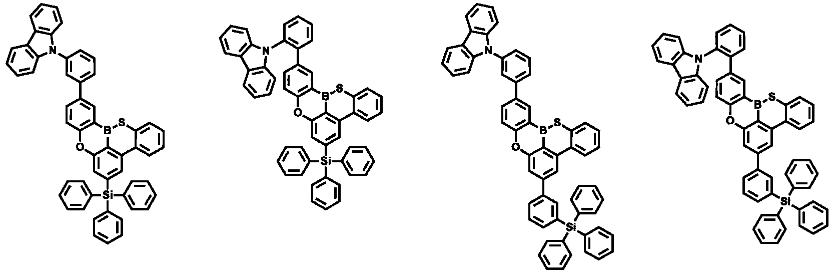 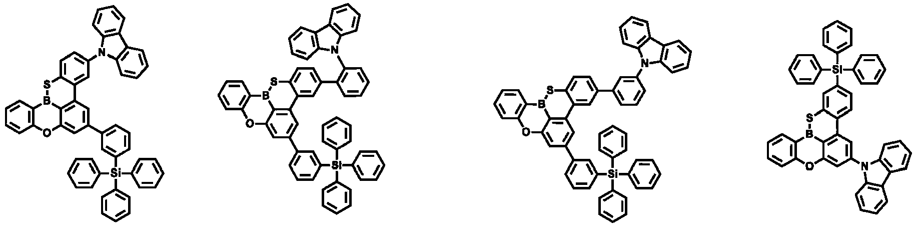 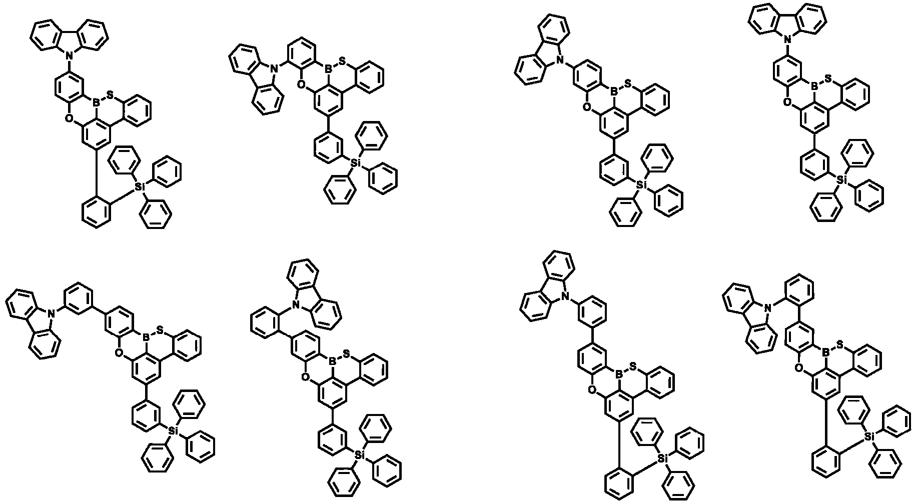 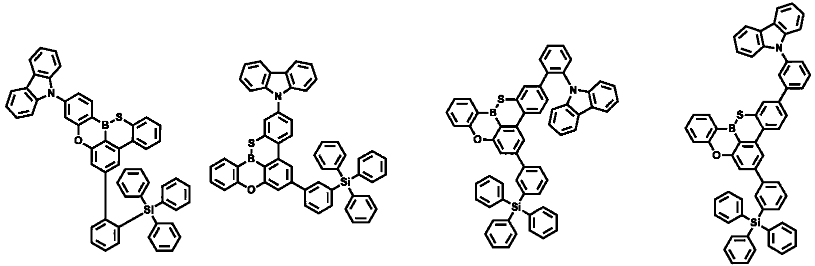 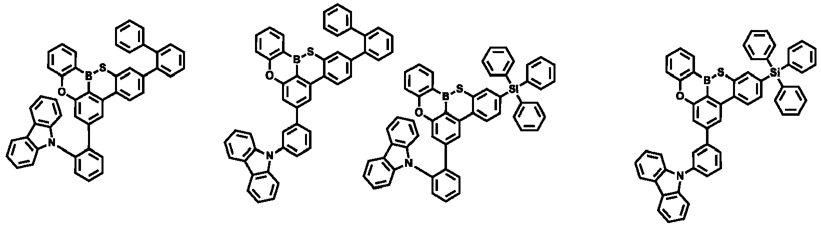 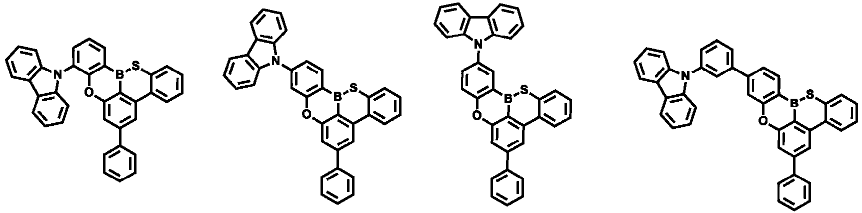 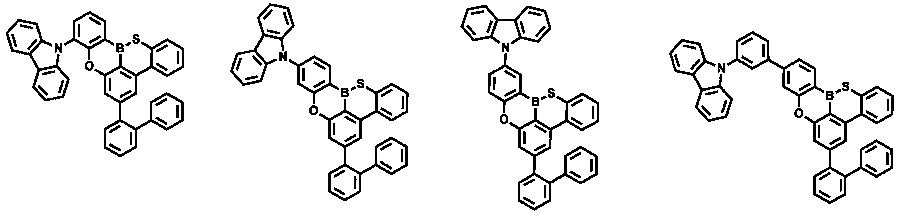 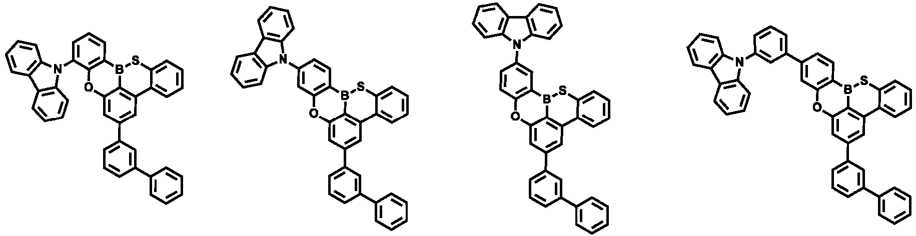 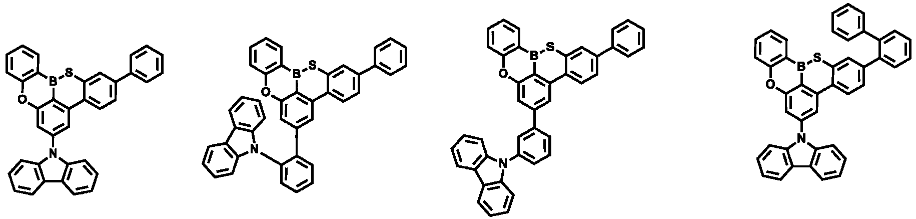 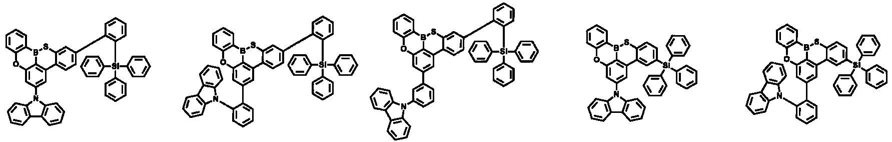 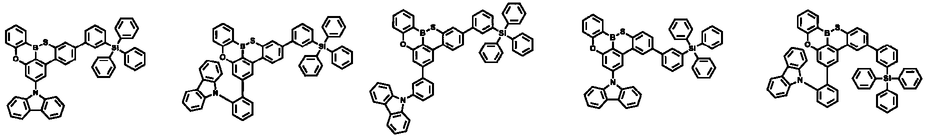 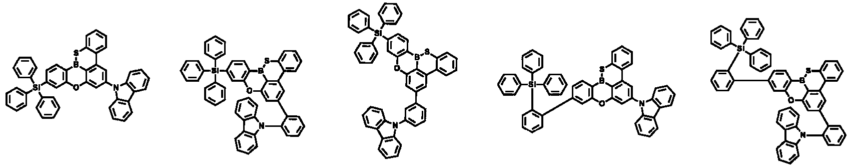 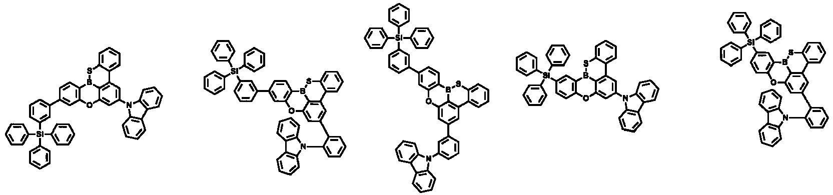 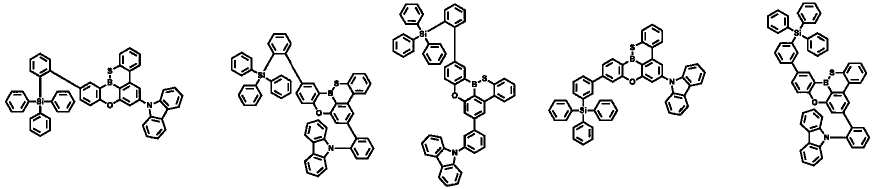 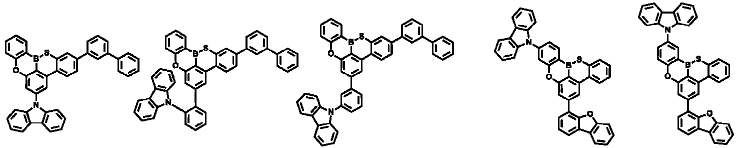 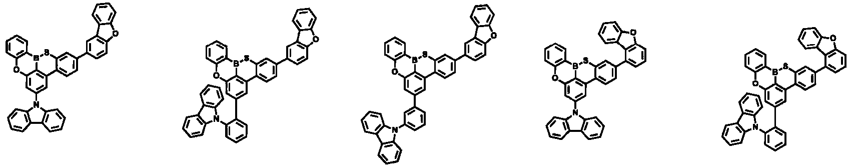 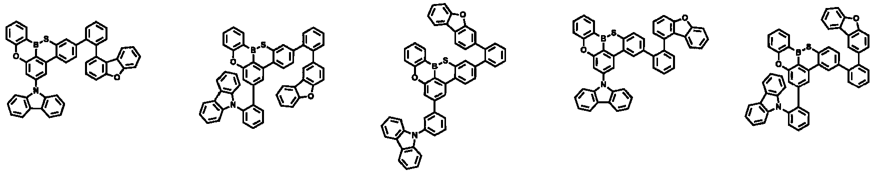 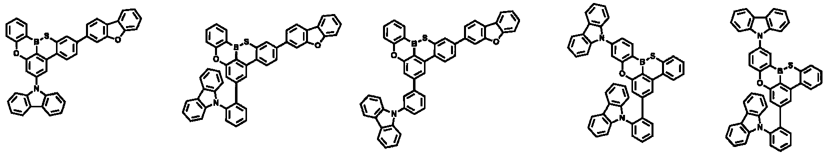 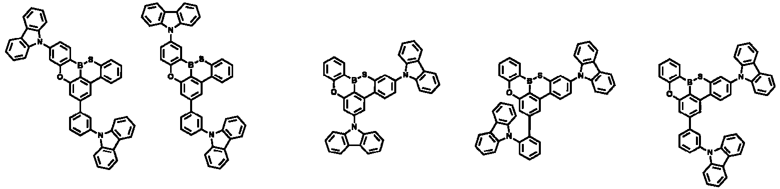 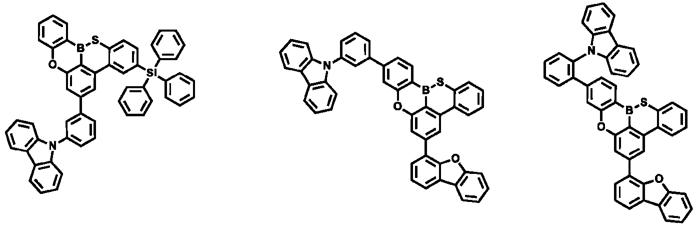 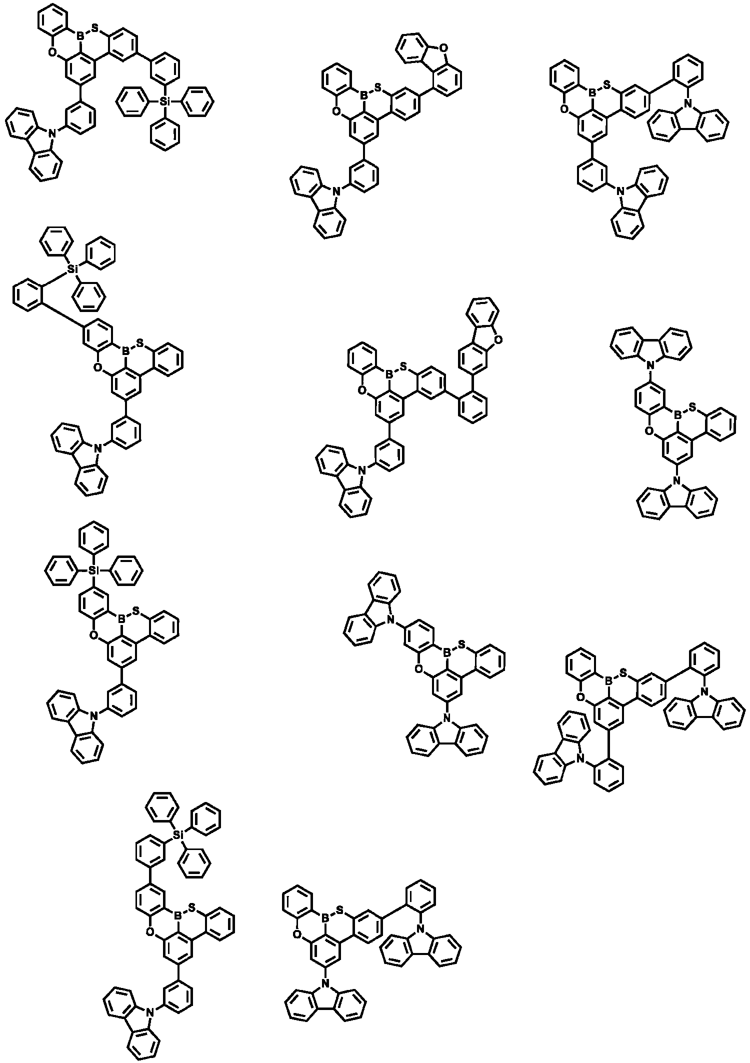 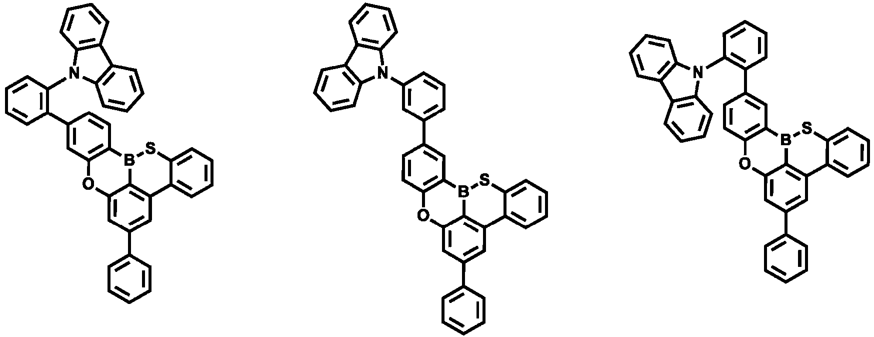 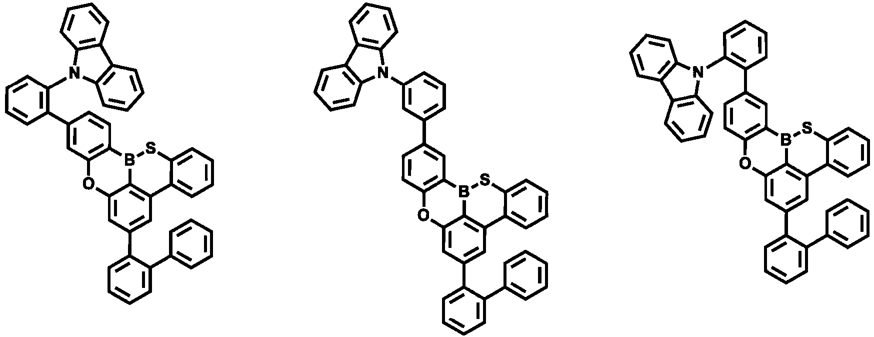 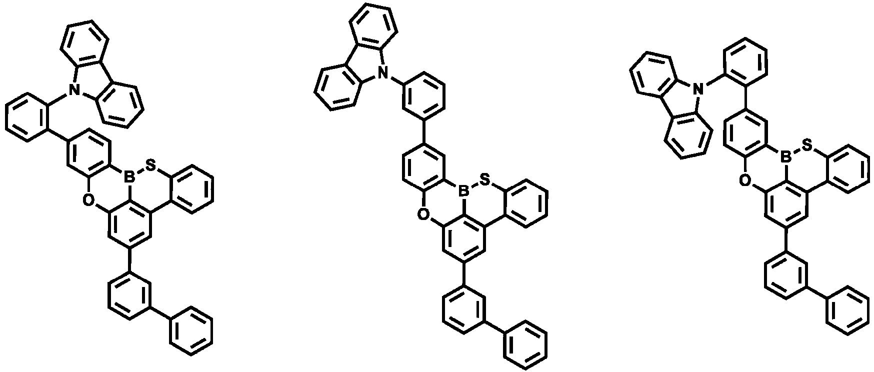 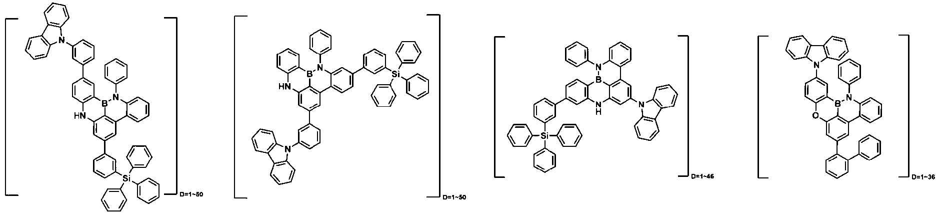 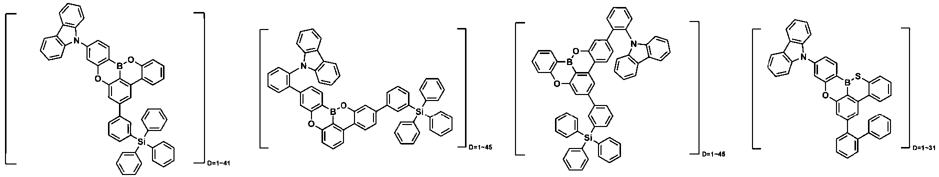 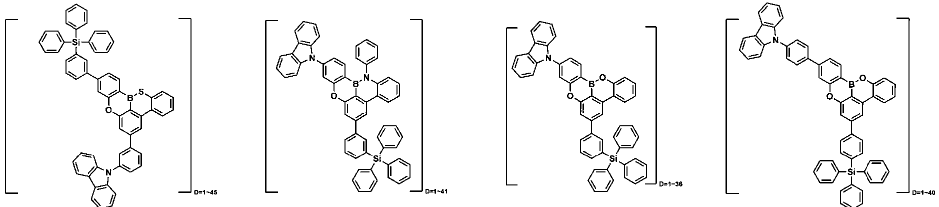 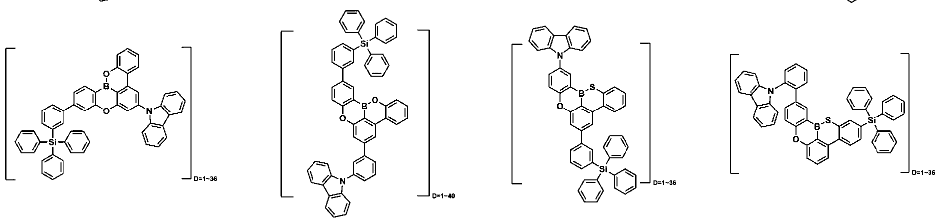 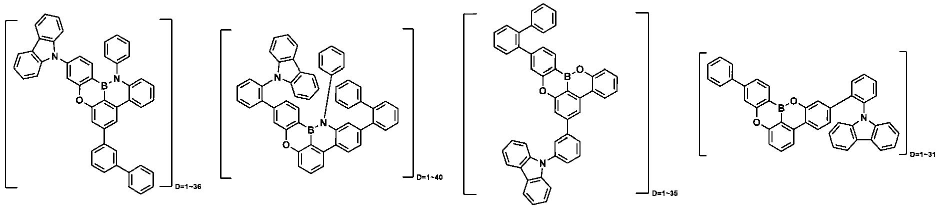 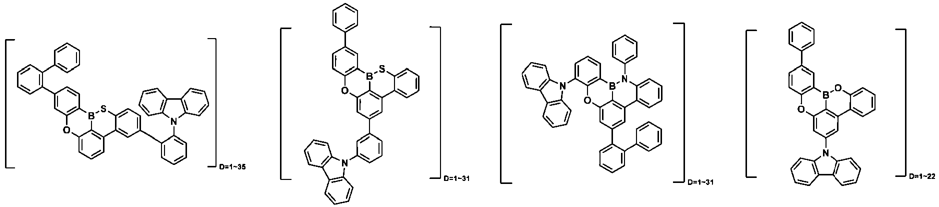 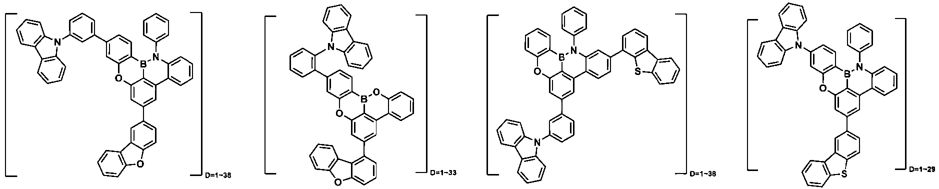 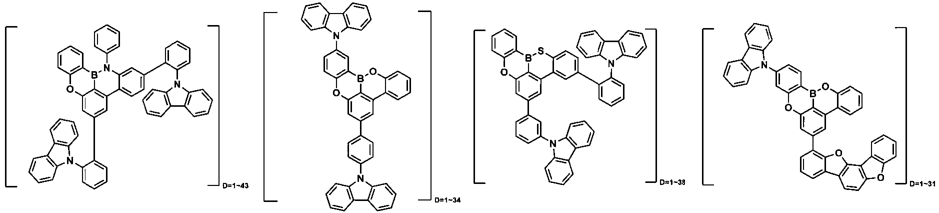 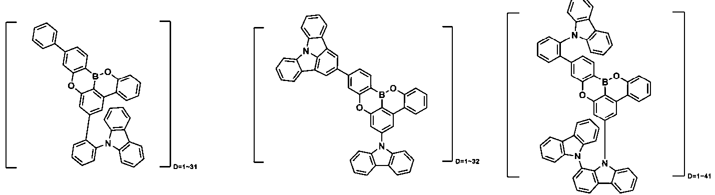 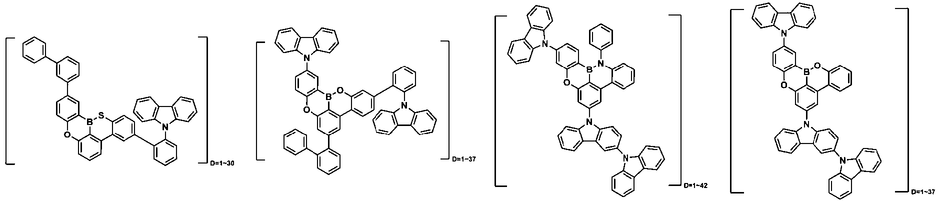 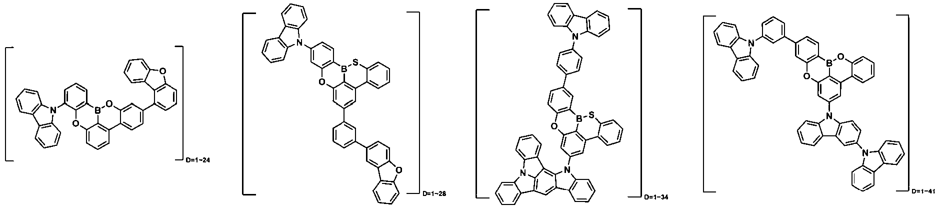 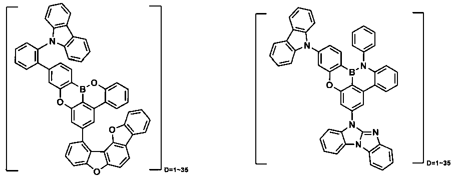 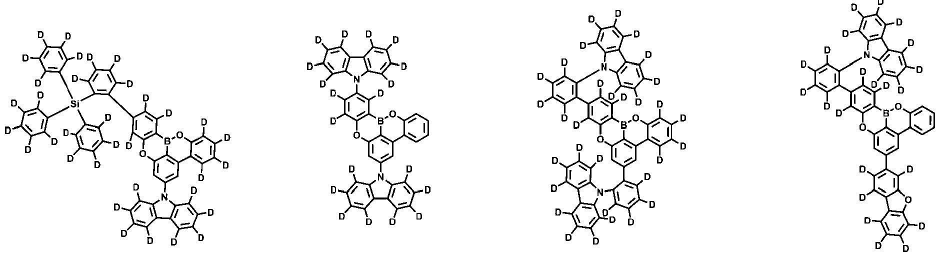 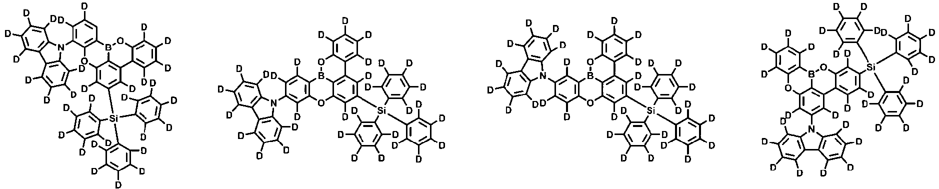 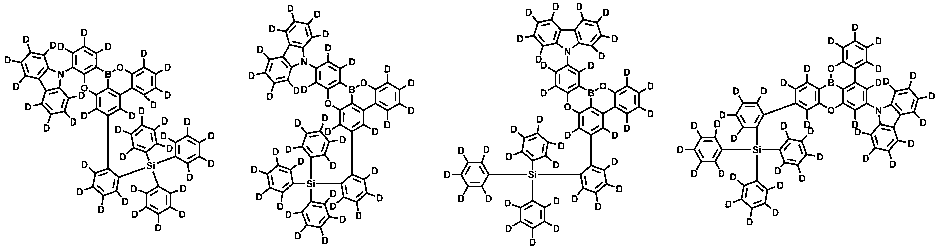 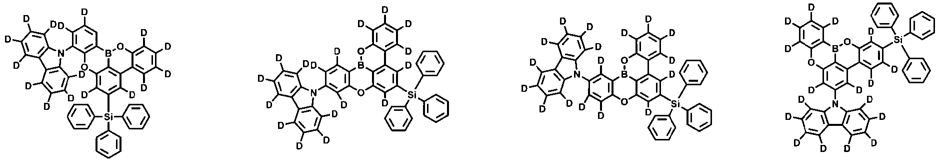 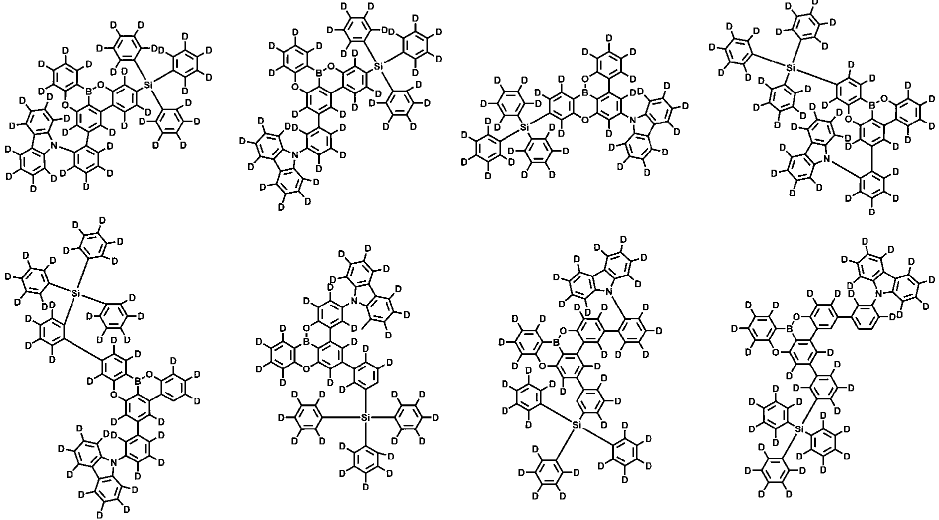 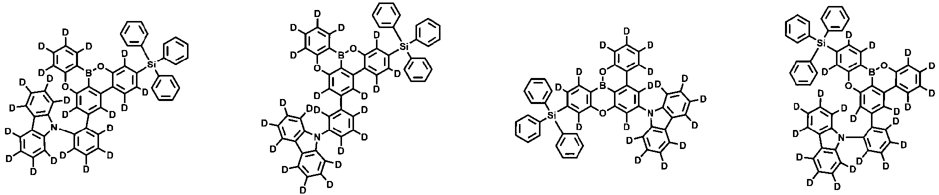 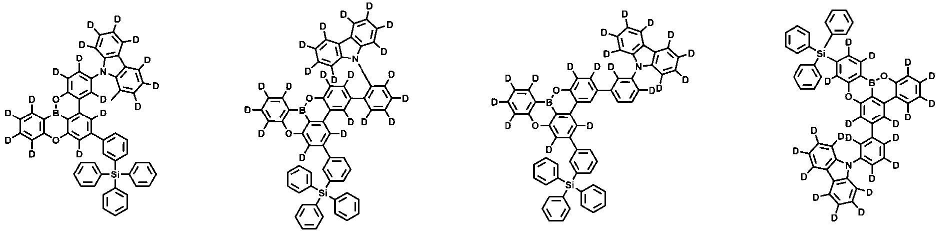 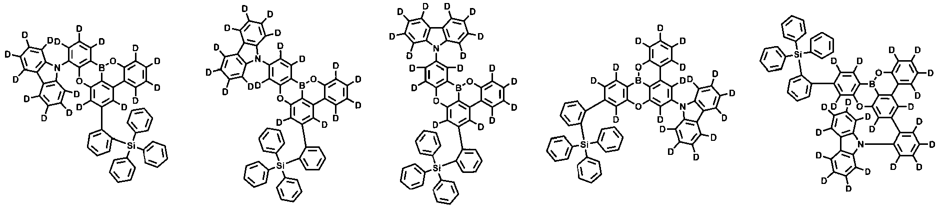 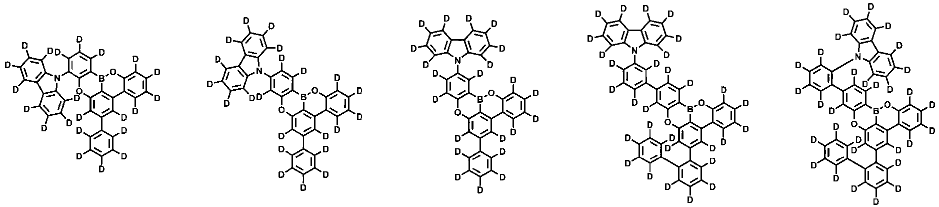 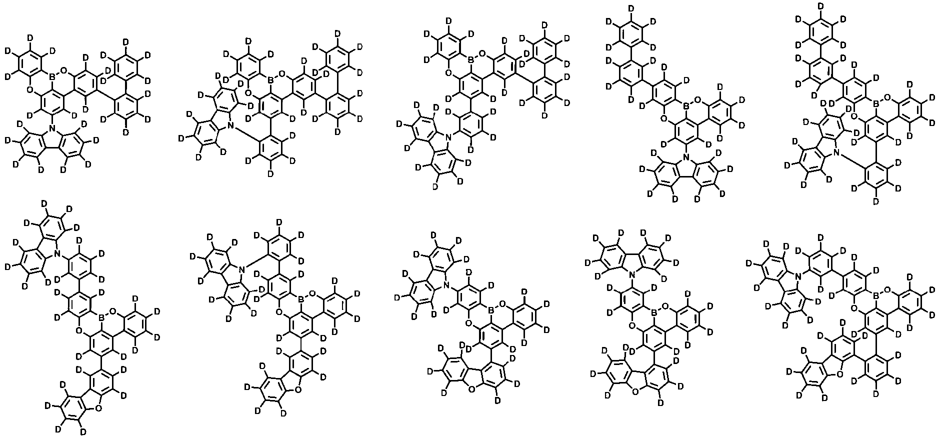 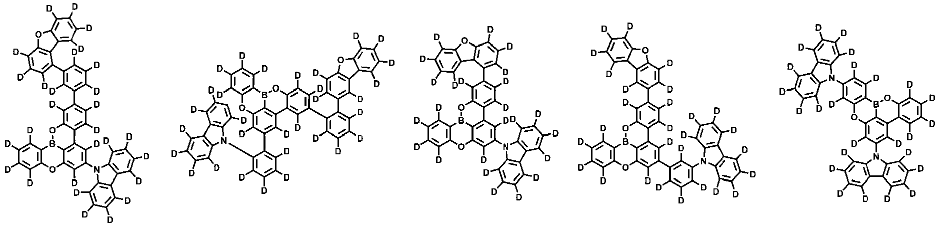 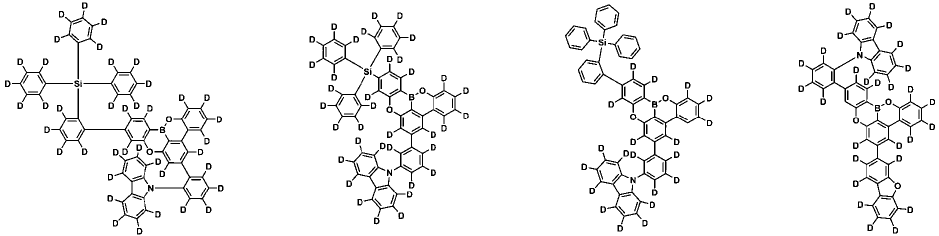 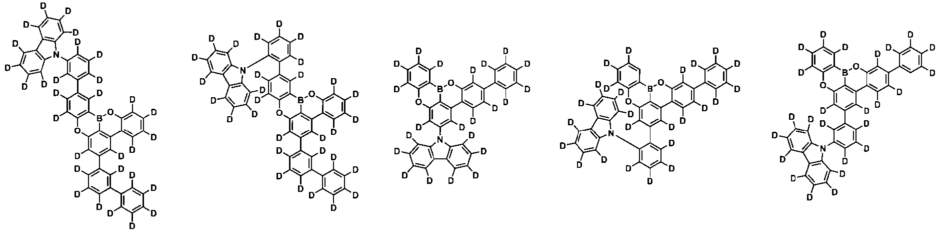 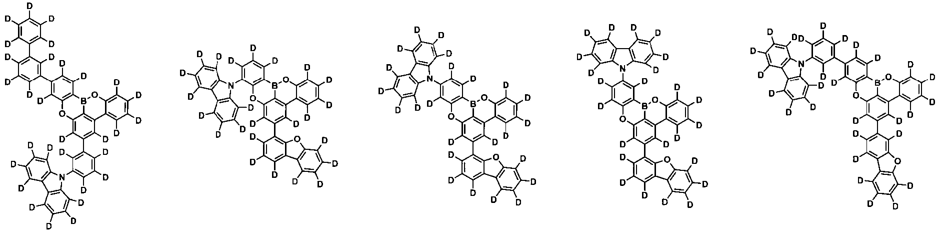 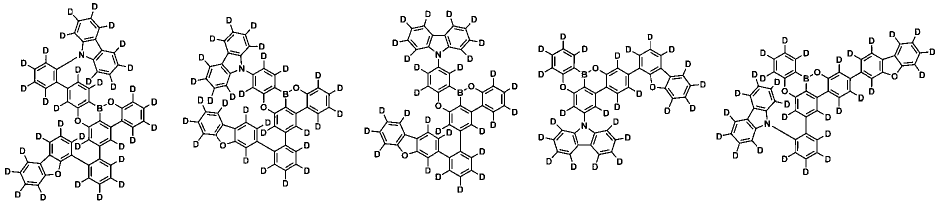 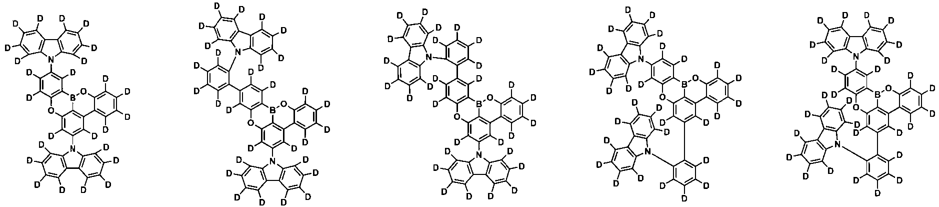 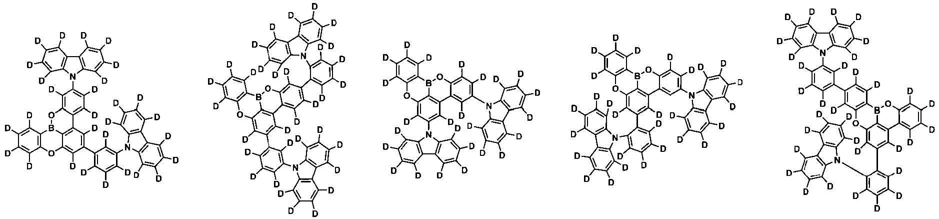 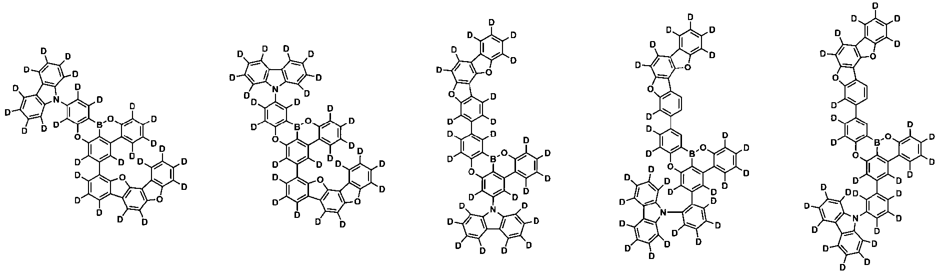 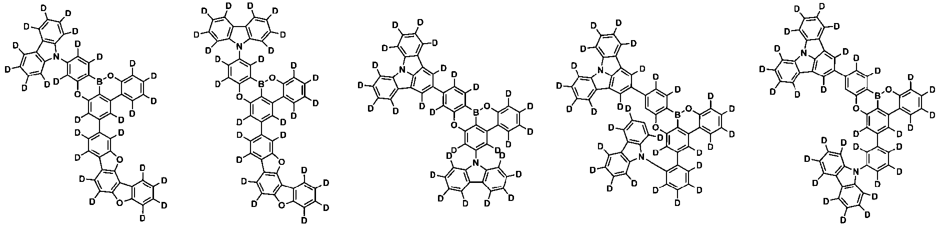 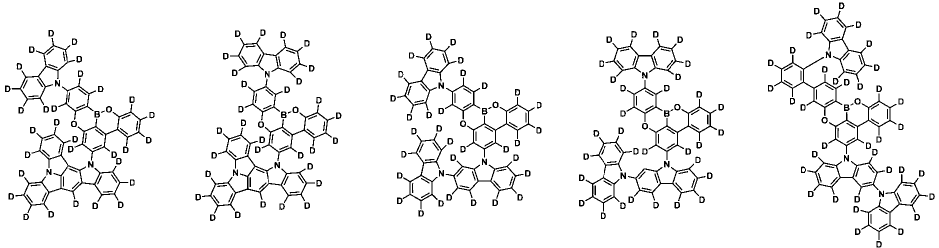 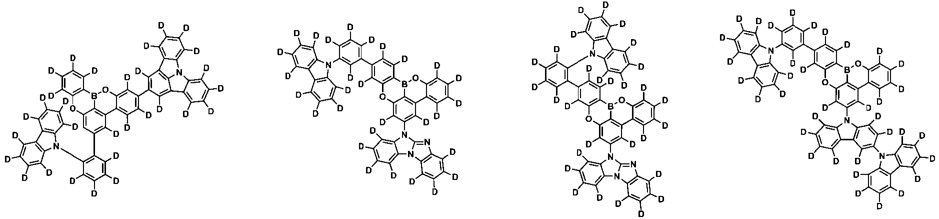 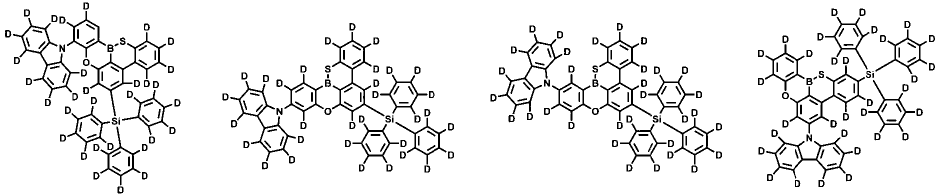 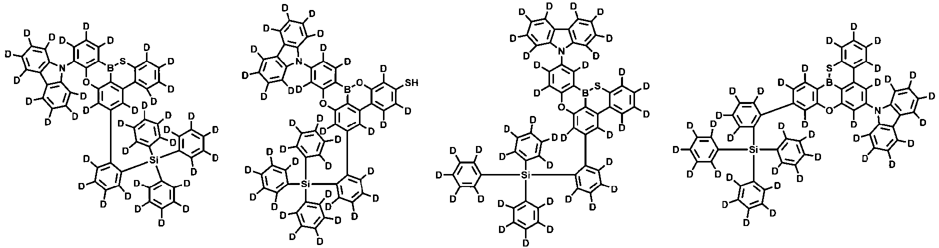 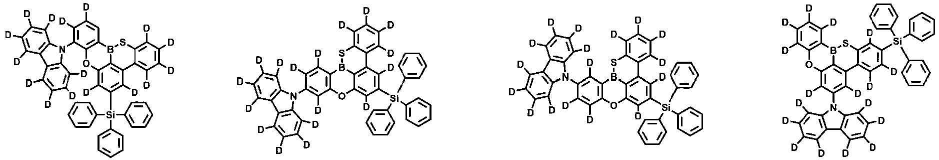 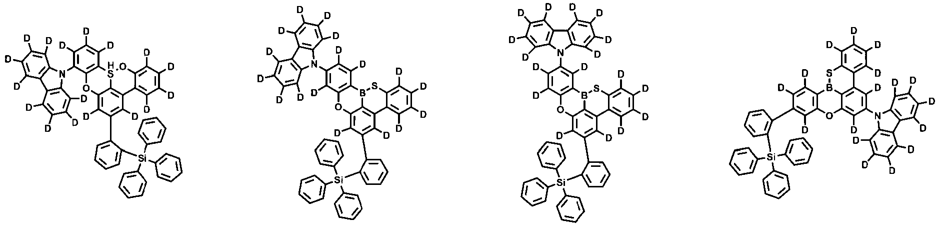 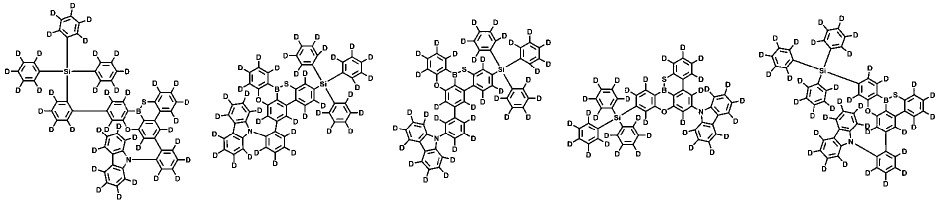 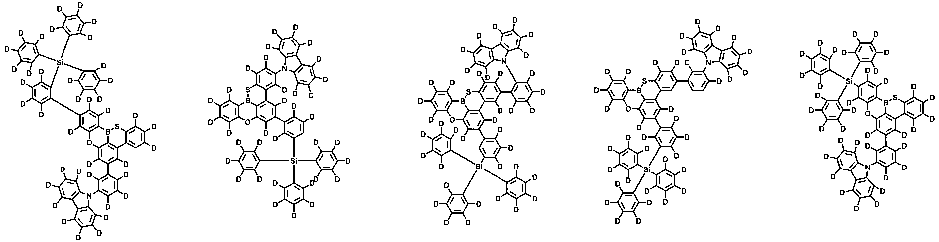 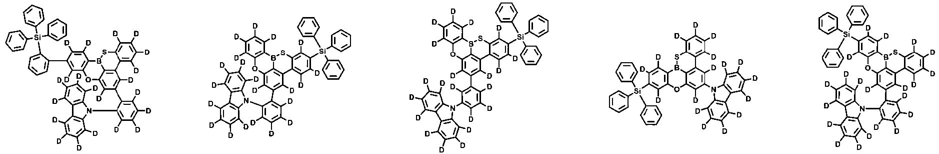 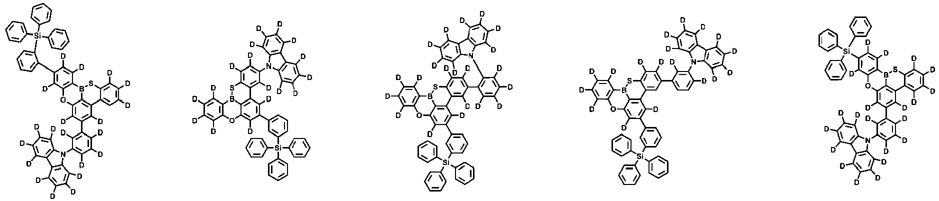 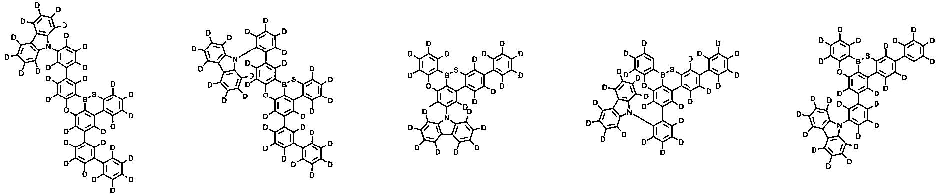 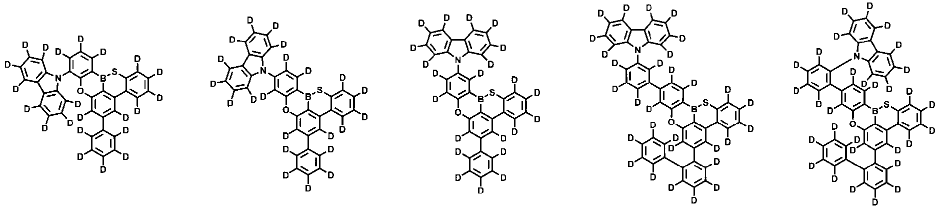 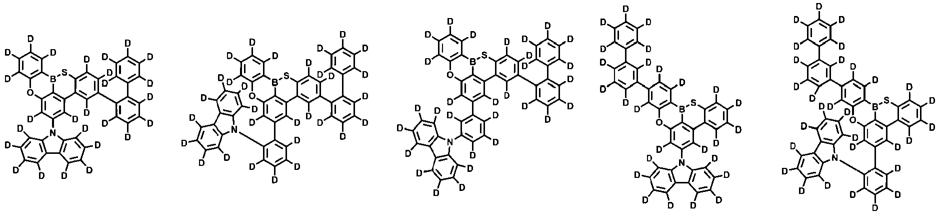 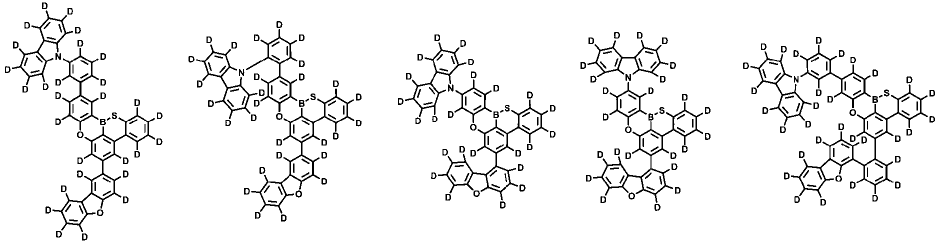 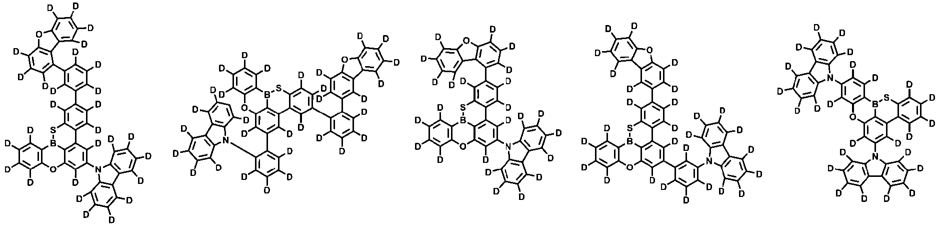 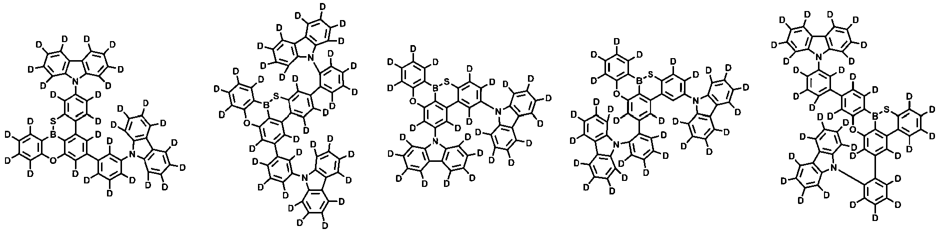 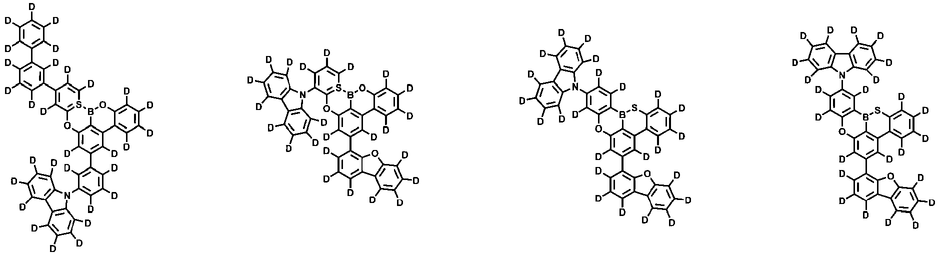 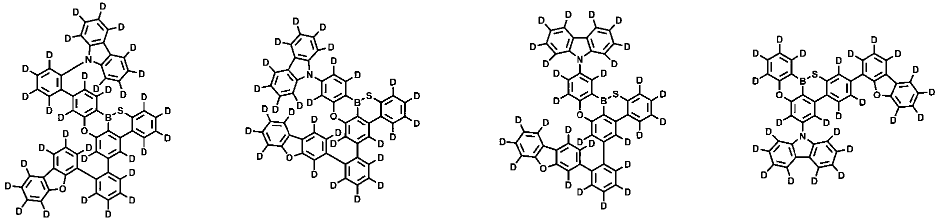 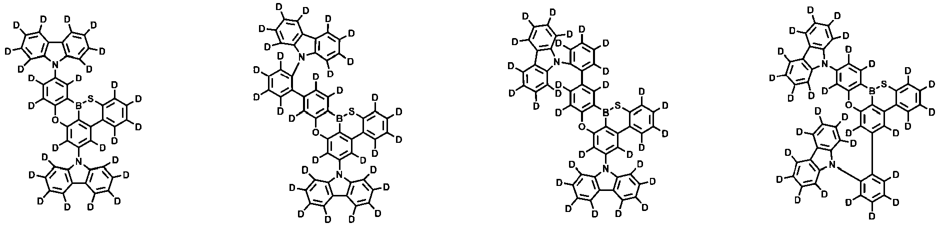 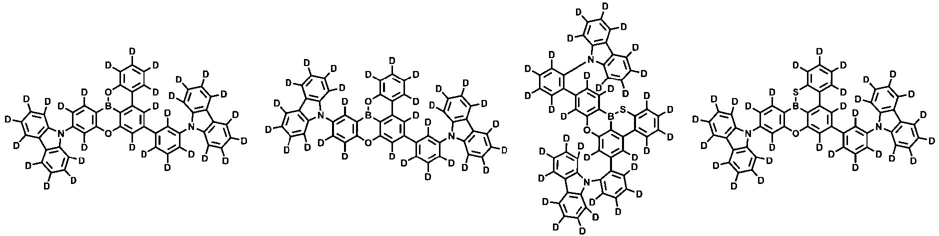 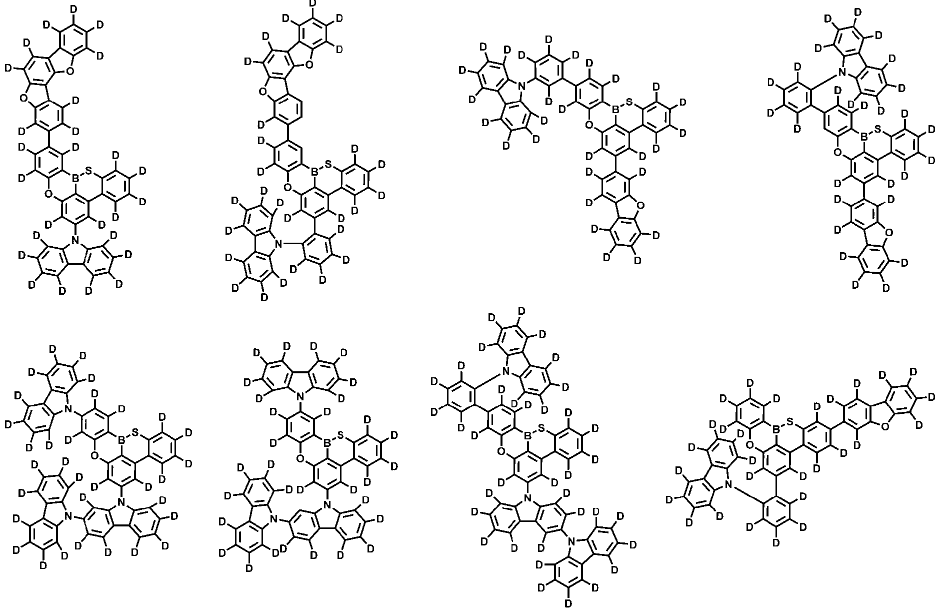 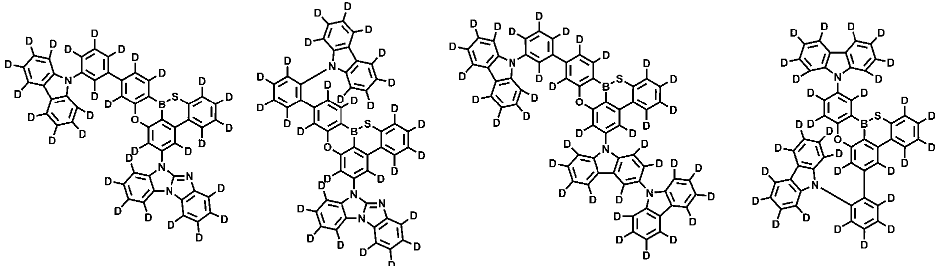 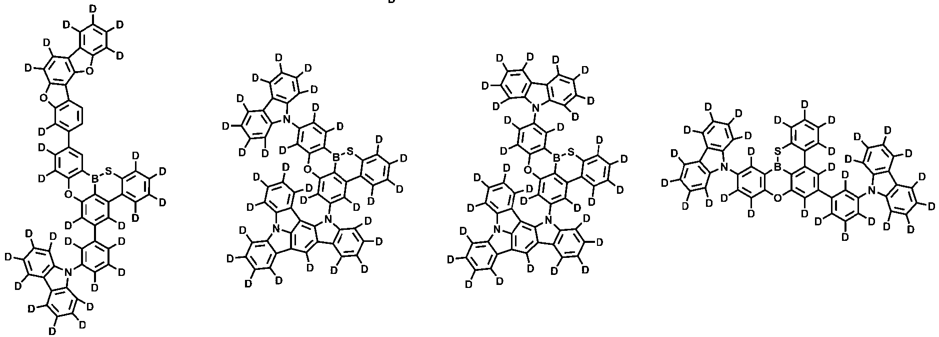 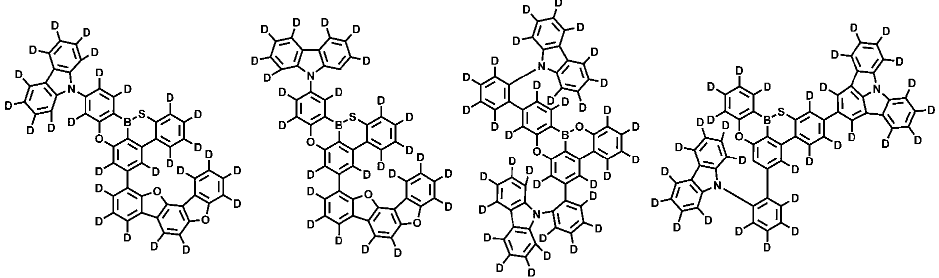 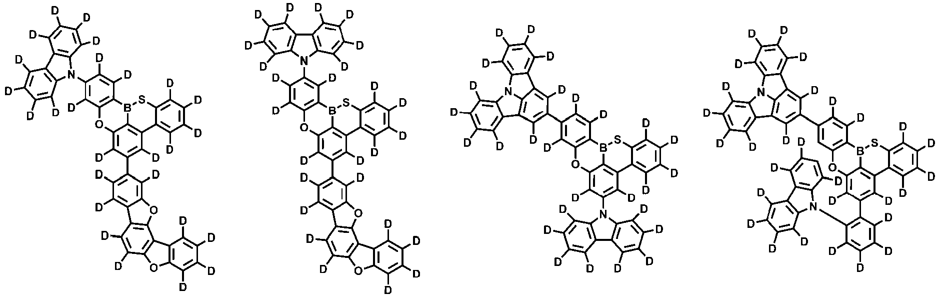 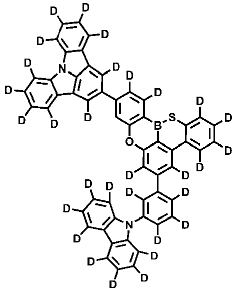 wherein [ ] _{D = x1 ∼ x2} means that the structure within the brackets contains x1 to x2 deuteriums, wherein x1 and x2 are integers.

9. An organic light-emitting device comprising an anode; a cathode; and one or more organic layers provided between the anode and the cathode, wherein one or more of the organic layers comprises the compound according to any one of claims 1 to 8.

10. The organic light-emitting device according to claim 9, wherein the organic layer comprises a light-emitting layer, and the light-emitting layer comprises the compound.

11. The organic light-emitting device according to claim 9, wherein the organic layer comprises a hole blocking layer, and the hole blocking layer comprises the compound.

12. The organic light-emitting device according to claim 9, wherein the organic layer comprises a light-emitting layer and a hole blocking layer, and the light-emitting layer and the hole blocking layer comprise the compound.

13. The organic light-emitting device according to claim 9, wherein the organic layer comprises an electron injection layer, an electron transport layer, or an electron injection and transport layer, and the electron injection layer, the electron transport layer, or the electron injection and transport layer comprises the compound.

14. The organic light-emitting device according to claim 9, wherein the organic layer comprises at least one of a hole transport layer, a hole injection layer, an electron blocking layer, a hole injection and transport layer, a light-emitting layer, an electron transport layer, an electron injection layer, a hole blocking layer, and an electron injection and transport layer.
